# EUROPEAN PATENT SPECIFICATION

(11) **EP 0 600 630 B1**
(45) Date of publication and mention of the grant of the patent: **30.08.2000**
(21) Application number: 93309116.7
(22) Date of filing: 15.11.1993
(51) Int. Cl.: H01L 31/075, H01L 31/20

(54) **Photoelectric conversion element and power generation system using the same**
Photoelektrischer Umwandler und Stromversorgungssystem mit Anwendung desselben
Elément de conversion photoélectrique et système générateur de puissance utilisant cet élément

(30) Priority: 16.11.1992 JP 30520392; 16.11.1992 JP 30536792
(43) Date of publication of application: 08.06.1994
(73) Proprietor: CANON KABUSHIKI KAISHA, Tokyo (JP)
(72) Inventor: Saito, Keishi, c/o Canon Kabushiki Kaisha, Tokyo (JP); Aoike, Tatsuyuki, c/o Canon Kabushiki Kaisha, Tokyo (JP); Sano, Masafumi, c/o Canon Kabushiki Kaisha, Tokyo (JP); Niwa, Mitsuyuki, c/o Canon Kabushiki Kaisha, Tokyo (JP); Hayashi, Ryo, c/o Canon Kabushiki Kaisha, Tokyo (JP); Tonogaki, Masahiko, c/o Canon Kabushiki Kaisha, Tokyo (JP)
(74) Representative: Beresford, Keith Denis Lewis

(56) References cited:
- EP-A- 0 092 925
- EP-A- 0 180 781
- EP-A- 0 304 145
- US-A- 5 104 455
- SOLAR CELLS. vol. 30, no. 1/4 , May 1991 , LAUSANNE CH pages 391 - 401 SHING ET AL. 'ELECTRON CYCLOTRON RESONANCE MICROWAVE PLASMA DEPOSITION OF a-Si:H AND a-SiC:H'
- PROCEEDINGS OF THE 8TH EC PHOTOVOLTAIC SOLAR ENERGY CONFERENCE 9 May 1988 , FLORENCE, ITALY pages 1211 - 1219 HAMAKAWA 'ELECTRON CYCLOTRON RESONANCE CVD OF a-SiC ALLOY AND ITS APPLICATION TO OPTO-ELECTRONIC DEVICES'

## Description

### BACKGROUND OF THE INVENTION

### Field of the Invention

The present invention relates to a photoelectric conversion element composed of silicon non-single crystalline material, and a fabrication method thereof, and a power generation system using the photoelectric conversion element.

Particularly, the invention relates to a photoelectric conversion element wherein the bandgap of pin-type photoelectric conversion semiconductor is changed, and a deposition method of said photoelectric conversion element by plasma CVD.

### Related Background Art

Conventionally, various proposals as presented below have been made for a photoelectric conversion element of the pin structure composed of silicon non-single crystalline material, in which an i-type layer contains silicon atoms and germanium atoms, with the bandgap changed in the i-type layer. For example, the following have been reported:
(1) "Optimum deposition conditions for a-(Si, Ge): H using a triode-configurated rf glow discharge system", J.A. Bragagnolo, P. Littlefield, A. Mastrovito and G. Storti, Conf. Rec. 19th IEEE Photovoltaic Specialists Conference-1987, pp. 878,
(2) "Efficiency improvement in amorphous-SiGe: H solar cells and its application to tandem type solar cells", S. Yoshida, S. Yamanaka, M. Konagai and K. Takahashi, Conf. Rec. 19th IEEE Photovoltaic Specialists Conference-1987, pp. 1101,
(3) "Stability and terrestrial application of a-Si tandem type solar cells", A. Hiroe, H. Yamagishi, H. Nishio, M. Kondo, and Y. Tawada, Conf. Rec. 19th IEEE Photovoltaic Specialists Conference, 1987, pp. 1111,
(4) "Preparation of high quality a-SiGe: H films and its application to the high efficiency triple-junction amorphous solar cells, "K. Sato, K. Kawabata, S. Terazono, H. Sasaki, M. Deguchi, T. Itagaki, H. Morikawa, M. Aiga and K. Fujikawa, Conf. Rec. 20th IEEE Photovoltaic Specialists Conference, 1988 pp. 73,
(5) U.S.P. 4,816,082
(6) U.S.P. 4,471,155
(7) U.S.P. 4,782,376
   Also, several theoretical researches for the characteristics of a photovoltaic element having the bandgap changed have been reported, for example,
(8) "A novel design for amorphous silicon alloy solar cells", S. Guha, J. Yang, A. Pawlikiewicz, T. Glatfelter, R. Ross, and S.R. Ovshinsky, Conf. Rec. 20th IEEE Photovoltaic specialists Conference-1988 pp. 79,
(9) "Numerical modelling of multijunction, amorphous silicon based P-I-N solar cells", A.H. Pawlikiewicz and S. Guha, Conf. Rec. 20th IEEE Photovoltaic Specialists Conference-1988 pp. 251.

Such photovoltaic elements in the conventional arts have a varying bandgap layer inserted into p/i and n/i interfaces for the purposes of preventing the recombination of photoexcited carriers in the neighborhood of p/i and n/i interfaces, increasing the open-circuit voltage, and enhancing the carrier range of holes.

US-A-5104455 discloses a method for producing a photoelectric conversion element having p, i and n laminated layers of silicon type non-monocrystalline semiconductor material, wherein a local minimum energy band gap occurs in a section of the i-layer between the centre of the i-layer and the p-layer. The required band structure of the i-layer is produced by a flow discharge method in which the flow ratio of GeH₄/(GeH₄+SiH₄) is varied, and CH₄ gas is subsequently introduced.

EP-A-0304145 discloses a photoelectric conversion device in which the intrinsic layer is spatially graded in the direction of the thickness of the layer. The intrinsic layer is formed using an RF sputtering process in which the amount of germane (GeH₄) gas is increased to a maximum value, held for a period of time and then reduced to zero over a period of time.

The article SOLAR CELLS, vol. 30, May 1991, pages 391-401 discloses a method of manufacturing a photoelectric conversion device by microwave-plasma-enhanced CVD wherein the sample stage may be RF induction heated.

### SUMMARY OF THE INVENTION

Conventional photovoltaic elements containing silicon atoms and germanium atoms and having the bandgap changed are required to have higher performance, e.g., in the photoelectric conversion efficiency, and reliability in practical use, wherein a further improvement is desired in the open-circuit voltage and the carrier range of holes by suppressing the recombination of photoexcited carriers.

Also, conventional photovoltaic elements had a problem that the photoelectric conversion efficiency may decrease when the illuminating light applied to the photovoltaic elements is weak.

Further, conventional photovoltaic elements had another problem that the photoelectric conversion efficiency may decrease if annealed in the place of variations as there is distortion in the i-type layer.

An object of the present invention is to provide a photoelectric conversion element which can solve one or more problems of the prior art.

That is, it is an object to provide a photoelectric conversion element in which the open-circuit voltage and the carrier range of holes are improved by preventing the recombination of photoexcited carriers.

Also, it is another object to provide a photoelectric conversion element with the improved conversion efficiency when the illuminating light applied to the photoelectric conversion element is weak.

Further, it is another object to provide a photoelectric conversion element which causes less decrease in the photoelectric conversion efficiency when annealed under vibrations for the long time.

In addition, it is another object to provide a photoelectric conversion element which is less liable to change in the photoelectric conversion efficiency against the temperature variations.

Still in addition, it is another object to provide a system utilizing a photoelectric conversion element in which one or more of the aforementioned objects have been achieved.

The present invention has been achieved as a result of careful research to solve one or more conventional problems and to accomplish one or more of the above objects.

According to the present invention there is provided a method for producing a photoelectric conversion element having p, i and n laminated layers of silicon type non-monocrystalline semiconductor material, wherein the local minimum energy band gap occurs in a section of said i-layer between the centre of said i-layer and said p layer, the method being characterised by comprising the steps of:
forming a first region of said i-layer by microwave plasma CVD in which a source gas including at least a silicon containing gas and a germanium containing gas is simultaneously subjected to microwave energy and RF energy, the RF energy being of a power density greater than the power density of said microwave energy, the power density of the microwave energy being less than that required to completely decompose said source gas; and
forming a second region of said i-layer by RF plasma CVD.

A photovoltaic element produced by a method according to the present invention in desirable form is characterized in that a valence electron control agent serving as the donor and a valence electron control agent serving as the acceptor are simultaneously doped into the i-type layer by microwave plasma CVD and/or the i-type layer by RF plasma CVD. These valence electron control agents are a Group III element and/or a Group V element in the periodic table, and preferably are distributed in the i-type layer by microwave plasma CVD.

A photovoltaic element produced by a method according to the present invention in desirable form is characterized in that the maximum value of bandgap takes place in at least one of the p-type layer side or the n-type layer side within the i-type layer by microwave plasma CVD, and the region of the maximum value of bandgap is from 1 to 30 nm.

Further, it is characterized in that oxygen atoms and/or nitrogen atoms are contained in the i-type layer by microwave plasma CVD and/or the i-type layer by RF plasma CVD.

Also, it is characterized in that the content of hydrogen contained in the i-type layer by microwave plasma CVD changes corresponding to the content of silicon atoms.

Further, a photovoltaic element produced by a method according to the present invention in desirable form is one in which at least one of the p-type layer and the n-type layer is of a lamination structure consisting of a layer having Group III element or Group V element in the periodic table as the main constituent and a layer containing a valence electron control agent and having silicon atoms as the main constituent. In particular, the layer having Group III element and/or group V element in the periodic table as the main constituent is desirably 1 nm thick or less.

A power generation system of the present invention is characterized by comprising a photovoltaic element produced by a method according to the present invention, an accumulator for accumulating the electric power supplied from the photovoltaic element and/or supplying electric power to an external load, and a control system for controlling the electric power to be supplied from the photovoltaic element to the accumulator and/or the external load while monitoring the voltage and/or current of the photovoltaic element.

### BRIEF DESCRIPTION OF THE DRAWINGS

Fig. 1 is a typical view of a layer constitution of a photovoltaic element according to the present invention.
Fig. 2 is a typical band diagram of the photovoltaic element according to the present invention in the thermal equilibrium state.
Fig. 3 is a typical view of another layer constitution of the photovoltaic element according to the present invention.
Fig. 4 is a typical band diagram for explaining another bandgap variation of the photovoltaic element according to the present invention.
Fig. 5 is a typical band diagram for explaining another bandgap variation of the photovoltaic element according to the present invention.
Fig. 6 is a typical band diagram for explaining another bandgap variation of the photovoltaic element according to the present invention.
Fig. 7 is a typical band diagram for explaining another bandgap variation of the photovoltaic element according to the present invention.
Fig. 8 is a typical band diagram for explaining another bandgap variation of the photovoltaic element according to the present invention.
Fig. 9 is a typical band diagram for explaining another bandgap variation of the photovoltaic element according to the present invention.
Fig. 10 is a typical band diagram for explaining another bandgap variation of the photovoltaic element according to the present invention.
Fig. 11 is a typical band diagram for explaining another bandgap variation of the photovoltaic element according to the present invention.
Fig. 12 is a typical band diagram for explaining another bandgap variation of the photovoltaic element according to the present invention.
Fig. 13 is a typical band diagram for explaining another bandgap variation of the photovoltaic element according to the present invention.
Fig. 14 is a typical band diagram for explaining another bandgap variation of the photovoltaic element according to the present invention.
Fig. 15 is a typical band diagram for explaining another bandgap variation of the photovoltaic element according to the present invention.
Fig. 16 is a typical band diagram for explaining another bandgap variation of the photovoltaic element according to the present invention.
Fig. 17 is a typical band diagram for explaining another bandgap variation of the photovoltaic element according to the present invention.
Fig. 18 is a schematic view of a manufacturing apparatus relying on the microwave plasma CVD method which exemplifies an apparatus for fabricating the photovoltaic element according to the present invention.
Fig. 19 is a schematic view of a manufacturing apparatus relying on the RF plasma CVD method which exemplifies an apparatus for fabricating the photovoltaic element according to the present invention.
Fig. 20 is a schematic view of a manufacturing apparatus of the multi-chamber separation-type deposition type which exemplifies an apparatus for fabricating the photovoltaic element according to the present invention.
Fig. 21 is a schematic view of a manufacturing apparatus of the multi-chamber separation-type deposition type which exemplifies another apparatus for fabricating the photovoltaic element according to the present invention.
Fig. 22 is a schematic view of a manufacturing apparatus of the multi-chamber separation-type deposition type which exemplifies another apparatus for fabricating the photovoltaic element according to the present invention.
Figs. 23A and 23B are graphic representations showing the patterns of the flow rate of SiH₄ and GeH₄ gas varying with the time.
Fig. 24 is a graphic representation showing the variation of i-type layer bandgap in layer thickness direction.
Figs. 25A and 25B are graphic representations showing an SiH₄ gas flow rate pattern in forming the i-type layer, and the variation in layer thickness direction of Si and H atoms contained in the i-type layer.
Fig. 26 is a graphic representation showing the SiH₄ and GeH₄ gas flow rate patterns varying with the time.
Fig. 27 is a typical circuit diagram of a power supply system according to the present invention.
Fig. 28 is a typical circuit diagram of another power supply system according to the present invention.
Fig. 29 is a typical circuit diagram of another power supply system according to the present invention.
Fig. 30 is a typical circuit diagram of another power supply system according to the present invention.
Fig. 31 is a typical circuit diagram of another power supply system according to the present invention.
Fig. 32 is a typical circuit diagram of another power supply system according to the present invention.
Figs. 33A and 33B are graphic representations showing the flow rate of NO/He gas introduced in forming the i-type layer, varying with the time, and the variation in layer thickness direction of N and O atoms contained in the i-type layer.
Fig. 34 is a graphic representation showing the patterns of the flow rate of SiH₄ and GeH₄ gas varying with the time.
Fig. 35 is a graphic representation showing the patterns of the flow rate of SiH₄ and GeH₄ gas varying with the time.

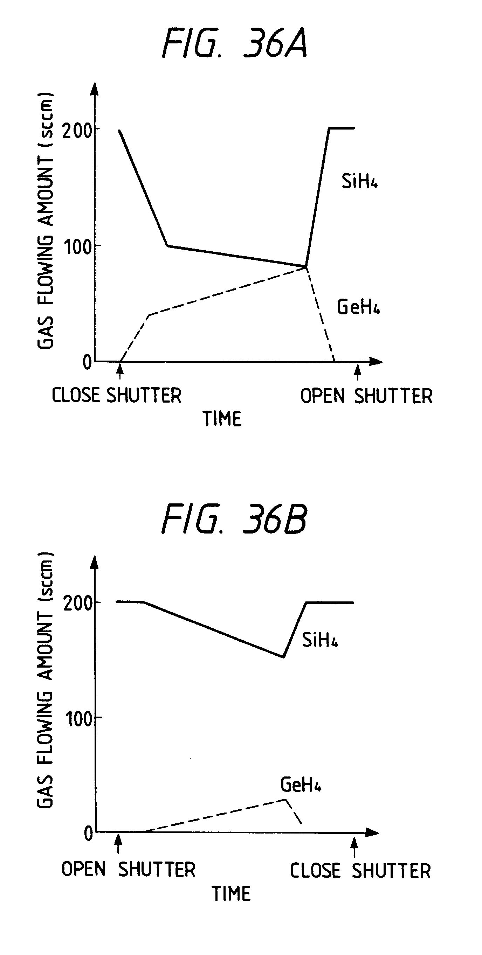

Figs. 36A and 36B are graphic representations showing the patterns of the flow rate of SiH₄ and GeH₄ gas varying with the time.
Fig. 37 is a graphic representation showing the patterns of the flow rate of SiH₄ and GeH₄ gas varying with the time.
Fig. 38 is a graphic representation showing the patterns of the flow rate of SiH₄ and GeH₄ gas varying with the time.

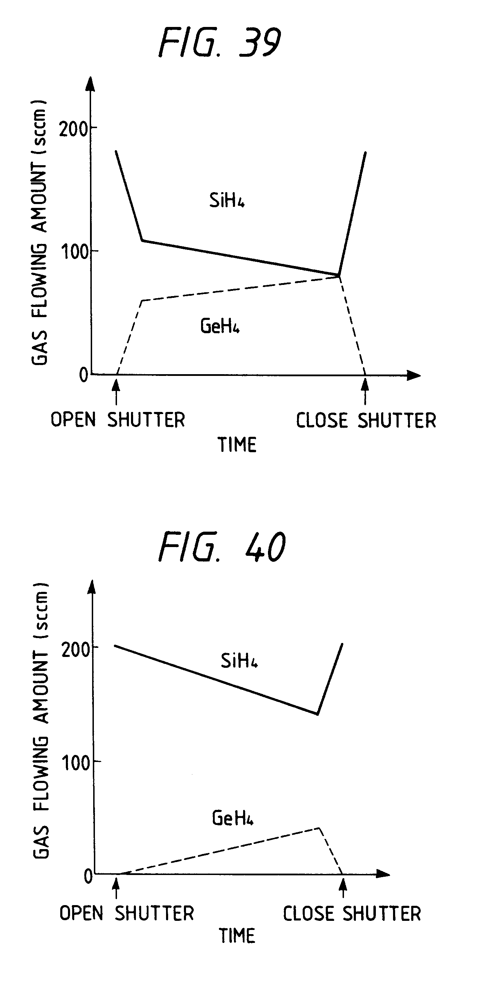

Fig. 39 is a graphic representation showing the patterns of the flow rate of SiH₄ and GeH₄ gas varying with the time.
Fig. 40 is a graphic representation showing the patterns of the flow rate of SiH₄ and GeH₄ gas varying with the time.
Fig. 41 is a graphic representation showing the flow rate of BF₃/H₂ and PH₃/H₂ gas introduced in forming the i-type layer, varying with the time, and the variation in layer thickness direction of B and P atoms contained in the i-type layer.
Fig. 42 is a graphic representation showing the flow rate of BF₃/H₂ and PH₃/H₂ gas introduced in forming the i-type layer, varying with the time, and the variation in layer thickness direction of B and P atoms contained in the i-type layer.
Fig. 43 is a graphic representation showing the flow rate of BF₃/H₂ and PH₃/H₂ gas introduced in forming the i-type layer, varying with the time, and the variation in layer thickness direction of B and P atoms contained in the i-type layer.
Fig. 44 is a graphic representation showing the flow rate of BF₃/H₂ and PH₃/H₂ gas introduced in forming the i-type layer, varying with the time, and the variation in layer thickness direction of B and P atoms contained in the i-type layer.

### DETAILED DESCRIPTION OF THE PREFERRED EMBODIMENTS

The actions and configurations of the present invention will be described below with reference to the drawings.

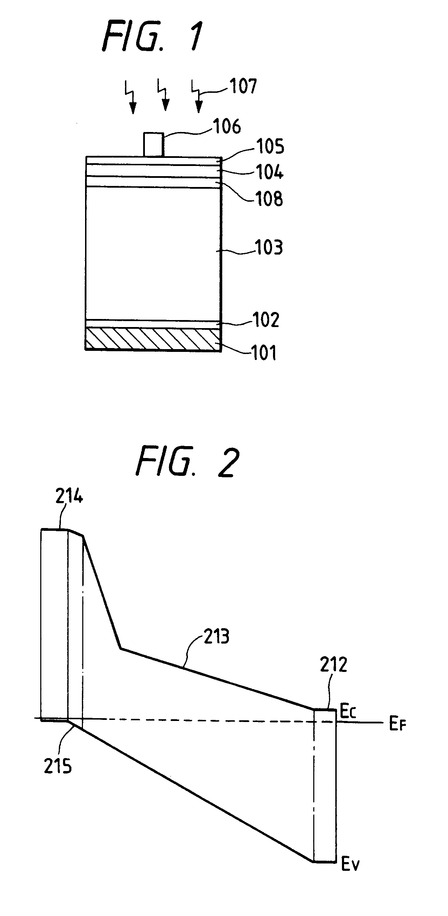

Fig. 1 is a typical view of the constitution of a photovoltaic element according to the present invention, wherein the incident light is indicated by 107. The photovoltaic element of the present invention is comprised of a conductive substrate 101 having a light reflecting layer and a light reflection multiplying layer, an n-type silicon non-single crystalline semiconductor layer 102, a non-single crystalline semiconductor layer 103 of substantial i-type by microwave plasma CVD containing silicon atoms and germanium atoms, an i-type layer 108 by RF plasma CVD, a p-type silicon non-single crystalline semiconductor layer 104, a transparent electrode 105 and a collector electrode 106.

Fig. 2 is a typical band diagram of the photovoltaic element having a layer constitution as shown in Fig. 1, in thermal equilibrium state, which is an example of the photovoltaic element of the present invention. In Fig. 2, E_{F} represents a Fermi level, E_{c} a conduction band, and Eᵥ a valence band. This figure shows a state of joining an n-type silicon non-single crystalline semiconductor layer 212, a non-single crystalline semiconductor layer 213 of substantial i-type by microwave plasma CVD containing silicon atoms and germanium atoms, an i-type layer 215 by RF plasma CVD and a p-type silicon non-single crystalline semiconductor layer 214. Since the minimum value of bandgap takes place at a position biased toward the p-type layer 214 side in the i-type layer 213 by microwave plasma CVD and there is a larger electric field of conduction band on the p-type layer side in the i-type layer 213, the efficient separation of electrons and holes results, whereby the recombination of electrons and positive holes in the neighborhood of the interface between p-type layer and i-type layer can be reduced. Also, since the electric field of valence band increases from the i-type layer 213 toward the n-type layer, the recombination of electrons and holes photoexcited in the neighborhood of the i-type layer 213 and the n-type layer 212 can be reduced.

Further, by adding a valence electron control agent as the donor and a valence electron control agent as the acceptor simultaneously into the i-type layer by microwave plasma CVD, the carrier range of electrons and holes can be extended. In particular, by containing a relatively great amount of valence electron control agent in the region where the bandgap is minimum, the carrier range of electrons and holes can be effectively extended. As a result, the high electric field in the neighborhood of the interface between the n-type layer and the i-type layer by microwave plasma CVD can be further effectively utilized, so that the collection efficiency of electrons and holes photoexcited in the i-type layer can be significantly enhanced. Since the defect level (so-called D_, D₊) can be compensated by the valence electron agent in the neighborhood of the interface between the n-type layer and the i-type layer, the dark current (in reverse bias) decreases due to hopping conduction via the defect level. In particular, if more valence electron control agent is contained in the neighborhood of interface than inside the i-type layer, the internal stress such as a distortion caused by rapid change of constituents peculiar to the neighborhood of interface can be decreased, so that the defect level in the neighborhood of interface can be lowered. Therefore, the open-circuit voltage and fill factor of the photovoltaic element can be improved.

In addition, by simultaneously adding a valence control agent as the donor and a valence electron agent as the acceptor into the i-type layer by microwave plasma CVD, the durability against optical degradation can be increased. The detailed mechanism is unknown, but considered as follows. That is, it is generally believed that the characteristics of photovoltaic element may be degraded due to recombination center of carriers with dangling bonds produced by light illumination. And in the present invention, both the valence electron agent as the donor and the valence electron agent as the acceptor are contained within the i-type layer and not activated 100%. As a result, if dangling bonds were produced by light illumination, they would react with inactive valence electron control agent to compensate for dangling bonds.

Also, particularly when the intensity of light directed to the photovoltaic element is weak, the probability of trapping electrons and holes photoexcited will decrease because the defect level is compensated by the valence electron control agent. And a sufficient electromotive force can be produced because the dark current in reverse bias is small, as previously described. As a result, even when the intensity of light illuminating the photovoltaic element is weak, the excellent photoelectric conversion efficiency can be exhibited.

In addition, the photovoltaic element according to the present invention is less likely to cause a decrease in the photoelectric conversion efficiency even when annealed under vibrations for the long time. The detailed mechanism is unknown, but considered as follows. That is, a photovoltaic element is formed by changing the constituents to provide a continuous change of the bandgap. Hence, a distortion is produced inside of the photovoltaic element. That is, this results in a number of weak bondings within the photovoltaic element. And owing to the vibration, the weak bondings within the i-type non-single crystalline semiconductor may be severed to form dangling bonds. However, it is believed that the adding a valence electron control agent serving as the donor and a valence electron control agent serving as the acceptor simultaneously, the photovoltaic element has an increased local flexibility to prevent the photoelectric conversion efficiency of the photovoltaic element from decreasing even with the annealing under vibrations for the long time. Besides, since inactive donor or acceptor is primarily three-coordinated, the local flexibility may also increase. As a result, the photoelectric conversion efficiency may be less liable to decrease in the annealing under vibrations for the long time. However, since inactive donor or acceptor forms a defect, it must be limited below a certain amount. That is, the preferable amount of inactive donor or acceptor is from 0.1 to 100 ppm.

Still in addition, by providing an i-type layer 215 by RF plasma CVD having a thickness of 30 nm or less between the p-type layer 214 and the i-type layer 213 at a deposition rate of 2 nm/sec or less, the photoelectric conversion efficiency of the photovoltaic element can be further improved. In particular, the photovoltaic element of the present invention is less likely to change in the photoelectric conversion efficiency when used under the environment where temperature greatly varies.

The non-single crystalline semiconductor layer of the i-type layer deposited by RF plasma CVD can be deposited by low power at a deposition rate of 2 nm/sec or less because vapor phase reaction hardly occurs. As a result, the packing density of deposited film is higher, and when the i-type layer is laminated on the deposited film by microwave plasma CVD, the interface level between the i-type layers becomes lower. In particular, when the deposition rate of the deposited film by microwave plasma CVD is 5 nm/sec or greater, the surface level is very high because the surface neighborhood of the i-type layer is not sufficiently relaxed after the microwave plasma is stopped. By forming a deposited film by RF microwave CVD with a slow deposition rate on the surface of such i-type layer, the surface level of the deposited film by microwave plasma CVD may be possibly reduced by the annealing due to diffusion of hydrogen atoms which occurs at the same time with the formation of deposited film by RF plasma CVD.

Also, by containing more valence electron control agent in the neighborhood of the interface between the p-type layer and the i-type layer by RF plasma CVD than inside the i-type layer, the internal stress such as a distortion yielded by rapid change of constituents peculiar to the neighborhood of interface can be decreased, and consequently the defect level in the interface neighborhood can be decreased. Therefore, the open-circuit voltage and fill factor of the photovoltaic element can be improved.

In addition, by adding a valence electron control agent serving as the donor and a valence electron control agent serving as the acceptor within the i-type layer by RF plasma CVD simultaneously, the durability against optical degradation can be increased. The detailed mechanism is unknown, but considered as follows. That is, it is generally believed that the characteristics of photovoltaic element may be degraded due to recombination center of carriers with dangling bonds produced by light illumination. And in the present invention, both the valence electron control agent serving as the donor and the valence electron control agent serving as the acceptor are contained within the i-type layer, and not activated 100%. As a result, if dangling bonds were produced by light illumination, they would react with inactive valence control agent to compensate for dangling bonds.

Also, particularly when the intensity of light directed to the photovoltaic element is weak, the probability of trapping electrons and holes photoexcited will decrease because the defect level is compensated by the valence electron control agent, and a sufficient electromotive force can be produced because the dark current in reverse bias is small, as previously described. As a result, when the intensity of light illuminating the photovoltaic element is weak, the excellent photoelectric conversion efficiency can be exhibited.

In addition, the photovoltaic element involves the photoelectric conversion efficiency which hardly decreases even when annealed under vibrations for the long time. The detailed mechanism is unknown, but considered as follows. That is, it is believed that if a valence electron control agent serving as the donor and a valence electron control agent serving as the acceptor are added simultaneously in the neighborhood of the interface between the p-type layer and the i-type layer composed of much different constituents, the photovoltaic element has an increased local flexibility to prevent the photoelectric conversion efficiency of the photovoltaic element from decreasing even in the annealing under vibrations for the ling time.

The p-type layer of the photovoltaic element according to the present invention has a lamination structure consisting of a layer containing a Group III element in the periodic table as the main constituent (hereinafter referred to as a doping A layer) and a layer having silicon atoms as the main constituent and containing a valence electron control agent (hereinafter referred to as a doping B layer), whereby the light transmittance of the p-type layer can be increased, and the specific resistance of the p-type layer reduced. In particular, the contact side of the p-type layer and the i-type layer is preferably a layer containing the valence electron control agent and having silicon atom as the main constituent (doping layer B). This makes it possible to decrease defects between the i-type layer and the p-type layer. The layer thickness of doping layer A is preferably in the range from 0.01 to 1 nm. Also, the content of hydrogen contained in the doping layer A is preferably 5% or less. Further, the content of valence electron control agent contained in the doping layer B is preferably in the range from 1500 to 10000 ppm. The p-type layer has been thus described, but the i-type layer can be also formed to the same effect by making a similar lamination structure using a Group V element in the periodic table.

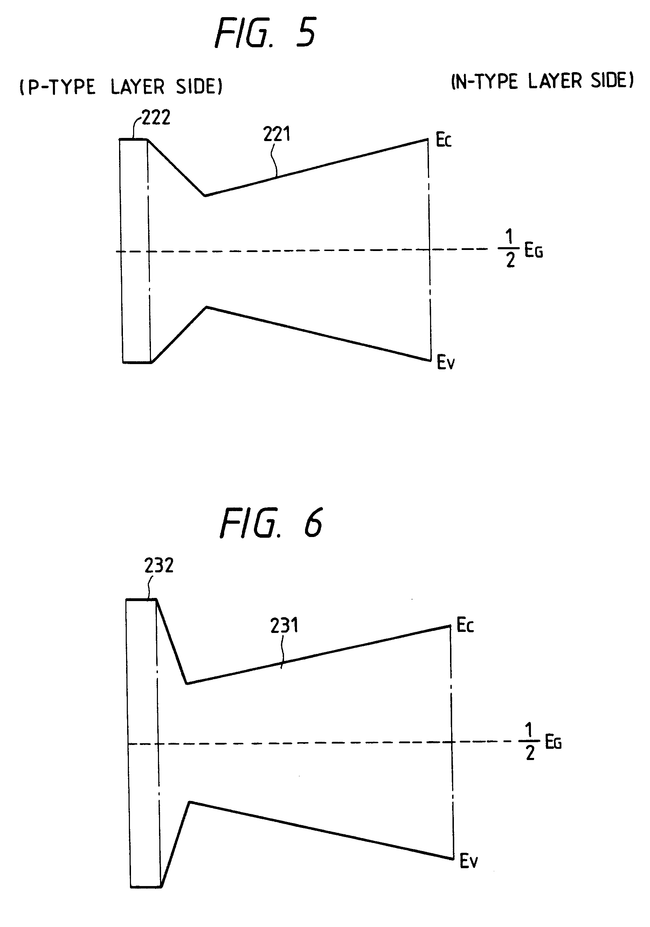

Fig. 5 is a typical diagram for explaining an example of the bandgap variation for the photovoltaic element of the present invention (hereinafter, the bandgap variation within the i-type layer is represented with reference to one-half the bandgap (E_{g}/2), if otherwise specified, and the n-type layer (not shown) side is located to the right and the p-type layer (not shown) side to the left in the figure.) The example of Fig. 5 has an i-type layer by microwave plasma CVD on the p-type layer side, wherein the minimum value of bandgap takes place closer to the p-type layer side within the i-type layer by microwave plasma CVD, and the maximum value of bandgap takes place both on the p-type layer side and the n-type layer side.

Fig. 6 is a typical explanation diagram for the bandgap variation as drawn similar to Fig. 5. In Fig. 6, as in Fig. 5, an i-type layer by RF plasma CVD is provided on the p-type layer side, wherein the minimum value of bandgap takes place closer to the p-type layer within the i-type layer by microwave plasma CVD, and the maximum value of bandgap takes place on the p-type layer side.

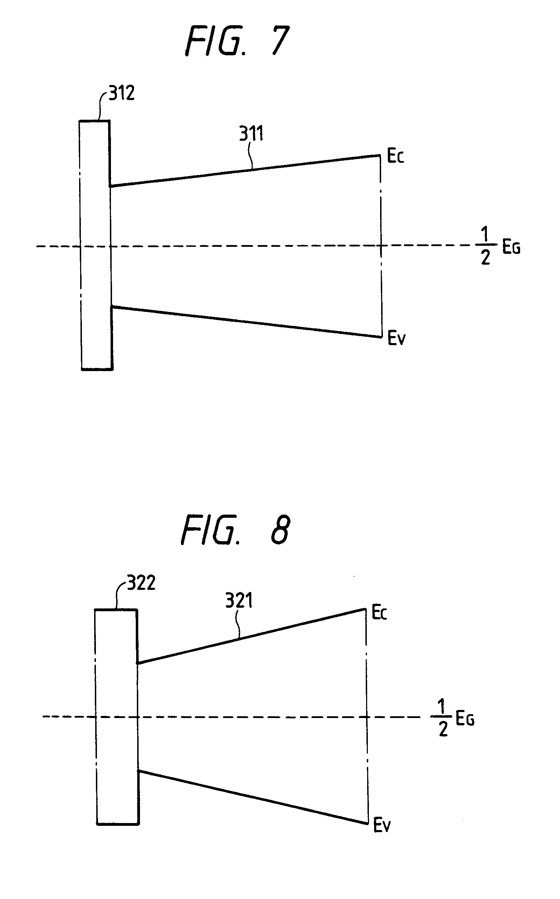

Figs. 7 to 9 are examples of photovoltaic elements wherein an i-type layer by RF plasma CVD is provided on the p-type layer side, with the bandgap decreasing monotonically until the i-type layer by microwave plasma CVD makes contact with the i-type layer by RF plasma CVD.

Fig. 7 shows an example of comprising an i-type layer 312 by RF plasma CVD having a fixed bandgap on the p-type layer side, and an i-type layer 311 by microwave plasma CVD having the bandgap decreasing from the n-type layer side to the i-type layer 312. And the minimum value of bandgap takes place at the interface between the i-type layer 312 and the i-type layer 311. The band junction between the i-type layer 311 and the i-type layer 312 is discontinuous. In this way, by providing a region of fixed bandgap, the dark current due to hopping conduction via the defect level in reverse bias of the photovoltaic element can be suppressed to the minimum. As a result, the open-circuit voltage of the photovoltaic element is increased.

The layer thickness of i-type layer 312 with the fixed bandgap is a very important factor, and preferably is in the range from 1 to 30 nm. When the layer thickness of the region with the fixed bandgap is below 1 nm, the dark current due to hopping conduction via the defect level can not be suppressed, so that the higher open-circuit voltage of the photovoltaic element can not be expected. On the other hand, when the layer thickness of i-type layer with the fixed bandgap is above 30 nm, holes photoexcited are likely to accumulate in the interface neighborhood between the i-type with the fixed bandgap and the i-type layer having varying bandgap, resulting in decreased collection efficiency of carriers photoexcited. That is, the short-circuit photocurrent decreases.

Fig. 8 is an example in which an i-type layer 322 by RF plasma CVD having fixed bandgap is provided on the p-type layer side, and an i-type layer 321 by microwave plasma CVD has a varying bandgap, whose bandgap on the n-type layer side is equal to that of the i-type layer 322.

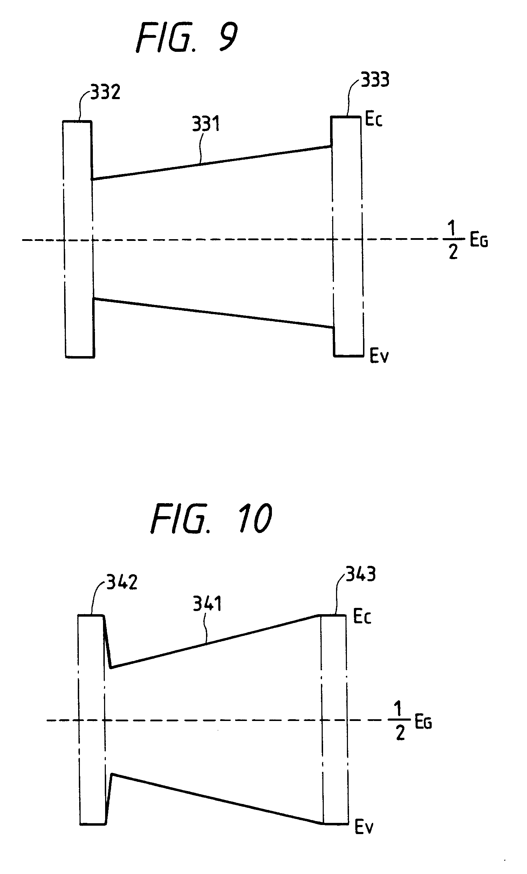

Fig. 9 is an example of comprising an i-type layer 332 by RF plasma CVD having a fixed bandgap provided on the p-type layer side, an i-type layer 331 by microwave plasma CVD having the bandgap decreasing monotonically from the n-type layer side to the p-type layer side, and an i-type layer 333 having a fixed bandgap by microwave plasma CVD or the RF plasma CVD on the n-type layer side. And the minimum value of bandgap takes place at the interface between the i-type layer 332 and the i-type layer 331. The band junction between the i-type layer 332 and the i-type layer 331 is discontinuous. In this way, by providing a region of fixed bandgap between the p-type layer and the i-type layer 331 and between the n-type layer and the i-type layer 331, the dark current due to hopping conduction via the defect level in reverse bias of the photovoltaic element can be suppressed to the minimum. As a result, the open-circuit voltage of the photovoltaic element is increased.

Figs. 10 to 13 are examples in which the minimum value of bandgap occurs in the i-type layer by microwave plasma CVD.

Fig. 10 is an example in which a photoconductive layer of photovoltaic element comprises an i-type layer 342 by RF plasma CVD having a fixed bandgap provided on the p-type layer side, an i-type layer 341 by microwave plasma CVD having the minimum value of bandgap inside thereof, and an i-type layer 343 having an even bandgap by microwave plasma CVD or by RF plasma CVD continuously joined with the i-type layer 341. Because the bandgap is continuous, electrons and holes photoexcited in the varying bandgap region of the i-type layer can be efficiently collected in the n-type layer and the p-type layer, respectively. In particular, when the fixed bandgap region 342, 343 is as thin as 5 nm or less, the dark current when a reverse bias is applied to the photovoltaic element can be decreased in the region of the i-type layer having greatly changing bandgap, and therefore the open-circuit voltage of the photovoltaic element can be increased.

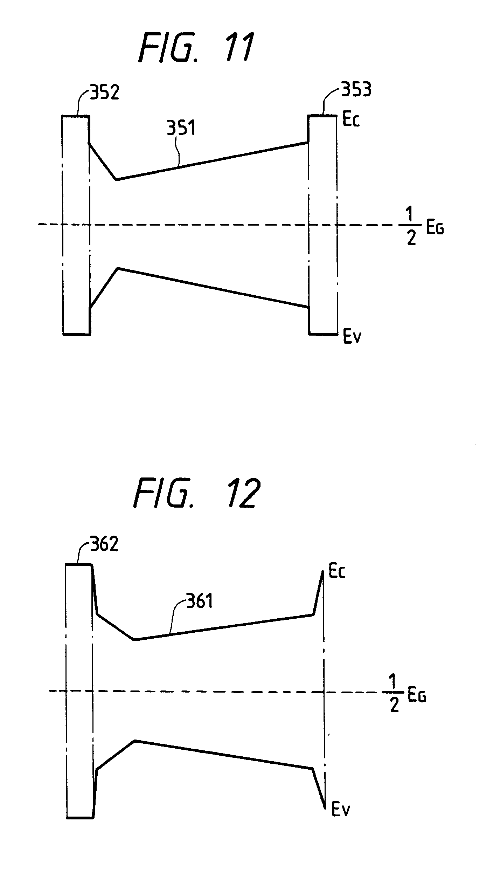

Fig. 11 is an example of a photoconductive layer in which an i-type layer 351 by microwave plasma CVD having varying bandgap is jointed discontinuously, but relatively moderately, with an i-type layer 352 by RF plasma CVD having a constant bandgap and an i-type layer 353 having a constant bandgap by microwave plasma CVD or by RF plasma CVD. However, since the fixed bandgap region and the varying bandgap region are moderately connected in the direction where the bandgap is widening, carriers photoexcited in the varying bandgap region are efficiently injected into the fixed bandgap region. As a result, the collection efficiency of photoexcited carriers increases.

Whether to connect the fixed bandgap region and the varying bandgap region continuously or not will depend on the layer thicknesses of the fixed bandgap region and the abruptly varying bandgap region. When the fixed bandgap region is as thin as 5 nm or less, and the rapidly varying bandgap region is 10 nm or less, in layer thickness, the higher photoelectric conversion efficiency of the photovoltaic element can be obtained if the fixed bandgap region and the varying bandgap region are continuously connected. On the other hand, when the fixed bandgap region is as thin as 5 nm or greater, and the rapidly varying bandgap region is from 10 to 30 nm in layer thickness, the higher photoelectric conversion efficiency of photovoltaic element can be obtained if the fixed bandgap region and the varying bandgap region are discontinuously connected.

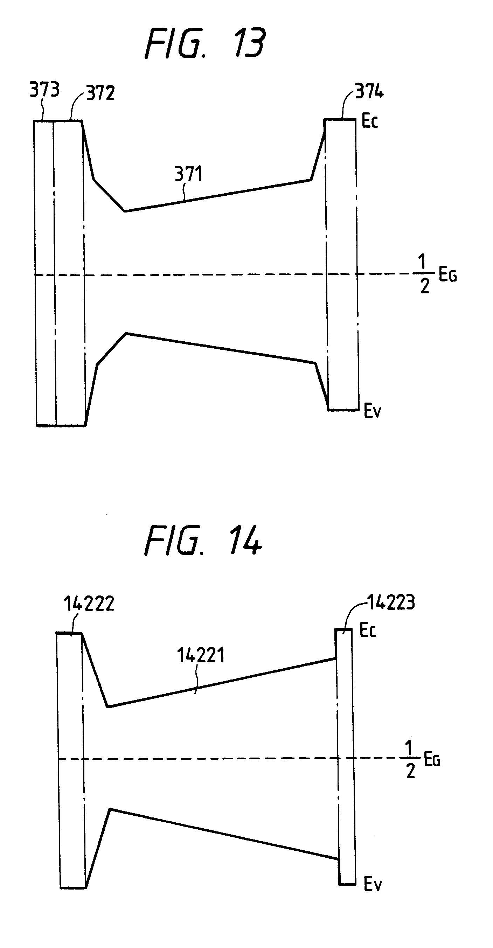

Fig. 12 is an example comprising an i-type layer 362 by RF plasma CVD on the p-type layer side and an i-type layer 361 by microwave plasma CVD having the minimum value of bandgap, in which the fixed bandgap region and the varying bandgap region are connected at two steps. The minimum value of bandgap is displaced to the p-type layer side. Carriers photoexcited in the varying bandgap region can be efficiently collected in such a manner as to connect with a wider, fixed bandgap region through two steps of moderately widening the bandgap from a minimum bandgap position and rapidly widening the bandgap. Also, in Fig. 12, a region where the bandgap is rapidly increasing toward the n-type layer is provided within the i-type layer in the neighborhood of the n-type layer.

Fig. 13 is an example comprising an i-type layer 373 by RF plasma CVD on the p-type side, an i-type layer 372 by microwave plasma CVD having a fixed bandgap, an i-type layer 371 by microwave plasma CVD which presents a region having the minimum value of bandgap inside thereof, and an i-type layer 374 by microwave plasma CVD or by RF plasma CVD, in which a fixed bandgap region is provided within the i-type layer on either of the p-type layer side and the n-type layer side, the fixed bandgap region on the p-type layer side being connected through two steps of varying the bandgap through the varying bandgap region, and the fixed bandgap region on the n-type layer side being connected through a rapid bandgap change.

As described above, by connecting the fixed bandgap region and the varying bandgap region through similar constituents, internal distortion can be decreased. As a result, there is less possibility of causing such a phenomenon that weak bondings within the i-type layer are severed when annealed under vibrations for the long time, thereby increasing the defect level and decreasing the photoelectric conversion efficiency, so that the high photoelectric conversion efficiency can be maintained.

Also, by containing a valence electron control agent into the i-type layer, as previously described, the carrier range of carriers within the i-type layer can be extended, and therefore the collection efficiency of carriers can be increased. In particular, by changing the amount of valence electron control agent in accordance with the variation of bandgap such that a greater amount is added in the narrower bandgap region and a smaller amount in the wider bandgap region, the collection efficiency of photoexcited carriers can be further increased. Further, by containing more valence electron control agent on the p-type layer side and the n-type layer side within the i-type layer having a fixed bandgap than the region having the minimum bandgap, the recombination of photoexcited carriers can be prevented from occurring in the neighborhood of p/i interface and n/i interface, so that the photoelectric conversion efficiency of photovoltaic element can be improved.

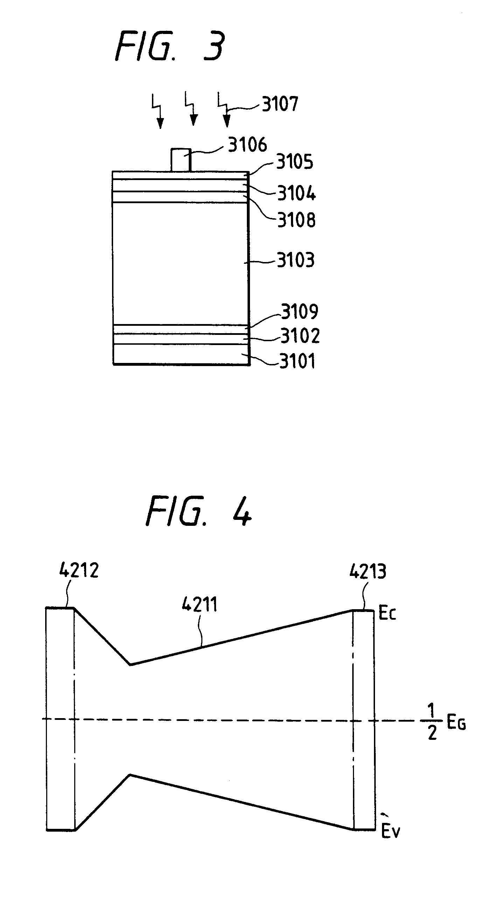

Fig. 3 is a typical explanation view showing another example of a photovoltaic element according to the present invention, wherein the incident light is indicated by 3107. The photovoltaic element of the present invention is comprised of a conductive substrate 3101 having a light reflecting layer and a light reflection multiplying layer, an n-type silicon non-single crystalline semiconductor layer 3102, an i-type layer 3109 by RF plasma CVD, a non-single crystalline semiconductor layer 3103 of substantially i-type by microwave plasma CVD containing silicon atoms and germanium atoms, an i-type layer 108 by RF plasma CVD, a p-type silicon non-single crystalline semiconductor layer 3104, a transparent electrode 3105 and a collector electrode 3106.

By inserting an i-type layer by RF plasma CVD 30 nm thick or less between the n-type layer and the i-type layer by microwave plasma CVD at a deposition rate of 2 nm/sec or less, the photoelectric conversion efficiency of photovoltaic element can be further enhanced. In particular, the photovoltaic element of the present invention is less likely to change in the photoelectric conversion efficiency when used under the environment of great temperature variations.

The microwave plasma CVD involves a greater kinetic energy of ion in the deposition as compared with the RF plasma CVD, and may possibly effect a damage on the lower semiconductor layer. Accordingly, it is required that the lower semiconductor layer be a semiconductor layer having resistance to ion damage, and further it is required that the deposited film deposited by microwave plasma CVD be of good quality as the semiconductor, and be made under the conditions of causing less damage on the lower semiconductor layer. The deposition conditions of the photovoltaic element according to the present invention is suitable for accomplishing this object.

Consequently, it is possible to form a photovoltaic element having lower interface level at the interface between the n-type layer and the i-type layer by RF plasma CVD, which results in improved open-circuit voltage and short-circuit current of the photovoltaic element.

Fig. 4 is a typical explanation diagram showing an example of the bandgap variation of the photovoltaic element of Fig. 3. In an example of Fig. 4, the minimum value of bandgap takes place near the p-type layer, and the maximum value of bandgap takes place in contact with either side of the p-type layer and the n-type layer. An i-type layer 4211 and an i-type layer 4212 are deposited by microwave plasma CVD, and an i-type layer 4213 is a non-single crystalline silicon layer deposited by RF plasma CVD. The i-type layer 4211 and the i-type layer 4213 are made to have a substantially equal bandgap by adjusting the content of hydrogen.

Fig. 14 is a typical explanation diagram showing another example of bandgap variation, similar to that of Fig. 4. In Fig. 14, as in Fig. 4, the minimum value of bandgap takes places closer to the p-type layer, but the maximum value of bandgap takes place in contact with the p-type layer. An i-type layer 14221 and an i-type layer 14222 are deposited by microwave plasma CVD, and an i-type layer 14223 is a non-single crystalline silicon layer deposited by RF plasma CVD. The bandgap of the i-type layer 14221 and the bandgap of the i-type layer 14223 are discontinuous. With a bandgap configuration of Fig. 14, particularly the open-circuit voltage can be increased.

Figs. 9 to 11, Fig. 13, and Figs. 15 to 17 are typical explanation diagrams showing the bandgap variation of the photovoltaic element in which the non-single crystalline layer of substantially i-type is provided between the n-type layer and the i-type layer by microwave plasma CVD and between the p-type layer and the i-type layer by microwave plasma CVD.

In Fig. 9, the layer thickness of i-type layer 333 by RF plasma CVD is a very important factor, and preferably is in the range from 1 to 30 nm. When the layer thickness of i-type layer with the fixed bandgap is below 1 nm, the dark current due to hopping conduction via the defect level can not be suppressed, so that the higher open-circuit voltage of the photovoltaic element can not be expected. On the other hand, when the layer thickness of i-type layer 333 by RF plasma CVD is above 30 nm, holes photoexcited are likely to accumulate in the neighborhood of the interface between the i-type layer 332 and the i-type layer 331 having a varying bandgap, resulting in decreased collection efficiency of carriers photoexcited. That is, the short-circuit photocurrent decreases.

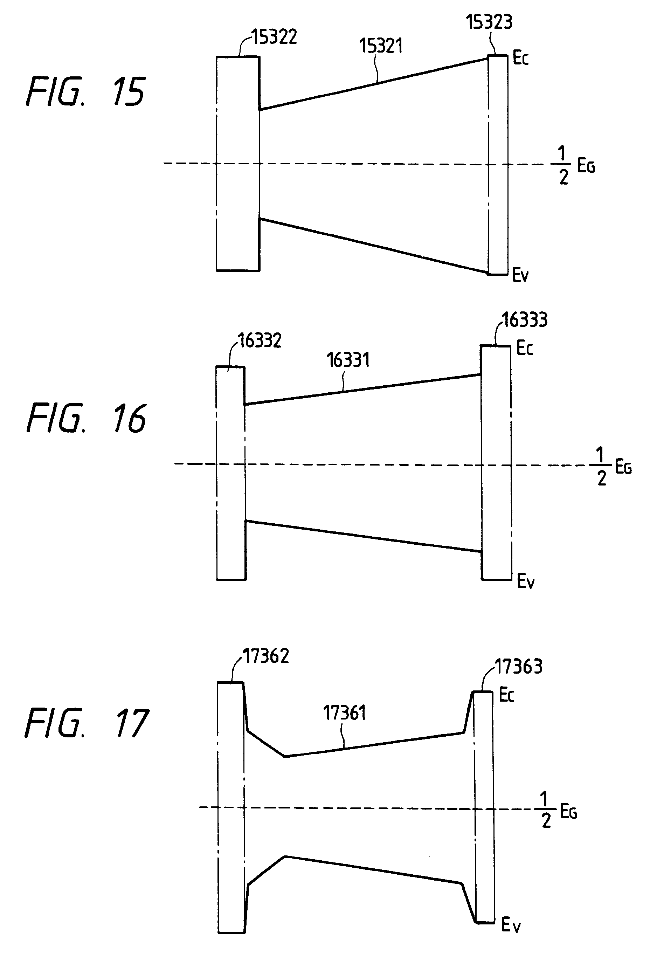

Fig. 15 is an example in which an i-type layer 15322 having a fixed bandgap by RF plasma CVD is provided between the p-type layer and an i-type layer 15321 by microwave CVD, and an i-type layer 15323 by RF plasma CVD having a bandgap equal to that of the i-type layer 15321 is provided between the n-type layer and an i-type layer 15321 by microwave plasma CVD.

Fig. 16 is an example in which i-type layers 16332, 16333 by RF plasma CVD are provided between the p-type layer and an i-type layer 16331 by microwave RF plasma CVD and between the n-type layer and an i-type layer 16331 by microwave plasma CVD. When a reverse bias is applied to the photovoltaic element, the dark current is further decreased, resulting in increased open-circuit voltage of the photovoltaic element.

Figs. 10, 11, 13 and 17 are examples of photovoltaic elements in which the i-type layer having fixed bandgap by RF plasma CVD is provided between the p-type layer and the i-type layer by microwave plasma CVD and between the n-type layer and the i-type layer by microwave plasma CVD, and the rapidly varying bandgap region is provided on the p-type layer side or n-type layer side of the i-type layer by microwave plasma CVD.

Fig. 17 is an example in which the i-type layers 17362, 17363 with fixed bandgap and an i-type layer 17361 with varying bandgap are connected through two steps, and in which the minimum bandgap position takes place closer to the p-type layer side. Carriers photoexcited in the varying bandgap region can be efficiently collected by connecting the i-type layers 17362, 17363 having wider fixed bandgap with the i-type layer 17361 through two steps of moderately widening the bandgap from the minimum bandgap position and rapidly widening the bandgap therefrom. Also, in Fig. 17, the i-type layer 17361 is provided with a rapidly varying bandgap toward the i-type layer 17363.

In the present invention, the minimum value of bandgap in the i-type layer containing silicon atoms and germanium atoms is preferably from 1.1 to 1.6 eV depending on the spectrum of illuminating light.

In the photovoltaic element with continuously varying bandgap according to the present invention, the inclination of tail state in the valence band is an important factor governing the characteristics of the photovoltaic element, in which it preferably is smoothly continuous from the inclination of tail state at the minimum value of bandgap to the inclination of tail state at the maximum value of bandgap.

Thus, the photovoltaic element of a pin structure has been described, but the above discussion can also apply to a photovoltaic element having pin structures laminated such as a pinpin structure or a pinpinpin structure.

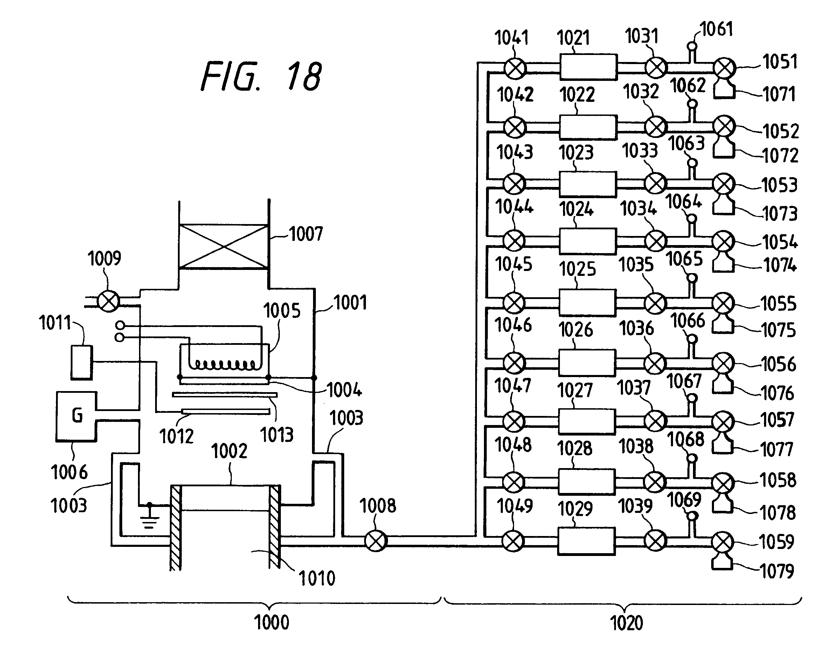

Fig. 18 is a typical explanation diagram of a deposited film forming apparatus suitable for carrying out a deposited film forming method of photovoltaic element according to the present invention. The deposited film forming apparatus is comprised of a deposition chamber 1001, a dielectric window 1002, a gas introducing tube 1003, a substrate 1004, a heater 1005, a vacuum gauge 1006, a conductance valve 1007, an auxiliary valve 1008, a leak valve 1009, a waveguide 1010, a bias power source 1011, a bias rod 1012, a shutter 1013, a source gas supply unit 1020, mass flow controllers 1021 to 1026, gas inlet valves 1031 to 1039, source gas bomb valves 1051 to 1059, pressure regulators 1061 to 1069, and source gas bombs 1071 to 1079.

The detailed deposition mechanism in the preferable deposition method for the photovoltaic element according to the present invention has not been clarified, but may be considered as in the following.

It is believed that active species suitable for forming a deposited film can be selected in such a manner as to apply a lower microwave energy than microwave energy required to decompose a source gas at 100% to the source gas and simultaneously apply a higher RF energy to the source gas. Further, it is believed that the mean free path of active species suitable for forming a high-quality deposited film is long enough in the state where the internal pressure of the deposition chamber in decomposing the source gas is 6.67 Pa (50 mTorr) or less, and therefore the vapor phase reaction can be suppressed to the minimum. And it is believed that in the state where the internal pressure of the deposition chamber is 6.67 Pa (50 mTorr) or less, the RF energy controls the potential between the plasma and the substrate within the deposition chamber without almost any effect on the decomposition of source gas. That is, with the microwave plasma CVD method, the potential between the plasma and the substrate is small, but the potential (+ at the plasma side and - at the substrate side) between the plasma and the substrate can be increased by inputting the RF energy together with the microwave energy. In this way, it is believed that if the plasma potential is positive or higher than the substrate, active species decomposed by microwave energy can be deposited on the substrate, and at the same time + ions accelerated by plasma potential will impinge onto the substrate to promote the relaxation reaction on the substrate surface and provide a higher-quality deposited film. In particular, this effect is remarkable when the deposition rate is several nm/sec or greater.

Further, since the RF frequency is high, unlike DC, the potential between the plasma and the substrate can be determined from the distribution of dissociated ions and electrons. That is, the potential between the substrate and the plasma can be determined by synergistic action of ions and electrons. Accordingly, there is the effect that less spark will occur within the deposition chamber. As a result, the stable glow discharge can be maintained for the long time over 10 hours.

In addition, since the flow rate and flow ratio of source gas may change with the time or spatially in depositing the layer with a varying bandgap, the DC voltage must be changed appropriately with the time or spatially, in the case of the DC. However, in the deposited film forming method of the present invention, the percentage of ions may change due to changes in the flow rate and flow ratio of source gas occurring with the time or spatially. In correspondence thereto, the RF self-bias is automatically changed. As a result, when an RF is applied to the bias rod to change the flow rate and flow ratio of source gas, the discharge can be quite stabilized as compared with the DC bias.

Still in addition, in the deposited film forming method, to obtain a desired bandgap variation, it is preferable to mix a silicon atom containing gas and a germanium atom containing gas at a distance 5 m or less away from the deposition chamber. If those source gases are mixed over 5 m apart, a delay in the mixing of source gases or a mutual diffusion of source gases may occur even by controlling mass flow controllers corresponding to the desired bandgap variation, because the mixing position of source gases is away from the deposition chamber, resulting in a drift from the desired bandgap. That is, if the mixing position of source gases is too far away from the deposition chamber, the controllability for the bandgap may decrease.

Furthermore, to change the content of hydrogen contained in the i-type layer in a direction of layer thickness, it is necessary that the RF energy to be applied to the bias rod is increased where the content of hydrogen is desired to be greater, while the RF energy to be applied to the bias rod is decreased where the content of hydrogen is desired to be smaller. On the other hand, when the DC energy is applied together with the RF energy, a plus large DC voltage may be applied to the bias rod, if the content of hydrogen atoms is desired to be greater, while a plus small DC voltage may be applied to the bias rod if the content of hydrogen atoms is desired to be smaller.

The photovoltaic element of the present invention is formed with a deposited film, for example, in the following manner. First, a substrate 1004 for the formation of deposited film is mounted within a deposition chamber 1001 as shown in Fig. 18, and the deposition chamber is exhausted of air sufficiently to 1.3·10⁻³ Pa (10⁻⁵ torr) or less. A turbo molecular pump is suitable for this exhaust, but an oil diffusion pump may be used. In the case of the oil diffusion pump, a gas such as H₂, He, Ar, Ne, Kr, Xe should be introduced into the deposition chamber if the internal pressure of the deposition chamber 1001 falls below 1.3·10⁻² Pa (10⁻⁴ torr) to prevent the oil from diffusing back to the deposition chamber. After the deposition chamber is sufficiently exhausted, the gas such as H₂, He, Ar, Ne, Kr, Xe is introduced into the deposition chamber so that the deposition chamber may reach an internal pressure substantially equal to that when the source gas for the formation of deposited film is flowed. The optimal range of pressure within the deposition chamber is from 67 mPa to 6.7 Pa (0.5 to 50 mtorr). If the internal pressure within the deposition chamber is stabilized, a substrate heater 1005 is turned on to heat the substrate up to a temperature from 100 to 500°C. If the temperature of the substrate is stabilized at a predetermined value, the flow of gas such as H₂, He, Ar, Ne, Kr, Xe is stopped and the source gas for the formation of deposited film is introduced by a predetermined quantity from the gas bomb via the mass flow controllers into the deposition chamber.

The supply amount of the source gas for the formation of deposited film to be introduced into the deposition chamber may be appropriately determined depending on the deposition conditions within the deposition chamber. On the other hand, the internal pressure within the deposition chamber when introducing the source gas for the formation of deposited film into the deposition chamber is a very important factor, the optimal internal pressure within the deposition chamber being from 67 mPa to 6.7 Pa (0.5 to 50 mTorr).

Also, in the deposited film forming method of the photovoltaic element according to the present invention, the microwave energy to be input into the deposition chamber is an important factor. The microwave energy may be appropriately determined by the flow rate of source gas introduced into the deposition chamber, but must be smaller than a microwave energy necessary to decompose the source gas at 100%, the preferable range being from 0.02 to 1 W/cm³. The preferable frequency range of microwave energy may be from 0.5 to 10 GHz. In particular, the frequencies near 2.45 GHz are suitable. Also, in order to form the deposited film with reproducibility by a deposited film forming method, and form the deposited film over a few to several tens hours, the stability of the frequency of microwave energy is very important. The frequency variation preferably may fall within the range of ±2%. Further, the ripple of microwave is preferably within the range of ±2%. Further, the RF energy input into the deposition chamber together with the microwave energy is a very important factor in combination with the microwave energy, the preferable range of the RF energy being from 0.04 to 2 W/cm³.

The preferable frequency range of the RF energy may be from 1 to 100 MHz. In particular, 13.56 MHz is optimal. Also, the variation in the RF frequency is within ±2%, and the waveform is preferably smooth.

When the RF energy is supplied, the RF energy may be appropriately selected by the area ratio between the area of the bias rod for the supply of the RF energy and the earth area, and in particular, when the area of the bias rod for the supply of the RF energy is narrower than the earth area, the self-bias (DC component) for the supply of the RF energy on the power supply side should be grounded. Further, when the self-bias (DC component) for the supply of the RF energy on the power supply side is not grounded, the area of the bias rod for the supply of the RF energy is preferably larger than the earth area with which the plasma makes contact.

Such microwave energy is introduced from the waveguide 1010 via the dielectric window 1002 into the deposition chamber, and concurrently the RF energy is introduced from the bias power supply 1011 via the bias rod 1012 into the deposition chamber. In such a state, source gases are decomposed for a desired time to form a deposited film having a desired layer thickness on the substrate. Thereafter, the input of the microwave energy and the RF energy is stopped, the deposition chamber is exhausted of air, and then sufficiently purged with a gas such as H₂, He, Ar, Ne, Kr or Xe, whereafter a deposited non-single crystalline semiconductor film is taken out from the deposition chamber.

In addition to the RF energy, the DC voltage may be applied to the bias rod 1012. The DC voltage to be applied preferably has such a polarity that the bias rod may be plus. And the preferable range of the DC voltage is from 10 to 300 V.

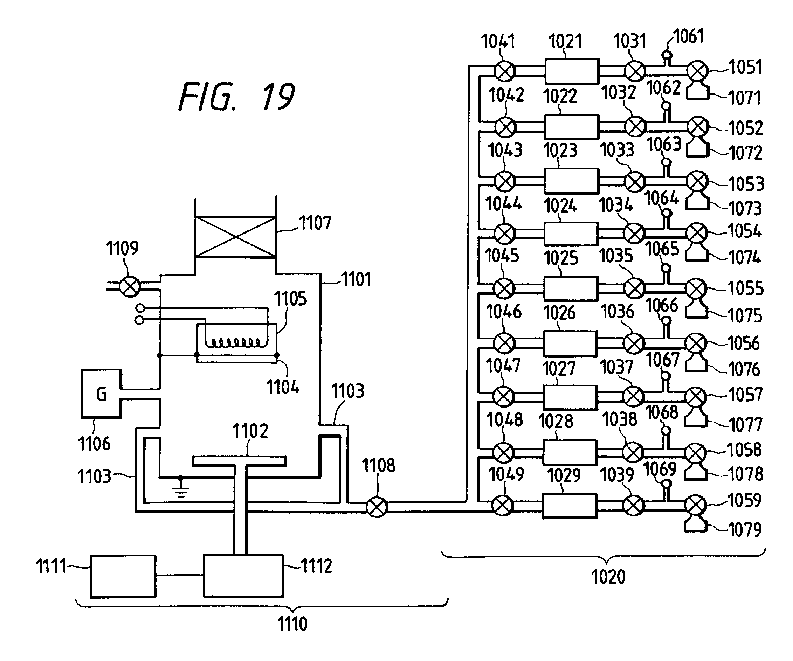

Fig. 19 is a typical explanation diagram of a deposited film forming apparatus suitable for the deposition of an i-type layer by an RF plasma CVD method of a photovoltaic element according to the present invention. The deposited film forming apparatus is comprised of a deposition chamber 1101, a cathode 1102, a gas introducing tube 1103, a substrate 1104, a heater 1105, a vacuum gauge 1106, a conductance valve 1107, an auxiliary valve 1108, a leak valve 1109, an RF power supply 1111, an RF matching box 1112, a source gas supply unit 1020, mass flow controllers 1021 to 1029, gas inlet valves 1031 to 1039, source gas bomb valves 1051 to 1059, pressure regulators 1061 to 1069, and source gas bombs 1071 to 1079.

The i-type layer by RF plasma CVD of the photovoltaic element according to the present invention can be formed, for example, in the following manner.

First, a substrate on which up to the i-type layer by microwave plasma CVD has been already deposited is mounted as the substrate 1104 on the heater within the deposition chamber 1101. Door is closed, and the deposition chamber 1101 is sufficiently exhausted below 0.13 Pa (10⁻³ Torr). A substrate heating gas, e.g., a gas such as H₂, He, Ar, Ne, Kr or Xe, is flowed at the same flow rate and under the same pressure as when conducting the RF plasma CVD. At the same time, the substrate heater 1105 is turned on, and is set so that the temperature of the heater 1105 may arrive at a desired substrate temperature. If the temperature of the substrate is stabilized at a predetermined value, the substrate heating gas is stopped, and a predetermined amount of source gas for the formation of deposited film is introduced from the gas bomb via mass flow controllers into the deposition chamber 1101.

If the internal pressure of the deposition chamber is stabilized at a desired pressure by the source gas, a desired RF energy is introduced from the RF power supply via the matching box 1112 into the cathode electrode 1102. And a plasma is excited and deposition is sustained for a predetermined time. After deposition for the predetermined time, the supply of RF energy is stopped, the substrate heater is turned off, the supply of source gas is stopped, and the deposition chamber is sufficiently purged. If the substrate temperature falls below room temperature, the substrate is taken out from the deposition chamber.

When the i-type layer is deposited by the RF plasma CVD, the optimal conditions may be attained in that the substrate temperature is from 100 to 350°C, the internal pressure is from 13 Pa to 13 hPa (0.1 to 10 Torr), the RF power is from 0.01 to 5.0 W/cm², and the deposition rate is from 0.01 to 2 nm/sec.

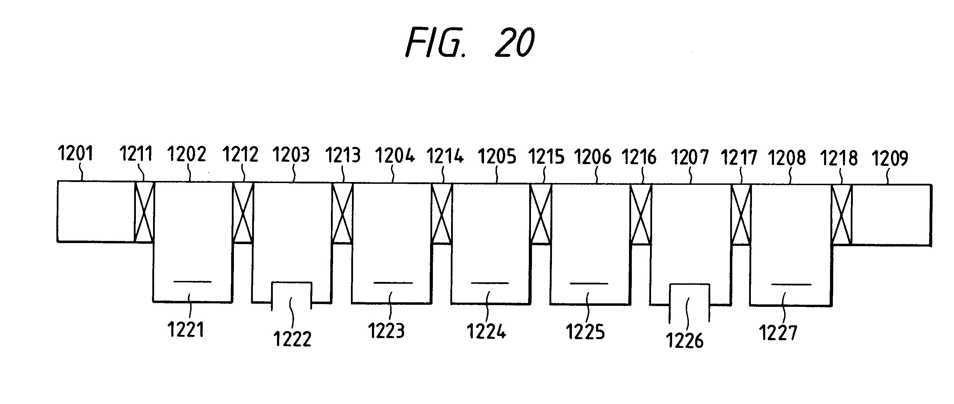

A more preferable deposition apparatus for the photovoltaic element of the present invention takes a form of successively combining microwave plasma CVD apparatuses and RF plasma CVD apparatuses, as shown in Figs. 20, 21 and 22. The deposition chamber for microwave plasma CVD and the deposition chamber for RF plasma CVD are preferably separated by a gate. The gate is preferably a mechanical gate valve or gas gate.

In the deposited film forming method as described above, suitable source gases for the deposition of silicon may include the compounds as cited below.

Specifically, the gasifiable compounds containing silicon atoms may include, for example, SiH₄, Si₂H₆, SiF₄, SiFH₃, SiF₂H₂, SiF₃H, Si₃H₈, SiD₄, SiHD₃, SiH₂D₂, SiH₃D, SiFD₃, SiF₂D₂, SiD₃H, and Si₂D₃H₃.

Suitable source gases for the deposition of germanium may include the following compounds.

Specifically, the gasifiable compounds containing germanium atoms may include, for example, GeH₄, GeD₄, GeF₄, GeFH₃, GeF₂H₂, GeF₃H, GeHD₃, GeH₂D₂, GeH₃D, Ge₂H₆, and Ge₂D₆.

In the present invention, valence electron control agents to be introduced into the non-single crystalline semiconductor for the control of valence electron for the non-single crystalline semiconductor layer may include Group III atoms or Group V atoms in the periodic table.

In the present invention, the starting materials effectively used for the introduction of Group III atoms may include boron hydride such as B₂H₆, B₄H₁₀, B₅H₉, B₅H₁₁, B₆H₁₀, B₆H₁₂, B₆H₁₄, and boron halide such as BF₃, BCl₃, for the introduction of boron atoms. Besides, AlCl₃, GaCl₃, InCl₃ and TlCl₃ may be included.

Also, in the present invention, the starting materials effectively used for the introduction of Group V atoms may include, for example, phosphorus hydride such as PH₃, P₃H₄, and phosphorus halide such as PH₄I, PF₃, PF₅, PCl₃, PCl₅, PBr₃, PBr₅, PI₃, for the introduction of phosphorus atoms. Besides, AsH₃, AsF₃, AsCl₃, AsBr₃, AsF₅, SbH₃, SbF₃, SbF₅, SbCl₃, SbCl₅, BiH₃, BiCl₃ and BiBr₃ may be included.

The introduction amount of Group III atoms or Group V atoms in the periodic table to be introduced into the i-type layer of non-single crystalline semiconductor layer to accomplish the objects of the present invention may be preferably in the range of 1000 ppm or less. Also, to accomplish the objects of the present invention, it is preferable to add Group III atoms or Group V atoms in the periodic table simultaneously to compensate.

Also, the gasifiable compounds as cited above may be introduced by diluting them with a gas such as H₂, D₂, He, Ne, Ar, Xe or Kr into the deposition chamber. In particular, the optimal gas for diluting the gasifiable compounds may be H₂ and He.

Examples of nitrogen containing gas may include N₃, NH₃, ND₃, NO, NO₃ and N₂O.

Examples of oxygen containing gas may include O₂, CO, CO₂, NO, NO₂, N₂O, CH₃CH₂OH and CH₃OH.

The p-type layer and the n-type layer having a lamination structure composed of a layer containing Group III element and/or Group V element in the periodic table as the main constituent (doping layer A) and a layer containing a valence electron control agent and having silicon atoms as the main constituent (doping layer B) can be formed using a deposited film forming apparatus relying on the microwave CVD or RF plasma CVD.

Doping layer A is preferably deposited using a gas containing Group III element and/or Group V element in the periodic table as the source gas and by the microwave CVD or RF plasma CVD. In particular, in order to reduce the content of hydrogen in the doping layer A, it is preferred that the source gas is decomposed by a power as high as possible for the deposition.

Doping layer B is preferably deposited using a gas containing Group III element and/or Group V element in the periodic table as the valence electron control agent which is mixed with a silicon atom containing gas and by the microwave CVD or RF plasma CVD.

On the other hand, the doping layer B containing a crystal phase is deposited by microwave CVD, it is preferable that the RF energy is smaller than the microwave energy and the microwave energy is relatively large. The preferable microwave energy is from 0.1 to 1.5 W/cm³. To make the crystal grain diameter larger, hydrogen dilution is preferable. The rate of dilution of source gas by a hydrogen gas is preferably from 0.01 to 10%.

Also, when the doping layer B containing crystal phase is deposited by RF plasma CVD, the silicon atom containing gas is diluted with hydrogen gas (H₂, D₂) to a concentration from 0.01 to 10%, and the RF power is preferably from 1 to 10 W/cm².

When the p-type layer and/or the n-type layer of the photovoltaic element of the present invention is constituted of a lamination of doping layer A and doping layer B, it is preferable to start from the doping layer B and end at the doping layer B. For example, a constitution of BAB, BABAB, BABABAB or BABABABAB is preferable.

In particular, when the transparent electrode and the p-type layer and/or the n-type layer having a lamination structure are contact with each other, contact of the doping layer B and the transparent electrode is more preferable because the diffusion of Group III element and/or Group V element into indium oxide or tin oxide constituting the transparent electrode can be prevented, so that the decrease in photoelectric conversion efficiency of the photovoltaic element over time can be suppressed.

The constitution of a photovoltaic element according to the present invention will be now described in detail.

### Conductive substrate

Conductive substrate may be directly a conductive member itself, or made by forming a support of an insulating material or conductive material and having its surface subjected to conductive treatment. Examples of the conductive support may include, for example, metals such as NiCr, stainless, Al, Cr, Mo, Au, Nb, Ta, V, Ti, Pt, Pb, Sn, and the alloys thereof.

Examples of electrical insulating support may include synthetic resin films such as polyester, polyethylene, polycarbonate, cellulose acetate, polypropylene, polyvinylchloride, polyvinylidene chloride, polystyrene, and polyamide, sheet, glass, ceramics, and paper. Such electrical insulating support preferably has at least one surface thereof subjected to conduction treatment, and desirably provided with a photovoltaic layer thereon.

For example, if glass is used, a thin film of NiCr, Al, Cr, Mo, Ir, Nb, Ta, V, Ti, Pt, Pb, In₂O₃ or ITO (In₂O₃+SnO₂) is formed on the surface to provide conductivity, or if synthetic resin film such as a polyester film is used, a metallic thin film of NiCr, Al, Ag, Pb, Zn, Ni, Au, Cr, Mo, Ir, Nb, Ta, V, Ti, Pt is formed on the surface by vacuum vapor deposition, electron beam vapor deposition or sputtering, or a lamination is made on the surface with any of the above metals to provide conductivity on the surface. The shape of support may be like a sheet having smooth or irregular surface. Its thickness can be appropriately determined to form a photovoltaic element as desired, but if the photovoltaic element is required to be flexible, the support should be formed as thin as possible as far as the support can sufficiently exhibit its function. However, for the convenience of fabricating or processing the support, the thickness may be usually 10 µm or greater from the point of mechanical strength.

### Light reflecting layer

Light reflecting layer is suitably made of a metal having high reflectance in the visible to near infrared region such as Ag, Al, Cu, or AlSi. It is preferable to form these metals by resistance heating vacuum vapor deposition, electron beam vacuum vapor deposition, co-vapor deposition, or sputtering. The layer thickness of these metals as the light reflecting layer may be suitably from 10 nm to 5000 nm. To make these metals a texture (concave and convex), it is necessary that the substrate temperature of these metals at the deposition may be above 200°C.

### Light reflection multiplying layer

Light reflection multiplying layer is optimally made of ZnO, SnO₂, In₂O₃, ITO, TiO₂, CdO, Cd₂Sn₄, Bi₂O₃, MoO₃, and NaxWO₃.

The deposition method of the reflection multiplying layer may be preferably a vacuum vapor deposition method, a sputtering method, a CVD method, a spray method, a spin on method, or a dip method.

The layer thickness of the reflection multiplying layer may be different depending on the refractive index of material for the reflection multiplying layer, and preferably is in a range from 50 nm to 10 µm.

Further, to make the reflection multiplying layer a texture, the substrate temperature in depositing the reflection multiplying layer is preferably set above 300°C.

### p-type layer or n-type layer (second, first conductive layer

The p-type layer or n-type layer is an important layer governing the characteristics of the photovoltaic element.

The amorphous materials (denoted as "a-") (of course including crystallite materials (denoted as "µc-") in the category of amorphous materials) may include, for example, a-Si:H, a-Si:HX, a-SiC:H, a-SiC:HX, a-SiGe:H, a-SiGeC:H, a-SiO:H, a-SiN:H, a-SiON:HX, a-SiOCN:HX, µc-Si:H, µc-SiC:H, µc-Si:HX, µc-SiC:HX, µc-SiGe:H, µc-SiO:H, µc-SiGeC:H, µc-SiN:H, µc-SiON:HX, and µc-SiOCN:HX with the addition of p-type valence control agent (e.g., Group III atoms in the periodic table such as B, Al, Ga, In, Tl) or n-type valence control agent (e.g., Group V atoms in the periodic table such as P, As, Sb, Bi) at high concentration; and the polycrystalline materials (denoted as "poly-") may include, for example, poly-Si:H, poly-Si:HX, poly-SiC:H, poly-SiC:HX, poly-SiGe:H, poly-Si, poly-SiC, and poly-SiGe with the addition of p-type valence control agent (e.g., Group III atoms in the periodic table such as B, Al, Ga, In, Tl) or n-type valence control agent (e.g., Group V atoms in the periodic table such as P, As, Sb, Bi) at high concentration.

In particular, for the p-type layer or n-type layer on the light incident side, a crystalline semiconductor layer with less light absorption or an amorphous semiconductor layer having wider band gap is suitable.

The additive amount of Group III atoms in the periodic table to the p-type layer or the additive amount of Group V atoms in the periodic table to the n-type layer is optimally in a range from 0.1 to 50 at%.

Hydrogen atom (H, D) or halogen atom contained in the p-type or n-type layer is to act the compensate for unbonded hands in the p-type or n-type layer and to improve the doping efficiency of the p-type or n-type layer. The additive amount of hydrogen atoms or halogen atoms to the p-type or n-type layer is optimally in a range from 0.1 to 40 at%. In particular, when the p-type or n-type layer is crystalline, the content of hydrogen atoms or halogen atoms is optimally from 0.1 to 8 at%. Further, a preferable distribution of hydrogen atoms and/or halogen atoms is such that a greater content is on each interface of p-type layer/i-type layer and n-type layer/i-type layer, the content of hydrogen atoms and/or halogen atoms near the interface being preferably 1.1 to 2 times that within the bulk. In this way, by providing the greater content of hydrogen atoms or halogen atoms near each interface of p-type layer/i-type layer and n-type layer/i-type layer, the defect level or mechanical distortion near the interface can be decreased, resulting in the increased photovoltaic power or photocurrent of the photovoltaic element of the present invention.

Of the electrical characteristics of the p-type or n-type layer in the photovoltaic element, the activation energy is preferably 0.2 eV or less, and optimally 0.1 eV or less. The specific resistance is preferably 100 Ωcm or less, and optimally 1 Ωcm or less. Further, the layer thickness of the p-type or n-type layer is preferably from 1 to 50 nm, and optimally from 3 to 10 nm.

The source gases suitable for the deposition of the p-type or n-type layer for the photovoltaic element may include, for example, gasifiable compounds containing silicon atoms, gasifiable compounds containing germanium atoms, gasifiable compounds containing nitrogen atoms, and the mixture gases thereof.

Specifically, the gasificable compounds containing silicon atoms may include, for example, SiH₄, Si₂H₆, SiF₄, SiFH₃, SiF₂H₃, SiF₃H, Si₃H₈, SiD₄, SiHD₃, SiH₂D₂, SiH₃D, SiFD₃, SiF₂D₂, SiD₃H, and Si₂D₃H₃.

Also, specifically, the gasifiable compounds containing germanium atoms may include, for example, GeH₄, GeD₄, GeF₄, GeFH₃, GeF₂H₂ GeF₃H, GeHD₃, GeH₃D₂, GeH₃D, Ge₂H₆, and Ge₂D₆.

Further, specifically, the gasifiable compounds containing carbon atoms may include, for example, CH₄, CD₄, CₙH₂ₙ₊₂ (n is an integer), CₙH₂ₙ (n is an integer), C₂H₂, C₆H₆, CO₂, and CO.

The nitrogen containing gases may include, for example, N₂, NH₃, ND₃, NO, NO₂, and N₂O.

Also, the oxygen containing gases may include, for example, O₂, CO, CO₂, NO, NO₃, N₃O, CH₃CH₂, OH, and CH₃OH.

The substances introduced into the p-type or n-type layer for the valence electron control may include Group III atoms and Group V atoms in the periodic table.

The starting materials effectively used for the introduction of Group III atoms may include, specifically, boron hydride such as B₂H₆, B₄H₁₀, B₅H₉, B₅H₁₁, B₆H₁₀, B₆H₁₂, B₆H₁₄, and boron halide such as BF₃, BCl₃, for the introduction of boron atoms. Besides, AlCl₃, GaCl₃, InCl₃ and TlCl₃ may be included. Among them, B₂H₆ and BF₃ are particularly suitable.

Also, the starting materials effectively used for the introduction of Group V atoms may include, for example, phosphorus hydride such as PH₃, P₂H₄, and phosphorus halide such as PH₄I, PF₃, PF₅, PCl₃, PCl₅, PBr₃, PBr₅, PI₃, for the introduction of phosphorus atoms. Besides, AsH₃, AsF₃, AsCl₃, AsBr₃, AsF₅, SbH₃, SbF₃, SbF₅, SbCl₃, SbCl₅, BiH₃, BiCl₃ and BiBr₃ may be included. Among them, PH₃ and PF₅ are particularly suitable.

The deposition method of the p-type or n-type layer suitable for the photovoltaic element relies on RF plasma CVD or microwave plasma CVD. Of the RF plasma CVD methods for the deposition, particularly, an RF plasma CVD method of the capacitive coupling type is suitable.

In depositing the p-type or n-type layer by the RF plasma CVD, the optimal conditions are such that the substrate temperature within the deposition chamber is from 100 to 350°C, the internal pressure is from 13 Pa to 13 hPa (0.1 to 10 Torr), the RF power is from 0.01 to 5.0 W/cm² and the deposition rate is from 0.01 to 3 nm/sec.

Also, the gasifiable compound as previously noted may be introduced into the deposition chamber by appropriately diluting it with a gas such as H₂, He, Ne, Ar, Xe, or Kr.

In particular, when depositing a layer having less light absorption or wide bandgap such as a crystallite semiconductor or a-SiC:H, it is preferable to dilute the source gas to two to 100 times thereof with a hydrogen gas and introduce a relatively high RF power. The RF frequency is preferably in a range from 1 MHz to 100 MHz, and particularly the frequency near 13.56 MHz is preferable.

When depositing the p-type or n-type layer by microwave plasma CVD, a method is suitable for the microwave plasma CVD apparatus, in which microwave is introduced through a waveguide via a dielectric window (made of alumina ceramics) into the deposition chamber.

When depositing the p-type or n-type layer by microwave plasma CVD, a film forming method as previously described of depositing the film by applying a microwave power and an RF power to the source gas at the same time is also suitable, but it is possible to use wider deposition conditions for forming deposited films applicable to the photovoltaic element. That is, when depositing the p-type layer or n-type layer by typical microwave plasma CVD methods, it is preferable that the substrate temperature within the deposition chamber is from 100 to 400°C, the internal pressure is from 67 mPa to 4 Pa (0.5 to 30 mTorr), the microwave power is from 0.01 to 1 W/cm³, and the microwave frequency is from 0.5 to 10 GHz.

The gasifiable compound as previously cited may be introduced into the deposition chamber by appropriately diluting it with a gas such as H₂, He, Ne, Ar, Xe or Kr.

In particular, when depositing a layer having less light absorption or wide bandgap such as a crystallite semiconductor or a-SiC:H, it is preferable to dilute the source gas 2 to 100 times with hydrogen gas and introduce a relatively higher microwave power.

### i-type layer by microwave plasma CVD

The i-type layer by microwave plasma CVD in the photovoltaic element is an important layer for generating and transporting carriers by illuminating light. The i-type layer may be a layer of slight p-type or slight n-type.

The i-type layer for the photovoltaic element of the present invention is a layer containing silicon atoms and germanium atoms and having the bandgap smoothly changing in a direction of layer thickness thereof, the minimum value of bandgap being biased to the direction of interface between the p-type layer and the n-type layer off the central position of the i-type layer. Also, it is preferred that a valence electron control agent as the donor and a valence electron control agent as the acceptor are doped in the i-type layer at the same time.

Hydrogen atoms (H, D) or halogen atoms (X) contained in the i-type layer are to act to compensate for unbonded hands of the i-type layer and to enhance the product of the mobility and the life of carriers in the i-type layer. Also, these atoms act to compensate for the interfacial level on each interface of n-type layer/i-type layer, with the effect of enhancing the photovoltaic power, photocurrent and light response ability of the photovoltaic element. The content of hydrogen atoms and/or halogen atoms in the i-type layer is optimally in a range from 1 to 40 at%. In particular, a preferable distribution is such that a greater content of hydrogen atoms and/or halogen atoms is on each interface of n-type layer/ i-type layer, the content of hydrogen atoms and/or halogen atoms near the interface being preferably 1.1 to 2 times that within the bulk. Further, it is preferable that the content of hydrogen atoms and/or halogen atoms changes corresponding to the content of silicon atoms. The content of hydrogen atoms and/or halogen atoms is preferably from 1 to 10 at%, when the content of silicon atoms is at minimum, and preferably 0.3 to 0.8 times the maximum content of hydrogen atoms and/or halogen atoms.

The content of hydrogen atoms and/or halogen atoms is changed corresponding to the content of silicon atoms, that is, corresponding to the bandgap, such that the content of hydrogen atoms and/or halogen atoms is smaller in the narrower bandgap region. The detailed mechanism has not been known, but in accordance with the deposited film forming method of the present invention, in depositing an alloy-type semiconductor containing silicon atoms and germanium atoms, different RF energies are absorbed by respective atoms due to the difference in ionization rate between silicon atom and germanium atom, causing sufficient relaxation even with a smaller content of hydrogen and/or halogen in the alloy-type semiconductor, so that the alloy-type semiconductor of high quality can be deposited.

In addition, by adding a slight amount of oxygen and/or nitrogen of 100 ppm or less to the i-type layer containing silicon atoms and germanium atoms, the photovoltaic element has a more durability against the annealing under vibrations for the long term. Its detailed reason has not been known, but may be considered as described below. That is, it is believed that, since the composition ratio of silicon atom and germanium atom continuously changes in a direction of layer thickness, there is a tendency of yielding more residual distortions than when the silicon atom and the germanium atom are mixed at a fixed ratio. It is believed that by adding oxygen atoms and/or nitrogen atoms to such a system, the structural distortion can be reduced, so that the photovoltaic element has a greater durability against the annealing under vibrations for the long term. A preferable distribution is such that the content of oxygen atoms and/or nitrogen atoms in a direction of layer thickness increases or decreases corresponding to the content of germanium atoms. This distribution is inverse to the distribution of hydrogen atoms and/or halogen atoms, but is believed to be preferable for the reason of balancing both effects of removing structural distortion and reducing dangling bonds. Further, with such a distribution of hydrogen atoms (and/or halogen atoms) and oxygen atoms (and/or nitrogen atoms), the tail state of valence band and that of conduction band can be connected smoothly and continuously.

The layer thickness of the i-type layer is optimally from 0.05 to 1.0 µm, although it may greatly depend on the structure of photovoltaic element (e.g., single cell, tandem cell, triple cell) and the bandgap of i-type layer.

The i-type layer containing silicon atoms and germanium atoms by the deposited film forming method of the present invention has small tail state on the valence band side even if the deposition rate is increased to 5 nm/sec or greater, the inclination of tail state being 60 meV or less, and the density of unbonded hands due to electron spin resonance (esr) being 10¹⁷/cm³ or less.

Also, it is preferable that the bandgap of i-type layer is designed to be wider on each interface of p-type layer/i-type layer and n-type layer/i-type layer. Such design allows for the increase in the photovoltaic power and photocurrent of the photovoltaic element and further allows for the prevention of the optical deterioration due to the use for the long time.

For the i-type layer of the photovoltaic element, the deposited film forming method as previously described of applying microwave and high frequency (RF) simultaneously is an optimal method.

### i-type layer by RF plasma CVD

The i-type layer by RF plasma CVD is deposited at a deposition rate of 1 nm/sec or less, the content of hydrogen atoms and/or halogen atoms in the deposition film being preferably from 1 to 40 at%. The bonding state of hydrogen atom or halogen atom is preferably a state where one hydrogen atom or one halogen atom is bonded with a silicon atom. It is preferable that the value of half-width at a peak of 2000 cm⁻¹, divided by the height of peak, in the infrared absorption spectrum representing the state where one hydrogen atom is bonded with a silicon atom is greater than the value of half-width at a peak of 2000 cm⁻¹, divided by the height of peak, for the i-type layer by microwave plasma CVD.

### Transparent electrode

Transparent electrode is suitably made of indium oxide or indium-tin oxide. The optimal deposition method for the transparent electrode may be a sputtering method and a vacuum vapor deposition method.

The transparent electrode is deposited in a manner as described below.

When the transparent electrode composed of indium oxide is deposited on the substrate with a DC magnetron sputtering apparatus, the target may be a target of metal indium (In) or indium oxide (In₂O₃).

Further, when the transparent electrode composed of indium-tin oxide is deposited on the substrate, the target may be an appropriate combination of targets of metal tin, metal indium, an alloy of metal tin and metal indium, tin oxide, indium oxide, or indium-tin oxide.

When deposition is made by sputtering, the substrate temperature is an important factor, the preferable range being from 25 to 600°C. When depositing the transparent electrode by sputtering, the sputtering gases may include inert gases such as argon gas (Ar), neon gas (Ne), xenon gas (Xe), and helium gas (He), among which particularly Ar gas is preferable. Also, it is preferable to add oxygen gas (O₂) to the inert gas as necessary, and particularly when metal is used as the target, oxygen gas (O₂) is requisite.

Further, when the target is sputtered with an inert gas, the pressure of discharge space is preferably from 13 mPa to 6.7 Pa (0.1 to 50 mTorr) for the effective sputtering.

In addition, the electric power source for the sputtering may be a DC power source or an RF power source. The electric power at the sputtering is preferably in a range from 10 to 1000 W.

The deposition rate for the transparent electrode depends on the pressure within discharge space or the discharge power, and optimally is in a range from 0.01 to 10 nm/sec.

In the vacuum vapor deposition, the vapor deposition source suitable for the deposition of transparent electrode may be metal tin, metal indium, or indium-tin alloy.

Also, the substrate temperature in depositing the transparent electrode is suitably in a range from 25 to 600°C.

Further, when depositing the transparent electrode, it is necessary that after the pressure reduction for the deposition chamber to 1.3·10⁻³ Pa (10⁻⁵ Torr) or less, oxygen gas (O₂) is introduced into the deposition chamber in a range from 6.7·10⁻³ to 12·10⁻² Pa (5x10⁻⁵ to 9x10⁻⁴ Torr). By introducing oxygen in this range, the metal gasified from the vapor deposition source will react with oxygen in the gas phase to deposit an excellent transparent electrode.

In addition, it is possible that an RF power is introduced with a degree of vacuum as above noted to produce a plasma, with which the vapor deposition is made.

The preferable deposition rate of the transparent electrode under the above conditions is from 0.01 to 10 nm/sec. If the deposition rate is below 0.01 nm/sec, the productivity is lowered, while if it is greater than 10 nm/sec, a rough film may be produced, resulting in lower transmittance, conductivity or adherence.

It is preferred that the layer thickness of transparent electrode is determined to meet the conditions of antireflection film. Specifically, the layer thickness of the transparent electrode is preferably in a range from 50 to 300 nm.

A power generation system of the present invention is comprised of a photovoltaic element of the present invention, a control system for controlling the supply of electric power from the photovoltaic element to an accumulator and/or an external load by monitoring the voltage and/or current of the photovoltaic element, and the accumulator for accumulating the electric power from the photovoltaic element and/or supplying the electric power to the external load.

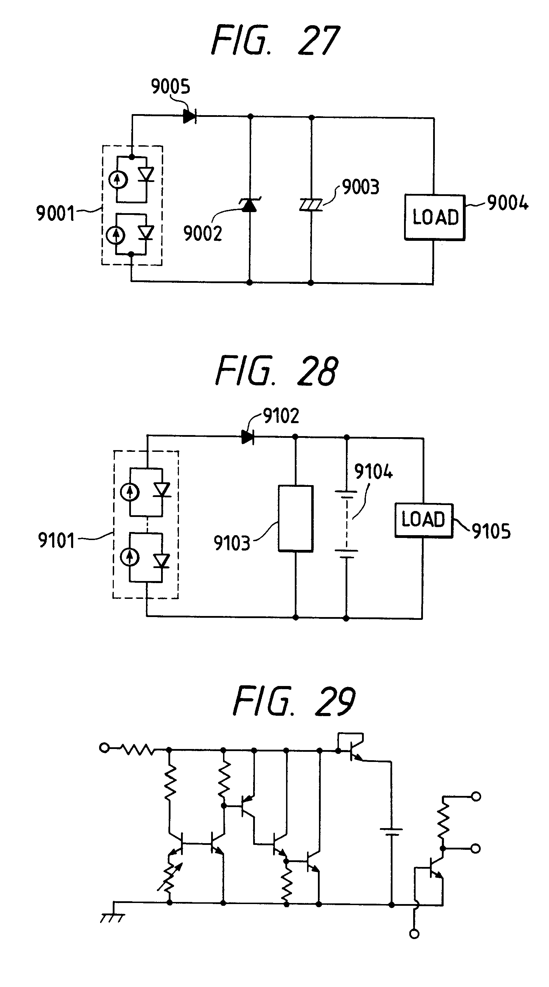

Fig. 27 is an example of a power supply system of the present invention, which is a basic circuit having only the photovoltaic element as the power source, wherein the power supply system is comprised of a photovoltaic element 9001 of the present invention as the solar cell, a diode 9002 for the voltage control of the photovoltaic element, a condenser 9003 for the voltage stabilization and acting as the accumulator, a load 9004 and preferably a reverse current preventing diode 9005.

Fig. 28 is an example of a power supply system of the present invention, which is a charging basic circuit using a photovoltaic element. The circuit is comprised of a solar cell 9101 which is a photovoltaic element of the present invention, a reverse current preventing diode 9102, a voltage control circuit 9103 for controlling the voltage by monitoring it, a secondary cell 9104, and a load 9105. The reverse current preventing diode suitably may be a silicon diode or Schottky diode. The secondary cell may be nickel cadmium cell, a charging silver oxide cell, a lead accumulator, and a flywheel energy accumulating unit. Fig. 29 is an example of a voltage control circuit 9103. The voltage control circuit outputs a voltage approximately equal to the output from the solar cell until the cell is fully charged, but stops the charging current by a charging control IC if the cell is fully charged.

The solar cell system utilizing such photovoltaic power can be used as the battery for an automobile battery charging system, a marine battery charging system, a street lamp lighting system, and an exhaust system.

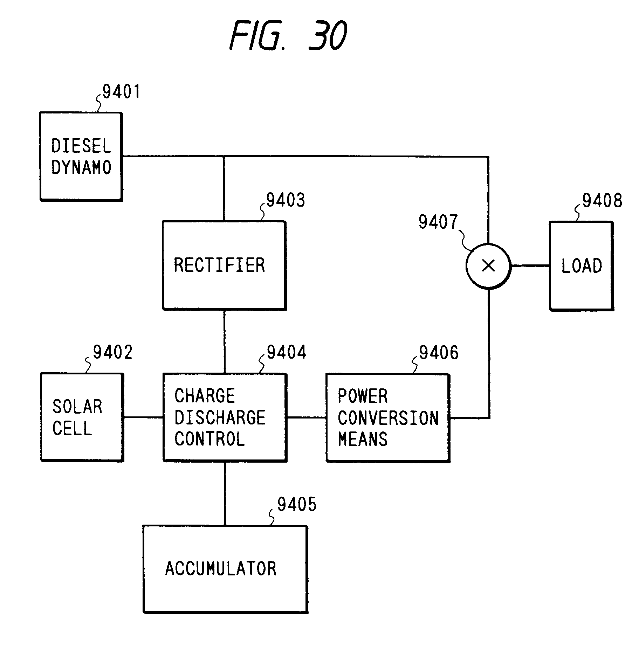

Fig. 30 is a block diagram of a solar cell, a diesel dynamo, and a power supply system of the hybrid type. The power generation system is comprised of a diesel dynamo 9401, a solar cell 9402 having a group of photoelectric conversion elements, a rectifier 9403, a charge/discharge control unit 9404, an accumulator 9405, a DC/AC conversion unit 9406 as power conversion means, a switch 9407, and an AC load 9408.

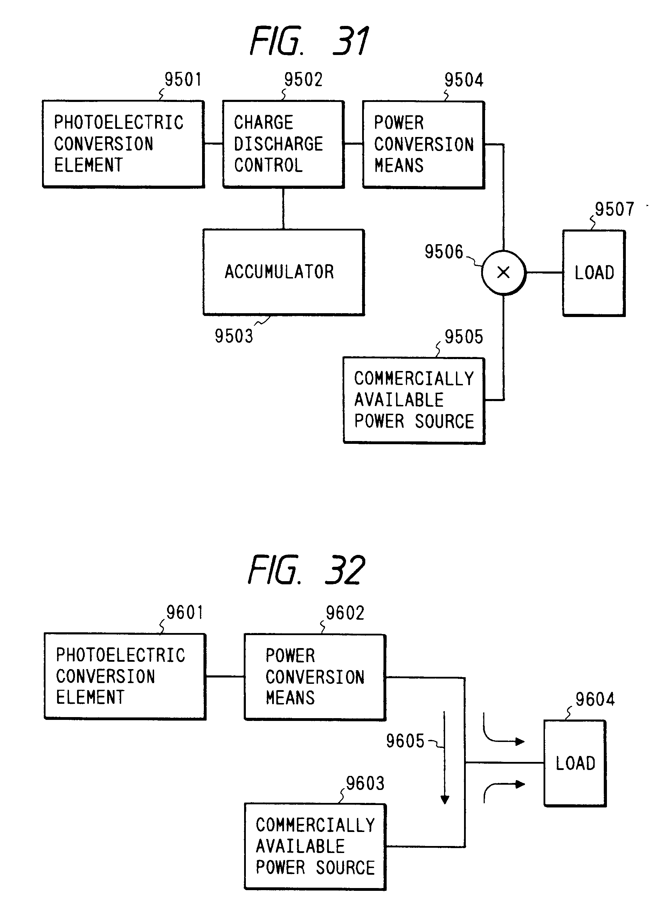

Further, Fig. 31 is a block diagram of a solar cell power supply system of commercially available backup type. The power supply system is comprised of a solar cell 9501 which is a photoelectric conversion element, a charge/discharge control unit 9502, an accumulator 9503, a DC/AC conversion unit 9504 as power conversion means, a commercially available power source 9505, a non-instantaneous switch 9506, and a load 9507.

In addition, Fig. 32 is a block diagram of a commercially available solar cell power supply system of complete link type. The power supply system is comprised of a solar cell 9601 which is a photoelectric conversion element, a DC/AC converter 9602 as power conversion means, a commercially available power source 9603, a load 9604, and a reverse current 9605.

As described above, a power supply system utilizing a photovoltaic element of the present invention as the solar cell, can be used stably for the long period, and sufficiently function as a photovoltaic element even when illuminating light directed to the solar cell varies, with the excellent stability.

### [Examples]

The present invention will be described below in more detail by way of example, but the invention is not limited to such examples.

### (Example 1)

Using a manufacturing apparatus of microwave plasma CVD method comprising a source gas supply unit 1020 and a deposition unit 1000 as shown in Fig. 18 and a manufacturing apparatus of RF plasma CVD method comprising a source gas supply unit 1020 and a deposition unit 1100 as shown in Fig. 19, a photovoltaic element of the present invention was fabricated.

Gas bombs 1071 to 1079 in the figure contain source gases for the fabrication of a p-type layer, an i-type layer and an n-type layer composed of silicon non-single crystalline semiconductor material of the present invention, wherein 1071 is an SiH₄ gas bomb, 1072 is a bomb of H₂ gas, 1073 is a bomb of BF₃ gas diluted to 1% with H₂ gas (hereinafter abbreviated as "BF₃(1%)/H₂"), 1074 is a bomb of PH₃ gas diluted to 1% with H₂ gas (hereinafter abbreviated as "PH₃(1%)/H₂"), 1075 is a bomb of Si₂H₆ gas, 1076 is a bomb of GeH₄ gas, 1077 is a bomb of BF₃ gas diluted to 2000 ppm with H₂ gas (hereinafter abbreviated as "BF₃(2000 ppm)/H₂"), 1078 is a bomb of PH₃ gas diluted to 2000 ppm with H₂ gas (hereinafter abbreviated with "PH₃(2000 ppm)/H₂"), and 1079 is a bomb of NO gas diluted to 1% with He gas (hereinafter abbreviated as "NO/He"). Also, the gases are each preintroduced through the valves 1051 to 1059 via inlet valves 1031 to 1039 into the gas pipes when mounting the gas bombs 1071 to 1079.

In the figure 1004 and 1104 are substrates, made of stainless (SUS430BA), 50 mm square and 1 mm thick, with its surface polished specularly, having a 100 nm-thick silver (Ag) thin film, made irregular, as the reflecting layer and a 1 µm-thick zinc oxide (ZnO) as the reflection multiplying layer which are deposited by sputtering.

First, SiH₄ gas from the gas bomb 1071, H₂ gas from the gas bomb 1072, BF₃(1%)/H₂ gas from the gas bomb 1073, PH₃(1%)/H₂ gas from the gas bomb 1074, Si₂H₆ gas from the gas bomb 1075, GeH₄ gas from the gas bomb 1076, BF₃(2000 ppm)/H₂ gas from the gas bomb 1077, PH₃(2000 ppm)/H₂ gas from the gas bomb 1078, and NO/He gas from the gas bomb 1079 were introduced by opening the valves 1051 to 1059, whereby each gas pressure was regulated by each pressure regulator 1061 to 1069 to about 2 Kg/cm².

Next, confirming that the inflow valves 1031 to 1039 and leak valve 1009, 1109 within the deposition chamber 1001, 1101 were closed, and that the outflow valves 1041 to 1049 and auxiliary valve 1008, 1108 were open, a conductance (butterfly type) valve 1007, 1107 was fully opened to evacuate the deposition chamber 1001, 1101 and the gas pipe by using a vacuum pump, not shown, and the auxiliary valve 1008, 1108 and the outflow valves 1041 to 1049 were closed at the time when the reading of vacuum gauge 1006, 1106 reached about 1x10⁻⁴ Torr.

Next, the inflow valves 1031 to 1039 were gradually opened to introduce respective gases into the mass flow controllers 1021 to 1029.

After the preparation for the film formation has been completed in the above way, an n-type layer, an i-type layer by microwave plasma CVD, an i-type layer by RF plasma CVD, and a p-type layer were formed on the substrate 1004, 1104.

To make the n-type layer, the substrate 1004 was heated to 350°C by the heater 1005, the outflow valves 1041 to 1044 and the auxiliary valve 1008 were gradually opened to flow SiH₄ gas and PH₃(1%)/H₂ gas through the gas introducing pipe 1003 into the deposition chamber 1001. Then, they were regulated by respective mass flow controllers 1021, 1024 so that the SiH₄ gas flow and the PH₃(1%)/H₂ gas flow were 50 sccm and 200 sccm, respectively. The opening of conductance valve 1007 was adjusted by referring to the vacuum gauge 1006 so that the pressure within the deposition chamber 1001 was 1.3 Pa (10 mTorr).

Thereafter, shutter 1013 was closed, a direct current (hereinafter abbreviated as "DC") bias of bias power source 1011 was set at 50V and applied to the bias rod 1012. Subsequently, the electric power of microwave power source, not shown, was set at 130 mW/cm³, and a microwave electric power was introduced through the waveguide, not shown, the waveguide portion 1010 and the dielectric window 1002 into the deposition chamber 1001 to excite a microwave glow discharge. Then, the shutter 1013 was opened to start fabrication of the n-type layer on the substrate 1004. Upon making the n-type layer having a layer thickness of 10 nm, the shutter 1013 was closed to stop microwave glow discharge, and the outflow valves 1041, 1044 and the auxiliary valve 1008 were closed to stop the gas inflow into the deposition chamber 1001, whereby the fabrication of the n-type layer was completed.

Next, to make the i-type layer by microwave plasma CVD, the substrate 1004 was heated to 350°C by the heater 1005, the outflow valves 1041, 1042, 1046 and the auxiliary valve 1008 were gradually opened to flow SiH₄ gas, H₂ gas and GeH₄ gas respectively through the gas introducing tube 1003 into the deposition chamber 1001. Then, they were regulated by respective mass flow controllers 1021, 1022, 1026 so that SiH₄ gas flow, H₂ gas flow and GeH₄ gas flow were 200 sccm, 500 sccm and 1 sccm, respectively. The opening of conductance valve 1007 was adjusted by referring to the vacuum gauge 1006 so that the pressure within the deposition chamber 1001 reached a value as indicated in Table 2.

Next, the shutter 1013 was closed, the electric power of microwave power source, not shown, was set at 170 mW/cm³, a microwave electric power was introduced through the waveguide, the waveguide portion 1010 and the dielectric window 1002 into the deposition chamber 1001 to excite a microwave glow discharge. The radio frequency (abbreviated as "RF") bias of bias power source 1011 was set at 350 mW/cm³, and the DC bias was set at 0 V via a coil for the RF cut, which were then applied to the bias rod 1012. Thereafter, the shutter 1013 was opened to start fabrication of the i-type layer by microwave plasma CVD on the n-type layer, and at the same time, SiH₄ gas flow and GeH₄ gas flow were adjusted in accordance with a flow pattern as shown in Fig. 16A by the mass flow controllers 1021, 1026. Upon making the i-type layer having a layer thickness of 300 nm, the shutter 1013 was closed, the output of bias power source 1011 was turned off, the microwave glow discharge was stopped, and the outflow valves 1041, 1042, 1046 and the auxiliary valve 1008 were closed to stop the gas inflow into the deposition chamber 1001.

Then, the substrate 1004 was taken out from the deposition chamber 1001, and installed in the deposition chamber 1101 of the deposition apparatus 1100 with RF plasma CVD method, where the i-type layer by RF plasma CVD was fabricated.

Next, to make the i-type layer by RF plasma CVD, the substrate 1104 was heated to 350°C by the heater 1105, the outflow valves 1041, 1042 and the auxiliary valve 1008 were gradually opened to flow SiH₄ gas and H₂ gas through the gas introducing tube 1103 into the deposition chamber 1101, respectively. Then, they were regulated by respective mass flow controllers 1021, 1022 so that SiH₄ gas flow and H₂ gas flow were 8sccm and 100 sccm, respectively. The opening of conductance valve 1107 was adjusted by referring to the vacuum gauge 1106 so that the pressure within the deposition chamber 1101 became 0.67 hPa (0.5 Torr).

Thereafter, the electric power of RF power source 1111 was set at 120 mW/cm³, an RF electric power was introduced through the RF matching box 1112 into the cathode 1102 to excite an RF glow discharge. The fabrication of the i-type layer by RF plasma CVD was started on the i-type layer made by microwave plasma CVD. Upon making the i-type layer having a layer thickness of 10 nm, the RF glow discharge was stopped, and the outflow valves 1041, 1042 and the auxiliary valve 1108 were closed to stop the gas inflow into the deposition chamber 1101, whereby the fabrication of the i-type layer was completed.

Then, the substrate 1104 was taken out from the deposition chamber 1101, and installed in the deposition chamber 1001 of the deposition apparatus 1000 with microwave plasma CVD method as shown in Fig. 18, where the p-type layer was fabricated.

To make the p-type layer, the substrate 1004 was heated to 300°C by the heater 1005, the outflow valves 1041 to 1043 and the auxiliary valve 1008 were gradually opened to flow SiH₄ gas, H₂ gas and BF₃(1%)/H₂ gas, respectively, through the gas introducing tube 1003 into the deposition chamber 1001. Then, they were regulated by respective mass flow controllers 1021 to 1023 so that the SiH₄ gas flow, the H₂ gas flow and BF₃(1%)/H₂ gas flow were 10 sccm, 700 sccm and 30 sccm, respectively. The opening of conductance valve 1007 was adjusted by referring to the vacuum gauge 1006 so that the pressure within the deposition chamber 1001 was 3.3 Pa (25 mTorr).

Thereafter, the electric power of microwave power source, not shown, was set at 250 mW/cm³, a microwave electric power was introduced through the waveguide, not shown, the waveguide portion 1010 and the dielectric window 1002 into the deposition chamber 1001 to excite a microwave glow discharge. And the shutter 1011 was opened to start fabrication of the p-type layer on the i-type layer by RF plasma CVD. Upon making the p-type layer having a layer thickness of 10 nm, the shutter 1013 was closed, the microwave glow discharge was stopped, and the outflow valves 1041 to 1043 and the auxiliary valve 1008 were closed to stop the gas inflow into the deposition chamber 1001, whereby the fabrication of the p-type layer was completed.

It is needless to say that the outflow valves 1041 to 1049 other than those of the necessary gases are fully closed in making the respective layers. In order to avoid each of the gases remaining within the deposition chamber 1001, 1101 and the pipes leading from the outflow valves 1041 to 1049 to the deposition chamber 1001, 1101, the operation of closing the outflow valves 1041 to 1049, opening the auxiliary valve 1008, 1108, and further fully opening the conductance valve 1007, 1107 to evacuate the system into high vacuum may be conducted, as required.

Next, on the p-type layer, a 70 µm-thick ITO (In₂O₃+SnO₂) thin film as the transparent electrode and a 2 µm-thick aluminum (Al) thin film as the collector electrode were vapor deposited in vacuum to fabricate photovoltaic elements (Element Nos. Example 1-1 to 1-7 and Comparative Example 1-1). The fabrication conditions for the photovoltaic element as described above are listed in Table 1.

The initial characteristics, low illuminance characteristic and durability characteristic were measured for the fabricated photovoltaic elements (Element Nos. Example 1-1 to 1-7 and Comparative Example 1-1).

The measurement of the initial characteristics was performed in terms of the open-circuit voltage and curve factor obtained by placing the fabricated photovoltaic elements (Element Nos. Example 1-1 to 1-7 and Comparative Example 1-1) under illumination of light with AM-1.5 (100 mW/cm²) and measuring the V-I characteristic. The results of measurement are listed in Table 2.

The measurement of low illuminance characteristic was performed in terms of the photoelectric conversion efficiency obtained by placing the fabricated photovoltaic elements (Element Nos. Example 1-1 to 1-7 and Comparative Example 1-1) under illumination of light with AM-1.5 (10 mW/cm²) and measuring the V-I characteristic. The results of measurement are listed in Table 2.

The measurement of durability characteristic was performed in terms of the change in the photoelectric conversion efficiency obtained by placing the fabricated photovoltaic elements (Element Nos. Example 1-1 to 1-7 and Comparative Example 1-1) in dark place with a humidity of 70% and a temperature of 60°C and then applying vibrations of 1 mm at 3600 rpm for 48 hours. The results of measurement are listed in Table 2.

As will be seen from Table 2, the photovoltaic element having excellent characteristics can be fabricated by making the i-type layer by microwave plasma CVD under the pressure of the deposition chamber 1001 being 6.7 Pa (50 mTorr) or less.

Next, using a substrate of barium borosilicate glass (7059 manufactured by Corning), an i-type layer by microwave plasma CVD was made on the substrate by opening the shutter 1013 for two minutes under the same fabrication conditions as the i-type layer by microwave plasma CVD in Element No. Example 1-5, except that SiH₄ gas flow and GeH₄ gas flow and the microwave electric power were as indicated in Table 3, whereby samples for the measurement of source gas decomposition efficiency were fabricated (Sample Nos. 1-1 to 1-5).

The film thickness of the fabricated sample for the measurement of source gas decomposition efficiency was measured by a layer thickness measuring instrument (alpha step 100 manufactured by TENCOR INSTRUMENTS) to obtain the decomposition efficiency of source gas. Its results are listed in Table 3.

Then, photovoltaic elements were fabricated (Element Nos. Example 1-9 to 1-10 and Comparative Example 1-2 to 1-3) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 1-5, except that the electric power of microwave electric power was as indicated in Table 4 in making the i-type layer by microwave plasma CVD.

For the fabricated photovoltaic elements (Element Nos. Example 1-8 to 1-10 and Comparative Example 1-2 to 1-3), the initial characteristics, the low illuminance characteristic and the durability characteristic were measured in the same manner as in Element No. Example 1-5. The results of measurement are listed in Table 4.

As will be seen from Tables 3 and 4, a photovoltaic element having more excellent characteristics can be obtained by decomposing the source gas with a lower microwave energy than the microwave energy necessary to decompose the source gas at 100%.

Then, photovoltaic elements were fabricated (Element Nos. Example 1-11 to 1-14 and Comparative Example 1-4) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 1-5, except that the RF bias was as indicated in Table 5 in making the i-type layer by microwave plasma CVD.

For the fabricated photovoltaic elements (Element Nos. Example 1-11 to 1-14 and Comparative Example 1-4), the initial characteristics, the low illuminance characteristic and the durability characteristic were measured in the same manner as in Element No. Example 1-5. The results of measurement are listed in Table 5. As will be seen from Table 5, a photovoltaic element having more excellent characteristics can be obtained by apply a higher RF energy to the source gas than the microwave energy.

Next, using a stainless substrate and a barium borosilicate glass (7059 manufactured by Corning) substrate, an i-type layer was made 1µm thick on the substrate under the same fabrication conditions as the i-type layer by microwave plasma CVD in Element No. Example 1-5, except that SiH₄ gas flow and GeH₄ gas flow were as indicated in Table 6, whereby samples for the measurement of material were fabricated (Sample Nos. 1-6 to 1-10).

Further, using a barium borosilicate glass (7059 manufactured by Corning) substrate, an i-type layer was made 1 µm thick on the substrate under the same fabrication conditions as the i-type layer by RF plasma CVD in Element No. Example 1-5, whereby a sample for the measurement of material was fabricated (sample No. 1-11).

The bandgap and the composition of the fabricated sample for the measurement of material were conducted to obtain the relaiton between the composition ratio of Si atom to Ge atom and the bandgap.

The measurement of bandgap was performed in such a manner as to install the glass substrate having the i-type layer fabricated in a spectrophotometer (330 type manufactured by Hitachi, Ltd.) to measure the wavelength dependency of absorption coefficient for the i-type layer and obtain the bandgap of the i-type layer in accordance with a method as described in "Amorphous solar cell" (written by Kiyoshi Takahashi and Makoto Konagai, published by Shokodo, p.109).

The analysis of composition was performed in such a manner as to install the stainless substrate having the i-type layer fabricated in an Auger electron spectral analysis instrument (JAMP-3 manufactured by JEOL, Ltd.), and measure the composition ratio of Si atom to Ge atom. The results of bandgap and composition are shown in Table 6.

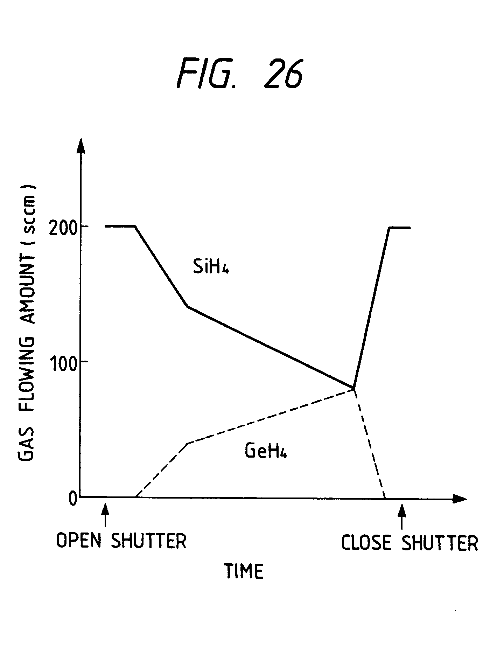

Then, a photovoltaic element was fabricated (Element No. Comparative Example 1-5) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 1-5, except that SiH₄ gas flow and GeH₄ gas flow were regulated by the mass flow controllers 1021, 1026 in accordance with the flow patterns as shown in Fig. 26B in making the i-type layer by microwave plasma CVD.

For the fabricated photovoltaic element (Element No. Comparative Example 1-5), the initial characteristics, the low illuminance characteristic and the durability characteristic were measured in the same manner as in Element No. Example 1-5. The results of measurement indicated that the open-circuit voltage and the curve factor in the initial characteristics, the low illuminance characteristic and the durability characteristic in Element No. Example 1-5 were 1.02 times, 1.03 times, 1.08 times and 1.07 times better than those in Comparative Example 1-5, respectively.

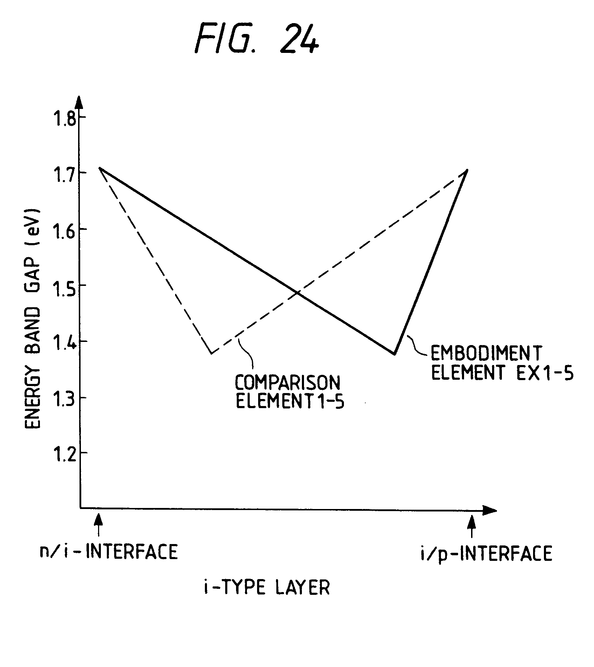

Next, the composition analysis in layer thickness direction of Si atoms and Ge atoms in the i-type layer by microwave plasma CVD in Element No. Example 1-5 and Element No. Comparative Example 1-5 was performed in the same manner as the previous composition analysis. And from the relation between the composition ratio and the bandgap of Si atom to Ge atom obtained by the Sample Nos. 1-6 to 1-10 as previously described, the variation of the bandgap in layer thickness direction of the i-type layer was obtained. Its results are shown in Fig. 24. As will be seen from Fig. 24, the photovoltaic element in Element No. Example 1-5 has the minimum value of bandgap at a position biased toward the interface between the p-type layer and the i-type layer off the central position of the i-type layer, while the photovoltaic element in Element No. Comparative Example 1-5 has the minimum value of bandgap at a position biased toward the interface between the n-type layer and the i-type layer off the central position of the i-type layer.

Then, photovoltaic elements were fabricated (Element Nos. Example 1-15 to 1-19 and Comparative Example 1-6) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 1-5, except that SiH₄ gas flow and RF discharge power were as indicated in Table 7 in making the i-type layer by RF plasma CVD.

For the fabricated photovoltaic elements (Element Nos. Example 1-15 to 1-19 and Comparative Example 1-6), the initial characteristics, the low illuminance characteristic and the durability characteristic were measured in the same manner as in Element No. Example 1-5.

Next, using a barium borosilicate glass (7059 manufactured by Corning) substrate, an i-type layer was made 1 µm thick on the substrate under the same fabrication conditions as the i-type layer by RF plasma CVD in Element No. Example 1-5, except that SiH₄ gas flow and RF discharge power were as indicated in Table 7, whereby a sample for the measurement of deposition rate was fabricated (Sample Nos. 1-12 to 1-17). The deposition rate of the fabricated sample for the measurement of deposition rate was obtained in the same manner as in Sample Nos. 1-1 to 1-5. Its results are listed in Table 7.

As will be seen from Table 7, it has been found that the photovoltaic element having excellent characteristics can be obtained by making the i-type layer by RF plasma CVD at a deposition rate of 2 nm/sec or less.

Then, photovoltaic elements were fabricated (Element Nos. Example 1-20 to 1-22 and Comparative Example 1-7 to 1-8) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 1-5, except that the layer thickness of the i-type layer was as indicated in Table 8 in making the i-type layer by RF plasma CVD.

For the fabricated photovoltaic elements (Element Nos. Example 1-20 to 1-22 and Comparative Example 1-7 to 1-8), the initial characteristics, the low illuminance characteristic and the durability characteristic were measured in the same manner as in Element No. Example 1-5. The results of measurement are listed in Table 8. As will be seen from Table 8, it has been found that the photovoltaic elements provided with the i-type layer by RF plasma CVD having a layer thickness of 30 nm or less (Element Nos. Example 1-20 to 1-22) has excellent characteristics.

Next, using a single crystal silicon substrate, an i-type layer by RF plasma CVD was made 1 µm thick on the substrate under the same fabrication conditions as the i-type layer by RF plasma CVD in Element No. Example 1-5, except that RF discharge power was as indicated in Table 9, whereby a sample for the measurement of infrared spectrum was fabricated (Sample Nos. 1-18 to 1-22).

Further, using a single crystal silicon substrate, an i-type layer by microwave plasma CVD was made 1 µm thick on the substrate under the same fabrication conditions as the i-type layer by microwave plasma CVD in Element No. Example 1-5, whereby a sample for the measurement of infrared spectrum was fabricated (Sample No. 1-23).

The fabricated sample for the measurement of infrared spectrum (Sample No. 1-18 to 1-23) was installed in an infrared spectrophotometer (1720-X manufactured by PERKIN ELMER) to obtain a value of half-width at a peak of 2000 cm⁻¹ in the infrared absorption spectrum divided by the height of peak. The results are listed in Table 9.

Then, photovoltaic elements were fabricated (Element Nos. Example 1-23 to 1-26) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 1-5, except that RF discharge power was as indicated in Table 9 in making the i-type layer by RF plasma CVD.

For the fabricated photovoltaic elements (Element Nos. Example 1-23 to 1-26), the infrared characteristics, the low illuminance characteristic and the durability characteristic were measured in the same manner as in Element No. Example 1-5. The results of measurement are listed in Table 9. As will be seen from Table 9, it has been found that the photovoltaic element having a greater value of half-width at a peak of 2000 cm⁻¹ in the infrared absorption spectrum divided by the height of peak in the i-type layer by RF plasma CVD than in the i-type layer by microwave plasma CVD has the excellent characteristics.

From the above measurement results, it has been found that the photovoltaic elements (Element Nos. Example 1-1 to 1-23) of the present invention have more excellent characteristics than the conventional photovoltaic elements (Element Nos. Comparative Example 1-1 to 1-8), wherein the photovoltaic elements of the present invention have been accomplished in that an i-type layer by microwave plasma CVD is formed at an internal pressure of 6.7 Pa (50 mTorr) or less by applying a lower microwave energy and a higher RF energy than the microwave energy necessary to decompose the source gas at 100% to the source gas, and an i-type layer by RF plasma CVD is deposited 30 nm thick or less at a deposition rate of 2 nm/sec or less, in such a manner that the bandgap smoothly changes in a direction of layer thickness, and the minimum value of bandgap takes place at a position biased toward the interface between the p-type layer and the i-type layer off the central position of the i-type layer. Thus, the effects of the present invention have been evidenced.

### (Example 2)

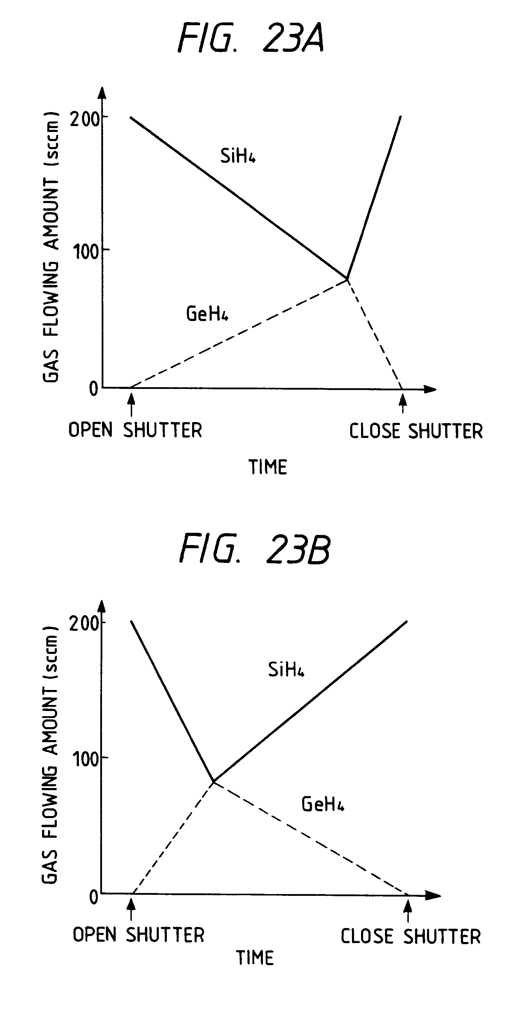

Photovoltaic elements were fabricated (Element Nos. Example 2-1 to 2-8) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that after SiH₄ gas flow and GeH₄ gas flow were regulated by the mass flow controllers 1021, 1026 in accordance with the flow patterns as shown in Fig. 23A, as in the example 1, SiH₄ gas flow was maintained at 200 sccm and GeH₄ gas flow at 1sccm, the region of the maximum value of bandgap was made to have a layer thickness as indicated in Table 10 in making the i-type layer by microwave plasma CVD.

For the fabricated photovoltaic elements (Element Nos. Example 2-1 to 2-8), the initial characteristics, the low illuminance characteristic and the durability characteristic were measured in the same manner as in the example 1. Its results are listed in Table 10. As will be seen from Table 10, it has been found that the photovoltaic elements (Element Nos. Example 2-1 to 2-7) having a layer thickness of 1 to 30 nm in the region of the maximum value of bandgap has excellent characteristics, whereby the effects of the present invention have been evidenced.

### (Example 3)

A photovoltaic element was fabricated (Element No. Example 3) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that BF₃(2000 ppm)/H₂ gas flow and PH₃(2000 ppm)/H₂ gas flow were flowed by 0.04 sccm and 0.02 sccm, using BF₃(2000 ppm)/H₂ gas bomb 1077 and PH₃(2000 ppm)/H₂ gas bomb 1078, respectively, in making the i-type layer by RF plasma CVD.

For the photovoltaic element fabricated in example 3 (Element No. Example 3), the initial characteristics, the low illuminance characteristic and the durability characteristic were measured in the same manner as in the example 1, and the initial characteristics, low illuminance characteristic and durability characteristic equivalent to those of Element No. Example 1-5 were obtained.

Also, the composition analysis for Element No. Example 3 was performed using a secondary ion mass spectrometer (IMS-3F manufactured by CAMECA), and it was confirmed that B atoms and P atoms were contained in the i-type layer by RF plasma CVD.

### (Example 4)

A photovoltaic element was fabricated (Element No. Example 4) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that using a bomb of AsH₃ gas diluted to 2000 ppm with H₂ gas (hereinafter abbreviated as "AsH₃/H₂"), instead of a bomb of PH₃(2000 ppm)H₂ gas, AsH₃/H₂ gas was flowed by 0.1 sccm in making the i-type layer by RF plasma CVD.

For the photovoltaic element fabricated in example 4 (Element No. Example 4), the initial characteristics, the low illuminance characteristic and the durability characteristic were measured in the same manner as in the example 1, and the initial characteristics, low illuminance characteristic and durability characteristic equivalent to those of Element No. Example 1-5 were obtained.

### (Example 5)

A photovoltaic element was fabricated (Element No. Example 5) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that using a bomb of No/He gas 1079, the flow rate of No/He gas was 0.5 sccm for the i-type layer by microwave plasma CVD and 0.05 sccm for the i-type layer by RF plasma CVD in making the i-type layer by microwave plasma CVD and the i-type layer by RF plasma CVD.

For the photovoltaic element fabricated (Element No. Example 5), the initial characteristics, the low illuminance characteristic and the durability characteristic were measured in the same manner as in the example 1, and the initial characteristics, low illuminance characteristic and durability characteristic equivalent to those of Element No. Example 1-5 were obtained.

Also, the composition analysis for Element No. Example 5 was performed using a secondary ion mass spectrometer, and it was confirmed that N atoms and O atoms were contained in the i-type layer.

### (Example 6)

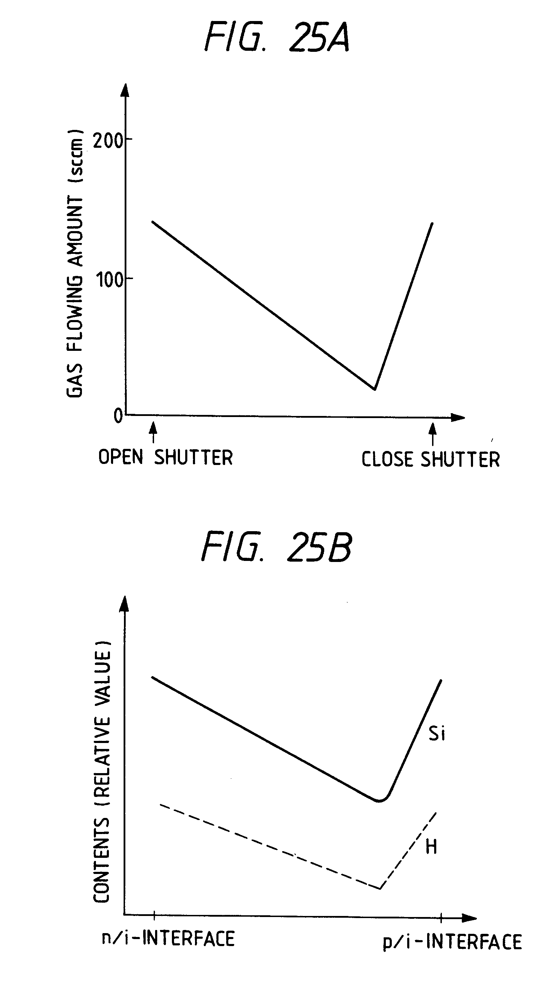

A photovoltaic element was fabricated (Element No. Example 6) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that using a bomb of Si₂H₆ gas, the flow rate of Si₂H₆ gas was 40 sccm and the flow rate of SiH₄ gas was regulated by a mass flow controller 1021 in accordance with a flow pattern as shown in Fig. 25A in making the i-type layer by microwave plasma CVD.

For the photovoltaic element fabricated (Element No. Example 6), the initial characteristics, the low illuminance characteristic and the durability characteristic were measured in the same manner as in the example 1, and the initial characteristics, low illuminance characteristic and durability characteristic equivalent to those of Element No. Example 1-5 were obtained.

Also, the distribution in layer thickness direction of each of Si atom and hydrogen atom in the i-type layer of the photovoltaic element in the example 6 (Element No. Example 6) was analyzed using a secondary ion mass spectrometer (IMS-3F manufactured by CAMECA). Its results are drawn in Fig. 25B.

From the above results, it has been found that the photovoltaic element in which the content of hydrogen atom changes corresponding to the content of Si atom has excellent characteristics, whereby the effects of the present invention have been evidenced.

### (Example 7)

A photovoltaic element was fabricated (Element No. Example 7) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that the distance between the point of mixing SiH₄ gas and GeH₄ gas and the deposition chamber 1001 in the source gas supply unit 1020 was set as listed in Table 11.

For the photovoltaic element fabricated (Element No. Example 7), the initial characteristics, the low illuminance characteristic and the durability characteristic were measured in the same manner as in the example 1. The measurement results are listed in Table 11. As will be seen from Table 11, if the distance between the point of mixing SiH₄ gas and GeH₄ gas and the deposition chamber 1001 is 5m or less, the photovoltaic element having further excellent characteristics can be obtained.

### (Example 8)

A photovoltaic element was fabricated under the same fabrication conditions as in Element No. Example 1-5 of the example 1, and using this photovoltaic element, a solar cell module was fabricated, whereby an analog clock with a circuit configuration as shown in Fig. 28 was made. In Fig. 28, the electric power generated by a solar cell module 9101 is passed via a reverse current preventing diode 9102 to charge a secondary cell 9104. 9103 is an overcharge preventing diode.

The electric power from the solar cell module 9101 and the secondary cell 9104 is supplied to a drive circuit 9105 of the analog clock.

### (Comparative Example 2)

As a comparative example, a photovoltaic element was fabricated under the same fabrication conditions as in Element No. Comparative Example 1-7, and using this photovoltaic element, the same analog clock as in example 8 was made.

The analog clocks as fabricated in the example 8 and the comparative example 2 were installed on the wall within room, and an indoor lamp was lighted for 8.5 hours a day. As a result, the analog clock of example 8 worked for all the day, but the analog clock of comparative example did not work all the day, whereby the effects of the power generation system of the present invention could be evidenced.

### (Example 9)

A photovoltaic element was fabricated (Element No. Example 9) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that the flow rates of SiH₄ gas and GeH₄ gas were regulated by mass flow controllers 1021, 1026 in accordance with the flow patterns as shown in Fig. 26 in making the i-type layer.

For the photovoltaic element fabricated (Element No. Example 9), the initial characteristics, the low illuminance characteristic and the durability characteristic were measured in the same manner as in the example 1, and the initial characteristics, low illuminance characteristic and durability characteristic equivalent to those of Element No. Example 1-5 of the example 1 were obtained, whereby the effects of the present invention could be evidenced.

### (Example 10)

A photovoltaic element was fabricated (Element No. Example 10) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that using a bomb of B₂H₆ gas diluted to 1% with H₂ gas (hereinafter abbreviated as "B₂H₆(1%)/H₂"), instead of a bomb of BF₃(2000 ppm)/H₂ gas, B₂H₆(1%)/H₂ gas for forming the i-type layer by RF plasma CVD was flowed by 0.05 sccm in making the i-type layer by RF plasma CVD.

For the photovoltaic element fabricated (Element No. Example 10), the initial characteristics, the low illuminance characteristic and the durability characteristic were measured in the same manner as in the example 1, and the initial characteristics, low illuminance characteristic and durability characteristic equivalent to those of Element No. Example 1-5 in the example 1 were obtained, whereby the effects of the present invention could be evidenced.

### (Example 11)

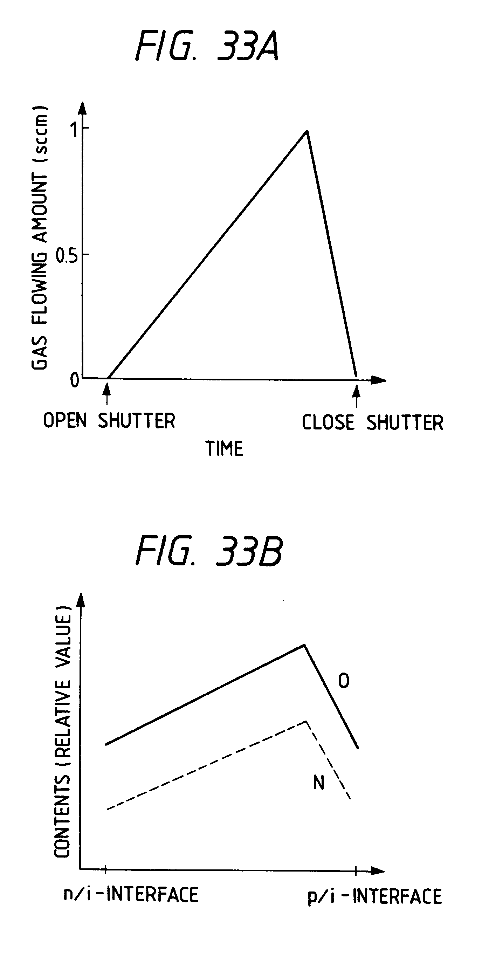

A photovoltaic element was fabricated (Element No. Example 11) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that the flow rate of NO/He gas was regulated by a mass flow controller 1029 in accordance with a flow pattern as shown in Fig. 33A in making the i-type layer by microwave plasma CVD.

For the photovoltaic element fabricated (Element No. Example 11), the initial characteristics, the low illuminance characteristic and the durability characteristic were measured in the same manner as in the example 1, and the initial characteristics, low illuminance characteristic and durability characteristic equivalent to those of Element No. Example 1-5 in example 1 were obtained.

Also, the distribution in layer thickness direction of each of N atom and O atom in the i-type layer of the photovoltaic element in the example 11 (Element No. Example 11) was analyzed using a secondary ion mass spectrometer. Its results are drawn in Fig. 33B.

From the above results, the effects of the present invention have been evidenced.

### (Example 12)

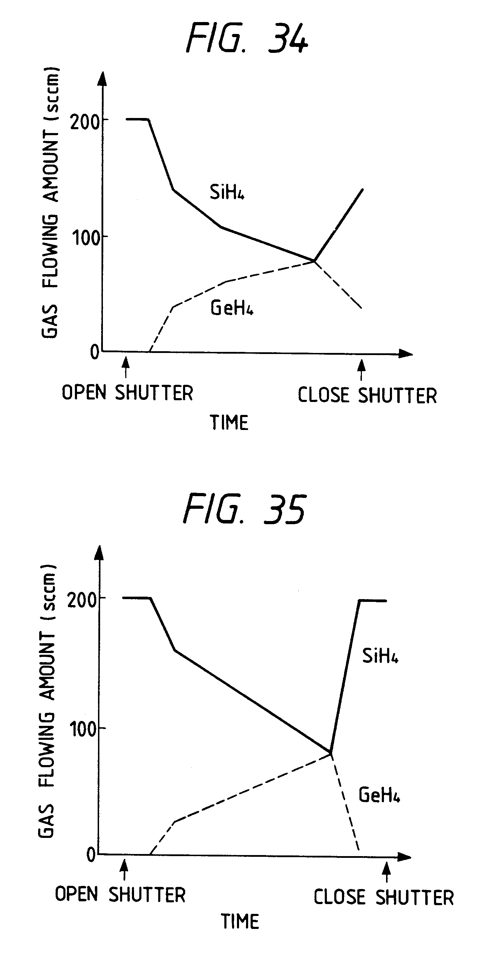

A photovoltaic element was fabricated (Element No. Example 12) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that the flow rates of SiH₄ gas and GeH₄ gas were regulated by mass flow controllers 1021, 1026 in accordance with the flow patterns as shown in Fig. 34 in making the i-type layer by microwave plasma CVD.

For the photovoltaic element fabricated (Element No. Example 12), the initial characteristics, the low illuminance characteristic and the durability characteristic were measured in the same manner as in the example 1, and the initial characteristics, low illuminance characteristic and durability characteristic equivalent to those of Element No. Example 1-5 of the example 1 were obtained, whereby the effects of the present invention could be evidenced.

### (Example 13)

A photovoltaic element was fabricated (Element No. Example 13) by forming a reflecting layer, a transparent conductive layer, an n-type layer, an i-type layer, a p-type layer, a transparent electrode, and a collector electrode on the substrate under the same fabrication conditions as those of example 9, except that RF bias of the bias power source 1011 was set 250 mW/cm³, and DC bias was set via a coil for RF cut at 50 V for the application to the bias rod 1012 in making the i-type layer by microwave plasma CVD.

For the photovoltaic element fabricated (Element No. Example 13), the initial characteristics, the low illuminance characteristic and the durability characteristic were measured in the same manner as in the example 9, and the initial characteristics, low illuminance characteristic and durability characteristic equivalent to those of the example 9 were obtained, whereby the effects of the present invention could be evidenced.

### (Example 14)

A photovoltaic element was fabricated (Element No. Example 14) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that using a bomb of D₂ gas, not shown, instead of H₂ gas bomb, D₂ gas was flowed by 300 sccm in making the i-type layer by microwave plasma CVD.

For the photovoltaic element fabricated (Element No. Example 14), the initial characteristics, the low illuminance characteristic and the durability characteristic were measured in the same manner as in the example 1, and the initial characteristics, low illuminance characteristic and durability characteristic equivalent to those of Element No. Example 1-5 in example 1 were obtained.

Also, the composition analysis of the photovoltaic element in the example 14 (Element No. Example 14) was performed using a secondary ion mass spectrometer, and it was confirmed that D atoms were contained in the i-type layer, whereby the effects of the present invention could be evidenced.

### (Example 15)

A photovoltaic element was fabricated (Element No. Example 15) by forming a reflecting layer, a transparent conductive layer, an n-type layer, an i-type layer, a p-type layer, a transparent electrode, and a collector electrode on the substrate under the same fabrication conditions as those of Element No. Example 1-5 in example 1, except that the DC bias of bias power source 1011 was changed at a constant rate from 50 V to 80 V at the same time when the shutter 1013 was opened in making the n-type layer.

For the photovoltaic element fabricated (Element No. Example 15), the initial characteristics, the low illuminance characteristic and the durability characteristic were measured in the same manner as in the example 1, and the initial characteristics, low illuminance characteristic and durability characteristic equivalent to those of Element No. Example 1-5 in example 1 were obtained, whereby the effects of the present invention could be evidenced.

### (Example 16)

Using a manufacturing apparatus with the RF plasma CVD method as shown in Fig. 19, an n-type layer and a p-type layer of a photovoltaic element of the present invention were fabricated in accordance with the same procedure as that for the i-type layer by RF plasma CVD of the example 1.

In the figure, 1104 is a substrate similar to that as used in the example 1. The gas bombs 1071 to 1079 as shown in the figure each were filled with the same source gases as in the example 1, each gas being introduced into a mass flow controller 1021 to 1029 with the same operation procedure as in the example 1.

After the preparation for the film formation was completed in the above way, the n-type layer was formed on the substrate 1104.

To make the n-type layer, the substrate 1104 was heated to 350°C by the heater 1105, the outflow valves 1042, 1044, 1045 and the auxiliary valve 1108 were gradually opened to flow H₂ gas, PH₃(1%)/H₂ gas and Si₂H₆ gas through the gas introducing pipe 1103 into the deposition chamber 1101. The inflow rates of the gases were regulated by respective mass flow controllers 1022, 1024, 1025 so that the H₂ gas flow, the PH₃(1%)/H₂ gas flow and the Si₂H₆ gas flow were 50 sccm, 5 sccm and 3 sccm, respectively. The opening of conductance valve 1107 was adjusted by referring to the vacuum gauge 1106 so that the pressure within the deposition chamber 1101 was 1.3 hPa (1Torr).

Thereafter, the electric power of RF power source 1111 was set at 120 mW/cm², an RF electric power was introduced through the RF matching box 1112 into the cathode 1102 to excite an RF glow discharge to start the formation of the n-type layer on the substrate 1104. Upon making the n-type layer having a layer thickness of 10nm, the RF glow discharge was stopped, and the outflow valves 1042, 1044, 1045 and the auxiliary valve 1108 were closed to stop the gas inflow into the deposition chamber 1101, whereby the formation of the n-type layer was completed.

Then, the substrate 1004 having the n-type layer made thereon was taken out from the deposition chamber 1101, and installed in the deposition apparatus 1000 with the microwave glow discharge decomposition method as used in the example 1, where an i-type layer by microwave plasma CVD was made on the n-type layer under the same fabrication conditions as those of Element No. Example 1-5 in the example 1.

Then, the substrate 1004 having the i-type layer by microwave plasma CVD made thereon was taken out from the deposition chamber 1000, and installed in the deposition apparatus 1100 with the RF plasma CVD method, as previously described, where an i-type layer by RF plasma CVD was made on the i-type layer by microwave plasma CVD under the same fabrication conditions as those of Element No. Example 1-5 in the example 1.

Subsequently, a p-type layer was made on the i-type by RF plasma CVD. To make the p-type layer, the substrate 1104 was heated to 200°C by the heater 1105, the outflow valves 1041 to 1043 and the auxiliary valve 1108 were gradually opened to flow SiH₄ gas, H₂ gas and BF₃(1%)/H₂ gas, respectively, through the gas introducing tube 1103 into the deposition chamber 1101. Then, the inflow rates of those gases were regulated by respective mass flow controllers 1021 to 1023 so that the SiH₄ gas flow, the H₂ gas flow and BF₃(1%)/H₂ gas flow were 0.5 sccm, 100 sccm and 1 sccm, respectively. The opening of conductance valve 1107 was adjusted by referring to the vacuum gauge 1106 so that the pressure within the deposition chamber 1101 was 1Torr.

Thereafter, the electric power of RF power source 1111 was set at 2 mW/cm², an RF electric power was introduced through the RF matching box 1112 into the cathode 1102 to excite an RF glow discharge to start the formation of the p-type layer on the i-type layer. Upon making the p-type layer having a layer thickness of 5 nm, the RF glow discharge was stopped, and the outflow valves 1041 to 1043 and the auxiliary valve 1108 were closed to stop the gas inflow into the deposition chamber 1101, whereby the formation of the p-type layer was completed.

Next, on the p-type layer, a transparent electrode and a collector electrode were vapor deposited in vacuum to fabricate a photovoltaic element (Cell No. Example 16). The fabrication conditions for the photovoltaic element as described above are listed in Table 12.

### (Comparative Example 3)

A photovoltaic element was fabricated (Element No. Comparative Example 3) by forming a reflecting layer, a transparent conductive layer, an n-type layer, an i-type layer, a p-type layer, a transparent electrode, and a collector electrode on the substrate under the same fabrication conditions as those of example 16, except that the i-type layer by RF plasma CVD was not made.

For the photovoltaic elements fabricated (Element No. Example 16 and Element No. Comparative Example 3), the initial characteristics, the low illuminance characteristic and the durability characteristic were measured in the same manner as in the example 1. From the measurements, it has been evidenced that the photovoltaic element of Element No. Example 16 was superior to that of Element No. Comparative Example 3, such that the open-circuit voltage and the curve factor of the initial characteristics, the photoelectric conversion efficiency of the low illuminance characteristic, and the decrease in the photoelectric conversion efficiency of the durability characteristic were 1.03 times, 1.04 times, 1.09 times and 1.07 times more excellent, respectively. Thus, the effects of the present invention could be evidenced.

### (Example 17)

A photovoltaic element was fabricated (Element No. Example 17) by forming a reflecting layer, a reflection multiplying layer, a first n-type layer, a first i-type layer, a first p-type layer, a second n-type layer, a second i-type layer, a second p-type layer, a transparent electrode, and a collector electrode on the substrate under the same fabrication conditions as listed in Table 13, with the same method as in the example 1.

### (Comparative Example 4)

A photovoltaic element was fabricated (Element No. Comparative Example 4) by forming a reflecting layer, a reflection multiplying layer, a first n-type layer, a first i-type layer, a first p-type layer, a second n-type layer, a second i-type layer, a second p-type layer, a transparent electrode, and a collector electrode on the substrate under the same fabrication conditions as listed in Table 17, except that the first i-type layer by RF plasma CVD was not made.

For the photovoltaic elements fabricated (Element No. Example 17 and Comparative Example 4) in the above manner, the initial characteristics, the low illuminance characteristic and the durability characteristic were measured in the same manner as in the example 1. From the measurements, it has been evidenced that the photovoltaic element of Element No. Example 17 was superior to that of Element No. Comparative Example 4, such that the open-circuit voltage and the curve factor of the initial characteristics, the photoelectric conversion efficiency of the low illuminance characteristic, and the decrease in the photoelectric conversion efficiency of the durability characteristic were 1.04 times, 1.03 times, 1.06 times and 1.10 times more excellent, respectively. Thus, the effects of the present invention could be evidenced.

### (Example 18)

A photovoltaic element was fabricated (Element No. Example 18) by forming a reflecting layer, a reflection multiplying layer, a first n-type layer, a first i-type layer, a first p-type layer, a second n-type layer, a second i-type layer, a second p-type layer, a third n-type layer, a third i-type layer, a third p-type layer, a transparent electrode, and a collector electrode on the substrate under the same fabrication conditions as listed in Table 14, with the same method as in the example 1.

### (Comparative Example 5)

A photovoltaic element was fabricated (Element No. Comparative Example 5) by forming a reflecting layer, a reflection multiplying layer, a first n-type layer, a first i-type layer, a first p-type layer, a second n-type layer, a second i-type layer, a second p-type layer, a third n-type layer, a third i-type layer, a third p-type layer, a transparent electrode, and a collector electrode on the substrate under the same fabrication conditions as listed in Table 17, except that the first and second i-type layers by RF plasma CVD were not made.

For the photovoltaic elements fabricated (Element No. Example 18 and Comparative Example 5), the initial characteristics, the low illuminance characteristic and the durability characteristic were measured in the same manner as in the example 1. From the measurements, it has been evidenced that the photovoltaic element of Element No. Example 18 was superior to that of Element No. Comparative Example 5, such that the open-circuit voltage and the curve factor of the initial characteristics, the photoelectric conversion efficiency of the low illuminance characteristic, and the decrease in the photoelectric conversion efficiency of the durability characteristic were 1.03 times, 1.02 times, 1.07 times and 1.07 times more excellent, respectively. Thus, the effects of the present invention could be evidenced.

### (Example 19)

Using a multiple chamber separation-type deposition apparatus as shown in Fig. 20, a photovoltaic element of the present invention was fabricated. In the figure, 1201 and 1209 are a load chamber and an unload chamber, respectively, 1202, 1204, 1205, 1206 and 1208 are deposition chambers for the layers by RF plasma CVD as in the example 16, 1203 and 1207 are deposition chambers for the layers by microwave plasma CVD as in the example 1, 1211 to 1218 are gate valves for separating one chamber from the other, 1221, 1223 to 1225 and 1227 are cathode electrodes, and 1222 and 1226 are a waveguide portion for microwave and a dielectric window, respectively.

First, the substrate was installed in the load chamber 1201, and the load chamber was evacuated of air. Thereafter, a gate valve 1211 was opened, the substrate was then moved to a first n-type layer deposition chamber 1202, and the gate valve 1211 was closed. Next, the first n-type layer was made on the substrate under the same conditions as those of the first n-type layer of example 17. Then, a gate valve 1212 was opened, the substrate was then moved to a first i-type layer deposition chamber 1203 by microwave plasma CVD, and the gate valve 1212 was closed. Next, a first i-type layer by microwave plasma CVD was made on the first n-type layer under the same conditions as those of the first i-type layer by microwave plasma CVD of example 17. Next, a gate valve 1213 was opened, the substrate was then moved to a first i-type layer deposition chamber 1204 by RF plasma CVD, and the gate valve 1213 was closed. Next, a first i-type layer by RF plasma CVD was made on the first i-type layer by microwave plasma CVD under the same conditions as those of the first i-type layer by RF plasma CVD of example 17.

A gate valve 1214 was opened, the substrate was then moved to a first p-type layer deposition chamber 1205, and the gate valve 1214 was closed. Next, a first p-type layer was made on the first i-type layer by RF plasma CVD under the same conditions as those of the first p-type layer of example 17. Then, a gate valve 1215 was opened, the substrate was then moved to a second n-type layer deposition chamber 1206, and the gate valve 1215 was closed. Next, a second n-type layer was made on the first p-type layer under the same conditions as those of the second n-type layer of example 17. Next, a gate valve 1216 was opened, the substrate was then moved to a second i-type layer deposition chamber 1207, and the gate valve 1216 was closed. Next, a second i-type layer was made on the second n-type layer under the same conditions as those of the second i-type layer of example 17. Next, a gate valve 1217 was opened, the substrate was then moved to a second p-type layer deposition chamber 1208, and the gate valve 1217 was closed. Next, a second p-type layer was made on the second i-type layer under the same conditions as those of the second p-type layer of example 17. Then, a gate valve 1218 was opened, the substrate was then moved to an unload chamber 1209, and the gate valve 1218 was closed. Then, the substrate was taken out from the unload chamber 1209, whereby the fabrication of a photovoltaic element was completed (Element No. Example 19).

For the photovoltaic element fabricated (Element No. Example 19), the initial characteristics, the low illuminance characteristic and the durability characteristic were measured in the same manner as in the example 1. From the measurements, it has been evidenced that the photovoltaic element of example 19 (Element No. Example 19) was superior to that of example 17 (Element No. Example 17), such that the open-circuit voltage and the curve factor of the initial characteristics, the photoelectric conversion efficiency of the low illuminance characteristic, and the decrease in the photoelectric conversion efficiency of the durability characteristic were 1.01 times, 1.02 times, 1.03 times and 1.01 times more excellent, respectively. Thus, it has been found that a photovoltaic element of the present invention can exhibit more excellent characteristics by fabricating it in the multiple chamber separation-type deposition chamber.

### (Example 20)

A photovoltaic element was fabricated under the same fabrication conditions as those of the example 17, and using the photovoltaic element, a solar cell module was fabricated to make a car-mounted ventilation fan having a circuit configuration as shown in Fig. 28. In Fig. 28, the electric power generated by the solar cell module 910 which is bonded onto the bonnet of car is charged through a reverse-current preventing diode 9102 into a secondary cell 9104. 9103 is an overcharge preventing diode. The electric power from the solar cell module 9101 and the secondary cell 9104 is supplied to a motor 9105 for the ventilation fan.

### (Comparative Example 6)

As a comparative example, a photovoltaic element was fabricated under the same fabrication conditions as those of comparative example 4, and a car-mounted ventilation fan similar to that of the example 21 was made using the photovoltaic element.

A car which has mounted the car-mounted ventilation fans as fabricated in example 20 and comparative example 4 was left away in an idling state with the engine rotating for 168 hours, and then left away in fine weather with the ventilation fan working and with the engine stopped, whereafter the temperature within the car was measured. As a result, the car-mounted cooling fan of example 20 achieved a room temperature three degrees lower than the car-mounted cooling fan of comparative example, whereby the effects of the power generation system of the present invention was evidenced.

### (Example 21)

In this example, a photovoltaic element having a p-type layer in the lamination structure was fabricated.

In a source gas supply unit 1020 as shown in Figs. 18 and 19, the BF₃(1%)/H₂ gas bomb was replaced with a bomb of B₂H₆ has diluted to 10% with H₂ gas (B₂H₆(10%)/H₂ gas).

On the SUS substrate, a reflecting layer, a reflection multiplying layer, an n-type layer, an i-type layer by microwave plasma CVD and an i-type layer by RF plasma CVD were formed, as in the example 1, and subsequently a p-type layer was formed as in the following manner.

After the formation of the i-type layer by RF plasma CVD, the substrate was installed in a deposition apparatus with the microwave plasma CVD method as shown in Fig. 18 to make a p-type layer with a doping layer A and a doping layer B laminated.

To make a doping layer B1, the substrate 1004 was heated to 300°C by the heater 1005, the outflow valves 1041, 1042, 1047 and the auxiliary valve 1008 were gradually opened to flow SiH₄ gas, H₂ gas and BF₃/H₂ gas through the gas introducing pipe 1003 into the deposition chamber 1001. The inflow rates of the gases were regulated by respective mass flow controllers 1021, 1022, 1027 so that the SiH₄ gas flow, the H₂ gas flow and the BF₃/H₂ gas flow were 1sccm, 300sccm and 2sccm, respectively. The pressure within the deposition chamber 1101 was set to 1Torr by adjusting the opening of conductance valve 1007 while referring to the vacuum gauge 1006.

Thereafter, the electric power of microwave power source, not shown, was set at 50mW/cm³, a microwave electric power was introduced through a waveguide, not shown, the waveguide portion 1010 and the dielectric window 1002 into the deposition chamber 1001 to excite a microwave glow discharge to start the formation of the doping layer B1 on the i-type layer by opening the shutter 1013. Upon making the doping layer B1 having a layer thickness of 0.5nm, the shutter 1013 was closed, the microwave glow discharge was stopped, and the outflow valves 1041, 1042, 1047 and the auxiliary valve 1008 were closed to stop the gas inflow into the deposition chamber 1001.

To make a doping layer A, the substrate 1004 was heated to 300°C by the heater 1005, the outflow valve 1043 and the auxiliary valve 1008 were gradually opened to flow B₂H₆(10%)/H₂ gas through the gas introducing pipe 1003 into the deposition chamber 1001. The inflow rate of the gas was regulated by mass flow controller 1023 so that the B₂H₆(10%)/H₂ gas flow was 100sccm. The pressure within the deposition chamber 1001 was set to 30mTorr by adjusting the opening of conductance valve 1007 while referring to the vacuum gauge 1006.

Thereafter, the electric power of microwave power source, not shown, was set at 50mW/cm³, a microwave electric power was introduced through a waveguide, not shown, the waveguide portion 1010 and the dielectric window 1002 into the deposition chamber 1001 to excite a microwave glow discharge to start the formation of the doping layer A on the doping layer B1 by opening the shutter 1013. Upon making the doping layer A having a layer thickness of 0.3nm, the shutter 1013 was closed, the microwave glow discharge was stopped, and the outflow valve 1043 and the auxiliary valve 1008 were closed to stop the gas inflow into the deposition chamber 1001.

Next, a doping layer B2 was formed on the doping layer A under the same fabricating conditions as those of the doping layer B1, except that the layer thickness was 10nm.

Subsequently, on the p-type layer, a 70µm-thick ITO (In₂O₃+SnO₂) thin film as the transparent electrode and a 2µm- thick aluminum (Al) thin film as the collector electrode were vapor deposited in vacuum to fabricated photovoltaic elements (Element Nos. Example 1-1 to 1-7 and Comparative Example 7-1). The fabrication conditions for the photovoltaic element as described above are listed in Table 15.

The initial characteristics, low illuminance characteristic and durability characteristic were measured for the fabricated photovoltaic elements (Element Nos. Example 21-1 to 21-7 and Comparative Example 1-1). The results are listed in Table 16.

From Table 16, it has been found that a photovoltaic element having more excellent characteristics can be obtained by forming the i-type layer by microwave plasma CVD within the deposition chamber at a pressure of 6.7 Pa (50mTorr) or less.

Next, photovoltaic elements were fabricated (Element Nos. Example 21-8 to 21-10 and Comparative Example 7-2 to 7-3) by forming a reflecting layer, a reflection multiplying layer, an n-type layer, an i-type layer, a p-type layer, a transparent electrode and a collector electrode on the substrate under the same fabrication conditions as those of Element No. Example 21-5, except that the electric power of microwave electric power source was as indicated in Table 17 in making the i-type layer by microwave plasma CVD.

For the fabricated photovoltaic elements (Element Nos. Example 21-8 to 21-10 and Comparative Example 7-2 to 7-3), the initial characteristics, the low illuminace characteristic and the durability characteristic were measured in the same manner as in Example 1. The results of measurement are listed in Table 17. From Table 17, it has been found that a photovoltaic element having more excellent characteristics can be obtained by decomposing the source gas with a lower microwave energy than the microwave energy necessary to decompose the source gas at 100%.

Then, photovoltaic elements were fabricated (Element Nos. Example 21-11 to 21-14 and Comparative Example 7-4) by forming a reflecting layer, a reflection multiplying layer, an n-type layer, an i-type layer, a p-type layer, a transparent electrode and a collector electrode on the substrate under the same fabrication conditions as those of Element No. Example 21-5, except that the RF bias was as indicated in Table 18 in making the i-type layer by microwave plasma CVD.

For the fabricated photovoltaic elements (Element Nos. Example 21-11 to 21-14 and Comparative Example 7-4), the initial characteristics, the low illuminance characteristic and the durability characteristic were measured in the same manner as in example 1. The results of measurement are listed in Table 18. From Table 18, it has been found that a photovoltaic element having excellent characteristics can be obtained by apply a higher RF energy to the source gas than the microwave energy.

Then, a photovoltaic element was fabricated (Element No. Comparative Example 7-5) by forming a reflecting layer, a reflection multiplying layer, an n-type layer, an i-type layer, a p-type layer, a transparent electrode, and a collector electrode on the substrate under the same fabrication conditions as those of Element No. Example 21-5, except that SiH₄ gas flow and GeH₄ gas flow were regulated by the mass flow controllers 1021, 1026 in accordance with the flow patterns as shown in Fig. 23B in making the i-type layer by microwave plasma CVD.

For the fabricated photovoltaic element (Element No. Comparative Example 7-5), the initial characteristics, the low illuminance characteristic and the durability characteristic were measured in the same manner as in example 1. The results of measurement indicated that the open-circuit voltage and the curve factor in the initial characteristics, the photoelectric conversion efficiency in the low illuminance characteristic and the phtoelectric conversion efficiency in the durability characteristic in Element No. Example 21-5 were 1.03 times, 1.02 times, 1.08 times and 1.07 times better than those in Element No. Comparative Example 7-5, respectively.

Also, the variation in the bandgap in a direction of layer thickness of the i-type layer was examined, so that it could be found that the photovoltaic element in Element No. Example 21-5 has the minimum value of bandgap at a position biased toward the interface between the p-type layer and the i-type layer off the central position of the i-type layer, while the photovoltaic element in Element No. Comparative Example 7-5 has the minimum value of bandgap at a position biased toward the interface between the n-type layer and the i-type layer off the central position of the i-type layer.

Then, photovoltaic elements were fabricated (Element Nos. Example 21-15 to 21-19 and Comparative Example 7-6) by forming a reflecting layer, a reflection multiplying layer, an n-type layer, an i-type layer, a p-type layer, a transparent electrode, and a collector electrode on the substrate under the same fabrication conditions as those of the photovoltaic element of Element No. Example 21-5, except that SiH₄ gas flow and RF discharge electric power were as indicated in Table 19 in making the i-type layer by RF plasma CVD.

For the fabricated photovoltaic elements (Element Nos. Example 21-15 to 21-19 and Comparative Example 7-6), the initial characteristics, the low illuminance characteristic and the durability characteristic were measured in the same manner as in Element No. Example 21-5. The results of measurement are listed in Table 19.

As will be seen from Table 19, it has been found that a photovoltaic element having more excellent characteristics can be obtained by making the i-type layer by RF plasma CVD at a deposition rate of 2nm/sec or less.

Then, photovoltaic elements were fabricated (Element Nos. Example 21-20 to 21-22 and Comparative Example 7-7 to 7-8) by forming a reflecting layer, a reflection multiplying layer, an n-type layer, an i-type layer, a p-type layer, a transparent electrode, and a collector electrode on the substrate under the same fabrication conditions as those of the photovoltaic element of Element No. Example 21-5, except that the layer thickness of the i-type layer was as indicated in Table 20 in making the i-type layer by RF plasma CVD.

For the fabricated photovoltaic elements (Element Nos. Example 21-20 to 21-22 and Comparative Example 7-7 to 7-8), the initial characteristics, the low illuminance characteristic and the durability characteristic were measured in the same manner as in Element No. Example 21-5. The results of measurement are listed in Table 20. As will be seen from Table 20, it has been found that a photovoltaic element having more excellent characteristics can be obtained by making the i-type layer by RF plasma CVD having a layer thickness of 30 nm or less (Element Nos. Example 21-20 to 21-22).

Then, photovoltaic elements were fabricated (Element Nos. Example 21-23 to 21-26) by forming a reflecting layer, a reflection multiplying layer, an n-type layer, an i-type layer, a p-type layer, a transparent electrode, and a collector electrode on the substrate under the same fabrication conditions as those of the photovoltaic element of Element No. Example 21-5, except that the RF electric power was as indicated in Table 21 in making the i-type layer by RF plasma CVD.

For the fabricated photovoltaic element (Element Nos. Example 21-23 to 21-26), the initial characteristics, the low illuminance characteristic and the durability characteristic were measured in the same manner as in Element No. Example 21-5. The results of measurement are listed in Table 21. As will be seen from Table 21, it has been found that a photovoltaic element having more excellent characteristics can be obtained wherein the value of half width at a peak of 2000 cm⁻¹ in the infrared absorption spectrum divided by the peak height is greater in the i-type layer by microwave plasma CVD than in the i-type layer by RF plasma CVD.

Then, photovoltaic element were fabricated (Element No. Example 21-27) by forming a reflecting layer, a reflection multiplying layer, an n-type layer, an i-type layer, a p-type layer, a transparent electrode, and a collector electrode on the substrate under the same fabrication conditions as those of Element No. Example 21-5, except that only the doping layer B was formed, but the doping layer A not formed, in making the p-type layer.

For the fabricated photovoltaic elements (Element No. Example 21-27), the initial characteristics, the low illuminance characteristic and the durability characteristic were measured in the same manner as in Example 1. The results of measurement indicated that the open-circuit voltage and the curve factor in the initial characteristics, the photoelectric conversion efficiency in the low illuminance characteristic and the photoelectric conversion efficiency in the durability characteristic in Element No. Example 21-5 were 1.02 times, 1.03 times, 1.07 times and 1.08 times better than those in Element No. Example 21-27, respectively.

From the above measurement results, it has been found that the photovoltaic elements (Element Nos. Example 21-1 to 21-26) of the present invention can exhibit more excellent characteristics than the conventional photovoltaic elements, wherein the photovoltaic elements of the present invention have been accomplished in that an i-type layer by microwave plasma CVD is formed at an internal pressure of 50 mTorr or less by applying a lower microwave energy and a higher RF energy than the microwave energy necessary to decompose the source gas at 100% to the source gas, and an i-type layer by RF plasma CVD is deposited 30 nm thick or less on the p-type layer at a deposition rate of 2 nm/sec, in such a manner that the bandgap smoothly changes in a direction of layer thickness, and the minimum value of bandgap takes place at a position biased toward the interface between the p-type layer and the i-type layer off the central position of the i-type layer, and at least one of the p-type layer and the n-type layer has a lamination structure comprising a layer composed of Group III element and/or Group V element in the periodic table as the main constituent, and a layer containing a valence electron control agent and having silicon atom as the main constituent. Thus, the effects of the present invention have been evidenced.

### (Example 22)

Photovoltaic elements (Element Nos. Example 22-1 to 22-8) were fabricated in such a manner as to form a reflecting layer, a reflection multiplying layer, an n-type layer, an i-type layer, a p-type layer, a transparent electrode, and a collector electrode on the substrate under the same fabrication conditions as those of Element No. Example 21-5 in the Example 21, except that after SiH₄ gas flow and GeH₄ gas flow were regulated by respective mass flow controllers 1021, 1026 in accordance with the flow patterns as shown in Fig. 23A, as conducted in the Example 21, SiH₄ gas flow was maintained at 200 sccm and GeH₄ at 1 sccm, and the region of the maximum bandgap was made to have a layer thickness as indicated in Table 22, in making the i-type layer by microwave plasma CVD.

For the fabricated photovoltaic elements (Element Nos. Example 22-1 to 22-8), the initial characteristics, the low illuminance characteristic and the durability characteristic were measured in the same manner as in Example 21. The results of measurement are listed in Table 22. As will be seen from Table 22, it has been found that the photovoltaic elements (Element Nos. Example 22-1 to 22-7) having a layer thickness of 1 to 30 nm in the region of the maximum bandgap can exhibit more excellent characteristics, whereby the effects of the present invention have been evidenced.

### (Example 23)

A photovoltaic element (Element No. Example 23) was fabricated by forming a reflecting layer, a transparent conductive layer, an n-type layer, an i-type layer, a p-type layer, a transparent electrode, and a collector electrode on the substrate under the same fabrication conditions as those of Element No. Example 21-5 in Example 1, except that BF₃(2000 pm)/H₂ gas flow and PH₃(2000 ppm)/H₂ gas flow were flowed by 0.4 sccm and 0.02 sccm, using BF₃(2000 ppm)/H₂ gas bomb 1077 and PH₃(2000 ppm)/H₂ gas bomb 1078, respectively, in making the i-type layer by RF plasma CVD.

For the photovoltaic element (Element No. Example 23) fabricated in Example 23, the initial characteristics, the low illuminance characteristic and the durability characteristic were measured in the same manner as in the Example 21, and the initial characteristics, low illuminance characteristic and durability characteristic equivalent to those of Element No. Example 21-5 were obtained.

### (Example 24)

A photovoltaic element (Element No. Example 24) was fabricated by forming a reflecting layer, a transparent conductive layer, an n-type layer, an i-type layer, a p-type layer, a transparent electrode, and a collector electrode on the substrate under the same fabrication conditions as those of element in Example 23, except that using a bomb of AsH₃/H₂ gas instead of a bomb of PH₃(2000ppm)/H₂ gas, AsH₃/H₂ gas was flowed by 0.01 sccm, in making the i-type layer by RF plasma CVD.

For the photovoltaic element fabricated in Example 24 (Element No. Example 24), the initial characteristics, the low illuminance characteristic and the durability characteristic were measured in the same manner as in the Example 23, and the initial characteristics, low illuminance characteristic and durability characteristic equivalent to those of Element No. Example 23 were obtained.

### (Example 25)

A photovoltaic element (Element No. Example 25) was fabricated by forming a reflecting layer, a reflection multiplying layer, an n-type layer, an i-type layer, a p-type layer, a transparent electrode, and a collector electrode on the substrate under the same fabrication conditions as those of Element No. Example 21-5, except that using a bomb of NO/He gas 1079, the flow rate of NO/He gas was 0.5 sccm for the i-type layer by microwave plasma CVD and 0.05 sccm for the i-type layer by RF plasma CVD, in making the i-type layer by microwave plasma CVD and the i-type layer by RF plasma CVD.

For the photovoltaic element fabricated (Element No. Example 25), the initial characteristics, the low illuminance characteristic and the durability characteristic were measured in the same manner as in the Example 21, and the initial characteristics, low illuminance characteristic and durability characteristic equivalent to those of Element No. Example 21-5 were obtained.

Also, the composition analysis for the photovoltaic element (Element No. Example 25) in the Example 25 was performed using a secondary ion mass spectrometer, and it was confirmed that oxygen atoms and nitrogen atoms were contained in the i-type layer.

The effects of the present invention have been evidenced from the above results.

### (Example 26)

A photovoltaic element (Element No. Example 26) was fabricated by forming a reflecting layer, a reflection multiplying layer, an n-type layer, an i-type layer, a p-type layer, a transparent electrode, and a collector electrode on the substrate under the same fabrication conditions as those of Element No. Example 21-5 in Example 21, except that using a bomb of Si₂H₆ gas, the flow rate of Si₂H₆ gas was 40 sccm and the flow rate of SiH₄ gas was regulated by a mass flow controller 1021 in accordance with a flow pattern as shown in Fig. 25A, in making the i-type layer by microwave plasma CVD.

For the photovoltaic element fabricated (Element No. Example 26), the initial characteristics, the low illuminance characteristic and the durability characteristic were measured in the same manner as in Example 21, and the initial characteristics, low illuminance characteristic and durability characteristic equivalent to those of Element No. Example 21-5 were obtained.

Also, the distribution in layer thickness direction of each of Si atom and hydrogen atom in the i-type layer of the photovoltaic element in the Example 26 (Element No. Example 26) was analyzed using a secondary ion mass spectrometer, resulting in the same tendency as indicated in Fig. 25B.

From the above results, the effects of the present invention have been evidenced.

### (Example 27)

A photovoltaic element (Element No. Example 27) was fabricated by forming a reflecting layer, a reflection multiplying layer, an n-type layer, an i-type layer, a p-type layer, a transparent electrode, and a collector electrode on the substrate under the same fabrication conditions as those of Element No. Example 21-5, except that the distance between the mixing point of SiH₄ gas and GeH₄ gas and the deposition chamber 1001 in the source gas supply unit 1020 was set as indicated in Table 23.

For the photovoltaic element fabricated (Element No. Example 27), the initial characteristics, the low illuminance characteristic and the durability characteristic were measured in the same manner as in the Example 21. The measurement results are listed in Table 23. As will be seen from Table 17, it has been found that by making the distance between the mixing point of SiH₄ gas and GeH₄ gas and the deposition chamber 1001 5 m or less, the photovoltaic element having further excellent characteristics can be obtained.

### (Example 28)

A photovoltaic element was fabricated under the same fabrication conditions as those of Element No. Example 21-5 of the Example 21, and using this photovoltaic element, a solar cell module was fabricated, whereby an analog clock with a circuit configuration as shown in Fig. 28 was made.

### (Comparative Example 8)

As a comparative example, a photovoltaic element was fabricated under the same fabrication conditions as those of Element No. Comparative Example 7-7, and using this photovoltaic element, the same analog clock as in Example 28 was made.

The analog clocks as fabricated in the Example 28 and the Comparative Example 8 were installed on the wall within room, and an indoor lamp was lighted for 8.5 hours a day. As a result, the analog clock of Example 28 worked for all the day, but the analog clock of comparative example did not work all the day, whereby the effects of the power generation system of the present invention could be evidenced.

### (Example 29)

A photovoltaic element (Element No. Example 29) was fabricated by forming a reflecting layer, a reflection multiplying layer, an n-type layer, an i-type layer, a p-type layer, a transparent electrode, and a collector electrode on the substrate under the same fabrication conditions as those of Element No. Example 21-5, except that the flow rates of SiH₄ gas and GeH₄ gas were regulated by mass flow controllers 1021, 1026 in accordance with the flow patterns as shown in Fig. 26 in making the i-type layer by microwave plasma CVD.

For the photovoltaic element fabricated (Element No. Example 29), the initial characteristics, the low illuminance characteristic and the durability characteristic were measured in the same manner as in the Example 21, and the initial characteristics, low illuminance characteristic and durability characteristic equivalent to those of Element No. Example 21-5 were obtained, whereby the effects of the present invention could be evidenced.

### (Example 30)

A photovoltaic element (Element No. Example 30) was fabricated by forming a reflecting layer, a transparent conductive layer, an n-type layer, an i-type layer, a p-type layer, a transparent electrode, and a collector electrode on the substrate under the same fabrication conditions as those of Element No. Example 21-5 in Example 21, except that using a bomb of B₂H₆(2000 ppm)/H₂ gas, instead of a bomb of BF₃ (2000 ppm)/H₂ gas, B₂H₆(2000 ppm)/H₂ gas for forming the i-type layer by RF plasma CVD was flowed by 0.5 sccm, in making the i-type layer by RF plasma CVD.

For the photovoltaic element fabricated (Element No. Example 30), the initial characteristics, the low illuminance characteristic and the durability characteristic were measured in the same manner as in the Example 21, and the initial characteristics, low illuminance characteristic and durability characteristic equivalent to those of Element No. Example 21-5 in the Example 21 were obtained, whereby the effects of the present invention could be evidenced.

### (Example 31)

A photovoltaic element (Element No. Example 31) was fabricated by forming a reflecting layer, a reflection multiplying layer, an n-type layer, an i-type layer, a p-type layer, a transparent electrode, and a collector electrode on the substrate under the same fabrication conditions as those of Element No. Example 21-5, except that the flow rate of NO/He gas was regulated by a mass flow controller 1029 in accordance with a flow pattern as shown in Fig. 33A, in making the i-type layer by microwave plasma CVD.

For the photovoltaic element fabricated (Element No. Example 31), the initial characteristics, the low illuminance characteristic and the durability characteristic were measured in the same manner as in the Example 21, and the initial characteristics, low illuminance characteristic and durability characteristic equivalent to those of Element No. Example 21-5 were obtained.

Also, the distribution in layer thickness direction of each of N atom and O atom in the i-type layer of the photovoltaic element in the Example 31 (Element No. Example 31) was analyzed using a secondary ion mass spectrometer, resulting in the same tendency as indicated in Fig. 33B.

From the above results, the effects of the present invention could be evidenced.

### (Example 32)

A photovoltaic element (Element No. Example 32) was fabricated by forming a reflecting layer, a reflection multiplying layer, an n-type layer, an i-type layer, a p-type layer, a transparent electrode, and a collector electrode on the substrate under the same fabrication conditions as those of Element No. Example 21-5, except that the flow rates of SiH₄ gas and GeH₄ gas were regulated by mass flow controllers 1021, 1026 in accordance with the flow patterns as shown in Fig. 34, in making the i-type layer by microwave plasma CVD.

For the photovoltaic element fabricated (Element No. Example 32), the initial characteristics, the low illuminance characteristic and the durability characteristic were measured in the same manner as in the Example 21, and the initial characteristics, low illuminance characteristic and durability characteristic equivalent to those of Element No. Example 21-5 were obtained, whereby the effects of the present invention could be evidenced.

### (Example 33)

A photovoltaic element (Element Nos. Example 33-1 to 33-5) was fabricated by forming a reflecting layer, a reflection multiplying layer, an n-type layer, an i-type layer, a p-type layer, a transparent electrode, and a collector electrode on the substrate under the same fabrication conditions as those of Element No. Example 21-5, except that the layer thickness of doping layer A was as indicated in Table 24, in making the p-type layer.

For the photovoltaic element fabricated (Element Nos. Example 33-1 to 33-5), the initial characteristics, the low illuminance characteristic and the durability characteristic were measured in the same manner as in the Example 21. Its results are listed in Table 24. As will be seen from Table 24, it has been found that the photovoltaic element (Element Nos. Example 33-1 to 33-4) having a layer thickness of the doping layer of 0.01 to 1 nm can exhibit more excellent characteristics, whereby the effects of the present invention have been evidenced.

### (Example 34)

A photovoltaic element (Element No. Example 34) was fabricated by forming a reflecting layer, a reflection multiplying layer, an n-type layer, an i-type layer, a p-type layer, a transparent electrode, and a collector electrode on the substrate under the same fabrication conditions as those of element No. Example 21-5, except that the doping layer A and the doping layer B were formed under the forming conditions as indicated in Table 25, in making the n-type layer.

For the photovoltaic element fabricated (Element No. Example 34), the initial characteristics, the low illuminance characteristic and the durability characteristic were measured in the same manner as in the Example 21, and the initial characteristics, low illuminance characteristic and durability characteristic equivalent to those of Element No. Example 21-5 were obtained, whereby the effects of the present invention could be evidenced.

### (Example 35)

A photovoltaic element (Element No. Example 35) was fabricated by forming a reflecting layer, a reflection multiplying layer, an n-type layer, an i-type layer, a p-type layer, a transparent electrode, and a collector electrode on the substrate under the same fabrication conditions as those of Element No. Example 21-5, except that the doping layer A and the doping layer B were formed under the forming conditions as indicated in Table 26, in making the p-type layer.

For the photovoltaic element fabricated (Element No. Example 35), the initial characteristics, the low illuminance characteristic and the durability characteristic were measured in the same manner as in the example 21, and the initial characteristics, low illuminance characteristic and durability characteristic equivalent to those of Element No. Example 21-5 were obtained, whereby the effects of the present invention could be evidenced.

### (Example 36)

A photovoltaic element (Element No. Example 36) was fabricated by forming a reflecting layer, a reflection multiplying layer, an n-type layer, an i-type layer, a p-type layer, a transparent electrode, and a collector electrode on the substrate under the same fabrication conditions as those of example 29, except that RF bias of the bias power source 1011 was set 250mW/cm³, and DC bias was set via a coil for RF cut at 50V for the application to the bias rod 1012, in making the i-type layer by microwave plasma CVD.

For the photovoltaic element fabricated (Element No. Example 36), the initial characteristics, the low illuminance characteristic and the durability characteristic were measured in the same manner as in the example 29, and the initial characteristics, low illuminance characteristic and durability characteristic equivalent to those of the example 29 were obtained, whereby the effects of the present invention could be evidenced.

### (Example 37)

A photovoltaic element (Element No. Example 37) was fabricated by forming a reflecting layer, a reflection multiplying layer, an n-type layer, an i-type layer, a p-type layer, a transparent electrode, and a collector electrode on the substrate under the same fabrication conditions as those of Element No. Example 21-5, except that using a bomb of D₂ gas, not shown, instead of H₂ gas bomb, D₂ gas was flowed by 300sccm, in making the i-type layer by microwave plasma CVD.

For the photovoltaic element fabricated (Element No. Example 37), the initial characteristics, the low illuminance characteristic and the durability characteristic were measured in the same manner as in the example 21, and the initial characteristics, low illuminance characteristic and durability characteristic equivalent to those of Element No. Example 21-5 were obtained.

Also, the composition analysis of the photovoltaic element in the example 37 (Element No. Example 37) was performed using a secondary ion mass spectrometer, and it was confirmed that D atoms were contained in the i-type layer, whereby the effects of the present invention could be evidenced.

### (Example 38)

A photovoltaic element (Element No. Example 38) was fabricated by forming a reflecting layer, a reflection multiplying layer, an n-type layer, an i-type layer, a p-type layer, a transparent electrode, and a collector electrode on the substrate under the same fabrication conditions as those of Element No. Example 21-5, except that the DC bias of bias power source 1011 was changed at a constant rate from 50V to 80V at the same time when the shutter 1013 was opened, in making the n-type layer.

For the photovoltaic element fabricated (Element No. Example 38), the initial characteristics, the low illuminance characteristic and the durability characteristic were measured in the same manner as in the example 21, and the initial characteristics, low illuminance characteristic and durability characteristic equivalent to those of Element No. Example 21-5 were obtained, whereby the effects of the present invention could be evidenced.

### (Example 39)

A photovoltaic element was fabricated under the same fabrication conditions as those of Element No. Example 21-5, except by making an n-type layer and a p-type layer using a deposition apparatus with the RF plasma CVD method as shown in Fig. 19.

To make the n-type layer, the substrate 1104 was heated to 350°C by the heater 1105, the outflow valves 1042, 1044, 1045 and the auxiliary valve 1108 were gradually opened to flow H₂ gas, PH₃(1%)/H₂ gas and Si₂H₆ gas through the gas introducing pipe 1103 into the deposition chamber 1101. The inflow rates of the gases were regulated by respective mass flow controllers 1022, 1024, 1025 so that the H₂ gas flow, the PH₃(1%)/H₂ gas flow and the Si₂H₆ gas flow were 50sccm, 5sccm and 3sccm, respectively. The pressure within the deposition chamber 1101 was set to 1Torr by adjusting the opening of conductance valve 1107 while referring to the vacuum gauge 1106.

Thereafter, the electric power of RF power source 1111 was set at 120mW/cm², an RF electric power was introduced through the RF matching box 1112 into the cathode 1102 to excite an RF glow discharge to start the formation of the n-type layer on the substrate 1104. Upon making the n-type layer having a layer thickness of 10nm, the RF flow discharge was stopped, and the outflow valves 1042, 1044, 1045 and the auxiliary valve 1108 were closed to stop the gas inflow into the deposition chamber 1101, whereby the formation of the n-type layer was completed.

Then, the substrate 1004 having the n-type layer made thereon was taken out from the deposition chamber 1101, and installed in the deposition apparatus 1000 with the microwave plasma CVD method as with Element No. Example 21-5, where an i-type layer by microwave plasma CVD was made on the n-type layer under the same fabrication conditions as those of Element No. Example 21-5 in the example 21.

Then, the substrate 1004 having the i-type layer made thereon was taken out from the deposition chamber 1000, and installed in the deposition apparatus 1100 with the RF plasma CVD method, as previously described, where an i-type layer by RF plasma CVD was made on the i-type layer by microwave plasma CVD under the same fabrication conditions as those of Element No. Example 21-5.

Subsequently, a p-type layer having a doping layer A and a doping layer B laminated was made on the i-type by RF plasma CVD.

To make a doping layer B1, the substrate 1104 was heated to 200°C by the heater 1105, the outflow valves 1041, 1042, 1047 and the auxiliary valve 1108 were gradually opened to flow SiH₄ gas, H₂ gas and BF₃(2000ppm)/H₂ gas, respectively, through the gas introducing tube 1103 into the deposition chamber 1101. The inflow rates of those gases were regulated by respective mass flow controllers 1021, 1022, 1027 so that the SiH₄ gas flow, the H₂ gas flow and BF₃(2000ppm)/H₂ gas flow were 0.03sccm, 100sccm and 1sccm, respectively. The pressure within the deposition chamber 1101 was set to 1.3 hPa (1Torr) by adjusting the opening of conductance valve 1107 while referring to the vacuum gauge 1106.

Thereafter, the electric power of RF power source 1111 was set at 2W/cm² an RF electric power was introduced through the RF matching box 1112 into the cathode 1102 to excite an RF glow discharge to start the formation of the doping layer B1 on the i-type layer by RF plasma CVD. Upon making the doping layer B1 having a layer thickness of 0.3nm, the RF glow discharge was stopped, and the outflow valves 1041, 1042, 1047 and the auxiliary valve 1108 were closed to stop the gas inflow into the deposition chamber 1101.

Then, to make the doping layer A, the substrate 1104 was heated to 200°C by the heater 1105, the outflow valve 1043 and the auxiliary valve 1108 were gradually opened to flow B₂H₆(10%)/H₂ gas through the gas introducing tube 1103 into the deposition chamber 1101. The inflow rate of the gas was regulated by a mass flow controller 1023 so that the B₂H₆(10%)/H₂ gas flow was 50sccm. The pressure within the deposition chamber 1101 was set to 1.3 hPa (1 Torr) by adjusting the opening of conductance valve 1107 while referring to the vacuum gauge 1106.

Thereafter, the electric power of RF power source 1111 was set at 3W/cm², an RF electric power was introduced through the RF matching box 1112 into the cathode 1102 to excite an RF glow discharge to start the formation of the doping layer A on the doping layer B1. Upon making the doping layer A having a layer thickness of 0.1nm, the RF glow discharge was stopped, and the outflow valve 1048 and the auxiliary valve 1108 were closed to stop the gas inflow into the deposition chamber 1101.

Next, a doping layer B2 was formed on the doping layer A under the same fabrication conditions as those of the doping layer B1, except that the SiH₄ gas flow and the BF₃/H₂ gas flow were 0.5sccm and 10sccm, respectively, and the layer thickness was 5nm.

Next, a transparent electrode and a collector electrode were vapor deposited on the p-type layer, whereby a photovoltaic element (Cell No. Example 39) was fabricated. The fabrication conditions for the photovoltaic element as described above are listed in Table 27.

### (Comparative Example 9)

A comparative example, a photovoltaic element (Element No. Comparative Example 9) was fabricated by forming a reflecting layer, a reflection multiplying layer, an n-type layer, an i-type layer, a p-type layer, a transparent electrode, and a collector electrode on the substrate under the same fabrication conditions as those of example 39, except that the i-type layer by RF plasma CVD was not made.

For the photovoltaic element fabricated (Element Nos. Example 39 and Comparative Example 9), the initial characteristics, the low illuminance characteristic and the durability characteristic were measured in the same manner as in the example 21. From the measurements, it has been evidenced that the photovoltaic element of Element No. Example 39 was superior to that of Element No. Comparative Example 9, in that the open-citcuit voltage and the curve factor of the initial characteristics, the photoelectric conversion efficiency of the low illuminance characteristic, and the decrease in the photoelectric conversion efficiency of the durability characteristic were 1.03 times, 1.04 times, 1.09 times and 1.07 times more excellent, respectively, whereby the effects of the present invention have been evidenced.

### (Example 40)

A photovoltaic element (Element No. Example 40) was fabricated by forming a reflecting layer, a reflection multiplying layer, a first n-type layer, a first i-type layer, a first p-type layer, a second n-type layer, a second i-type layer, a second p-type layer, a transparent electrode, and a collector electrode on the substrate under the same fabrication conditions as listed in Table 28, with the same method as in the example 21.

### (Comparative Example 10)

A photovoltaic element (Element No. Comparative Example 10) was fabricated by forming a reflecting layer, a reflection multiplying layer, a first n-type layer, a first i-type layer, a first p-type layer, a second n-type layer, a second i-type layer, a second p-type layer, a transparent electrode, and a collector electrode on the substrate under the same fabrication conditions as in example 40, except that the first i-type layer by RF plasma CVD was not made.

For the photovoltaic element fabricated (Element Nos. Example 40 and Comparative Example 10), the initial characteristics, the low illuminance characteristic and the durability characteristic were measured in the same manner as in the example 21. From the measurements, it has been evidenced that the photovoltaic element of Element No. Example 40 was superior to that of Element No. Comparative Example 10, in that the open-circuit voltage and the curve factor of the initial characteristics, the photoelectric conversion efficiency of the low illuminance characteristic, and the decrease in the photoelectric conversion efficiency of the durability characteristic were 1.03 times, 1.03 times, 1.07 times and 1.06 times more excellent, respectively, whereby the effects of the present invention have been evidenced.

### (Example 41)

A photovoltaic element (Element No. Example 41) was fabricated by forming a reflecting layer, a reflection multiplying layer, a first n-type layer, a first i-type layer, a first p-type layer, a second n-type layer, a second i-type layer, a second p-type layer, a third n-type layer, a third i-type layer, a third p-type layer, a transparent electrode, and a collector electrode on the substrate under the same fabrication conditions as listed in Table 29, with the same method as in the example 21.

### (Comparative Example 11)

A photovoltaic element was fabricated (Element No. Comparative Example 11) by forming a reflecting layer, a reflection multiplying layer, a first n-type layer, a first i-type layer, a first p-type layer, a second n-type layer, a second i-type layer, a second p-type layer, a third n-type layer, a third i-type layer, a third p-type layer, a transparent electrode, and a collector electrode on the substrate under the same fabrication conditions as in example 41, except that the first and second i-type layers by RF plasma CVD were not made.

For the photovoltaic element fabricated (Element No. Example 41 and Comparative Example 11), the initial characteristics, the low illuminance characteristic and the durability characteristic were measured in the same manner as in the example 21. From the measurements, it has been evidenced that the photovoltaic element of Element No. Example 41 was superior to that of Element No. Comparative Example 11, in that the open-circuit voltage and the curve factor of the initial characteristics, the photoelectric conversion efficiency of the low illuminance characteristic, and the decrease in the photoelectric conversion efficiency of the durability characteristic were 1.03 times, 1.03 times, 1.08 times and 1.07 times more excellent, respectively, whereby the effects of the present invention have been evidenced.

### (Example 42)

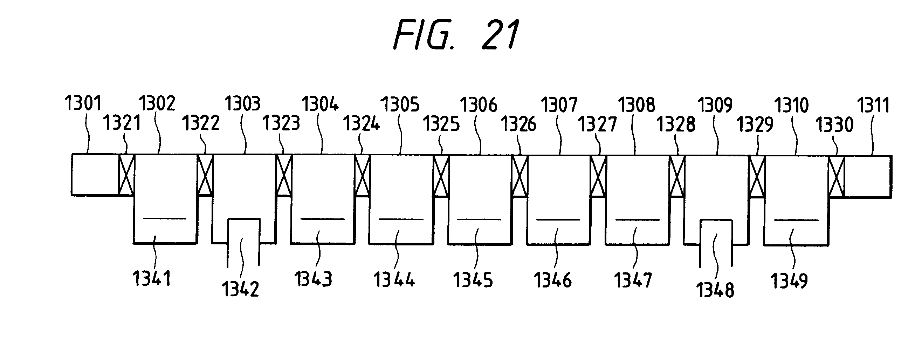

Using a multiple chamber separation-type deposition apparatus as shown in Fig. 21, a photovoltaic element of the present invention was fabricated. In the figure, 1301 and 1311 are a load chamber and an unload chamber, respectively, 1302, 1304 to 1308 and 1310 are deposition chambers for the layers by RF plasma CVD as in the example 39, 1303 and 1309 are deposition chambers for the layers by microwave plasma CVD as in the example 21, 1321 to 1330 are gate valves for separating one chamber from the other, 1341, 1343 to 1347 and 1349 are cathode electrodes, and 1342 and 1348 are a waveguide portion for microwave and a dielectric window, respectively.

First, the substrate was installed in the load chamber 1301, and the load chamber 1301 was evacuated of air. Thereafter, a gate valve 1321 was opened, the substrate was then moved to a first n-type layer deposition chamber 1302, and the gate valve 1321 was closed. Next, the first n-type layer was made on the substrate under the same conditions as those of the first n-type-layer of example 40. Then, a gate valve 1322 was opened, the substrate was then moved to a first i-type layer deposition chamber 1303 by microwave plasma CVD, and the gate valve 1322 was closed. Next, a first i-type layer by microwave plasma CVD was made on the first n-type layer under the same conditions as those of the first i-type layer by microwave plasma CVD of example 40. Next, a gate valve 1323 was opened, the substrate was then moved to a first i-type layer deposition chamber 1304 by RF plasma CVD, and the gate valve 1323 was closed. Next, a first i-type layer by RF plasma CVD was made on the first n-type layer under the same conditions as those of the first i-type layer by RF plasma CVD of example 40.

A gate valve 1324 was opened, the substrate was then moved to a first p-type layer/doping layer B1 deposition chamber 1305, and the gate valve 1324 was closed. Next, a first p-type layer/doping layer B1 was made on the first i-type layer by RF plasma CVD under the same conditions as those of the first p-type layer/doping layer B1 of example 40. Then, a gate valve 1325 was opened, the substrate was then moved to a first p-type layer/doping layer A deposition chamber 1306, and the gate valve 1325 was closed. Next, a first p-type layer/doping layer A was made on the first p-type layer/doping layer B1 under the same conditions as those of the first p-type layer/doping layer A of example 40. Next, a gate valve 1326 was opened, the substrate was then moved to a first p-type layer/doping layer B2 deposition chamber 1307, and the gate valve 1326 was closed. Next, a first p-type layer/doping layer B2 was made on the first p-type layer/doping layer A under the same conditions as those of the first p-type layer/doping layer B2 of example 40. Next, a gate valve 1327 was opened, the substrate was then moved to a second n-type layer deposition chamber 1308, and the gate valve 1327 was closed. Next, a second n-type layer was made on the first p-type layer/doping layer B2 under the same conditions as those of the second n-type layer of example 40. Then, a gate valve 1328 was opened, the substrate was then moved to the second i-type layer deposition chamber 1309, and the gate valve 1328 was closed. Next, a second i-type layer was made on the second n-type layer under the same conditions as those of the second i-type layer of example 40. Then, a gate valve 1329 was opened, the substrate was then moved to the second p-type layer deposition chamber 1310, and the gate valve 1329 was closed. Next, a second p-type layer was made on the second i-type layer under the same conditions as those of the second p-type layer of example 40. Then, a gate valve 1330 was opened, the substrate was then moved to an unload chamber 1311, and the gate valve 1330 was closed. Then, the substrate was taken out from the unload chamber 1311, whereby the fabrication of a photovoltaic element was completed (Element No. Example 42).

For the photovoltaic element fabricated (Element No. Example 42), the initial characteristics, the low illuminance characteristic and the durability characteristic were measured in the same manner as in the example 21. From the measurements, it has been found that the photovoltaic element of example 42 (Element No. Example 42) was superior to that of example 40 (Element No. Example 40), in that the open-circuit voltage and the curve factor of the initial characteristics, the photoelectric conversion efficiency of the low illuminance characteristic, and the decrease in the photoelectric conversion efficiency of the durability characteristic were 1.01 times, 1.02 times, 1.02 times and 1.02 times more excellent, respectively, whereby a photovoltaic element of the present invention can exhibit more excellent characteristics by fabricating it in the multiple chamber separation-type deposition chamber. Thus, the effects of the present invention have been evidenced.

### (Example 43)

A photovoltaic element was fabricated under the same fabrication conditions as those of the example 40, whereby a solar cell module was created using the photovoltaic element, and a car-mounted ventilation fan having a circuit configuration as shown in Fig. 28 was fabricated.

### (Comparative Example 11)

As a comparative example, a photovoltaic element was fabricated under the same fabrication conditions as those of comparative example 10, and a car-mounted ventilation fan similar to that of the example 41 was made using the photovoltaic element.

A car which has mounted the car-mounted ventilation fans as fabricated in example 41 and comparative example 11 was left away in an idling state with the engine rotating for 168 hours, and then left away in fine weather with the ventilation fan working and with the engine stopped, whereafter the temperature within the car was measured. As a result, the car-mounted cooling fan of example 43 achieved a room temperature three degrees lower than the car-mounted cooling fan of comparative example, whereby the effects of the power generation system of the present invention were evidenced.

### (Example 44)

Using a manufacturing apparatus with the microwave plasma CVD method comprising a source gas supply unit 1020 and a deposition unit 1000 as shown in Fig. 18 and a manufacturing apparatus with the RF plasma CVD method comprising a source gas supply unit 1020 and a deposition unit 1100 as shown in Fig. 19, a photovoltaic element of the present invention was fabricated. In this example, B and P atoms were doped into the i-type layer by microwave plasma CVD.

On the substrate, reflecting layer, a reflection multiplying layer, and an n-type layer were formed under the same fabrication conditions as those of Element No. Example 1-5 of the example 1, and subsequently, the formation of i-type layers by microwave plasma CVD and RF plasma CVD was performed in the following manner.

To make an i-type layer by microwave plasma CVD, the substrate 1004 was heated to 350°C by the heater 1005, the outflow valves 1041, 1042, 1046 to 1048 and the auxiliary valve 1008 were gradually opened to flow SiH₄ gas, H₂ gas, GeH₄ gas, BF₃(2000ppm)/H₂ gas and PH₃(2000ppm)/H₂ gas through a gas introducing pipe 1003 into the deposition chamber 1001. The inflow rates of the gases were regulated by respective mass flow controllers 1021, 1022, 1026 to 1028 so that the SiH₄ gas flow, the H₂ gas flow, the GeH₄ gas flow, the BF₃(2000ppm)/H₂ gas flow and the PH₃(2000ppm)/H₂ gas flow were 200sccm, 500sccm, 1sccm, 0.2sccm and 0.1sccm, respectively. The pressure within the deposition chamber 1001 was set to the value as indicated in Table 30 by adjusting the opening of conductance valve 1007 while referring to the vacuum gauge 1006.

Thereafter, shutter 1013 was closed, the electric power of a microwave power source, not shown, was set at 170mW/cm³, and a microwave electric power was introduced through a waveguide, not shown, the waveguide portion 1010 and the dielectric window 1002 into the deposition chamber 1001 to excite a microwave glow discharge. Then, the RF bias of bias power source 1011 was set at 350mW/cm³, and the DC bias was set via a coil for the RF cut at 0V, and applied to the bias rod 1012. Thereafter, the shutter 1013 was opened to start fabrication of an i-type layer by microwave plasma CVD on the n-type layer, while at the same time regulating the SiH₄ gas flow and the GeH₄ gas flow in accordance with the flow patterns as indicated in Fig. 23A, by means of the mass flow controllers 1021, 1026, respectively. Upon making the i-type layer having a layer thickness of 300nm, the shutter 1013 was closed, the output of bias power source 1011 was turned off, the microwave glow discharge was stopped, and the outflow valves 1041, 1042, 1046 and the auxiliary valve 1008 were closed to stop the gas inflow into the deposition chamber 1001.

Then, the substrate 1004 was taken out from the deposition chamber 1001, and installed in the deposition chamber 1101 of the deposition unit 1100 with the RF plasma CVD method as shown in Fig. 19, where an i-type layer by RF plasma CVD was fabricated.

To make an i-type layer by RF plasma CVD, the substrate 1104 was heated to 300°C by the heater 1105, the outflow valves 1041, 1042, 1047, 1048 and the auxiliary valve 1008 were gradually opened to flow SiH₄ gas, H₂ gas, BF₃(2000ppm)/H₂ gas, and PH₃(2000ppm)/H₂ gas respectively through the gas introducing tube 1003 into the deposition chamber 1001. The inflow rates of the gases were regulated by respective mass flow controllers 1021, 1022, 1027, 1028 so that SiH₄ gas flow, H₂ gas flow, the BF₃(2000ppm)/H₂ gas, and PH₃(2000ppm)/H₂ gas flow were 8sccm, 100sccm, 0.4sccm and 0.02sccm, respectively. The pressure within the deposition chamber 1101 was set to 0.67 hPa (0.5Torr) by adjusting the opening of conductance valve 1007 while referring to the vacuum gauge 1006.

Thereafter, the electric power of an RF power source 1111 was set at 120mW/cm³, and an RF electric power was introduced through the RF matching box 1112 into the cathode 1102 to excite an RF glow discharge to start fabrication of an i-type layer by RF plasma CVD on the i-type layer by microwave plasma CVD. Upon making the i-type layer having a layer thickness of 10nm, the RF glow discharge was stopped, and the outflow valves 1041, 1042 and the auxiliary valve 1008 were closed to stop the gas inflow into the deposition chamber 1001, whereby the formation of the i-type layer was completed.

Then, the substrate 1004 was taken out from the deposition chamber 1001, and installed in the deposition chamber 1001 of the deposition unit 1000 with the microwave plasma CVD method as shown in Fig. 18, where a p-type layer was formed under the same conditions as in example 1.

Further, on the p-type layer, a 70µm-thick ITO (In₂O₃+SnO₂) thin film as the tarnsparent electrode and a 2µm-thick aluminum (Al) thin film as the collector electrode were vapor deposited in vacuum to fabricate a photovoltaic element (Element Nos. Example 44-1 to 44-7, Comparative Example 12-1).

The initial characteristics, low illuminance characteristic and durability characteristic were measured for the fabricated photovoltaic element (Element Nos. Example 1-1 to 1-7 and Comparative Example 1-1). The results are listed in Table 30.

As will be seen from Table 30, the photovoltaic element having excellent characteristics can be fabricated by making the i-type layer by microwave plasma CVD under the pressure of the deposition chamber 1001 being 6.7 Pa (50mTorr) or less.

Next, using a substrate of barium borosilicate glass (7059 manufactured by Corning), an i-type layer by microwave plasma CVD was made on the substrate by opening the shutter 1013 for two minutes under the same fabrication conditions as the i-type layer by microwave plasma CVD in Element No. Example 44-5, except that SiH₄ gas flow and GeH₄ gas flow and the microwave electric power were as indicated in Table 3, whereby the decomposition efficiency of the source gas was obtained in accordance with the layer thickness, and the same results of Table 3 were attained.

Then, a photovoltaic element (Element Nos. Example 44-8 to 44-10 and Comparative Example 12-2 to 12-3) was fabricated by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 44-5, except that the electric power of microwave electric power was as indicated in Table 31, in making the i-type layer by microwave plasma CVD.

For the fabricated photovoltaic element (Element Nos. Example 44-8 to 44-10 and Comparative Example 12-2 to 12-3), the initial characteristics, the low illuminance characteristic and the durability characteristic were measured in the same manner as in Element No. Example 44-5. The results of measurement are listed in Table 31.

As will be seen from Table 31, it has been found that a photovoltaic element having excellent characteristics can be obtained by decomposing the source gas with a lower microwave energy than the microwave energy necessary to decompose the source gas at 100%.

Then, photovoltaic elements (Element Nos. Example 44-11 to 44-14 and Comparative Example 12-4) were fabricated by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 44-5, except that the RF bias was as indicated in Table 32 in making the i-type layer by microwave plasma CVD.

For the fabricated photovoltaic elements (Element Nos. Example 44-11 to 44-14 and Comparative Example 12-4), the initial characteristics, the low illuminance characteristic and the durability characteristic were measured in the same manner as in Element No. Example 44-5. The results of measurement are listed in Table 32. As will be seen from Table 32, it has been found that a photovoltaic element having excellent characteristics can be obtained by applying a higher RF energy to the source gas than the microwave energy.

Next, using a stainless substrate and a barium borosilicate glass (7059 manufactured by Corning) substrate, an i-type layer was made 1µm thick on the substrate under the same fabrication conditions as the i-type layer by microwave plasma CVD in Element No. Example 44-5, except that SiH₄ gas flow and GeH₄ gas flow were as indicated in Table 6, whereby a sample for the measurement of material was fabricated. Further, using a barium borosilicate glass (7059 manufactured by Corning) substrate, an i-type layer was made 1µm thick on the substrate under the same fabrication conditions as the i-type layer by RF plasma CVD in Element No. Example 44-5, whereby a sample for the measurement of material was fabricated.

The bandgap and the composition of the fabricated sample for the measurement of material were conducted to obtain the relaiton between the composition ratio of Si atom to Ge atom and the bandgap, and the same results as Table 6 were obtained.

Then, a photovoltaic element was fabricated (Element No. Comparative Example 12-5) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 44-5, except that SiH₄ gas flow and GeH₄ gas flow were regulated by the mass flow controllers 1021, 1026 in accordance with the flow patterns as shown in Fig. 23B in making the i-type layer by microwave plasma CVD.

For the fabricated photovoltaic element (Element No. Comparative Example 12-5), the initial characteristics, the low illuminance characteristic and the durability characteristic were measured in the same manner as in Element No. Example 44-5. The results of measurement indicated that the open-circuit voltage and the curve factor in the initial characteristics, the low illuminance characteristic and the durability characteristic in Element No. Example 44-5 were 1.03 times, 1.03 times, 1.08 times and 1.06 times better than those in Element No. Comparative Example 12-5, respectively.

Further, the composition analysis in layer thickness direction of Si atoms and Ge atoms in the i-type layer by microwave plasma CVD in Element No. Example 44-5 and Element No. Comparative Example 12-5 was performed in the same manner as the previous composition analysis. It could be found that the photovoltaic element in Element No. Example 44-5 has the minimum value of bandgap at a position biased toward the interface between the p-type layer and the i-type layer off the central position of the i-type layer, while the photovoltaic element in Element No. Comparative Example 12-5 has the minimum value of bandgap at a position biased toward the interface between the n-type layer and the i-type layer off the central position of the i-type layer.

For the comparison, a photovoltaic element was fabricated (Element No. Example 44-15) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 44-5, except that BF₃(2000ppm)/H₂ gas and PH₃(2000ppm)/H₂ gas were not flowed in making the i-type layer by microwave plasma CVD.

For the fabricated photovoltaic element (Element No. Example 44-15), the initial characteristics, the low illuminance characteristic and the durability characteristic were measured in the same manner as in Element No. Example 44-5. From the measurement results, it could be found that the photovoltaic element of Element No. Example 44-5 was superior to that of Element No. Example 44-15, in that the open-circuit voltage and the curve factor of the initial characteristics, the low illuminance characteristic and the durability characteristic were 1.03 times, 1.02 times, 1.07 times and 1.07 times better.

The composition analysis of the photovoltaic element of Element No. Example 44-5 was performed using a secondary ion mass spectrometer, and it was confirmed that B atoms and P atoms were contained in the i-type layer.

Then, photovoltaic elements were fabricated (Element Nos. Example 44-16 to 44-20 and Comparative Example 12-6) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 44-5, except that the SiH₄ gas flow and the RF discharge electric power were as indicated in Table 33 in making the i-type layer by RF plasma CVD.

For the fabricated photovoltaic elements (Element Nos. Example 44-16 to 44-20 and Comparative Example 12-6), the initial characteristics, the low illuminance characteristic and the durability characteristic were measured in the same manner as in Element No. Example 44-5. The results of measurement are listed in Table 33.

As will be seen from Table 33, it has been found that the photovoltaic element having excellent characteristics can be fabricated by making the i-type layer by RF plasma CVD at a deposition rate of 2nm/sec or less.

Then, photovoltaic elements were fabricated (Element Nos. Example 44-21 to 44-23 and Comparative Example 12-7 to 12-8) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 44-5, except that the layer thickness of i-type layer was as indicated in Table 34 in making the i-type layer by RF plasma CVD.

For the fabricated photovoltaic elements (Element Nos. Example 44-21 to 44-23 and Comparative Example 12-7 to 12-8), the initial characteristics, the low illuminance characteristic and the durability characteristic were measured in the same manner as in Element No. Example 44-5. The results of measurement are listed in Table 34. As will be seen from Table 34, it has been found that the photovoltaic element (Element Nos. Example 44-21 to 44-23) provided with the i-type layer by RF plasma CVD having a layer thickness of 30nm or less have excellent characteristics.

Then, photovoltaic elements were fabricated (Element Nos. Example 44-24 to 44-27) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 44-5, except that RF discharge electric power was as indicated in Table 35 in making the i-type layer by RF plasma CVD.

For the fabricated photovoltaic elements (Element Nos. Example 44-24 to 44-27), the initial characteristics, the low illuminance characteristic and the durability characteristic were measured in the same manner as in Element No. Example 44-5. The results of measurement are listed in Table 35. As will be seen from Table 35, it has been found that the photovoltaic element having a greater value of half-width at a peak of 2000cm⁻¹ in the infrared absorption spectrum divided by the height of peak in the i-type layer by RF plasma CVD than in the i-type layer by microwave plasma CVD has the more excellent characteristics.

From the above measurement results, it has been found that the photovoltaic elements of the present invention have more excellent characteristics as compared with the conventional photovoltaic elements, wherein the photovoltaic elements of the present invention have been accomplished in that an i-type layer by microwave plasma CVD is formed at an internal pressure of 50mTorr or less by applying a lower microwave energy and a higher RF energy than the microwave energy necessary to decompose the source gas at 100% to the source gas, and an i-type layer by RF plasma CVD is deposited 30nm thick or less at a deposition rate of 2nm/sec or less, in such a manner that the bandgap smoothly changes in a direction of layer thickness, and the minimum value of bandgap takes place at a position biased toward the interface between the p-type layer and the i-type layer off the central position of the i-type layer, and wherein a valence electron control agent serving as the donor and the acceptor is doped in the i-type layer. Thus, the effects of the present invention have been evidenced.

### (Example 45)

Photovoltaic elements (Element Nos. Example 45-1 to 45-8) were fabricated in such a manner as to form a reflecting layer, a transparent conductive layer, an n-type layer, an i-type layer, a p-type layer, a transparent electrode, and a collector electrode on the substrate under the same fabrication conditions as those of element No. Example 44-5 in the example 44, except that after SiH₄ gas flow and GeH₄ gas flow were regulated by respective mass flow controllers 1021, 1026 in accordance with the flow patterns as shown in Fig. 23A, as conducted in the example 1, SiH₄ gas flow was maintained at 200sccm and GeH₄ at 1sccm, and the region of the maximum bandgap was made to have a layer thickness as indicated in Table 36, in making the i-type layer by microwave plasma CVD.

For the fabricated photovoltaic elements (Element Nos. Example 45-1 to 45-8), the initial characteristics, the low illuminance characteristic and the durability characteristic were measured in the same manner as in example 44. The results of measurement are listed in Table 36. As will be seen from Table 36, it has been found that the photovoltaic elements (Element Nos. Example 45-1 to 45-7) having a layer thickness of 1 to 30nm in the region of the maximum bankgap according to the present invention can exhibit more excellent characteristics, whereby the effects of the present invention have been evidenced.

### (Example 46)

A photovoltaic element (Element No. Example 46) was fabricated by forming a reflecting layer, a transparent conductive layer, an n-type layer, an i-type layer, a p-type layer, a transparent electrode, and a collector electrode on the substrate under the same fabrication conditions as those of Element No. Example 44-5 in example 44, except that using a bomb of AsH₃/H₂ gas instead of a bomb of PH₃(2000ppm)/H₂ gas, AsH₃/H₂ gas was flowed by 0.5sccm for the i-type layer by microwave plasma CVD, and by 0.1sccm for the i-type layer by RF plasma CVD, in making the i-type layer by RF plasma CVD.

For the photovoltaic element fabricated in example 46 (Element No. Example 46), the initial characteristics, the low illuminance characteristic and the durability characteristic were measured in the same manner as in the example 44, and the initial characteristics, low illuminance characteristic and durability characteristic equivalent to those of Element No. Example 44-5 were obtained.

### (Example 47)

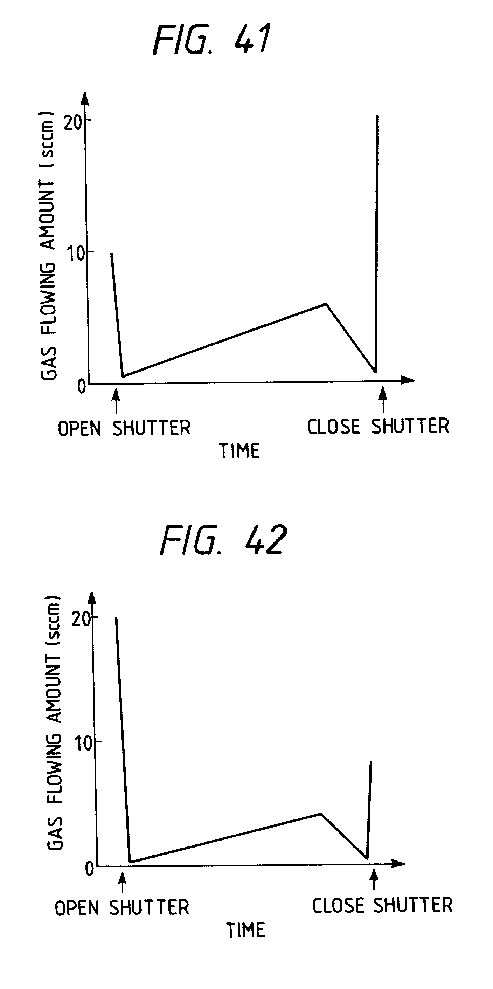

A photovoltaic element (Element No. Example 47) was fabricated by forming a reflecting layer, a transparent conductive layer, an n-type layer, an i-type layer, a p-type layer, a transparent electrode, and a collector electrode on the substrate under the same fabrication conditions as those of Element No. Example 44-5 in example 44, except that BF₃(2000ppm)/H₂ gas flow and PH₃(2000ppm)/H₂ gas flow were regulated in accordance with a flow pattern as shown in Fig. 41 and a flow pattern as shown in Fig. 42 by the mass flow controllers 1027, 1028, respectively, in making the i-type layer by microwave plasma CVD, and BF₃(2000ppm)/H₂ gas flow and PH₃(2000ppm)/H₂ gas flow were flowed by 1sccm and 0.3sccm, in making the i-type layer by RF plasma CVD.

For the photovoltaic element (Element No. Example 47) fabricated in example 47, the initial characteristics, the low illuminance characteristic and the durability characteristic were measured in the same manner as in the example 44, and the initial characteristics, low illuminance characteristic and durability characteristic equivalent to those of Element No. Example 44-5 were obtained.

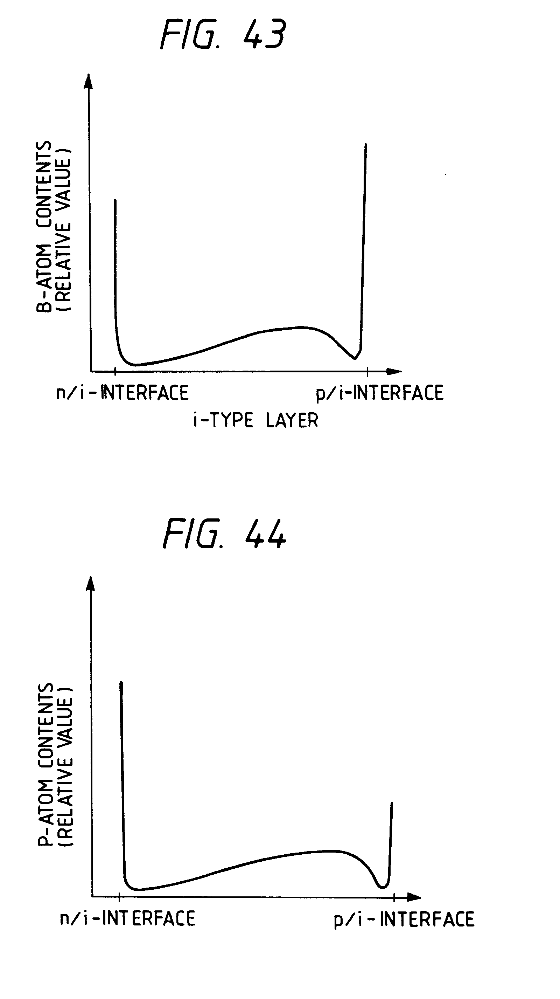

Also, the distribution of B and P atoms in the i-type layer of the photovoltaic element of example 47 (Element No. Example 47) was analyzed using a secondary ion mass spectrometer. The results are shown in Figs. 43 and 44. From the above results, the effects of the present invention could be evidenced.

### (Example 48)

A photovoltaic element (Element No. Example 48) was fabricated by forming a reflecting layer, a transparent conductive layer, an n-type layer, an i-type layer, a p-type layer, a transparent electrode, and a collector electrode on the substrate under the same fabrication conditions as those of element No. Example 44-5 in the example 44, except that using a bomb of NO/He gas 1079, the flow rate of NO/He gas was 0.5sccm for the i-type layer by microwave plasma CVD and 0.05sccm for the i-type layer by RF plasma CVD, in making the i-type layer by microwave plasma CVD and the i-type layer by RF plasma CVD.

For the photovoltaic element fabricated (Element No. Example 48), the initial characteristics, the low illuminance characteristic and the durability characteristic were measured in the same manner as in the example 44, and the initial characteristics, low illuminance characteristic and durability characteristic equivalent to those of Element No. Example 44-5 were obtained.

Also, the composition analysis for the photovoltaic element of the example 48 was performed using a secondary ion mass spectrometer, and O and N atoms were confirmed in the i-type layer.

### (Example 49)

A photovoltaic element (Element No. Example 49) was fabricated by forming a reflecting layer, a transparent conductive layer, an n-type layer, an i-type layer, a p-type layer, a transparent electrode, and a collector electrode on the substrate under the same fabrication conditions as those of Element No. Example 44-5 in example 44, except that using a bomb of Si₂H₆ gas, the flow rate of Si₂H₆ gas was 40sccm and the flow rate of SiH₄ gas was regulated by a mass flow controller 1021 in accordance with a flow pattern as shown in Fig. 25A, in making the i-type layer by microwave plasma CVD.

For the photovoltaic element fabricated (Element No. Example 49), the initial characteristics, the low illuminance characteristic and the durability characteristic were measured in the same manner as in the example 44, and the initial characteristics, low illuminance characteristic and durability characteristic equivalent to those of Element No. Example 44-5 were obtained.

Also, the distribution in layer thickness direction of each of Si atom and hydrogen atom in the i-type layer of the photovoltaic element in the example 49 (Element No. Example 49) was analyzed using a secondary ion mass spectrometer (IMS-3F manufacured by CAMECA), resulting in the same tendency as indicated in Fig. 25B.

From the above results, it has been found that the photovoltaic element in which the content of hydrogen atom changes in correspondence with the content of Si atom, whereby the effects of the present invention have been evidenced.

### (Example 50)

A photovoltaic element (Element No. Example 50) was fabricated by forming a reflecting layer, a transparent conductive layer, an n-type layer, an i-type layer, a p-type layer, a transparent electrode, and a collector electrode on the substrate under the same fabrication conditions as those of Element No. Example 44-5, except that the distance between the mixing point of SiH₄ gas and GeH₄ gas and the deposition chamber 1001 in the source gas supply unit 1020 was set to the value as indicated in Table 37.

For the photovoltaic element fabricated (Element No. Example 50), the initial characteristics, the low illuminance characteristic and the durability characteristic were measured in the same manner as in the example 44. The measurement results are listed in Table 37. As will be seen from Table 37, it has been found that by making the distance between the mixing point of SiH₄ gas and GeH₄ gas and the deposition chamber 1001 equal to or less than 5m, the photovoltaic element having further excellent characteristics can be obtained.

### (Example 51)

A photovoltaic element was fabricated under the same fabrication conditions as those of Element No. Example 44-5 of the example 44, whereby a solar cell module was fabricated using this photovoltaic element, and an analog clock with a circuit configuration as shown in Fig. 28 was made.

### (Comparative Example 13)

As a comparative example, a photovoltaic element was fabricated under the same fabrication conditions as those of element No. Comparative Example 12-6, and using this photovoltaic element, the same analog clock as in example 51 was made.

The analog clocks as fabricated in the example 51 and the comparative example 13 were installed on the wall within room, and an indoor lamp was lighted for 8.5 hours a day. As a result, the analog clock of example 51 worked for all the day, but the analog clock of comparative example 13 did not work all the day, whereby the effects of the power generation system of the present invention could be evidenced.

### (Example 52)

A photovoltaic element (Element No. Example 52) was fabricated by forming a reflecting layer, a reflection multiplying layer, an n-type layer, an i-type layer, a p-type layer, a transparent electrode, and a collector electrode on the substrate under the same fabrication conditions as those of Element No. Example 44-5 in the example 44, except that the flow rates of SiH₄ gas and GeH₄ gas were regulated by mass flow controllers 1021, 1026 in accordance with the flow patterns as shown in Fig. 35 in making the i-type layer by microwave plasma CVD.

For the photovoltaic element fabricated (Element No. Example 52), the initial characteristics, the low illuminance characteristic and the durability characteristic were measured in the same manner as in the example 44, and the initial characteristics, low illuminance characteristic and durability characteristic equivalent to those of Element No. Example 44-5 in the example 44 were obtained, whereby the effects of the present invention could be evidenced.

### (Example 53)

A photovoltaic element (Element No. Example 53) was fabricated by forming a reflecting layer, a transparent conductive layer, an n-type layer, an i-type layer, a p-type layer, a transparent electrode, and a collector electrode on the substrate under the same fabrication conditions as those of Element No. Example 44-5 in example 44, except that using a bomb of B₂H₆(2000ppm)/H₂ gas, instead of a bomb of BF₃(2000ppm)/H₂ gas, B₂H₆(2000ppm)/H₂ gas was flowed by 1sccm for forming the i-type layer by microwave plasma CVD, and B₂H₆(2000ppm)/H₂ gas was flowed by 0.5sccm for forming the i-type layer by RF plasma CVD, in making the i-type layers by microwave plasma CVD and RF plasma CVD.

For the photovoltaic element fabricated (Element No. Example 53), the initial characteristics, the low illuminance characteristic and the durability characteristic were measured in the same manner as in the example 44, and the initial characteristics, low illuminance characteristic and durability characteristic equivalent to those of Element No. Example 44-5 in the example 44 were obtained, whereby the effects of the present invention could be evidenced.

### (Example 54)

A photovoltaic element (Element No. Example 54) was fabricated by forming a reflecting layer, a transparent conductive layer, an n-type layer, an i-type layer, a p-type layer, a transparent electrode, and a collector electrode on the substrate under the same fabrication conditions as those of Element No. Example 44-5 in the example 44, except that the flow rate of NO/He gas was regulated by a mass flow controller 1029 in accordance with a flow pattern as shown in Fig. 33A, in making the i-type layer by microwave plasma CVD.

For the photovoltaic element fabricated (Element No. Example 54), the initial characteristics, the low illuminance characteristic and the durability characteristic were measured in the same manner as in the example 44, and the initial characteristics, low illuminance characteristic and durability characteristic equivalent to those of element No. Example 44-5 in the example 44 were obtained.

Also, the distribution in layer thickness direction of each of N atom and O atom in the i-type layer of the photovoltaic element in the example 54 (Element No. Example 54) was analyzed using a secondary ion mass spectrometer, resulting in the same tendency as indicated in Fig. 33B.

From the above results, the effects of the present invention could be evidenced.

### (Example 55)

A photovoltaic element (Element No. Example 55) was fabricated by forming a reflecting layer, a transparent conductive layer, an n-type layer, an i-type layer, a p-type layer, a transparent electrode, and a collector electrode on the substrate under the same fabrication conditions as those of Element No. Example 44-5 in the example 44, except that the flow rates of SiH₄ gas and GeH₄ gas were regulated by mass flow controllers 1021, 1026 in accordance with the flow patterns as shown in Fig. 34, in making the i-type layer by microwave plasma CVD.

For the photovoltaic element fabricated (Element No. Example 55), the initial characteristics, the low illuminance characteristic and the durability characteristic were measured in the same manner as in the example 44, and the initial characteristics, low illuminance characteristic and durability characteristic equivalent to those of Element No. Example 44-5 in the example 44 were obtained, whereby the effects of the present invention could be evidenced.

### (Example 56)

A photovoltaic element (Element No. Example 56) was fabricated by forming a reflecting layer, a transparent conductive layer, an n-type layer, an i-type layer, a p-type layer, a transparent electrode, and a collector electrode on the substrate under the same fabrication conditions as those of example 52, except that RF bias of the bias power source 1011 was set at 250mW/cm³, and DC bias was set via a coil for the RF cut at 50V for the application to the bias rod 1012, in making the i-type layer by microwave plasma CVD.

For the photovoltaic element fabricated (Element No. Example 56), the initial characteristics, the low illuminance characteristic and the durability characteristic were measured in the same manner as in the example 52, and the initial characteristics, low illuminance characteristic and durability characteristic equivalent to those of the example 52 were obtained, whereby the effects of the present invention could be evidenced.

### (Example 57)

A photovoltaic element (Element No. Example 57) was fabricated by forming a reflecting layer, a transparent conductive layer, an n-type layer, an i-type layer, a p-type layer, a transparent electrode, and a collector electrode on the substrate under the same fabrication conditions as those of Element No. Example 44-5 in the example 44, except that using a bomb of D₂ gas, not shown, instead of H₂ gas bomb, D₂ gas was flowed by 300sccm, in making the i-type layer by microwave plasma CVD.

For the photovoltaic element fabricated (Element No. Example 57), the initial characteristics, the low illuminance characteristic and the durability characteristic were measured in the same manner as in the example 44, and the initial characteristics, low illuminance characteristic and durability characteristic equivalent to those of Element No. Example 44-5 in the example 44 were obtained.

Also, the composition analysis of the photovoltaic element in the example 57 (Element No. Example 57) was performed using a secondary ion mass spectrometer, and it was confirmed that D atoms were contained in the i-type layer, whereby the effects of the present invention could be evidenced.

### (Example 58)

A photovoltaic element (Element No. Example 58) was fabricated by forming a reflecting layer, a transparent conductive layer, an n-type layer, an i-type layer, a p-type layer, a transparent electrode, and a collector electrode on the substrate under the same fabrication conditions as those of Element No. Example 44-5 in the example 44, except that the DC bias of bias power source 1011 was changed at a constant rate from 50V to 80V at the same time when the shutter 1013 was opened, in making the n-type layer.

For the photovoltaic element fabricated (Element No. Example 58), the initial characteristics, the low illuminance characteristic and the durability characteristic were measured in the same manner as in the example 44, and the initial characteristics, low illuminance characteristic and durability characteristic equivalent to those of Element No. Example 44-5 in the example 44 were obtained, whereby the effects of the present invention could be evidenced.

### (Example 59)

A photovoltaic element (Element No. Example 59-1) was fabricated under the same fabrication conditions as those of Element No. Example 44-5 in the example 44, except that an n-type layer and a p-type layer were formed under the same conditions as those of the example 16, using a deposition apparatus with the RF plasma CVD method.

A photovoltaic element (Element No. Example 59-2) was fabricated by forming a reflecting layer, a transparent conductive layer, an n-type layer, an i-type layer, a p-type layer, a transparent electrode, and a collector electrode on the substrate under the same fabrication conditions as those of Example 59-1, except that BF₃(2000ppm)/H₂ gas and PH₃(2000ppm)/H₂ gas were not used, in making the i-type layer by microwave plasma CVD.

For the photovoltaic elements fabricated (Element Nos. Example 59-1 to 59-2), the initial characteristics, the low illuminance characteristic and the durability characteristic were measured in the same manner as in the example 44. From the measurement results, it could be evidenced that the photovoltaic element of Element No. Example 59-1 was better than the photovoltaic element of Element No. Example 59-2, i.e., more excellent 1.02 times in the open-circuit voltage and 1.04 times in the curve factor of the initial characteristics, 1.08 times in the photovoltaic conversion efficiency of the low illuminance characteristic, and 1.07 times in the decrease in the photovoltaic conversion efficiency of the durability characteristic, whereby the effects of the present invention could be evidenced.

### (Example 60)

A photovoltaic element (Element No. Example 60-1) was fabricated by forming a reflecting layer, a reflection multiplying layer, a first n-type layer, a first i-type layer, a first p-type layer, a second n-type layer, a second i-type layer, a second p-type layer, a transparent electrode, and a collector electrode on the substrate under the fabrication conditions as listed in Table 38, with the same method as the example 44.

A photovoltaic element (Element No. Example 60-2) was fabricated by forming a reflecting layer, a reflection multiplying layer, a first n-type layer, a first i-type layer, a first p-type layer, a second n-type layer, a second i-type layer, a second p-type layer, a transparent electrode, and a collector electrode on the substrate under the same fabrication conditions as those of example 60-1, except that BF₃(2000ppm)/H₂ gas and PH₃(2000ppm)/H₂ gas were not used, in making the first i-type layer by microwave plasma CVD.

For the photovoltaic elements fabricated (Element Nos. Example 60-1 to 60-2), the initial characteristics, the low illuminance characteristic and the durability characteristic were measured in the same manner as in the example 44. From the measurement results, it could be evidenced that the protovoltaic element of Element No. Example 60-1 was better than the photovoltaic element of Element No. Example 60-2, i.e., more excellent 1.03 times in the open-circuit voltage and 1.03 times in the curve factor of the initial characteristics, 1.08 times in the photovoltaic conversion efficiency of the low illuminance characteristic, and 1.09 times in the decrease in the photovoltaic conversion efficiency of the durability characteristic, whereby the effects of the present invention could be evidenced.

### (Example 61)

A photovoltaic element (Element No. Example 61-1) was fabricated by forming a reflecting layer, a reflection multiplying layer, a first n-type layer, a first i-type layer, a first p-type layer, a second n-type layer, a second i-type layer, a second p-type layer, a third n-type layer, a third i-type layer, a third p-type layer, a transparent electrode, and a collector electrode on the substrate under the fabrication conditions as listed in Table 39, with the same method as the Example 44.

A photovoltaic element (Element No. Example 61-2) was fabricated by forming a reflecting layer, a reflection multiplying layer, a first n-type layer, a first i-type layer, a first p-type layer, a second n-type layer, a second i-type layer, a second p-type layer, a third n-type layer, a third i-type layer, a third p-type layer, a transparent electrode, and a collector electrode on the substrate under the same fabrication conditions as those of Example 61-1, except that BF₃(2000 ppm)/H₂ gas and PH₃(2000 ppm)/H₂ gas were not used, in making the first and second i-type layers by microwave plasma CVD.

For the photovoltaic elements fabricated (Element Nos. Example 61-1 to 61-2), the initial characteristics, the low illuminance characteristic and the durability characteristic were measured in the same manner as in the Example 44. From the measurement results, it could be evidenced that the photovoltaic element of Element No. Example 61-1 was better than the photovoltaic element of Element No. Example 61-2, i.e., more excellent 1.03 times in the open-circuit voltage and 1.04 times in the curve factor of the initial characteristics, 1.08 times in the photovoltaic conversion efficiency of the low illuminance characteristic, and 1.07 times in the decrease in the photovoltaic conversion efficiency of the durability characteristic, whereby the effects of the present invention could be evidenced.

### (Example 62)

A photovoltaic element of the present invention was fabricated using a multiple chamber separation-type deposition apparatus as shown in Fig. 20. The photovoltaic element (Element No. Example 62) was made in accordance with a procedure of Example 19 under the same layer forming conditions as those of the Example 60.

For the photovoltaic element fabricated (Element No. Example 62), the initial characteristics, the low illuminance characteristic and the durability characteristic were measured in the same manner as in the Example 44. From the measurement results, it could be evidenced that the photovoltaic element (Element No. Example 62) of the Example 62 was better than the photovoltaic element (Element No. Example 60) of the Example 60, i.e., more excellent 1.01 times in the open-circuit voltage and 1.02 times in the curve factor of the initial characteristics, 1.03 times in the photovoltaic conversion efficiency of the low illuminance characteristic, and 1.02 times in the decrease in the photovoltaic conversion efficiency of the durability characteristic, whereby the photovoltaic of the present invention could have more excellent characteristics by fabricating the photovoltaic element in the multiple chamber separation-type deposition apparatus, whereby the effects of the present invention could be evidenced.

### (Example 63)

A photovoltaic element was fabricated under the same fabrication conditions as those of Element No. Example 60-1, whereby a solar cell module was made using the photovoltaic element, and a car-mounted ventilation fan having a circuit configuration was produced as shown in Fig. 28.

For the comparison, a photovoltaic element was fabricated under the same fabrication conditions as those of Element No. Example 60-2, and a car-mounted ventilation fan similar to that of the Example 63 was made using the photovoltaic element.

A car which has mounted the car-mounted ventilation fans utilizing Element Nos. Example 60-1 to 60-2 was left away in an idling state with the engine rotating for 168 hours, and then left away in fine weather with the ventilation fan working and with the engine stopped, whereafter the temperature within the car was measured. As a result, the car-mounted cooling fan of Element No. Example 60-1 achieved a room temperature four degrees lower than the car-mounted cooling fan of Element No. Example 60-2.

### (Example 64)

In this example, a photovoltaic element wherein a valence electron control agent was doped into the i-type layer by microwave plasma CVD and a p-type layer was provided in the lamination structure was fabricated.

The same gas supply unit as in Example 1 was used, except that the BF₃(1%)/H₂ gas bomb was replaced with a bomb of B₂H₆ gas diluted to 10% with H₂ gas (B₂H₆(10%)/H₂ gas) in a source gas supply unit 1020 as shown in Figs. 18 and 19.

ON the SUS substrate, a reflecting layer, a reflection multiplying layer, an n-type layer, and an i-type layer by microwave plasma CVD were formed under the same fabrication conditions as in the Example 44, and then an i-type layer by RF plasma CVD was formed, under the same fabrication conditions as those of the i-type layer by RF plasma CVD in the Example 44 except that BF₃(2000 ppm)/H₂ gas flow was changed to 0.5 sccm and PH₃(2000 ppm)/H₂ gas flow to 0.05 sccm. Subsequently a p-type layer was formed under the same fabrication conditions as those of the p-type layer in the Example 21, whereby a photovoltaic element was fabricated (Element Nos. Example 64-1 to 64-7 and Comparative Example 14-1).

The initial characteristics, low illuminance characteristic and durability characteristic were measured for the fabricated photovoltaic element (Element Nos. Example 64-1 to 64-7 and Comparative Example 14-1). The results are listed in Table 40.

From Table 40, it has been found that a photovoltaic element more excellent characteristics can be obtained by forming the i-type layer by microwave plasma CVD within the deposition chamber at a pressure of 50 mTorr or less.

Then, photovoltaic elements (Element Nos. Example 64-8 to 64-10 and Comparative Example 14-2 to 14-3) were fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that the electric power of microwave electric power was as indicated in Table 41, in making the i-type layer by microwave plasma CVD.

For the fabricated photovoltaic elements (Element Nos. Example 64-8 to 64-10 and Comparative Example 14-2 to 14-3), the initial characteristics, the low illuminance characteristic and the durability characteristic were measured in the same manner as in Example 1. The results of measurement are listed in Table 41. As will be seen from Table 41, it has been found that a photovoltaic element having excellent characteristics can be obtained by decomposing the source gas with a lower microwave energy than the microwave energy necessary to decompose the source gas at 100%.

Then, photovoltaic elements (Element Nos. Example 64-11 to 64-14 and Comparative Example 14-4) were fabricated by forming a reflecting layer, a reflection multipying layer, an n-type layer, an i-type layer, a p-type layer, a transparent electrode, and a collector electrode on the substrate under the same fabrication conditions as those of Element No. Example 64-5, except that the RF bias was as indicated in Table 42 in making the i-type layer by microwave plasma CVD.

For the fabricated photovoltaic elements (Element Nos. Example 64-11 to 64-14 and Comparative Example 14-4), the initial characteristics, the low illuminance characteristic and the durability characteristic were measured in the same manner as in Example 1. The results of measurement are listed in Table 42. As will be seen from Table 42, it has been found that a photovoltaic element having excellent characteristics can be obtained by applying a higher RF energy to the source gas than the microwave energy.

Then, a photovoltaic element was fabricated (Element No. Comparative Example 14-5) by forming a reflecting layer, a reflection multiplying layer, an n-type layer, an i-type layer, a p-type layer, a transparent electrode, and a collector electrode on the substrate under the same fabrication conditions as those of Element No. Example 64-5, except that SiH₄ gas flow and GeH₄ gas flow were regulated by respective mass flow controllers 1021, 1026 in accordance with the flow patterns as shown in Fig. 23B in making the i-type layer by microwave plasma CVD.

For the fabricated photovoltaic element (Element No. Comparative Example 14-5), the initial characteristics, the low illuminance characteristic and the durability characteristic were measured in the same manner as in Example 1. The results of measurement indicated that the open-circuit voltage and the curve factor in the initial characteristics, the low illuminance characteristic and the durability characteristic in Element No. Example 64-5 were 1.02 times, 1.03 times, 1.07 times and 1.08 times better than those in Element No. Comparative Example 14-5, respectively.

The change in the bandgap of the i-type layer in the layer thickness direction was obtained, and it could be found that the photovoltaic element of Element No. Example 64-5 has the minimum value of bandgap at a position biased toward the interface between the p-type layer and the i-type layer off the central position of the i-type layer, while the photovoltaic element of Element No. Comparative Example 14-5 has the minimum value of bandgap at a position biased toward the interface between the n-type layer and the i-type layer off the central position of the i-type layer.

Next, a photovoltaic element was fabricated (Element No. Example 64-15) by forming a reflecting layer, a reflection multiplying layer, an n-type layer, an i-type layer, a p-type layer, a transparent electrode, and a collector electrode on the substrate under the same fabrication conditions as those of Element No. Example 64-5, except that BF₃(2000 ppm)/H₂ gas and PH₃(2000 ppm)/H₂ gas were not flowed in making the i-type layer by microwave plasma CVD.

For the fabricated photovoltaic element (Element No. Example 64-15), the initial characteristics, the low illuminance characteristic and the durability characteristic were measured in the same manner as in Example 1. From the measurement results, it could be found that the photovoltaic element of Element No. Example 64-5 was superior to that of Element No. Example 64-15, wherein the open-circuit voltage and the curve factor of the initial characteristics, the low illuminance characteristic and the durability characteristic were 1.03 times, 1.02 times, 1.07 times and 1.07 times better.

The composition analysis of the photovoltaic element of Element No. Example 64-5 was performed using a secondary ion mass spectrometer, and it was confirmed that B atoms and P atoms were contained in the i-type layer by microwave plasma CVD.

Then, photovoltaic element (Element Nos. Example 64-16 to 64-20 and Comparative Example 14-6) were fabricated by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 64-5, except that the SiH₄ gas flow and the RF discharge electric power were as indicated in Table 43 in making the i-type layer by layer by RF plasma CVD.

For the fabricated photovoltaic elements (Element Nos. Example 64-16 to 64-20 and Comparative Example 14-6), the initial characteristics, the low illuminance characteristic and the durability characteristic were measured in the same manner as in Element No. Example 64-5. The results of measurement are listed in Table 43.

As will be seen from Table 43, it has been found that the photovoltaic element having excellent characteristics can be fabricated by making the i-type layer by RF plasma CVD at a deposition rate of 2 nm/sec or less.

Then, photovoltaic elements (Element Nos. Example 64-21 to 64-23 and Comparative Example 14-7 to 14-8) were fabricated by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 64-5, except that the layer thickness of i-type layer was as indicated in Table 44 in making the i-type layer by RF plasma CVD.

For the fabricated photovoltaic elements (Element Nos. Example 64-21 to 64-23 and Comparative Example 14-7 to 14-8), the initial characteristics, the low illuminance characteristic and the durability characteristic were measured in the same manner as in Element No. Example 64-5. The results of measurement are listed in Table 44. As will be seen from Table 44, it has been found that the photovoltaic elements (Element Nos. Example 64-21 to 64-23) provided with the i-type layer by RF plasma CVD having a layer thickness of 30 nm or less have excellent characteristics.

Then, photovoltaic elements (Element Nos. Example 64-24 to 64-27) were fabricated by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 64-5, except that RF electric power was as indicated in Table 45 in making the i-type layer by RF plasma CVD.

For the fabricated photovoltaic elements (Element Nos. Example 64-24 to 64-27), the initial characteristics, the low illuminance characteristic and the durability characteristic were measured in the same manner as in Element No. Example 64-5. The results of measurement are listed in Table 45. As will be seen from Table 45, it has been found that the photovoltaic element wherein the value of half-width at a peak of 2000 cm⁻¹ in the infrared absorption spectrum divided by the peak height is greater in the i-type layer by RF plasma CVD than in the i-type layer by microwave plasma CVD has the more excellent characteristics.

Next, a photovoltaic element (Element No. Example 64-28) was fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that only the doping layer was formed, but the doping layer A was not formed, in making the p-type layer.

For the fabricated photovoltaic element (Element No. Example 64-28), the initial characteristics, the low illuminance characterstic and the durability characteristic were measured in the same manner as in Example 1. From the measurement results, it could be found that the photovoltaic element of Element No. Example 64-5 was superior to that of Element No. Comparative Example 64-28, wherein the open-circuit voltage and the curve factor of the initial characteristics, the photoelectric conversion efficiency of the low illuminance characteristic and the decrease in the photoelectric conversion efficiency of the durability characteristic were 1.04 times, 1.02 times, 1.09 times and 1.07 times better.

From the above measurement results, it has been found that the photovoltaic elements of the present invention have more excellent characteristics at compared with the conventional photovoltaic elements, wherein the photovoltaic elements of the present invention have been accomplished in that an i-type layer by microwave plasma CVD is formed at an internal pressure of 50 mTorr or less by simultaneously applying a lower microwave energy and a higher RF energy than the microwave energy necessary to decompose the source gas at 100%, and an i-type layer by RF plasma CVD is deposited 30 nm thick or less on the p-type layer at a deposition rate of 2 nm/sec or less, in such a manner that the bandgap smoothly changes in a direction of layer thickness, and the minimum value of bandgap takes place at a position biased toward the interface between the p-type layer and the i-type layer off the central position of the i-type layer, and wherein B and P atoms are doped in the i-type layer by microwave plasma CVD, and at least one of the p-type layer and wherein the n-type layer has a lamination structure consisting of a layer having Group III element and/or Group V element in the periodic table as the main constituent and a layer containing a valence electron control agent and having silicon atoms as the main constituent. Thus, the effects of the present invention have been evidenced.

### (Example 65)

Photovoltaic elements (Element Nos. Example 65-1 to 65-8) were fabricated in such a manner as to form a reflecting layer, a reflection multiplying layer, an n-type layer, an i-type layer, a p-type layer, a transparent electrode, and a collector electrode on the substrate under the same fabrication conditions as those of Element No. Example 64-5 in the Example 64, except that after SiH₄ gas flow and GeH₄ gas flow were regulated by respective mass flow controllers 1021, 1026 in accordance with the flow patterns as shown in Fig. 23A, as conducted in the Example 64, SiH₄ gas flow was maintained at 200 sccm and GeH₄ gas flow at 1 sccm, and the region of the maximum bandgap was made to have a layer thickness as indicated in Table 46, in making the i-type layer by microwave plasma CVD.

For the fabricated photovoltaic elements (Element Nos. Example 65-1 to 65-8), the initial characteristics, the low illuminance characteristic and the durability characteristic were measured in the same manner as in Example 64. The results of measurement are listed in Table 46. As will be seen from Table 46, it has been found that the photovoltaic elements (Element Nos. Example 65-1 to 65-7) having a layer thickness of 1 to 30 nm in the region of the maximum bandgap can exhibit more excellent characteristics, whereby the effects of the present invention have been evidenced.

### (Example 66)

A photovoltaic element (Element No. Example 66) was fabricated by forming a reflecting layer, a transparent conductive layer, an n-type layer, an i-type layer, a p-type layer, a transparent electrode, and a collector electrode on the substrate under the same fabrication conditions as those of Element No. Example 64-5 in Example 64, except that using a bomb of AsH₃/H₂ gas instead of a bomb of PH₃(2000 ppm)/H₂ gas, AsH₃/H₂ gas was flowed by 0.2 sccm for the i-type layer by microwave plasma CVD, and by 0.02 sccm for the i-type layer by RF plasma CVD, in making the i-type layers by microwave plasma CVD and RF plasma CVD.

For the photovoltaic element fabricated in Example 66 (Element No. Example 66), the initial characteristics, the low illuminance characteristic and the durability characteristic were measured in the same manner as in the Example 64, and the initial characteristics, low illuminance characteristic and durability characteristic equivalent to those of Element No. Example 64-5 were obtained.

### (Example 67)

A photovoltaic element (Element No. Example 67) was fabricated by forming a reflecting layer, a transparent conductive layer, an n-type layer, an i-type layer, a p-type layer, a transparent electrode, and a collector electrode on the substrate under the same fabrication conditions as those of Element No. Example 64-5 in Example 64, except that BF₃(2000ppm)/H₂ gas flow and PH₃(2000 ppm)/H₂ gas flow were regulated in accordance with a flow pattern as shown in Fig. 41 and a flow pattern as shown in Fig. 42 by the mass flow controllers 1027, 1028, respectively, in making the i-type layer by microwave plasma CVD, and BF₃(2000ppm)/H₂ gas flow and PH₃(2000 ppm)/H₂ gas flow were flowed by 3 sccm and 0.04 sccm, respectively, in making the i-type layer by RF plasma CVD.

For the photovoltaic element (Element No. Example 67) fabricated in Example 67, the initial characteristics, the low illuminance characteristic and the durability characteristic were measured in the same manner as in the Example 64, and the initial characteristics, low illuminance characteristic and durability characteristic equivalent to those of Element No. Example 64-5 were obtained.

Also, the distribution of B and P atoms in the i-type layer of Element No. Example 67 was analyzed using a secondary ion mass spectrometer, resulting in the same tendency as shown in Figs. 43 and 44.

### (Example 68)

A photovoltaic element (Element No. Example 68) was fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that using a bomb of NO/He gas 1079, the flow rate of NO/He gas was 0.5 sccm for the i-type layer by microwave plasma CVD and 0.05 sccm for the i-type layer by RF plasma CVD, in making the i-type layer.

For the photovoltaic element fabricated (Element No. Example 68), the initial characteristics, the low illuminance characteristic and the durability characteristic were measured in the same manner as in the Example 64, and the initial characteristics, low illuminance characteristic and durability characteristic equivalent to those of Element No. Example 64-5 were obtained.

Also, the composition analysis for the photovoltaic element of the Example 68 (Element No. Example 68) was performed using a secondary ion mass spectrometer, and it could be confirmed that O and N atoms were contained in the i-type layer.

From the above results, the effects of the present invention could be evidenced.

### (Example 69)

A photovoltaic element (Element No. Example 69) was fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5 in Example 64, except that using a bomb of Si₂H₆ gas, the flow rate of Si₂H₆ gas was 40 sccm and the flow rate of SiH₄ gas was regulated by a mass flow controller 1021 in accordance with a flow pattern as shown in Fig. 18A, in making the i-type layer by microwave plasma CVD.

For the photovoltaic element fabricated (Element No. Example 69), the initial characteristics, the low illuminance characteristic and the durability characteristic were measured in the same manner as in the Example 64, and the initial characteristics, low illuminance characteristic and durability characteristic equivalent to those of Element No. Example 64-5 were obtained.

Also, the distribution in layer thickness direction of each of Si atom and hydrogen atom in the i-type layer of the photovoltaic element in the Example 69 (Element No. Example 69) was analyzed using a secondary ion mass spectrometer, resulting in the same tendency as indicated in Fig. 25B.

From the above results, the effects of the present invention could be evidenced.

### (Example 70)

A photovoltaic element (Element No. Example 70) was fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that the distance between the mixing point of SiH₄ gas and GeH₄ gas and the deposition chamber 1001 in the source gas supply unit 1020 was set to the value as indicated in Table 47.

For the photovoltaic element fabricated (Element No. Example 70), the initial characteristics, the low illuminance characteristic and the durability characteristic were measured in the same manner as in the Example 64. The measurement results are listed in Table 47. As will be seen from Table 47, it has been found that by making the distance between the mixing point of SiH₄ gas and GeH₄ gas and the deposition chamber 1001 equal to or less than 5 m, the photovoltaic element havig further excellent characteristics can be obtained.

### (Example 71)

A photovoltaic element was fabricated under the same fabrication conditions as those of Element Nos. Example 64-5 and 64-15 of the Example 64, whereby a solar cell module was fabricated using this photovoltaic element, and an analog clock with a circuit configuration as shown in Fig. 28 was made.

The analog clocks as fabricated were installed on the wall within room. As a result, the analog clock using Element No. Example 64-5 worked for a longer time than the analog clock using Element No. Example 64-15.

### (Example 72)

A photovoltaic element (Element No. Example 72) was fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that the flow rates of SiH₄ gas and GeH₄ gas were regulated by mass flow controllers 1021, 1026 in accordance with the flow patterns as shown in Fig. 26 in making the i-type layer by microwave plasma CVD.

For the photovoltaic element fabricated (Element No. Example 72), the initial characteristics, the low illuminance characteristic and the durability characteristic were measured in the same manner as in the Example 64, and the initial characteristics, low illuminance characteristic and durability characteristic equivalent to those of Element No. Example 64-5 were obtained, whereby the effects of the present invention could be evidenced.

### (Example 73)

A photovoltaic element (Element No. Example 73) was fabricated by forming a reflecting layer, a transparent conductive layer, an n-type layer, an i-type layer, a p-type layer, a transparent electrode, and a collector electrode on the substrate under the same fabrication conditions as those of Element No. Example 64-5 in Example 64, except that using a bomb of B₂H₆(2000 ppm)/H₂ gas, instead of a bomb of BF₃(2000 ppm)/H₂ gas, B₂H₆(2000 ppm)/H₂ gas was flowed by 1 sccm for forming the i-type layer by microwave plasma CVD, and B₂H₆(2000 ppm)/H₂ gas was flowed by 2 sccm for forming the i-type layer by RF plasma CVD, in making the i-type layers by microwave plasma CVD and RF plasma CVD.

For the photovoltaic element fabricated (Element No. Example 73), the initial characteristics, the low illuminance characteristic and the durability characteristic were measured in the same manner as in the Example 64, and the initial characteristics, low illuminance characteristic and durability characteristic equivalent to those of Element No. Example 64-5 in the Example 64 were obtained, whereby the effects of the present invention could be evidenced.

### (Example 74)

A photovoltaic element (Element No. Example 74) was fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that the flow rate of NO/He gas was regulated by a mass flow controller 1029 in accordance with a flow pattern as shown in Fig. 33A, in making the i-type layer by microwave plasma CVD.

For the photovoltaic element fabricated (Element No. Example 31), the initial characteristics, the low illuminance characteristic and the durability characteristic were measured in the same manner as in the Example 64, and the initial characteristics, low illuminance characteristic and durability characteristic equivalent to those of Element No. Example 64-5 were obtained.

Also, the distribution in layer thickness direction of each of N atom and O atom in the i-type layer of the photovoltaic element in the Example 74 (Element No. Example 74) was analyzed using a secondary ion mass spectrometer, resulting in the same tendency as indicated in Fig. 33B.

From the above results, the effects of the present invention could be evidenced.

### (Example 75)

A photovoltaic element (Element No. Example 75) was fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that the flow rates of SiH₄ gas and GeH₄ gas were regulated by mass flow controllers 1021, 1026 in accordance with the flow patterns as shown in Fig. 34, in making the i-type layer by microwave plasma CVD.

For the photovoltaic element fabricated (Element No. Example 75), the initial characteristics, the low illuminance characteristic and the durability characteristic were measured in the same manner as in the Example 64, and the initial characteristics, low illuminance characteristic and durability characteristic equivalent to those of Element No. Example 64-5 were obtained, whereby the effects of the present invention could be evidenced.

### (Example 76)

Photovoltaic elements (Element Nos. Example 76-1 to 76-5) were fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that the layer thickness of doping layer A was as indicated in Table 48, in making the p-type layer.

For the photovoltaic elements fabricated (Element No. Example 76-1 to 76-5), the initial characteristics, the low illuminance characteristic and the durability characteristic were measured in the same manner as in the Example 64. Its results are listed in Table 48. As will be seen from Table 48, it has been found that the photovoltaic elements (Element Nos. Example 76-1 to 76-4) having a layer thickness of the doping layer A of 0.01 to 1 nm can exhibit more excellent characteristics, whereby the effects of the present invention have been evidenced.

### (Example 77)

A photovoltaic element (Element No. Example 77) was fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that the doping layer A and the doping layer B were formed under the forming conditions as indicated in Table 25, in making the n-type layer.

For the photovoltaic element fabricated (Element No. Example 34), the initial characteristics, the low illuminance characteristic and the durability characteristic were measured in the same manner as in the Example 64, and the initial characteristics, low illuminance characteristic and durability characteristic equivalent to those of Element No. Example 64-5 were obtained, whereby the effects of the present invention could be evidenced.

### (Example 78)

A photovoltaic element (Element No. Example 78) was fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that the doping layer A and the doping layer B were formed under the forming conditions as indicated in Table 26, in making the p-type layer.

For the photovoltaic element fabricated (Element No. Example 78), the initial characteristics, the low illuminance characteristic and the durability characteristic were measured in the same manner as in the Example 64, and the initial characteristics, low illuminance characteristic and durability characteristic equivalent to those of Element No. Example 64-5 were obtained, whereby the effects of the present invention could be evidenced.

### (Example 79)

A photovoltaic element (Element No. Example 79) was fabricated by forming a reflecting layer, a reflection multiplying layer, an n-type layer, an i-type layer, a p-type layer, a transparent electrode, and a collector electrode on the substrate under the same fabrication conditions as those of Example 72, except that RF bias of the bias power source 1011 was set at 250 mW/cm³, and DC bias was set via a coil for the RF cut at 50 V for the application to the bias rod 1012, in making the i-type layer by microwave plasma CVD.

For the photovoltaic element fabricated (Element No. Example 79), the initial characteristics, the low illuminance characteristic and the durability characteristic were measured in the same manner as in the Example 72, and the initial characteristics, low illuminance characteristic and durability characteristic equivalent to those of the Example 72 were obtained, whereby the effects of the present invention could be evidenced.

### (Example 80)

A photovoltaic element (Element No. Example 80) was fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that using a bomb of D₂ gas, not shown, instead of H₂ gas bomb, D₂ gas was flowed by 300 sccm, in making the i-type layer by microwave plasma CVD.

For the photovoltaic element fabricated (Element No. Example 80), the initial characteristics, the low illuminance characteristic and the durability characteristic were measured in the same manner as in the Example 64, and the initial characteristics, low illuminance characteristics and durability characteristic equivalent to those of Element No. Example 64-5 were obtained.

Also, the composition analysis of the photovoltaic element in the Example 80 (Element No. Example 80) was performed using a secondary ion mass spectrometer, and it was confirmed that D atoms were contained in the i-type layer, whereby the effects of the present invention could be evidenced.

### (Example 81)

A photovoltaic element (Element No. Example 81) was fabricated by forming a reflecting layer, a reflection multiplying layer, an n-type layer, an i-type layer, a p-type layer, a transparent electrode, and a collector electrode on the substrate under the same fabrication conditions as those of Element No. Example 64-5, except that the DC bias of bias power source 1011 was changed at a constant rate from 50 V to 80 V at the same time when the shutter 1013 was opened, in making the n-type layer.

For the photovoltaic element fabricated (Element No. Example 81), the initial characteristics, the low illuminance characteristic and the durability characteristic were measured in the same manner as in the Example 64, and the initial characteristics, low illuminance characteristic and durability characteristic equivalent to those of Element No. Example 64-5 were obtained, whereby the effects of the present invention could be evidenced.

### (Example 82)

Using a deposition apparatus with the RF plasma CVD method as shown in Fig. 19, an n-type layer and a p-type layer of lamination structure were formed by RF plasma CVD. A photovoltaic element (Element No. Example 82-1) was fabricated under the same fabrication conditions as those of Example 39 for the n-type layer and the p-type layer, and under the same fabrication conditions as those of Element No. Example 64-5 for the i-type layers by microwave plasma CVD and RF plasma CVD.

For the comparison, a photovoltaic element (Element No. Example 82-2) was fabricated by forming a reflecting layer, a reflection multiplying layer, an n-type layer, an i-type layer, a p-type layer, a transparent electrode, and a collector electrode on the substrate under the same fabrication conditions as those of Element No. Example 82-1, except that BF₃ (2000 ppm)/H₂ gas and PH₃(2000 ppm)/H₂ gas were not used, in making the i-type layer by microwave plasma CVD.

For the photovoltaic elements fabricated (Element Nos. Example 82-1 to 82-2), the initial characteristics, the low illuminance characteristic and the durability characteristic were measured in the same manner as in the Example 64. From the measurement results, it could be evidenced that the photovoltaic element of Element No. Example 82-1 was 1.04 times better in the open-circuit voltage and 1.03 times better in the curve factor of the initial characteristics, 1.08 times better in the photovoltaic conversion efficiency of the low illuminance characteristic, and 1.07 times better in the decrease in the photovoltaic conversion efficiency of the durability characteristic than the photovoltaic element of Element No. Example 82-2, whereby the effects of the present invention could be evidenced.

### (Example 83)

A photovoltaic element (Element No. Example 83) was fabricated by forming a reflecting layer, a reflection multiplying layer, a first n-type layer, a first i-type layer, a first p-type layer, a second n-type layer, a second i-type layer, a second p-type layer, a transparent electrode, and a collector electrode on the substrate under the fabrication conditions as indicated in Table 28, except that BF₃(2000 ppm)/H₂ gas was flowed by 0.3 sccm and PH₃(2000 ppm)/H₂ gas was flowed by 0.5 sccm, in making the first i-type layer by microwave plasma CVD, with the same method as Example 64.

For the photovoltaic element fabricated (Element No. Example 83), the initial characteristics, the low illuminance characteristic and the durability characteristic were measured in the same manner as in the Example 64. From the measurement results, it could be evidenced that the photovoltaic element of Element No. Example 83 was 1.03 times better in the open-circuit voltage and 1.04 times better in the curve factor of the initial characteristics, 1.07 times better in the photovoltaic conversion efficiency of the low illuminance characteristic, and 1.07 times better in the decrease in the photovoltaic conversion efficiency of the durability characteristic than the photovoltaic element of Element No. Example 40, whereby the effects of the present invention could be evidenced.

### (Example 84)

A photovoltaic element (Element No. Example 84) was fabricated by forming a reflecting layer, a reflection multiplying layer, a first n-type layer, a first i-type layer, a first p-type layer, a second n-type layer, a second i-type layer, a second p-type layer, a third n-type layer, a third i-type layer, a third p-type layer, a transparent electrode, and a collector electrode on the substrate under the fabrication conditions as indicated in Table 29, except that BF₃(2000 ppm)/H₂ gas was flowed by 1 sccm and PH₃(2000 ppm)/H₂ gas was flowed by 0.3 sccm, in making the first i-type layer by microwave plasma CVD, and BF₃(2000 ppm)/H₂ gas was flowed by 0.5 sccm and PH₃(2000 ppm)/H₂ gas was flowed by 0.1 sccm, in making the second i-type layer by microwave plasma CVD, with the same method as Example 64.

For the photovoltaic element fabricated (Element No. Example 84), the initial characteristics, the low illuminance characteristic and the durability characteristic were measured in the same manner as in the Example 64. From the measurement results, it could be evidenced that the photovoltaic element of Element No. Example 84 was 1.03 times better in the open-circuit voltage and 1.03 times better in the curve factor of the initial characteristics, 1.08 times better in the photovoltaic conversion efficiency of the low illuminance characteristic, and 1.07 times better in the decrease in the photovoltaic conversion efficiency of the durability characteristic than the photovoltaic element of Element No. Example 41, whereby the effects of the present invention could be evidenced.

### (Example 85)

A photovoltaic element (Element No. Example 85) of the present invention was fabricated using a multiple chamber separation-type deposition apparatus as shown in Fig. 21. The formation of the photovoltaic element was performed by making each layer under the same forming conditions as in Example 83, in accordance with the same procedure as Example 42.

For the photovoltaic element fabricated (Element No. Example 85), the initial characteristics, the low illuminance characteristic and the durability characteristic were measured in the same manner as in the Example 64. From the measurement results, it could be evidenced that the photovoltaic element of Example 85 (Element No. Example 85) was 1.01 times better in the open-circuit voltage and 1.02 times better in the curve factor of the initial characteristics, 1.02 times better in the photovoltaic conversion efficiency of the low illuminance characteristic, and 1.02 times better in the decrease in the photovoltaic conversion efficiency of the durability characteristic than the photovoltaic element of Example 83 (Element No. Example 83), whereby the photovoltaic element having more excellent characteristics could be obtained by fabricating the photovoltaic element of the present invention in the multiple chamber separation-type deposition apparatus. Thus, the effects of the present invention could be evidenced.

### (Example 86)

A photovoltaic element was fabricated under the same fabrication conditions as those of Element Nos. Example 83 and 40, whereby a solar cell module was created using the photovoltaic element, and a car-mounted ventilation fan having a circuit configuration as shown in Fig. 28 was fabricated.

A car which has mounted the car-mounted ventilation fans as fabricated was left away in an idling state with the engine rotating for 168 hours, and then left away in fine weather with the ventilation fan working and with the engine stopped, whereafter the temperature within the car was measured. As a result, the car-mounted cooling fan using the Element No. Example 83 achieved a room temperature three degrees lower than the car-mounted cooling fan using the Element No. Example 40, whereby the effects of the power generation system of the present invention were evidenced.

### (Example 87)

After the preparation for the film formation was completed, as in the Example 1, on the substrates 1004, 1104, an n-type layer, i-type layers by RF plasma CVD and microwave plasma CVD and a p-type layer were formed.

Herein, the film formation up to the n-type layer was performed as in the Example 1.

Then, the substrate 1004 was taken out from the deposition chamber 1001, and installed in the deposition chamber 1101 of the deposition unit 1100 with the RF plasma CVD method as shown in Fig. 19, where an i-type layer by RF plasma CVD was fabricated.

To make an i-type layer by RF plasma CVD, the substrate 1104 was heated to 350°C by the heater 1105, the outflow valves 1041, 1042 and the auxiliary valve 1108 were gradually opened to flow SiH₄ gas and H₂ gas through a gas introducing pipe 1103 into the deposition chamber 1101. The inflow rates of the gases were regulated by respective mass flow controllers 1021, 1022 so that the SiH₄ gas flow and the H₂ gas flow were 8 sccm and 100 sccm, respectively. The pressure within the deposition chamber 1101 was set to 6.7 hPa (0.5 Torr) by adjusting the opening of conductance valve 1107 while referring to the vacuum gauge 1106.

Thereafter, the electric power of an RF power source 1111 was set at 120 mW/cm³, and an RF electric power was introduced through the RF matching box 1112 into the cathode 1102 to excite an RF glow discharge to start the fabrication of an i-type layer by RF plasma CVD on the i-type layer made by microwave plasma CVD. Upon making the i-type layer having a layer thickness of 10 nm, the RF glow discharge was stopped, and the outflow valves 1041, 1042 and the auxiliary valve 1108 were closed to stop the gas inflow into the deposition chamber 1101, whereby the fabrication of the i-type layer was completed.

Then, the substrate 1104 was taken out from the deposition chamber 1101, and installed in the deposition chamber 1001 of the deposition unit 1000 with the microwave plasma CVD method as shown in Fig. 11, where an i-type layer by microwave plasma CVD was fabricated.

To make an i-type layer by microwave plasma CVD, the substrate 1004 was heated to 350°C by the heater 1005, the outflow valves 1041, 1042, 1046 and the auxiliary valve 1008 were gradually opened to flow SiH₄ gas, H₂ gas and GeH₄ gas respectively through the gas introducing tube 1003 into the deposition chamber 1001. The inflow rates of the gases were regulated by respective mass flow controllers 1021, 1022, 1026 so that SiH₄ gas flow, H₂ gas flow and GeH₄ gas flow were 200 sccm, 500 sccm and 1 sccm, respectively. The pressure within the deposition chamber 1001 was set to the value as indicated in Table 2 by adjusting the opening of conductance valve 1007 while referring to the vacuum gauge 1006.

Thereafter, the shutter 1013 was closed, the electric power of a microwave power source, not shown, was set at 170 mW/cm³, and a microwave electric power was introduced through a waveguide, not shown, the waveguide portion 1010 and the dielectric window 1002 into the deposition chamber 1001 to excite a microwave glow discharge. Then, the radio frequency (hereinafter abbreviated as "RF") bias of the bias power source 1011 was set 350 mW/cm³ and the DC bias was set via a coil for the RF cut at 0 V for the application to the bias rod 1012. Thereafter, the shutter 1013 was opened to start fabrication of an i-type layer by microwave plasma CVD on the i-type layer by RF plasma CVD, while at the same time regulating the SiH₄ gas flow and the GeH₄ gas flow in accordance with the flow patterns as shown in Fig. 14 by means of the mass flow controllers 1021, 1026. Upon making the i-type layer having a layer thickness of 300 nm, the shutter 1013 was closed, the output of microwave glow discharge was stopped, and the outflow valves 1041, 1042, 1046 and the auxiliary valve 1008 were closed to stop the gas inflow into the deposition chamber 1001.

Subsequently, a p-type layer was fabricated under the same conditions as in the Example 1.

The fabrication of the p-type layer on the i-type layer by microwave plasma CVD was started, and upon making the p-type layer having a layer thickness of 10 nm, the shutter 1013 was closed, the microwave glow discharge was stopped, and the outflow valves 1041 to 1043 and the auxiliary valve 1008 were closed to stop the gas inflow into the deposition chamber 1001, whereby the fabrication of the p-type was completed.

Further, on the p-type layer, a 70 µm-thick ITO (In₂O₃+SnO₂) thin film as the transparent electrode and a 2 µm-thick aluminum (Al) thin film as the collector electrode were vapor deposited in vacuum to fabricate photovoltaic elements (Element Nos. Example 84-1 to 84-7, Comparative Example 87-1). The fabrication conditions of the photovoltaic elements as above are listed in Table 49.

The initial characteristics, low illuminance characteristic and durability characteristic were measured for the fabricated photovoltaic elements (Element Nos. Example 84-1 to 84-7 and Comparative Example 84-1).

The measurement of the initial characteristics was performed in terms of the open-circuit voltage and curve factor obtained by installing the fabricated photovoltaic elements (Element Nos. Example 87-1 to 87-7, Comparatic Example 87-1) under illumination of light with AM-1.5 (100 mW/cm²) and measuring the V-I characteristic. The results of measurement are listed in Table 50.

The measurement of low illuminance characteristic was performed in terms of the photoelectric conversion efficiency obtained by installing the fabricated photovoltaic elements (Element Nos. Example 87-1 to 87-7 and Comparative Example 87-1) under illumination of light with AM-1.5 (10 mW/cm²) and measuring the V-I characteristic. The results of measurement are listed in Table 50.

The measurement of durability characteristic was performed in terms of the change in the photoelectric conversion efficiency obtained by installing the fabricated photovoltaic elements (Element Nos. Example 87-1 to 87-7 and Comparative Example 87-1) in the dark place with a humidity of 70% and a temperature of 60°C and then applying vibrations of 1 mm at 3600 rpm for 48 hours. The results of measurement are listed in Table 50.

As will be seen from Table 50, the photovoltaic element having excellent characteristics can be fabricated by making the i-type layer by microwave plasma CVD under the pressure of the deposition chamber 1001 being 50 mTorr or less.

Next, using a substrate of barium borosilicate glass (7059 manufactured by Corning), an i-type layer by microwave plasma CVD was made on the substrate by opening the shutter 1013 for two minutes under the same fabrication conditions as the i-type layer by microwave plasma CVD in Element No. Example 87-5, except that SiH₄ gas flow and GeH₄ gas flow and the microwave electric power were as indicated in Table 51, whereby a sample for the measurement of source gas decomposition efficiency was fabricated (Sample Nos. 87-1 to 87-5).

The film thickness of the fabricated sample for the measurement of source gas decomposition efficiency was measured by a layer thickness measuring instrument (alpha step 100 manufactured by TENCOR INSTRUMENTS) to obtain the decomposition efficiency of source gas from the layer thickness. Its results are listed in Table 51.

Then, photovoltaic elements were fabricated (Element Nos. Example 87-8 to 87-10 and Comparative Example 87-2 to 87-3) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 87-5, except that the electric power of microwave electric power was as indicated in Table 52 in making the i-type layer by microwave plasma CVD.

For the fabricated photovoltaic elements (Element Nos. Example 87-8 to 87-10 and Comparative Example 87-2 to 87-3), the initial characterisitics, the low illuminance characteristic and the durability characteristic were measured in the same manner as in Element No. Example 87-5. The results of measurement are listed in Table 52.

As will be seen from Table 52, it has been found that a photovoltaic element having excellent characteristics can be obtained by decomposing the source gas with a lower microwave energy than the microwave energy necessary to decompose the source gas at 100%.

Then, photovoltaic elements were fabricated (Element Nos. Example 87-11 to 87-14 and Comparative Example 87-4) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 87-5, except that the RF bias was as indicated in Table 53 in making the i-type layer by microwave plasma CVD.

For the fabricated photovoltaic elements (Element Nos. example 87-11 to 87-14 and Comparative Example 87-4), the initial characteristics, the low illuminance characteristic and the durability characteristic were measured in the same manner as in Element No. Example 87-5. The results of measurement are listed in Table 53. As will be seen from Table 53, it has been found that a photovoltaic element having excellent characteristics can be obtained by applying a higher RF energy to the source gas than the microwave energy.

Next, using a stainless substrate and a barium borosilicate glass (7059 manufactured by Corning) substrate, an i-type layer was made 1 µm thick on the substrate under the same fabrication conditions as the i-type layer by microwave plasma CVD in Element No. Example 87-5, except that SiH₄ gas flow and GeH₄ gas flow were as indicated in Table 54, whereby a sample for the measurement of material was fabricated (Sample Nos. 87-6 to 87-10).

Further, using a barium borosilicate glass (7059 manufactured by Corning) substrate, an i-type layer was made 1 µm thick on the substrate under the same fabrication conditions as the i-type layer by RF plasma CVD in Element No. Example 87-5, whereby a sample for the measurement of material was fabricated (Sample No. 87-11).

The bandgap and the composition of the fabricated sample for the measurement of material were conducted to obtain the relation between the composition ratio of Si atom to Ge atom and the bandgap.

The measurement of bandgap was performed in the same manner as in the Example 1 to obtain the bandgap of the i-type layer.

Also, the analysis of composition was performed in the same manner as in the Example 1 to measure the composition ratio of Si atom to Ge atom. The results of bandgap and composition analysis are shown in Table 54.

Then, a photovoltaic element was fabricated (Element No. Comparative Example 87-5) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 87-5, except that SiH₄ gas flow and GeH₄ gas flow were regulated by the mass flow controllers 1021, 1026 in accordance with the flow patterns as shown in Fig. 14 in making the i-type layer by microwave plasma CVD.

For the fabricated photovoltaic element (Element No. Comparative Example 87-5), the initial characteristics, the low illuminance characteristic and the durability characteristic were measured in the same manner as in Element No. Example 87-5. The results of measurement indicated that the open-circuit voltage and the curve factor in the initial characteristics, the low illuminance characteristic and the durability characteristic in Element No. Example 87-5 were 1.02 times, 1.03 times, 1.08 times and 1.07 times better than those in Element No. Comparative Example 87-5, respectively.

Next, the composition analysis in layer thickness direction of Si atoms and Ge atoms in the i-type layer by microwave plasma CVD in Element No. Example 87-5 and Element No. Comparative Example 87-5 was performed in the same manner as the previous composition analysis. And from the relation between the composition ratio of Si atom to Ge atom and the bandgap obtained by the Sample Nos. 87-6 to 87-10 as previously described, the variation of the bandgap in layer thickness direction of the i-type layer by microwave plasma CVD was obtained. Its results are shown in Fig. 24. As will be seen from Fig. 24, the photovoltaic element in Element No. Example 87-5 has the minimum value of bandgap at a position biased toward the interface between the p-type layer and the i-type layer off the central position of the i-type layer, while the photovoltaic element in Element No. Comparative Example 87-5 has the minimum value of bandgap at a position biased toward the interface between the n-type layer and the i-type layer off the central position of the i-type layer.

Then, photovoltaic elements were fabricated (Element Nos. Example 87-15 to 87-19 and Comparative Example 87-6) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 87-5, except that SiH₄ gas flow and RF discharge power were as indicated in Table 55 in making the i-type layer by RF plasma CVD.

For the fabricated photovoltaic elements (Element Nos. Example 87-15 to 87-19 and Comparative Example 87-6), the initial characteristics, the low illuminance characteristic and the durability characteristic were measured in the same manner as in Element No. Example 87-5. Its results are listed in Table 55.

Next, using a barium borosilicate glass (7059 manufactured by Corning) substrate, an i-type layer was made 1 µm thick on the substrate under the same fabrication conditions as the i-type layer by RF plasma CVD in Element No. Example 87-5, except that SiH₄ gas flow and the RF discharge power were as indicated in Table 55, whereby samples for the measurement of deposition rate were fabricated (Sample Nos. 87-12 to 87-17). The deposition rate of the fabricated samples for the measurement of deposition rate was obtained in the same manner as in Sample Nos. 87-1 to 87-5. Its results are listed in Table 55.

As will be seen from Table 55, it has been found that the photovoltaic element having excellent characteristics can be obtained by making the i-type layer by RF plasma CVD at a deposition rate of 2 nm/sec or less.

Then, photovoltaic elements were fabricated (Element Nos. Example 87-20 to 87-22 and Comparative Example 87-7 to 87-8) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 87-5, except that the layer thickness of the i-type layer was as indicated in Table 56 in making the i-type layer by RF plasma CVD.

For the fabricated photovoltaic elements (Element Nos. Example 87-20 to 87-22 and Comparative Example 87-7 to 87-8), the initial characteristics, the low illuminance characteristic and the durability characteristic were measured in the same manner as in Element No. Example 87-5. The results of measurement are listed in Table 56. As will be seen from Table 56, it has been found that the photovoltaic element provided with the i-type layer by RF plasma CVD having a layer thickness of 30 nm or less (Element Nos. Example 87-20 to 87-22) has excellent characteristics.

Next, using a single crystal silicon substrate, an i-type layer by RF plasma CVD was made 1 µm thick on the substrate under the same fabrication conditions as the i-type layer by RF plasma CVD in Element No. Example 87-5, except that RF discharge power was as indicated in Table 57, whereby samples for the measurement of infrared spectrum were fabricated (Sample Nos. 87-18 to 87-22).

Further, using a single crystal silicon substrate, an i-type layer by microwave plasma CVD was made 1 µm thick on the substrate under the same fabrication conditions as the i-type layer by microwave plasma CVD in Element No. Example 87-5, whereby a sample for the measurement of infrared spectrum was fabricated (Sample No. 87-23).

The fabricated sample for the measurement of infrared spectrum (Sample Nos. 87-18 to 87-23) was installed in an infrared spectrophotometer (1720-X manufactured by PERKIN ELMER) to obtain the value of half-width at a peak of 2000 cm⁻¹ in the infrared absorption spectrum divided by the height of peak. The results are listed in Table 57.

Then, photovoltaic elements were fabricated (Element Nos. Example 87-23 to 87-26) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 87-5, except that RF discharge power was as indicated in Table 57 in making the i-type layer by RF plasma CVD.

For the fabricated photovoltaic element (Element Nos. Example 87-23 to 87-26), the initial characteristics, the low illuminance characteristic and the durability characteristic were measured in the same manner as in Element No. Example 87-5. The results of measurement are listed in Table 57. As will be seen from Table 57, it has been found that the photovoltaic element having a greater value of half-width at a peak of 2000 cm⁻¹ in the infrared absorption spectrum divided by the height of peak in the i-type layer by RF plasma CVD than in the i-type layer by microwave plasma CVD has the excellent characteristics.

From the above measurement results, it has been found that the photovoltaic elements (Element Nos. Example 87-1 to 87-23) of the present invention have more excellent characteristics than the conventional photovoltaic elements (Element Nos. Comparative Example 87-1 to 87-8), wherein the photovoltaic elements of the present invention have been accomplished in that an i-type layer by microwave plasma CVD is formed at an internal pressure of 50 mTorr or less by applying a lower microwave energy and a higher RF energy than the microwave energy necessary to decompose the source gas at 100% to the source gas, and an i-type layer by RF plasma CVD is deposited 30 nm thick or less at a deposition rate of 2 nm/sec or less, in such a manner that the bandgap smoothly changes in a direction of layer thickness, and the minimum value of bandgap takes place at a position biased toward the interface between the p-type layer and the i-type layer off the central position of the i-type layer. Thus, the effects of the-present invention have been evidenced.

### (Example 88)

Photovoltaic elements were fabricated (Element Nos. Exampe 88-1 to 88-8) by forming a reflecting layer, a transparent conductive layer, an n-type layer, an i-type layer, a p-type layer, a transparent electrode, and a collector electrode on the substrate under the same fabrication conditions as those of Element No. Example 87-5 in Example 87, except that after SiH₄ gas flow and GeH₄ gas flow were regulated by the mass flow controllers 1021, 1026 in accordance with the flow patterns as shown in Fig. 14, as in the Example 1, SiH₄ gas flow was maintained at 200 sccm and GeH₄ gas flow at 1 sccm, the region of the maximum value of bandgap was made to have a layer thickness as indicated in Table 58 in making the i-type layer by microwave plasma CVD.

For the fabricated photovoltaic elements (Element Nos. Example 88-1 to 88-8), the initial characteristics, the low illuminance characteristic and the durability characteristic were measured in the same manner as in the Example 1. Its results are listed in Table 58. As will be seen from Table 58, it has been found that the photovoltaic element (Element Nos. Example 88-1 to 88-7) having a layer thickness of 1 to 30 nm in the region of the maximum value of bandgap has excellent characteristics, whereby the effects of the present invention have been evidenced.

### (Example 89)

A photovoltaic element was fabricated (Element No. Example 89) by forming a reflecting layer, a transparent conductive layer, an n-type layer, an i-type layer, a p-type layer, a transparent electrode, and a collector electrode on the substrate under the same fabrication conditions as those of Element No. Example 87-5 in Example 87, except that BF₃(2000 ppm)/H₂ gas flow and PH₃(2000 ppm)/H₂ gas flow were flowed by 0.04 sccm and 0.02 sccm, using BF₃(2000 ppm)/H₂ gas bomb 1077 and PH₃(2000 ppm)/H₂ gas bomb 1078, respectively, in making the i-type layer by RF plasma CVD.

For the photovoltaic element fabricated in Example 89 (Element No. Example 89), the initial characteristics, the low illuminance characteristic and the durability characteristic were measured in the same manner as in the Example 1, and the initial characteristics, low illuminance characteristic and durability characteristic equivalent to those of Element No. Example 87-5 were obtained.

Also, the composition analysis for Element No. Example 89 was performed using a secondary ion mass spectrometer (IMS-3F manufactured by CAMECA), and it was confirmed that B atoms and P atoms were contained in the i-type layer by RF plasma CVD.

### (Example 90)

A photovoltaic element was fabricated (Element No. Example 90) by forming a reflecting layer, a reflection multiplying layer, an n-type layer, an i-type layer, a p-type layer, a transparent electrode, and a collector electrode on the substrate under the same fabrication conditions as those of Example 89, except that using a bomb of AsH₃ gas diluted to 2000 ppm with H₂ gas (hereinafter abbreviated as "AsH₃/H₂"), instead of a bomb of PH₃(2000 ppm)/H₂ gas, AsH₃/H₂ gas was flowed by 0.1 sccm in making the i-type layer by RF plasma CVD.

For the photovoltaic element fabricated in Example 90 (Element No. Example 90), the initial characteristics, the low illuminance characterisitc and the durability characteristic were measured in the same manner as in the Example 1, and the initial characteristics, low illuminance characteristic and durability characteristic equivalent to those of Element No. Example 89 were obtained.

### (Example 91)

A photovoltaic element was fabricated (Element No. Example 91) by forming a reflecting layer, a reflection multiplying layer, an n-type layer, an i-type layer, a p-type layer, a transparent electrode, and a collector electrode on the substrate under the same fabrication conditions as those of Element No. Example 87-5 in Example 87, except that using a bomb of NO/He gas 1079, the flow rate of NO/He gas was 0.5 sccm for the i-type layer by microwave plasma CVD and 0.05 sccm for the i-type layer by RF plasma CVD in making the i-type layer by microwave plasma CVD and the i-type layer by RF plasma CVD.

For the photovoltaic element fabricated (Element No. Example 91), the initial characteristics, the low illuminane characteristic and the durability characteristic were measured in the same manner as in the Example 1, and the initial characteristics, low illuminance characteristic and durability characteristic equivalent to those of Element No. Example 87-5 were obtained.

Also, the composition analysis for Element No. Example 91 was performed using a secondary ion mass spectrometer, and it was confirmed that N atoms and O atoms were contained in the i-type layer.

### (Example 92)

A photovoltaic element was fabricated (Element No. Example 92) by forming a reflecting layer, a reflection multiplying layer, an n-type layer, an i-type layer, a p-type layer, a transparent electrode, and a collector electrode on the substrate under the same fabrication conditions as those of Element No. Example 87-5 in Example 87, except that using a bomb of Si₂H₆ gas, the flow rate of Si₂H₆ gas was 40 sccm and the flow rate of SiH₄ gas was regulated by a mass flow controller 1021 in accordance with a flow pattern as shown in Fig. 25A in making the i-type layer by microwave plasma CVD.

For the photovoltaic element fabricated (Element No. Example 92), the initial characteristics, the low illuminance characteristic and the durability characteristic were measured in the same manner as in the Example 1, and the initial characteristics, low illuminance characteristic and durability characteristic equivalent to those of Element No. Example 87-5 were obtained.

Also, the distribution in layer thickness direction of each of Si atom and hydrogen atom in the i-type layer of the photovoltaic element in the Example 92 (Element No. Example 92) was analyzed using a secondary ion mass spectrometer (IMS-3F manufactured by CAMECA). Its results are drawn in Fig. 25B.

From the above results, it has been found that the photovoltaic element in which the content of hydrogen atom change corresponding to the content of Si atom has excellent characteristics, whereby the effects of the present invention have been evidenced.

### (Example 93)

A photovoltaic element was fabricated (Element No. Example 93) by forming a reflecting layer, a reflection multiplying layer, an n-type layer, an i-type layer, a p-type layer, a transparent electrode, and a collector electrode on the substrate under the same fabrication conditions as those of Element No. Example 87-5 in Example 87, except that the distance between the point of mixing SiH₄ gas and GeH₄ gas and the deposition chamber 1001 in the source gas supply unit 1020 was set as listed in Table 59.

For the photovoltaic element fabricated (Element No. Example 93), the initial characteristics, the low illuminance characteristic and the durability characteristic were measured in the same manner as in the Example 1. The measurement results are listed in Table 59. As will be seen from Table 59, if the distance between the point of mixing SiH₄ gas and GeH₄ gas and the deposition chamber 1001 is 5 m or less, the photovoltaic element having further excellent characteristics can be obtained.

### (Example 94)

A photovoltaic element was fabricated under the same fabrication conditions as in Element No. Example 87-5 of the Example 87, and using this photovoltaic element, a solar cell module was fabricated, whereby an analog clock with a circuit configuration as shown in Fig. 28 was made. In Fig. 28, the electric power generated by a solar cell module 9101 is passed via a reverse current preventing diode 9102 to charge a secondary cell 9104, 9103 is an overchange preventing diode.

The electric power from the solar cell module 9101 and the secondary cell 9104 is supplied to a drive circuit 9105 of the analog clock.

### (Comparative Example 88)

As a comparative example, a photovoltaic element was fabricated under the same fabrication conditions as in Element No. Comparative Example 88-7, and using this photovoltaic element, the same analog clock as in Example 8 was made.

The analog clocks as fabricated in the Example 94 and the Comparative Example 88 were installed on the wall within room, and an indoor lamp was lighted for 8.5 hours a day. As a result, the analog clock of Example 94 worked for all the day, but the analog clock of comparative example did not work all the day, whereby the effects of the power generation system of the present invention could be evidenced.

### (Example 95)

A photovoltaic element was fabricated (Element No. Example 95) by forming a reflecting layer, a reflection multiplying layer, an n-type layer, an i-type layer, a p-type layer, a transparent electrode, and a collector electrode on the substrate under the same fabrication conditions as those of Element No. Example 87-5 in Example 87, except that the flow rates of SiH₄ and GeH₄ gas were regulated by mass flow controllers 1021, 1026 in accordance with the flow patterns as shown in Fig. 26 in making the i-type layer by microwave plasma CVD.

For the photovoltaic element fabricated (Element No. Example 95), the initial characteristics, the low illuminance characteristic and the durability characteristic were measured in the same manner as in the Example 1, and the initial characteristics, low illuminance characteristic and durability characteristic equivalent to those of Element No. Example 87-5 of the Example 87 were obtained, whereby the effects of the present invention could be evidenced.

### (Example 96)

A photovoltaic element was fabricated (Element No. Example 96) by forming a reflecting layer, a reflection multiplying layer, an n-type layer, an i-type layer, a p-type layer, a transparent electrode, and a collector electrode on the substrate under the same fabrication conditions as those of Element No. Example 87-5 in Example 87, except that using a bomb of B₂H₆ gas diluted to 1% with H₂ gas (hereinafter abbreviated as "B₂H₆(1%)/H₂"), instead of a bomb of BF₃(2000 ppm)/H₂ gas, B₂H₆(1%)/H₂ gas for forming the i-type layer by RF plasma CVD was flowed by 0.05 sccm in making the i-type layer by RF plasma CVD.

For the photovoltaic element fabricated (Element No. Example 96), the initial characteristics, the low illuminance characteristic and the durability characteristic were measured in the same manner as in the Example 1, and the initial characteristics, low illuminance characteristic and durability characteristic equivalent to those of Element No. Example 87-5 in the Example 87 were obtained, whereby the effects of the present invention could be evidenced.

### (Example 97)

A photovoltaic element was fabricated (Element No. Example 97) by forming a reflecting layer, a reflecting multiplying layer, an n-type layer, an i-type layer, a p-type layer, a transparent electrode, and a collector electrode on the substrate under the same fabrication conditions as those of Element No. Example 87-5 in Example 87, except that the flow rate of NO/He gas was regulated by a mass flow controller 1029 in accordance with a flow pattern as shown in Figs. 33A and 33B in making the i-type layer by microwave plasma CVD.

For the photovoltaic element fabricated (Element No. Example 97), the initial characteristics, the low illuminance characteristic and the durability characteristic were measured in the same manner as in the Example 1, and the initial characteristics, low illuminance characteristic and durability characteristic equivlant to those of Element No. Example 87-5 in Example 87 were obtained.

Also, the distribution in layer thickness direction of each of N atom and O atom in the i-type layer of the photovoltaic element in the Example 97 (Element No. Example 97) was analyzed using a secondary ion mass spectrometer. Its results are drawn in Figs. 33A and 33B.

From the above results, the effects of the present invention have been evidenced.

### (Example 98)

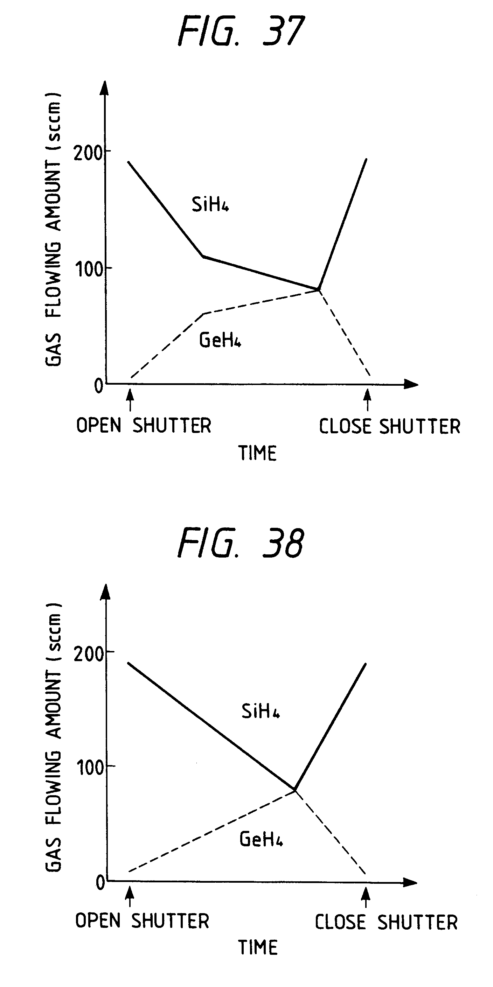

A photovoltaic element was fabricated (Element No. Example 98) by forming a reflecting layer, a reflection multiplying layer, an n-type layer, an i-type layer, a p-type layer, a transparent electrode, and a collector electrode on the substrate under the same fabrication conditions as those of Element No. Example 87-5 in Example 87, except that the flow rates of SiH₄ gas and GeH₄ gas were regulated by mass flow controllers 1021, 1026 in accordance with the flow patterns as shown in Fig. 37 in making the i-type layer by microwave plasma CVD.

For the photvoltaic element fabricated (Element No. Example 98), the initial characteristics, the low illuminance characteristic and the durability characteristic were measured in the same manner as in the Example 1, and the initial characteristics, low illuminance characteristic and durability characteristic equivalent to those of Element No. Example 87-5 of the Example 87 were obtained, whereby the effects of the present invention could be evidenced.

### (Example 99)

A photovoltaic element was fabricated (Element No. Example 99) by forming a reflecting layer, a reflection multiplying layer, an n-type layer, an i-type layer, a p-type layer, a transparent electrode, and a collector electrode on the substrate under the same fabrication conditions as those of Example 95, except that RF bias of the bias power source 1011 was set at 250 mW/cm³, and DC bias was set via a coil for the RF cut at 50 V for the application to the bias rod 1012 in making the i-type layer by microwave plasma CVD.

For the photovoltaic element fabricated (Element No. Example 99), the initial characteristics, the low illuminance characteristic and the durability characteristic were measured in the same manner as in the Example 95, and the initial characteristics, low illuminance characteristic and durability characteristic equivalent to those of the Example 95 were obtained, whereby the effects of the present invention could be evidenced.

### (Example 100)

A photovoltaic element was fabricated (Element No. Example 100) by forming a reflecting layer, a reflection multiplying layer, an n-type layer, an i-type layer, a p-type layer, a transparent electrode, and a collector electrode on the substrate under the same fabrication conditions as those of Element No. Example 87-5 in Example 87, except that using a bomb of D₂ gas, not shown, instead of H₂ gas bomb, D₂ gas was flowed by 300 sccm in making the i-type layer by microwave plasma CVD.

For the photovoltaic element fabricated (Element No. Example 100), the initial characteristics, the low illuminance characteristic and the durability characterisitic were measured in the same manner as in the Example 1, and the initial characteristics, low illuminance characteristic and durability characterisitc equivalent to those of Element No. Example 87-5 in Example 87 were obtained.

Also, the composition analysis of the photovoltaic element in the Example 100 (Element No. Example 100) was performed using a secondary ion mass spectrometer, and it was confirmed that D atoms were contained in the i-type layer, whereby the effects of the present invention could be evidenced.

### (Example 101)

A photovoltaic element was fabricated (Element No. Example 101) by forming a reflecting layer, a reflection multiplying layer, an n-type layer, an i-type layer, a p-type layer, a transparent electrode, and a collector electrode on the substrate under the same fabrication conditions as those of Element No. Example 87-5 in Example 87, except that the DC bias of bias power source 1011 was changed at a constant rate from 50 V to 80 V at the same time when the shutter 1013 was opened in making the n-type layer.

For the photovoltaic element fabricated (Element No. Example 101), the initial characteristics, the low illuminance characteristic and the durability characteristic were measured in the same manner as in the Example 1, and the initial characteristics, low illuminance characteristic and durability characteristic equivalent to those of Element No. Example 87-5 in Example 87 were obtained, whereby the effects of the present invention could be evidenced.

### (Example 102)

Using a manufacturing apparatus with the RF plasma CVD method as shown in Fig. 19, an n-type layer and a p-type layer of a photovoltaic element of the preset invention were fabricated in accordance with the same procedure as that for the i-type layer by RF plasma CVD of the Example 87.

To make the n-type layer, the substrate 1104 was heated to 350°C by the heater 1105, the outflow valves 1042, 1044, 1045 and the auxiliary valve 1108 were gradually opened to flow H₂ gas, PH₃(1%)/H₂ gas and Si₂H₆ gas through the gas introducing pipe 1103 into the deposition chamber 1101. The inflow rates of the gases were regulated by respective mass flow controllers 1022, 1024, 1025 so that the H₂ gas flow, the PH₃(1%)/H₂ gas flow and the Si₂H₆ gas flow were 50 sccm, 5 sccm and 3 sccm, respectively. The pressure within the deposition chamber 1101 was set at 1 Torr by adjusting the opening of conductance valve 1107 while referring to the vacuum gauge 1106.

Thereafter, the electric power of RF power source 1111 was set at 120 mW/cm², an RF electric power was introduced through the RF matching box 1112 into the cathode 1102 to excite an RF glow discharge to start the formation of the n-type layer on the substrate 1104. Upon making the n-type layer having a layer thickness of 10 nm, the RF glow discharge was stopped, and the outflow valves 1042, 1044, 1045 and the auxiliary valve 1108 were closed to stop the gas inflow into the deposition chamber 1101, whereby the formation of the n-type layer was completed.

Then, an i-type layer by RF plasma CVD was formed on the n-type layer under the same fabrication conditions as those of Element No. Example 87-5 in the Example 87.

Then, the substrate 1104 having the i-type layer by RF plasma CVD made thereon was taken out from the deposition chamber 1101, and installed in the deposition apparatus 1000 with the microwave plasma CVD method as used in the Example 87, where an i-type layer by microwave plasma CVD was made on the i-type layer by RF plasma CVD under the same fabrication conditions as those of Element No. Example 87-5 in the Example 87.

Then, the substrate 1004 having the i-type layer by microwave plasma CVD made thereon was taken out from the deposition chamber 1000, and installed in the deposition apparatus 1100 with the RF plasma CVD method, as previously described, where a p-type layer was made on the i-type layer by microwave plasma CVD.

To make the p-type layer, the substrate 1104 was heated to 200°C by the heater 1105, the outflow valves 1041 to 1043 and the auxiliary valve 1108 were gradually opened to flow SiH₄ gas, H₂ gas and BF₃(1%)/H₂ gas, respectively, through the gas introducing tube 1103 into the deposition chamber 1101. The inflow rates of those gases were regulated by respective mass flow controllers 1021 to 1023 so that the SiH₄ gas flow, the H₂ gas flow and BF₃(1%)/H₂ gas flow were 0.5 sccm, 100 sccm and 1 sccm, respectively. The opening of conductance valve 1107 was adjusted by referring to the vacuum gauge 1106 so that the pressure within the deposition chamber 1101 was 1 Torr.

Thereafter, the electric power of RF power source 1111 was set at 2 mW/cm², an RF electric power was introduced through the RF matching box 1112 into the cathode 1102 to excite an RF glow discharge to start the formation of the p-type layer on the i-type layer. Upon making the p-type layer having a layer thickness of 5 nm, the RF glow discharge was stopped, and the outflow valves 1041 to 1043 and the auxiliary valve 1108 were closed to stop the gas inflow into the deposition chamber 1101, whereby the formation of the p-type layer was completed.

Next, on the p-type layer, a transparent electrode and a collector electrode were vapor deposited to fabricate a photovoltaic element (Element No. Example 102). The fabrication conditions for the photovoltaic element as described above are listed in Table 61.

### (Comparative Example 89)

A photovoltaic element was fabricated (Element No. Comparative Example 89) by forming a reflecting layer, a reflection multiplying layer, an n-type layer, an i-type layer, a p-type layer, a transparent electrode, and a collector electrode on the substrate under the same fabrication conditions as those of Example 102, except that the i-type layer by RF plasma CVD was not made.

For the photovoltaic element fabricated (Element Nos. Example 102 and Comparative Example 89), the initial characteristics, the low illuminance characteristic and the durability characteristic were measured in the same manner as in the Example 1. From the measurements, it has been evidenced that the photovoltaic element of Element No. Example 102 was superior to that of Element No. Comparative Example 89, such that the open-circuit voltage and the curve factor of the initial characteristics, the photoelectric conversion efficiency of the low illuminance characteristic, and the decrease in the photoelectric conversion efficiency of the durability characteristic were 1.04 times, 1.03 times, 1.08 times and 1.09 times more excellent, respectively. Thus, the effects of the present invention could be evidenced.

### (Example 103)

A photovoltaic element was fabricated (Element No. Example 103) by forming a reflecting layer, a reflection multiplying layer, a first n-type layer, a first i-type layer, a first p-type layer, a second n-type layer, a second i-type layer, a second p-type layer, a transparent electrode, and a collector electrode on the substrate under the fabrication conditions as listed in Table 62, with the same method as in the Example 1.

### (Comparative Example 90)

A photovoltaic element was fabricated (Element No. Comparative Example 90) by forming a reflecting layer, a reflection multiplying layer, a first n-type layer, a first i-type layer, a first p-type layer, a second n-type layer, a second i-type layer, a second p-type layer, a transparent electrode, and a collector electrode on the substrate under the same fabrication conditions as those of Example 103, except that the first i-type layer 1 and i-type layer 2 by RF plasma CVD were not made.

For the photovoltaic element fabricated (Element No. Example 103 and Comparative Example 90) in the above manner, the initial characteristics, the low illuminance characteristic and the durability characteristic were measured in the same manner as in the Example 1. From the measurements, it has been evidenced that the photovoltaic element of Element No. Example 103 was superior to that of Element No. Comparative Example 90, such that the open-circuit voltage and the curve factor of the initial characteristics, the photoelectric conversion efficiency of the low illuminance characteristic, and the decrease in the photoelectric conversion efficiency of the durability characteristic were 1.03 times, 1.03 times, 1.08 times and 1.10 times more excellent, respectively. Thus, the effects of the present invention could be evidenced.

### (Example 104)

A photovoltaic element was fabricated (Element No. Example 104) by forming a reflecting layer, a reflection multiplying layer, a first n-type layer, a first i-type layer, a first p-type layer, a second n-type layer, a second i-type layer, a second p-type layer, a third n-type layer, a third i-type layer, a third p-type layer, a transparent electrode, and a collector electrode on the substrate under the fabrication conditions as listed in Table 63, with the same method as in the Example 1.

### (Comparative Example 91)

A photovoltaic element was fabricated (Element No. Comparative Example 91) by forming a reflecting layer, a reflection multiplying layer, a first n-type layer, a first i-type layer, a first p-type layer, a second n-type layer, a second i-type layer, a second p-type layer, a third n-type layer, a third i-type layer, a third p-type layer, a transparent electrode, and a collector electrode on the substrate under the same fabrication conditions as above, except that the first i-type layer and the second i-type layer 1 and i-type layer 2 by RF plasma CVD were not made.

For the photovoltaic element fabricated (Element Nos. Example 104 and Comparative Example 91), the initial characteristics, the low illuminance characteristic and the durability characteristic were measured in the same manner as in the Example 1. From the measurements, it has been evidenced that the photovoltaic element of Element No. Example 104 was superior to that of Element No. Comparative Example 91, such that the open-circuit voltage and the curve factor of the initial characteristics, the photoelectric conversion efficiency of the low illuminance characteristics, and the decrease in the photoelectric conversion efficiency of the durability characteristic were 1.03 times, 1.03 times, 1.09 times and 1.07 times more excellent, respectively. Thus, the effects of the present invention could be evidenced.

### (Example 105)

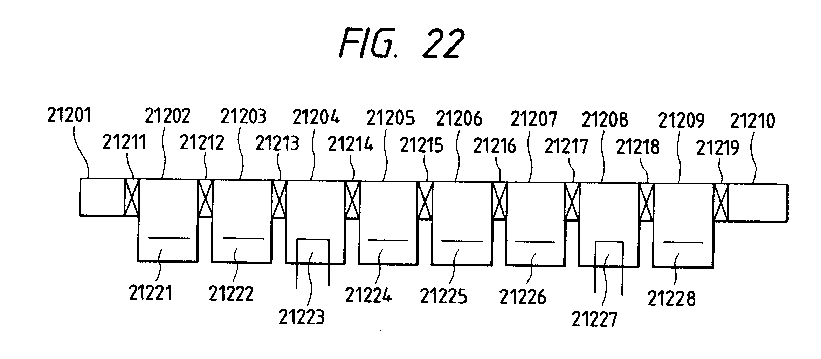

Using a multiple chamber separation-type deposition apparatus as shown in Fig. 22, a photovoltaic element of the present invention was fabricated. In the figure, 21201 and 21210 are a load chamber and an unload chamber, respectively, 21202, 21203, 21205 to 21207 and 21209 are deposition chambers for the layers by RF plasma CVD as in the Example 102, 21204 and 21208 are deposition chambers for the layers by microwave plasma CVD as in the Example 87, 21211 to 21219 are gate valves for separating one chamber from the other, 21221, 21222, 21224 to 21226 and 21228 are cathode electrodes, and 21223 and 21227 are a waveguide portion for microwave and dielectric window.

First, the substrate was installed in the load chamber 21201, and the load chamber 21201 was evacuated of air. Thereafter, a gate valve 21211 was opened, the substrate was then moved to a first n-type layer deposition chamber 21202, and the gate valve 21211 was closed. Next, the first n-type layer was made on the substrate under the same conditions as those of the first n-type layer of Example 103. Then, a gate valve 21212 was opened, the substrate was then moved to a first i-type layer deposition chamber 21203 by RF plasma CVD, and the gate valve 21212 was closed. Next, a first i-type layer 1 by RF plasma CVD was made on the first n-type layer under the same conditions as those of the first i-type layer 1 by RF plasma CVD of Example 103. Next, a gate valve 21213 was opened, the substrate was then moved to a first i-type layer deposition chamber 21204 by microwave plasma CVD, and the gate valve 21213 was closed. Next, a first i-type layer by microwave plasma CVD was made on the first i-type layer 1 by RF plasma CVD under the same conditions as those of the first i-type layer by microwave plasma CVD of Example 103. Then, a gate valve 21214 was opened, the substrate was then moved to a first i-type layer deposition chamber 21205 by RF plasma CVD, and the gate valve 21214 was closed. Next, a first i-type layer 2 by RF plasma CVD was made on the first i-type layer by microwave plasma CVD under the same conditions as those of the first i-type layer 2 by RF plasma CVD of example 103.

Then, a gate valve 21215 was opened, the substrate was then moved to a first p-type layer deposition chamber 21206, and the gate valve 21215 was closed. Next, a first p-type layer was made on the first i-type layer 2 by RF plasma CVD under the same conditions as those of the first p-type layer of Example 103. Next, a gate valve 21216 was opened, the substrate was then moved to a second n-type layer deposition chamber 21207, and the gate valve 21216 was closed. Next, a second n-type layer was made on the first p-type layer under the same conditions as those of the second n-type layer of Example 103. Next, a gate valve 21217 was opened, the substrate was then moved to a second i-type layer deposition chamber 21208, and the gate valve 21217 was closed. Next, a second i-type layer was made on the second n-type layer under the same conditions as those of the second i-type layer of Example 103. Then, a gate valve 21218 was opened, the substrate was then moved to a second p-type layer deposition chamber 21209, and the gate valve 21218 was closed. Next, a second p-type layer was made on the second i-type layer under the same conditions as those of the second p-type layer of Example 103. Then, a gate valve 21219 was opened, the substrate was then moved to an unload chamber 21210, and the gate valve 21219 was closed. Then, the substrate was taken out from the unload chamber 21210, whereby the fabrication of a photovoltaic element was completed (Element No. Example 105).

For the photovoltaic element fabricated (Element No. Example 105), the initial characteristics, the low illuminance characteristic and the durability characteristic were measured in the same manner as in the example 1. From the measurements, it has been found that the photovoltaic element of Example 105 (Element No. Example 105) was superior to that of Example 103 (Element No. Example 103), such that the open-circuit voltage and the curve factor of the initial characteristics, the photoelectric conversion efficiency of the low illuminance characteristic, and the decrease in the photoelectric conversion efficiency of the durability characteristic were 1.01 times, 1.02 times, 1.03 times and 1.02 times more excellent, respectively. Therefore, it has been evidenced that a photovoltaic element of the present invention can exhibit more excellent characteristics by fabricating it in the multiple chamber separation-type deposition chamber. Thus, the effects of the present invention could be evidenced.

### (Example 106)

A photovoltaic element was fabricated under the same fabrication conditions as those of the Example 103, and using the photovoltaic element, a solar cell module was fabricated to make a car-mounted ventilation fan having a circuit configuration as shown in Fig. 28. In Fig. 28, the electric power generated by the solar cell module 9101 which is bonded onto the bonnet of car is charged through a reverse-current preventing diode 9102 into a secondary cell 9104. 9103 is a overcharge preventing diode. The electric power from the solar cell module 9101 and the secondary cell 9104 is supplied to a motor 9105 for the ventilation fan.

### (Comparative Example 92)

As a Comparative Example, a photovoltaic element was fabricated under the same fabrication conditions as those of Comparative Example 90, and a car-mounted ventilation fan similar to that of the Example 106 was made using the photovoltaic element.

A car which has mounted the car-mounted ventilation fans as fabricated in Example 106 and comparative Example 92 was left away in an idling state with the engine rotating for 168 hours, and then left away in fine weather with the ventilation fan working and with the engine stopped, whereafter the temperature within the car was measured. As a result, the car-mounted cooling fan of Example 106 achieved a room temperature three degrees lower than the car-mounted cooling fan of comparative Example 92, whereby the effects of the power generation system of the present invention could be evidenced.

### (Example 107)

Using a manufacturing apparatus with the microwave plasma CVD method comprising a source gas supply unit 1020 and a deposition unit 1000 as shown in Fig. 18 and a manufacturing apparatus with the RF plasma CVD method comprising a source gas supply unit 1020 and a deposition unit 1100 as shown in Fig. 19, a photovoltaic element of the present invention was fabricated. In this example, B and P atoms were doped into the i-type layer by microwave plasma CVD.

On the substrate, a reflecting layer, a reflection multiplying layer, and an n-type layer were formed under the same fabrication conditions as those of Element No. Example 87-5 of the Example 87, and subsequently, the formation of i-type layers by RF plasma CVD and microwave plasma CVD was performed in the following manner.

Then, the substrate 1004 was taken out from the deposition chamber 1001, and installed in the deposition chamber 1101 of the deposition unit 1100 with the RF plasma CVD method as shown in Fig. 19, where an i-type layer by RF plasma CVD was formed.

To make an i-type layer by RF plasma CVD, the substrate 1104 was heated to 350°C by the heater 1105, the outflow valves 1041, 1042, 1047, 1048 and the auxiliary valve 1008 were gradually opened to flow SiH₄ gas, H₂ gas, BF₃(2000 ppm)/H₂ gas, and PH₃(2000 ppm)/H₂ gas respectively through the gas introducing tube 1103 into the deposition chamber 1101. The inflow rates of the gases were regulated by respective mass flow controllers 1021, 1022, 1027, 1028 so that SiH₄ gas flow, H₂ gas flow, BF₃(2000 ppm)/H₂ gas flow, and PH₃(2000 ppm)/H₂ gas flow were 8 sccm, 100 sccm, 0.04 sccm and 1 sccm, respectively. The pressure within the deposition chamber 1101 was set to 0.5 Torr by adjusting the opening of conductance valve 1107 while referring to the vacuum gauge 1106.

Thereafter, the electric power of RF power source 1111 was set at 120mW/cm³, and an RF electric power was introduced through the RF matching box 1112 into the cathode 1102 to excite an RF glow discharge to start fabrication of an i-type layer by RF plasma CVD on the n-type layer. Upon making the i-type layer having a layer thickness of 10nm, the RF glow discharge was stopped, and the outflow valves 1041, 1042 and the auxiliary valve 1108 were closed to stop the gas inflow into the deposition chamber 1101, whereby the formation of the i-type layer was completed.

Then, the substrate 1104 was taken out from the deposition chamber 1101, and installed in the deposition chamber 1001 of the deposition unit 1000 with the microwave plasma CVD method as shown in Fig. 18, where an i-type layer by microwave plasma CVD was formed.

To make an i-type layer by microwave plasma CVD, the substrate 1004 was heated to 350°C by the heater 1005, the outflow valves 1041, 1042, 1046 to 1048 and the auxiliary valve 1008 were gradually opened to flow SiH₄ gas, H₂ gas, GeH₄ gas, BF₃(2000 ppm)/H₂ gas and PH₃(2000 ppm)/H₂ gas through the gas introducing pipe 1003 into the deposition chamber 1001. The inflow rates of the gases were regulated by respective mass flow controllers 1021, 1022, 1026 to 1028 so that the SiH₄ gas flow, the H₂ gas flow, the GeH₄ gas flow, the BF₃(2000 ppm)/H₂ gas flow and the PH₃(2000 ppm)/H₂ gas flow were 200 sccm, 500 sccm, 1 sccm, 0.2 sccm and 0.1 sccm, respectively. The pressure within the deposition chamber 1001 was set to the value as indicated in Table 16 by adjusting the opening of conductance valve 1007 while referring to the vacuum gauge 1006.

Then, shutter 1013 was closed, the electric power of a microwave power source, not shown, was set at 170 mW/cm³, and a microwave electric power was introduced through a waveguide, not shown, the waveguide portion 1010 and the dielectric window 1002 into the deposition chamber 1001 to excite a microwave glow discharge. Then, the RF bias of bias power source 1011 was set at 350 mW/cm³, and the DC bias was set via a coil for the RF cut at 0V, and applied to the bias rod 1012. Thereafter, the shutter 1013 was opened to start fabrication of an i-type layer by microwave plasma CVD on the i-type layer by RF plasma CVD, while at the same time regulating the SiH₄ gas flow and the GeH₄ gas flow in accordance with the flow patterns as indicated in Fig. 14, by means of the mass flow controllers 1021, 1026, respectively. Upon making the i-type layer having a layer thickness of 300 nm, the shutter 1013 was closed, the output of bias power source 1011 was turned off, the microwave glow discharge was stopped, and the outflow valves 1041, 1042, 1046 and the auxiliary valve 1008 were closed to stop the gas inflow into the deposition chamber 1001.

Subsequently, a p-type layer was formed on the i-type layer by RF plasma CVD under the same conditions as those of Example 1. Further, on the p-type layer, a 70 µm-thick ITO (In₂O₃+SnO₂) thin film as the transparent electrode and a 2µm-thick aluminum (Al) thin film as the collector electrode were vapor deposited in vacuum to fabricate photovoltaic elements (Element Nos. Example 104-1 to 104-7 and Comparative Example 93-1).

The initial characteristics, low illuminance characteristic and durability characteristic were measured for the fabricated photovoltaic elements (Element Nos. Example 104-1 to 104-7 and Comparative Example 93-1). The results are listed in Table 64.

As will be seen from Table 64, the photovoltaic element having excellent characteristics can be fabricated by making the i-type layer by microwave plasma CVD under the pressure of the deposition chamber 1001 being 6.7 Pa (50 mTorr) or less.

Next, using a substrate of barium borosilicate glass (7059 manufactured by Corning), an i-type layer by microwave plasma CVD was made on the substrate by opening the shutter 1013 for two minutes under the same fabrication conditions as the i-type layer by microwave plasma CVD in Element No. Example 107-5, except that SiH₄ gas flow and GeH₄ gas flow and the microwave electric power were as indicated in Table 51, whereby the decomposition efficiency of the source gas was obtained in accordance with the layer thickness, and the same results of Table 51 were attained.

Then, photovoltaic elements (Element Nos. Example 107-8 to 107-10 and Comparative Example 93-2 to 93-3) were fabricated by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 107-5, except that the electric power of microwave electric power was as indicated in Table 65, in making the i-type layer by microwave plasma CVD.

For the fabricated photovoltaic elements (Element Nos. Example 107-8 to 107-10 and Comparative Example 93-2 to 93-3), the initial characteristics, the low illuminance characteristic and the durability characteristic were measured in the same manner as in Element No. Example 107-5. The results of measurement are listed in Table 65.

As will be seen from Table 65, it has been found that a photovoltaic element having excellent characteristics can be obtained by decomposing the source gas with a lower microwave energy than the microwave energy necessary to decompose the source gas at 100%.

Then, photovoltaic elements (Element Nos. Example 107-11 to 107-14 and Comparative Example 93-4) were fabricated by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 107-5, except that the RF bias was as indicated in Table 66 in making the i-type layer by microwave plasma CVD.

For the fabricated photovoltaic elements (Element Nos. Example 107-11 to 107-14 and Comparative Example 93-4), the initial characteristics, the low illuminance characteristic and the durability characteristic were measured in the same manner as in Element No. Example 107-5. The results of measurement are listed in Table 66. As will be seen from Table 66, it has been found that the photovoltaic element having excellent characteristics can be obtained by applying a higher RF energy to the source gas than the microwave energy.

Next, using a stainless substrate and a barium borosilicate glass (7059 manufactured by Corning) substrate, an i-type layer was made 1 µm thick on the substrate under the same fabrication conditions as the i-type layer by microwave plasma CVD in Element No. Example 107-5, except that SiH₄ gas flow and GeH₄ gas flow were as indicated in Table 57, whereby a sample for the measurement of material was fabricated. Further, using a barium borosilicate glass (7059 manufactured by Corning) substrate, an i-type layer was made 1 µm thick on the substrate under the same fabrication conditions as the i-type layer by RF plasma CVD in Element No. Example 107-5, whereby a sample for the measurement of material was fabricated.

The bandgap and the composition analysis of the fabricated samples for the measurement of material were conducted to obtain the relation between the composition ratio of Si atom to Ge atom and the bandgap, and the same results as Table 57 were obtained.

Then, a photovoltaic element was fabricated (Element No. Comparative Example 93-5) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 107-5, except that SiH₄ gas flow and GeH₄ gas flow were regulated by the mass flow controllers 1021, 1026 in accordance with the flow patterns as shown in Fig. 14 in making the i-type layer by microwave plasma CVD.

For the fabricated photovoltaic element (Element No. Comparative Example 93-5), the initial characteristics, the low illuminance characteristic and the durability characteristic were measured in the same manner as in Element No. Example 107-5. The results of measurement indicated that the open-circuit voltage and the curve factor in the initial characteristics, the low illuminance characteristic and the durability characteristic in Element No. Example 107-5 were 1.02 times, 1.03 times, 1.09 times and 1.07 times better than those in Element No. Comparative Example 93-5, respectively.

Further, the composition analysis in layer thickness direction of Si atoms and Ge atoms in the i-type layer by microwave plasma CVD in Element No. Example 107-5 and Element No. Comparative Example 93-5 was performed in the same manner as the previous composition analysis. It could be found that the photovoltaic element in Element No. Example 107-5 has the minimum value of bandgap at a position biased toward the interface between the p-type layer and the i-type layer off the central position of the i-type layer, while the photovoltaic element in Element No. Comparative Example 93-5 has the minimum value of bandgap at a position biased toward the interface between the n-type layer and the i-type layer off the central position of the i-type layer.

For the comparison, a photovoltaic element was fabricated (Element No. Example 107-15) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 107-5, except that BF₃(2000 ppm)/H₂ gas and PH₃(2000 ppm)/H₂ gas were not flowed in making the i-type layer by microwave plasma CVD.

For the fabricated photovoltaic element (Element No. Example 107-15), the initial characteristics, the low illuminance characteristic and the durability characteristic were measured in the same manner as in Element No. Example 107-5. From the measurement results, it could be found that the photovoltaic element of Element No. Example 107-5 was superior to that of Element No. Example 107-15, in that in open-circuit voltage and the curve factor of the initial characteristics, the low illuminance characteristic and the durability characteristic were 1.02 times, 1.03 times, 1.09 times and 1.07 times better.

The composition analysis of the photovoltaic element of Element No. Example 107-5 was performed using a secondary ion mass spectrometer, and it was confirmed that B atoms and P atoms were contained in the i-type layer.

Then, photovoltaic elements were fabricated (Element Nos. Example 107-16 to 107-20 and Comparative Example 93-6) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 107-5, except that the SiH₄ gas flow and the RF discharge electric power were as indicated in Table 67 in making the i-type layer by RF plasma CVD.

For the fabricated photovoltaic elements (Element Nos. Example 107-16 to 107-20 and Comparative Example 93-6), the initial characteristics, the low illuminance characteristic and the durability characteristic were measured in the same manner as in Element No. Example 107-5. The results of measurement are listed in Table 67.

As will be seen from Table 67, it has been found that the photovoltaic element having excellent characteristics can be fabricated by making the i-type layer by RF plasma CVD at a deposition rate of 2nm/sec or less.

Then, photovoltaic elements were fabricated (Element Nos. Example 107-21 to 107-23 and Comparative Example 93-7 to 93-8) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 107-5, except that the layer thickness of the i-type layer was as indicated in Table 68 in making the i-type layer by RF plasma CVD.

For the fabricated photovoltaic elements (Element Nos. Example 107-21 to 107-23 and Comparative Example 93-7 to 93-8), the initial characteristics, the low illuminance characteristic and the durability characteristic were measured in the same manner as in Element No. Example 107-5. The results of measurement are listed in Table 68. As will be seen from Table 68, it has been found that the photovoltaic elements (Element Nos. Example 107-21 to 107-23) provided with the i-type layer by RF plasma CVD having a layer thickness of 30nm or less have excellent characteristics.

Then, photovoltaic elements were fabricated (Element Nos. Example 107-24 to 107-27) by forming a reflecting layer, a reflection multiplying layer, an n-type layer, an i-type layer, a p-type layer, a transparent electrode, and a collector electrode on the substrate under the same fabrication conditions as those of the photovoltaic element in Element No. Example 107-5, except that RF discharge electric power was as indicated in Table 69 in making the i-type layer by RF plasma CVD.

For the fabricated photovoltaic elements (Element Nos. Example 107-24 to 107-27), the initial characteristics the low illuminance characteristic and the durability characteristic were measured in the same manner as in Element No. Example 107-5. The results of measurement are listed in Table 69. As will be seen from Table 69, it has been found that the photovoltaic element having a greater value of half-width at a peak of 2000cm⁻¹ in the infrared absorption spectrum divided by the height of peak in the i-type layer by RF plasma CVD than in the i-type layer by microwave plasma CVD has the more excellent characteristics.

From the above measurement results, it has been found that the photovoltaic elements of the present invention have more excellent characteristics as compared with the conventional photovoltaic elements, wherein the photovoltaic elements of the present invention have been accomplished in that an i-type layer by microwave plasma CVD is formed at an internal pressure of 50mTorr or less by applying a lower microwave energy and a higher RF energy than the microwave energy necessary to decompose the source gas at 100% to the source gas, and an i-type layer by RF plasma CVD is deposited 30nm thick or less at a deposition rate of 2nm/sec or less, in such a manner that the bandgap smoothly changes in a direction of layer thickness, and the minimum value of bandgap takes place at a position biased toward the interface between the p-type layer and the i-type layer off the central position of the i-type layer, and wherein a valence electron control agent serving as the donor and the acceptor is doped in the i-type layer. Thus, the effects of the present invention have been evidenced.

### (Example 108)

Photovoltaic elements (Element Nos. Example 108-1 to 108-8) were fabricated in such a manner as to form a reflecting layer, a reflection multiplying layer, an n-type layer, an i-type layer, a p-type layer, a transparent electrode, and a collector electrode on the substrate under the same fabrication conditions as those of Element No. Example 107-5 in the Example 107, except that after SiH₄ gas flow and GeH₄ gas flow were regulated by respective mass flow controllers 1021, 1026 in accordance with the flow patterns as shown in Fig. 14, as conducted in the Example 1, SiH₄ gas flow was maintained at 200sccm and GeH₄ gas flow at 1sccm, and the region of the maximum bandgap was made to have a layer thickness as indicated in Table 70, in making the i-type layer by microwave plasma CVD.

For the fabricated photovoltaic elements (Element Nos. Example 108-1 to 108-8), the initial characteristics, the low illuminance characteristic and the durability characteristic were measured in the same manner as in example 107. The results of measurement are listed in Table 70. As will be seen from Table 70, it has been found that the photovoltaic elements (Element Nos. Example 108-1 to 108-8) having a layer thickness of 1 to 30nm in the region of the maximum bandgap according to the present invention can exhibit more excellent characteristics, whereby the effects of the present invention have been evidenced.

### (Example 109)

A photovoltaic element (Element No. Example 109) was fabricated by forming a reflecting layer, a reflection multiplying layer, an n-type layer, an i-type layer, a p-type layer, a transparent electrode, and a collector electrode on the substrate under the same fabrication conditions as those of Element No. Example 107-5 in Example 107, except that using a bomb of AsH₃/H₂ gas instead of a bomb of PH₃(2000 ppm)/H₂ gas, AsH₃/H₂ gas was flowed by 0.2sccm for the i-type layer by microwave plasma CVD, and by 0.5sccm for the i-type layer by RF plasma CVD, in making the i-type layers by microwave plasma CVD and RF plasma CVD.

For the photovoltaic element fabricated in Example 109 (Element No. Example 109), the initial characteristics, the low illuminance characteristic and the durability characteristic were measured in the same manner as in the Example 107, and the initial characteristics, low illuminance characteristic and durability characteristic equivalent to those of Element No. Example 107-5 were obtained.

### (Example 110)

A photovoltaic element (Element No. Example 110) was fabricated by forming a reflecting layer, a reflection multiplying layer, an n-type layer, an i-type layer, a p-type layer, a transparent electrode, and a collector electrode on the substrate under the same fabrication conditions as those of Element No. Example 107-5 in Example 107, except that BF₃(2000 pm)/H₂ gas flow and PH₃(2000 ppm)/H₂ gas flow were regulated in accordance with a flow pattern as shown in Fig. 41 and a flow pattern as shown in Fig. 42 by the mass flow controllers 1027, 1028, respectively, in making the i-type layer by microwave plasma CVD, and BF₃(2000 ppm)/H₂ gas flow and PH₃(2000 ppm)/H₂ gas flow were flowed by 0.06sccm and 2sccm, in making the i-type layer by RF plasma CVD.

For the photovoltaic element (Element No. Example 110) fabricated in Example 110, the initial characteristics, the low illuminance characteristic and the durability characteristic were measured in the same manner as in the Example 107, and the initial characteristics, low illuminance characteristic and durability characteristic equivalent to those of Element No. Example 107-5 were obtained.

Also, the distribution of B and P atoms in the i-type layer of the photovoltaic element of Example 110 (Element No. Example 110) was analyzed using a secondary ion mass spectrometer. The results are shown in Figs. 43 and 44. From the above results, the effects of the present invention could be evidenced.

### (Example 111)

A photovoltaic element (Element No. Example 111) was fabricated by forming a reflecting layer, a reflection multiplying layer, an n-type layer, an i-type layer, a p-type layer, a transparent electrode, and a collector electrode on the substrate under the same fabrication conditions as those of Element No. Example 107-5 in the Example 107, except that using a bomb of NO/He gas 1079, the flow rate of NO/He gas was 0.5sccm for the i-type layer by microwave plasma CVD and 0.05sccm for the i-type layer by RF plasma CVD, in making the i-type layer by microwave plasma CVD and the i-type layer by RF plasma CVD.

For the photovoltaic element fabricated (Element No. Example 111), the initial characteristics, the low illuminance characteristic and the durability characteristic were measured in the same manner as in the Example 107, and the initial characteristics, low illuminance characteristic and durability characteristic equivalent to those of Element No. Example 107-5 were obtained.

Also, the composition analysis for the photovoltaic element of the Example 111 was performed using a secondary ion mass spectrometer, and O and N atoms were confirmed in the i-type layer.

### (Example 112)

A photovoltaic element (Element No. Example 112) was fabricated by forming a reflecting layer, a reflection multiplying layer, an n-type layer, an i-type layer, a p-type layer, a transparent electrode, and a collector electrode on the substrate under the same fabrication conditions as those of Element No. Example 107-5 in Example 107, except that using a bomb of Si₂H₆ gas, the flow rate of Si₂H₆ gas was 40sccm and the flow rate of SiH₄ gas was regulated by a mass flow controller 1021 in accordance with a flow pattern as shown in Figs. 25A and 25B, in making the i-type layer by microwave plasma CVD.

For the photovoltaic element fabricated (Element No. Example 112), the initial characteristics, the low illuminance characteristic and the durability characteristic were measured in the same manner as in the Example 107, and the initial characteristics, low illuminance characteristic and durability characteristic equivalent to those of Element No. Example 107-5 were obtained.

Also, the distribution in layer thickness direction of each of Si atom and hydrogen atom in the i-type layer of the photovoltaic element in the Example 112 (Element No. Example 112) was analyzed using a secondary ion mass spectrometer (IMS-3F manufactured by CAMECA), resulting in the same tendency as indicated in Figs. 25A and 25B.

From the above results, it has been found that the photovoltaic element in which the content of hydrogen atom changes in correspondence with the content of Si atom, whereby the effects of the present invention have been evidenced.

### (Example 113)

Photovoltaic elements (Element Nos. Example 113-1 to 113-5) was fabricated by forming a reflecting layer, a reflection multiplying layer, an n-type layer, an i-type layer, a p-type layer, a transparent electrode, and a collector electrode on the substrate under the same fabrication conditions as those of Element No. Example 107-5 in the Example 107, except that the distance between the mixing point of SiH₄ gas and GeH₄ gas and the deposition chamber 1001 in the source gas supply unit 1020 was set to the value as indicated in Table 71.

For the photovoltaic elements fabricated (Element Nos. Example 113-1 to 113-5), the initial characteristics, the low illuminance characteristic and the durability characteristic were measured in the same manner as in the Example 107. The measurement results are listed in Table 71. As will be seen from Table 71, it has been found that by making the distance between the mixing point of SiH₄ gas and GeH₄ gas and the deposition chamber 1001 equal to or less than 5m, the photovoltaic element having further excellent characteristics can be obtained.

### (Example 114)

A photovoltaic element was fabricated under the same fabrication conditions as those of Element Nos. Example 107-5 and 107-15 of the Example 107, whereby a solar cell module was fabricated using this photovoltaic element, and an analog clock with a circuit configuration as shown in Fig. 28 was made.

The analog clocks as fabricated were installed on the wall within room, so that the analog clock using Element No. Example 107-5 exhibited more excellent performance than the analog clock using Element No. Example 107-15.

### (Example 115)

A photovoltaic element (Element No. Example 115) was fabricated by forming a reflecting layer, a reflection multiplying layer, an n-type layer, an i-type layer, a p-type layer, a transparent electrode, and a collector electrode on the substrate under the same fabrication conditions as those of Element No. Example 107-5 in the Example 107, except that the flow rates of SiH₄ gas and GeH₄ gas were regulated by mass flow controllers 1021, 1026 in accordance with the flow patterns as shown in Fig. 26 in making the i-type layer by microwave plasma CVD.

For the photovoltaic element fabricated (Element No. Example 115), the initial characteristics, the low illuminance characteristic and the durability characteristic were measured in the same manner as in the Example 107, and the initial characteristics, low illuminance characteristic and durability characteristic equivalent to those of Element No. Example 107-5 in the Example 107 were obtained, whereby the effects of the present invention could be evidenced.

### (Example 116)

A photovoltaic element (Element No. Example 116) was fabricated by forming a reflecting layer, a reflection multiplying layer, an n-type layer, an i-type layer, a p-type layer, a transparent electrode, and a collector electrode on the substrate under the same fabrication conditions as those of Element No. Example 107-5 in Example 107, except that using a bomb of B₂H₆ gas diluted to 2000 ppm with H₂ gas (B₂H₆/H₂ gas), instead of a bomb of BF₃/H₂ gas, B₂H₆/H₂ gas was flowed by 1sccm for forming the i-type layer by microwave plasma CVD, and B₂H₆/H₂ gas was flowed by 0.05 sccm for forming the i-type layer by RF plasma CVD, in making the i-type layers by microwave plasma CVD and RF plasma CVD.

For the photovoltaic element fabricated (Element No. Example 116), the initial characteristics, the low illuminance characteristic and the durability characteristic were measured in the same manner as in the example 107, and the initial characteristics, low illuminance characteristic and durability characteristic equivalent to those of Element No. Example 107-5 in the Example 107 were obtained, whereby the effects of the present invention could be evidenced.

### (Example 117)

A photovoltaic element (Element No. Example 117) was fabricated by forming a reflecting layer, a reflection multiplying layer, an n-type layer, an i-type layer, a p-type layer, a transparent electrode, and a collector electrode on the substrate under the same fabrication conditions as those of Element No. Example 107-5 in the Example 107, except that the flow rate of NO/He gas was regulated by a mass flow controller 1029 in accordance with a flow pattern as shown in Figs. 33A and 33B, in making the i-type layer by microwave plasma CVD.

For the photovoltaic element fabricated (Element No. Example 117), the initial characteristics, the low illuminance characteristic and the durability characteristic were measured in the same manner as in the Example 107, and the initial characteristics, low illuminance characteristic and durability characteristic equivalent to those of Element No. Example 107-5 in the Example 107 were obtained.

Also, the distribution in layer thickness direction of each of N atom and O atom in the i-type layer of the photovoltaic element in the Example 117 (Element No. Example 117) was analyzed using a secondary ion mass spectrometer, resulting in the same tendency as indicated in Figs. 33A and 33B.

From the above results, the effects of the present invention could be evidenced.

### (Example 118)

A photovoltaic element (Element No. Example 118) was fabricated by forming a reflecting layer, a reflection multiplying layer, an n-type layer, an i-type layer, a p-type layer, a transparent electrode, and a collector electrode on the substrate under the same fabrication conditions as those of Element No. Example 107-5 in the Example 107, except that the flow rates of SiH₄ gas and GeH₄ gas were regulated by mass flow controllers 1021, 1026 in accordance with the flow patterns as shown in Fig. 37, and the i-type layer by RF plasma CVD was formed under the fabrication conditions of Table 60 after the formation of the i-type layer by microwave plasma CVD, in making the i-type layer by microwave plasma CVD.

For the photovoltaic element fabricated (Element No. Example 118), the initial characteristics, the low illuminance characteristic and the durability characteristic were measured in the same manner as in the Example 107, and the initial characteristics, low illuminance characteristic and durability characteristic equivalent to those of Element No. Example 107-5 in the Example 107 were obtained, whereby the effects of the present invention could be evidenced.

### (Example 119)

A photovoltaic element (Element No. Example 119) was fabricated by forming a reflecting layer, a reflection multiplying layer, an n-type layer, an i-type layer, a p-type layer, a transparent electrode, and a collector electrode on the substrate under the same fabrication conditions as those of Example 115, except that RF bias of the bias power source 1011 was set at 250mW/cm³, and DC bias was set via a coil for the RF cut a 50V for the application to the bias rod 1012, in making the i-type layer by microwave plasma CVD.

For the photovoltaic element fabricated (Element No. Example 119), the initial characteristics, the low illuminance characteristic and the durability characteristic were measured in the same manner as in the Example 115, and the initial characteristics, low illuminance characteristic and durability characteristic equivalent to those of the Example 115 were obtained, whereby the effects of the present invention could be evidenced.

### (Example 120)

A photovoltaic element (Element No. Example 120) was fabricated by forming a reflecting layer, a reflection multiplying layer, an n-type layer, an i-type layer, a p-type layer, a transparent electrode, and a collector electrode on the substrate under the same fabrication conditions as those of Element No. Example 107-5 in the Example 107, except that using a bomb of D₂ gas, not shown, instead of H₂ gas bomb, D₂ gas was flowed by 300sccm, in making the i-type layer by microwave plasma CVD.

For the photovoltaic element fabricated (Element No. Example 120), the initial characteristics, the low illuminance characteristic and the durability characteristic were measured in the same manner as in the Example 107, and the initial characteristics, low illuminance characteristic and durability characteristic equivalent to those of Element No. Example 107-5 in the Example 107 were obtained.

Also, the composition analysis of the photovoltaic element in the Example 120 (Element No. Example 120) was performed using a secondary ion mass spectrometer, and it was confirmed that D atoms were contained in the i-type layer, whereby the effects of the present invention could be evidenced.

### (Example 121)

A photovoltaic element (Element No. Example 121) was fabricated by forming a reflecting layer, a reflection multiplying layer, an n-type layer, an i-type layer, a p-type layer, a transparent electrode, and a collector electrode on the substrate under the same fabrication conditions as those of Element No. Example 107-5 in the Example 107, except that the DC bias of bias power source 1011 was changed at a constant rate from 50V to 80V at the same time when the shutter 1013 was opened, in making the n-type layer.

For the photovoltaic element fabricated (Element No. Example 121), the initial characteristics, the low illuminance characteristic and the durability characteristic were measured in the same manner as in the Example 107, and the initial characteristics, low illuminance characteristic and durability characteristic equivalent to those of Element No. Example 107-5 in the Example 107 were obtained, whereby the effects of the present invention could be evidenced.

### (Example 122)

A photovoltaic element (Element No. Example 122-1) was fabricated by forming an n-type layer and a p-type layer under the same fabrication conditions as those of Example 102, and other layers under the same conditions as those of Element No. Example 107-5 in the Example 44.

A photovoltaic element (Element No. Example 122-2) was fabricated by forming a reflecting layer, a reflection multiplying layer, an n-type layer, an i-type layer, a p-type layer, a transparent electrode, and a collector electrode on the substrate under the same fabrication conditions as those of Example 122-1, except that BF₃(2000 ppm)/H₂ gas and PH₃(2000 ppm)/H₂ gas were not used, in making the i-type layer by microwave plasma CVD.

For the photovoltaic elements fabricated (Element Nos. Example 122-1 to 122-2), the initial characteristics, the low illuminance characteristic and the durability characteristic were measured in the same manner as in the Example 107. From the measurement results, it could be evidenced that the photovoltaic element of Element No. Example 122-1 was 1.03 times better in the open-circuit voltage and 1.04 times better in the curve factor of the initial characteristics, 1.09 times better in the photovoltaic conversion efficiency of the low illuminance characteristic, and 1.08 times better in the decrease in the photovoltaic conversion efficiency of the durability characteristic than the photovoltaic element of Element No. Example 122-2, whereby the effects of the present invention could be evidenced.

### (Example 123)

A photovoltaic element (Element No. Example 123-1) was fabricated by forming a reflecting layer, a reflection multiplying layer, a first n-type layer, a first i-type layer, a first p-type layer, a second n-type layer, a second i-type layer, a second p-type layer, a transparent electrode, and a collector electrode on the substrate under the fabrication conditions as listed in Table 72, with the same method as the Example 107.

A photovoltaic element (Element No. Example 123-2) was fabricated by forming a reflecting layer, a reflection multiplying layer, a first n-type layer, a first i-type layer, a first p-type layer, a second n-type layer, a second i-type layer, a second p-type layer, a transparent electrode, and a collector electrode on the substrate under the same fabrication conditions as those of Example 123-1, except that BF₃(2000 ppm)/H₂ gas and PH₃(2000 ppm)/H₂ gas were not used, in making the first i-type layer by microwave plasma CVD.

For the photovoltaic elements fabricated (Element Nos. Example 123-1 to 123-2), the initial characteristics, the low illuminance characteristic and the durability characteristic were measured in the same manner as in the Example 107. From the measurement results, it could be evidenced that the photovoltaic element of Element No. Example 123-1 was 1.04 times better in the open-circuit voltage and 1.03 times better in the curve factor of the initial characteristics, 1.08 times better in the photovoltaic conversion efficiency of the low illuminance characteristic, and 1.09 times better in the decrease in the photovoltaic conversion efficiency of the durability characteristic than the photovoltaic element of Element No. Example 123-2, whereby the effects of the present invention could be evidenced.

### (Example 124)

A photovoltaic element (Element No. Example 124-1) was fabricated by forming a reflecting layer, a reflection multiplying layer, a first n-type layer, a first i-type layer, a first p-type layer, a second n-type layer, a second i-type layer, a second p-type layer, a third n-type layer, a third i-type layer, a third p-type layer, a transparent electrode, and a collector electrode on the substrate under the same fabrication conditions as listed in Table 73, with the same method as the Example 107.

A photovoltaic element (Element No. Example 124-2) was fabricated by forming a reflecting layer, a reflection multiplying layer, a first n-type layer, a first i-type layer, a first p-type layer, a second n-type layer, a second i-type layer, a second p-type layer, a third n-type layer, a third i-type layer, a third p-type layer, a transparent electrode, and a collector electrode on the substrate under the same fabrication conditions as those of Example 124-1, except that BF₃(2000 ppm)/H₂ gas and PH₃(2000 ppm)/H₂ gas were not used, in making the first and second i-type layers by microwave plasma CVD.

For the photovoltaic elements fabricated (Element Nos. Example 124-1 to 124-2), the initial characteristics, the low illuminance characteristic and the durability characteristic were measured in the same manner as in the Example 107. From the measurement results, it could be evidenced that the photovoltaic element of Element No. Example 124-1 was 1.03 times better in the open-circuit voltage and 1.04 times better in the curve factor of the initial characteristics, 1.08 times better in the photovoltaic conversion efficiency of the low illuminance characteristic, and 1.07 times better in the decrease in the photovoltaic conversion efficiency of the durability characteristic than the photovoltaic element of Element No. Example 124-2, whereby the effects of the present invention could be evidenced.

### (Example 125)

A photovoltaic element of the present invention was fabricated using a multiple chamber separation-type deposition apparatus as shown in Fig. 22. The photovoltaic element (Element No. Example 125) was made in accordance with a procedure of Example 105 under the same layer forming conditions as those of the example 123.

For the photovoltaic element fabricated (Element No. Example 125), the initial characteristics, the low illuminance characteristic and the durability characteristic were measured in the same manner as in the example 107. From the measurement results, it could be evidenced that the photovoltaic element (Element No. Example 125) of the Example 125 was 1.01 times better in the open-circuit voltage and 1.02 times better in the curve factor of the initial characteristics, 1.02 times better in the photovoltaic conversion efficiency of the low illuminance characteristic, and 1.03 times better in the decrease in the photovoltaic conversion efficiency of the durability characteristic than the photovoltaic element (Element No. Example 123) of the Example 123, whereby the photovoltaic of the present invention could have more excellent characteristics by fabricating it in the multiple chamber separation-type deposition apparatus, whereby the effects of the present invention could be evidenced.

### (Example 126)

A photovoltaic element was fabricated under the same fabrication conditions as those of Element Nos. Example 123-1 to 123-2, whereby a solar cell module was made using the photovoltaic element, and a car-mounted ventilation fan having a circuit configuration as shown in Fig. 28 was produced.

A car which has mounted the car-mounted ventilation fans utilizing Element Nos. Example 123-1 to 123-2 was left away in an idling state with the engine rotating for 168 hours, and then left away in fine weather with the ventilation fan working and with the engine stopped, whereafter the temperature within the car room was measured. As a result, the car-mounted cooling fan of Element No. Example 123-1 achieved a room temperature three degrees lower than the car-mounted cooling fan of Element No. Example 123-2.

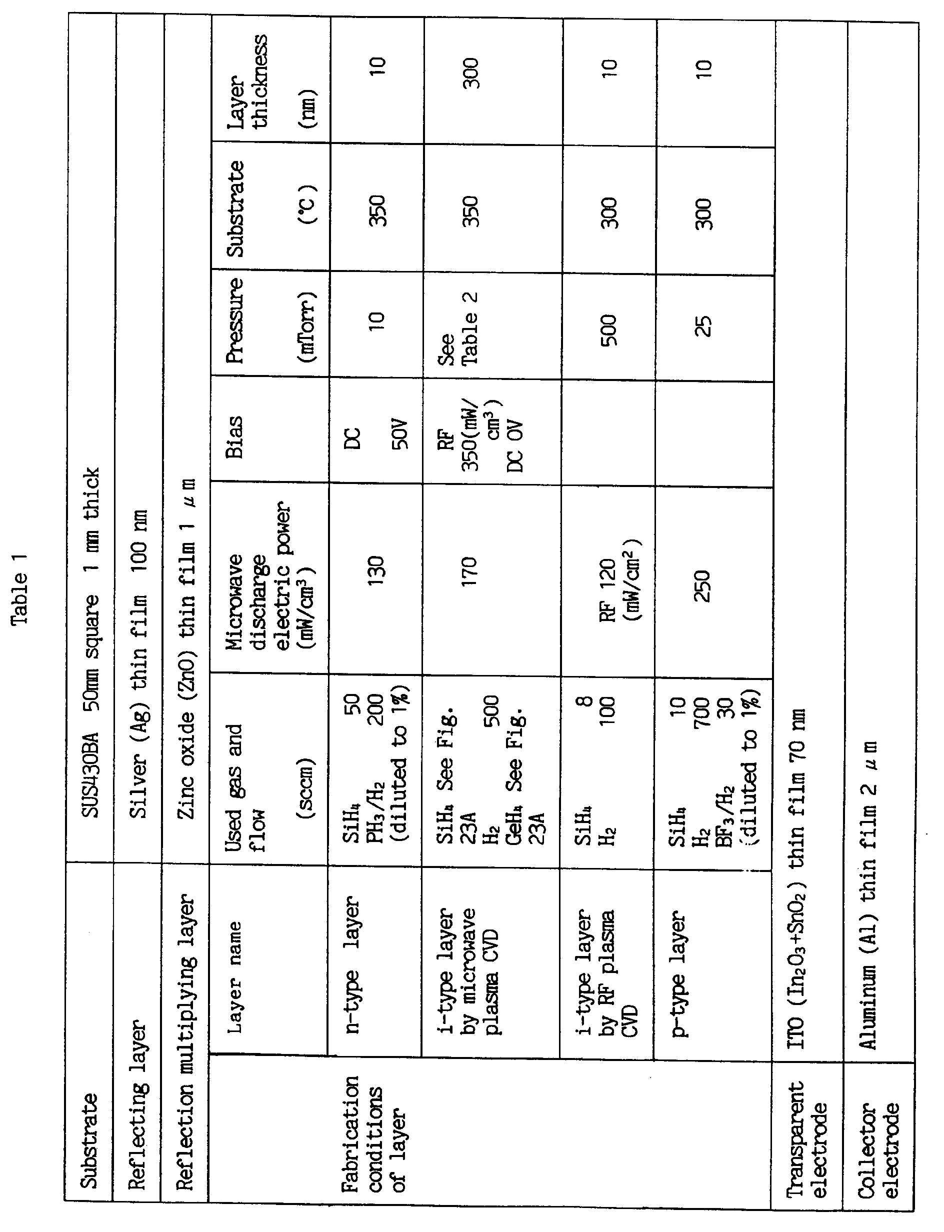

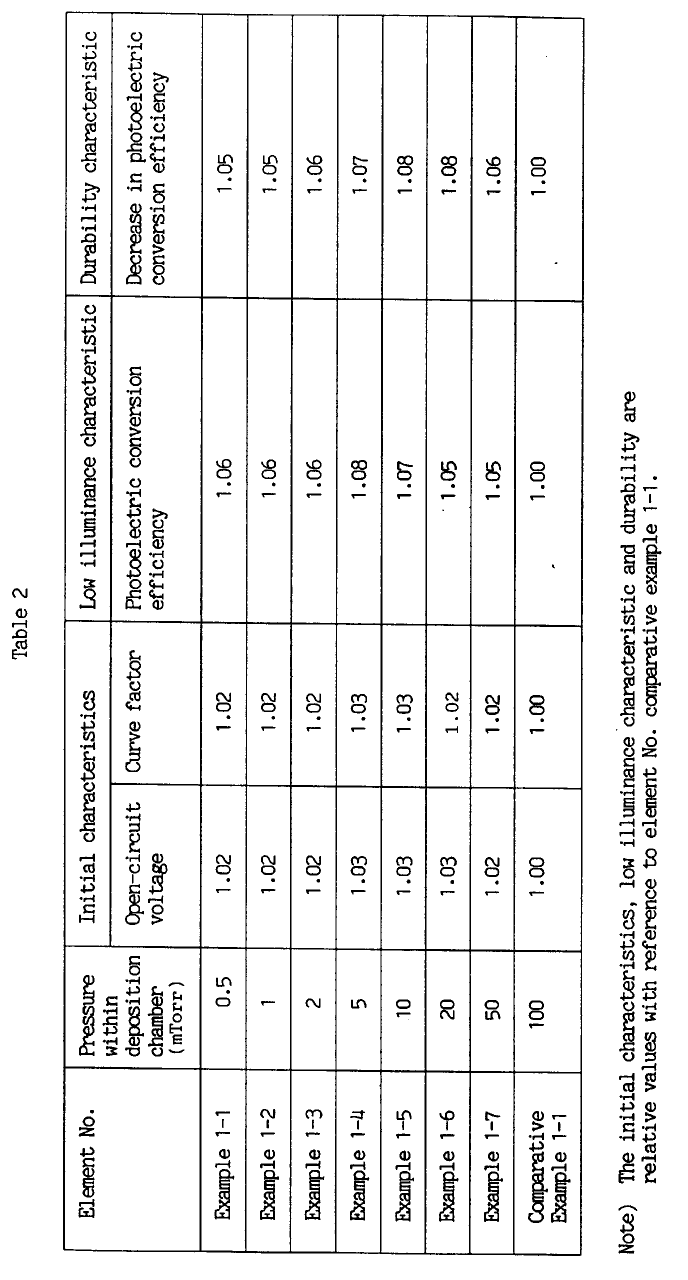

**Table 3**

| Sample No. | Gas flow rate (sccm) | | Decomposition efficiency of source gas at each microwave electric power (W/cm³) (%) | | | | |
|---|---|---|---|---|---|---|---|
| | SiH₄ | GeH₄ | 0.1 | 0.2 | 0.3 | 0.4 | 0.5 |
| 1 - 1 | 200 | 1 | 24 | 45 | 68 | 93 | 100 |
| 1 - 2 | 170 | 20 | 25 | 48 | 73 | 97 | 100 |
| 1 - 3 | 140 | 40 | 27 | 51 | 76 | 99 | 100 |
| 1 - 4 | 110 | 60 | 28 | 53 | 81 | 100 | 100 |
| 1 - 5 | 80 | 80 | 31 | 58 | 88 | 100 | 100 |

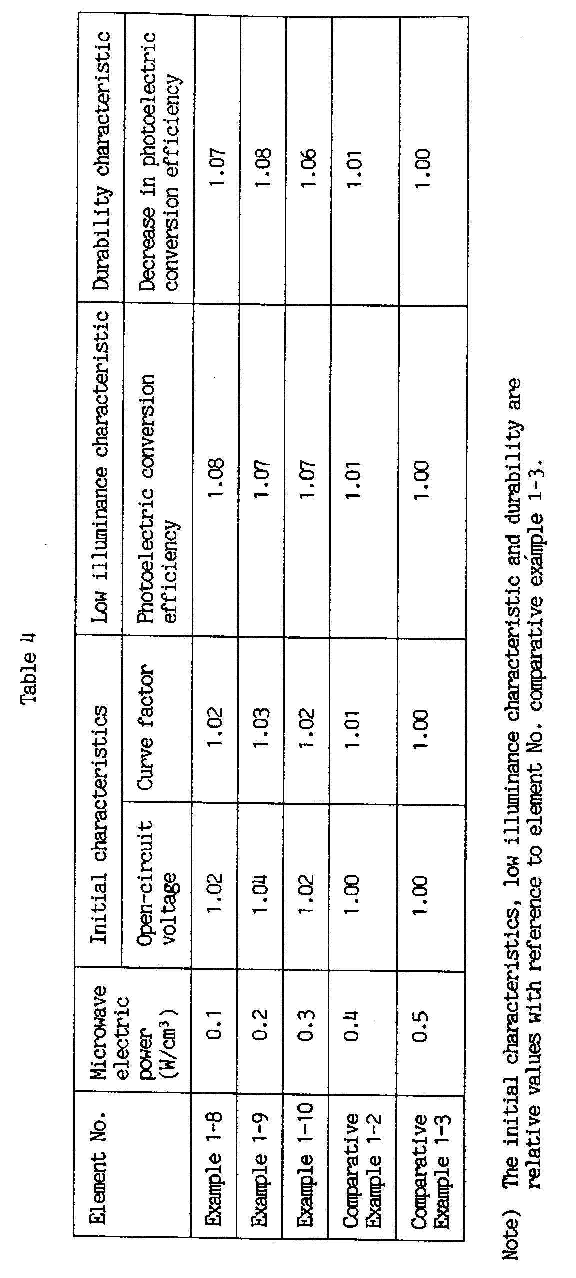

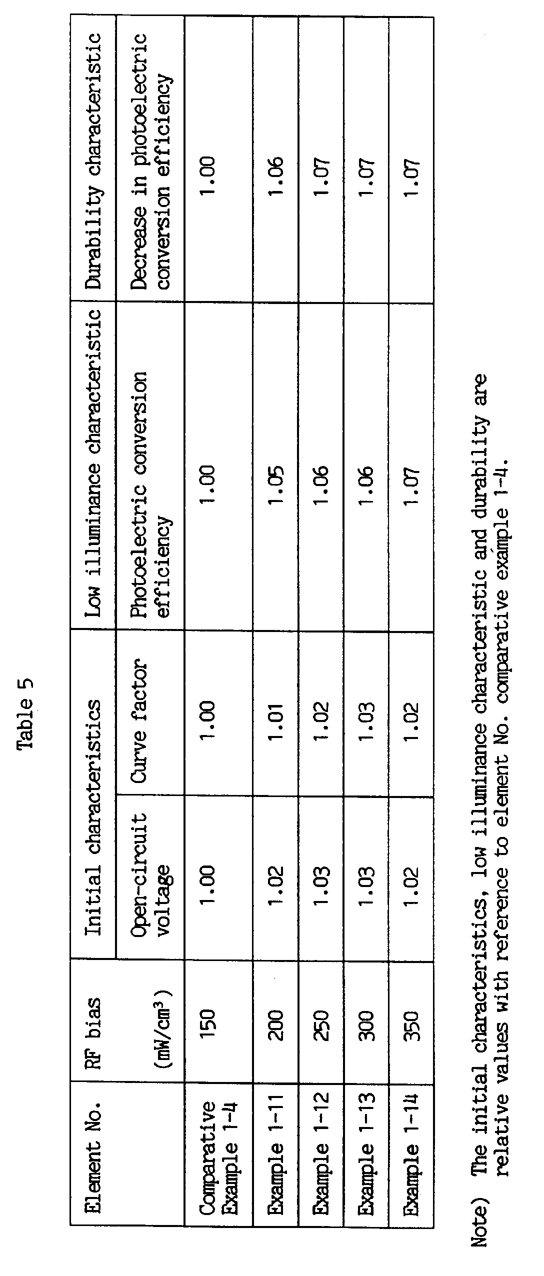

**Table 6**

| Sample No. | Gas flow rate (sccm) | | Bandgap (eV) | Composition ratio | |
|---|---|---|---|---|---|
| | SiH₄ | GeH₄ | | Si | Ge |
| 1-6 | 200 | 1 | 1.71 | 100 | 1 |
| 1-7 | 170 | 20 | 1.60 | 8.7 | 1 |
| 1-8 | 140 | 40 | 1.52 | 3.3 | 1 |
| 1-9 | 110 | 60 | 1.45 | 1.9 | 1 |
| 1-10 | 80 | 80 | 1.38 | 1.1 | 1 |
| 1-11 | | | 1.69 | | |

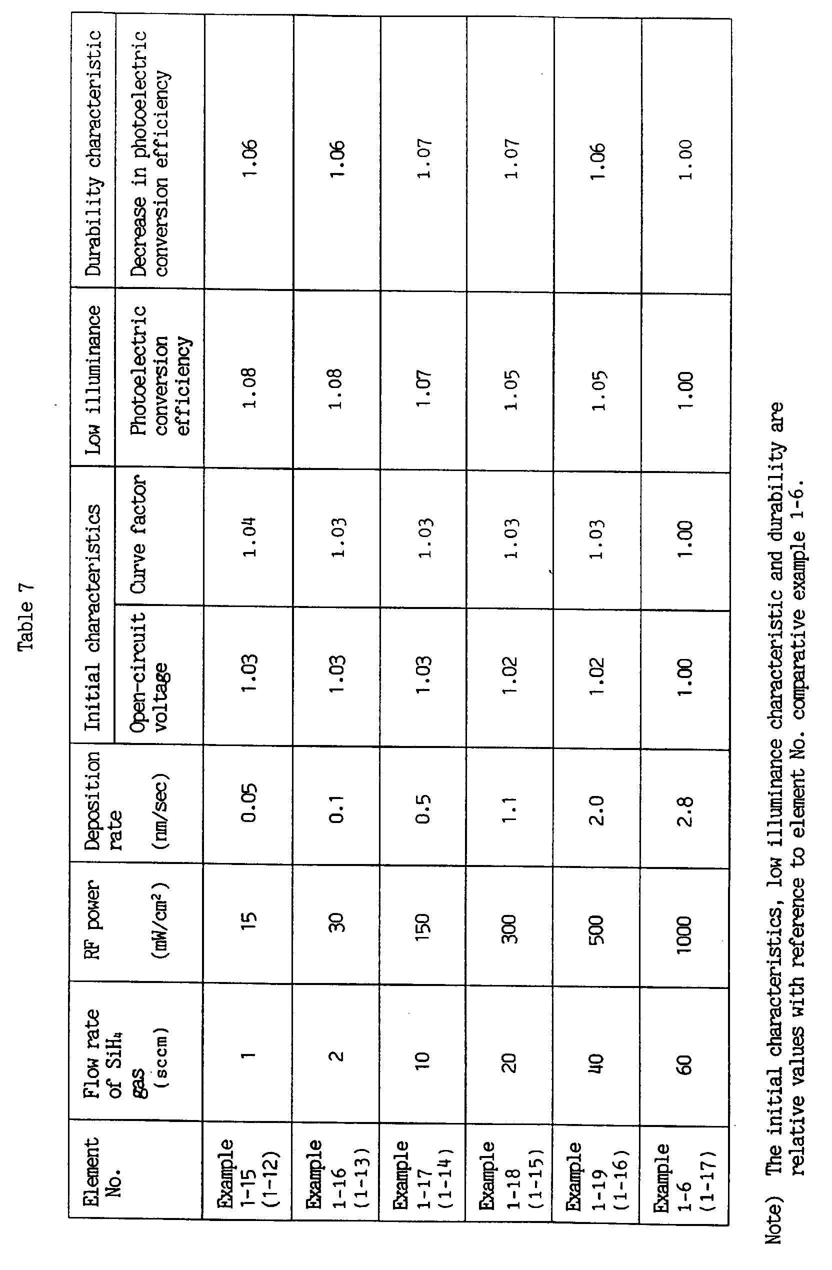

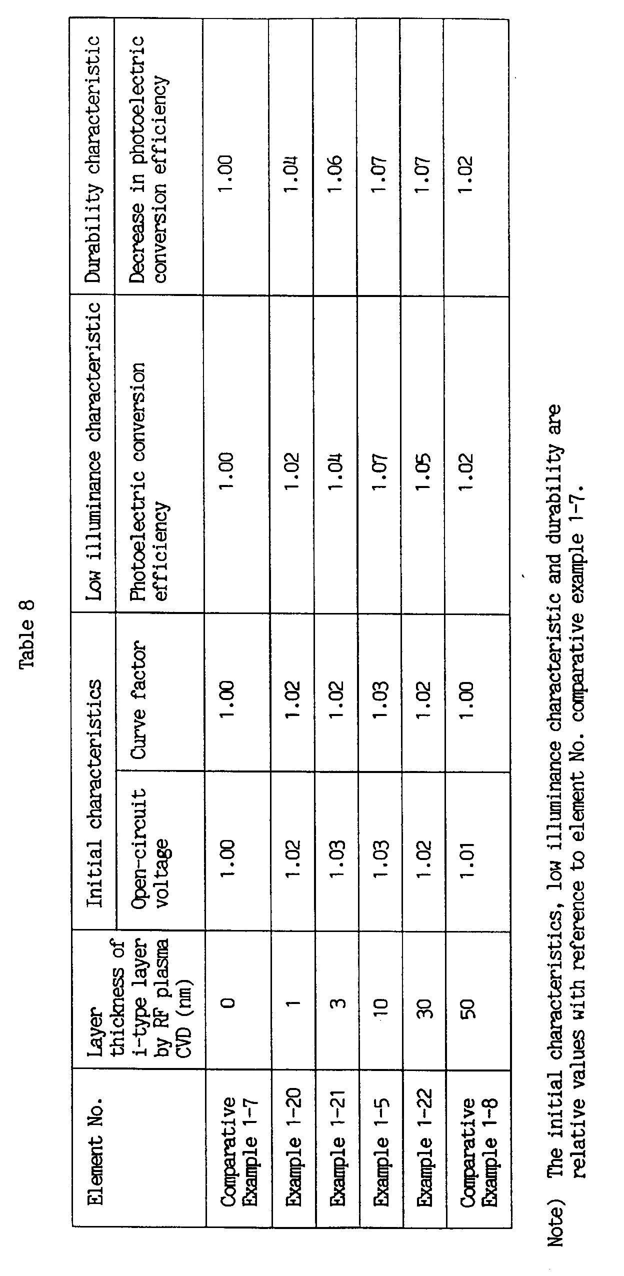

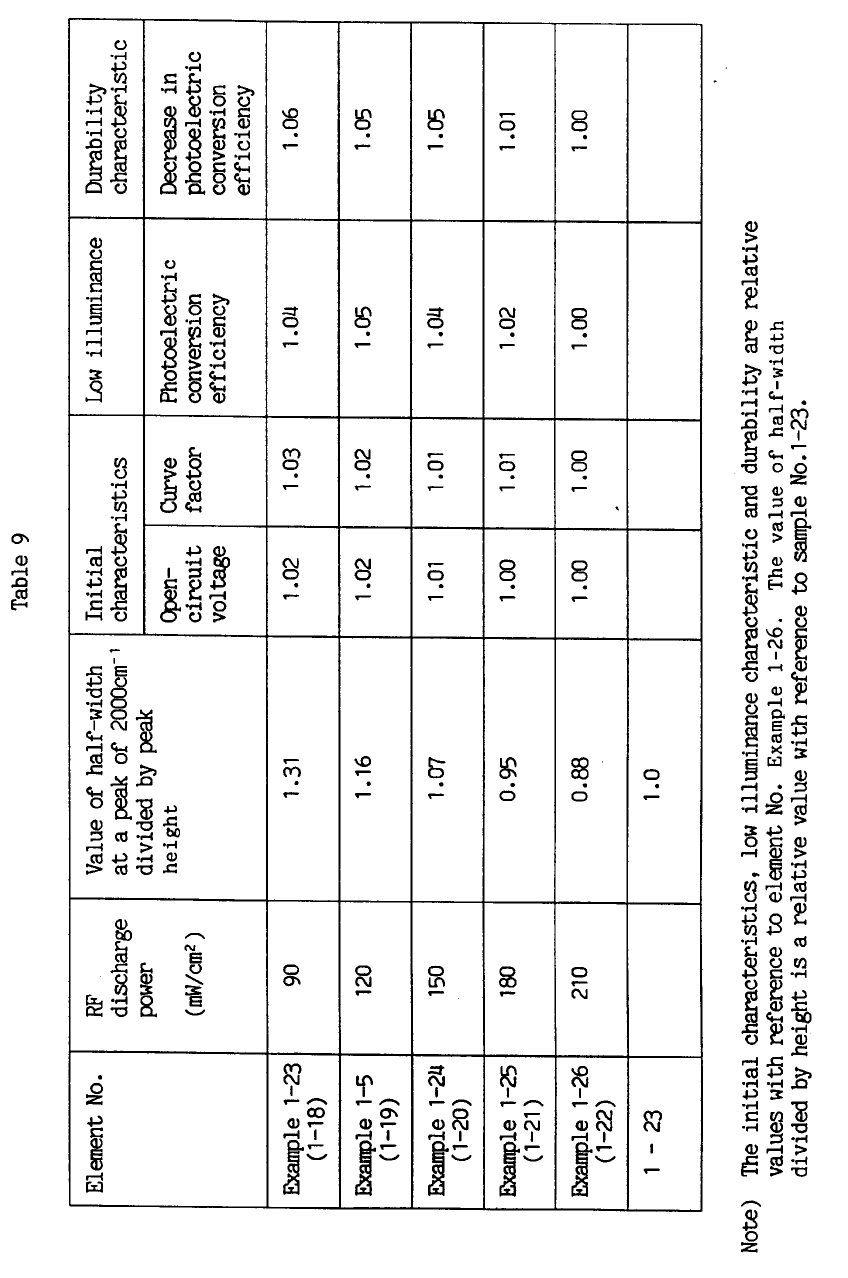

**Table 10**

| Element No. | Layer thickness of the region at maximum bandgap (nm) | Initial characteristics | | Low illuminance | Durability characteristic |
|---|---|---|---|---|---|
| | | Open-circuit voltage | Curve factor | Photoelectric conversion efficiency | Decrease in photoelectric conversion efficiency |
| Example 2-1 | 1 | 1.01 | 1.02 | 1.03 | 1.02 |
| Example 2-2 | 2 | 1.02 | 1.03 | 1.05 | 1.04 |
| Example 2-3 | 3 | 1.03 | 1.03 | 1.06 | 1.06 |
| Example 2-4 | 5 | 1.03 | 1.03 | 1.05 | 1.07 |
| Example 2-5 | 10 | 1.04 | 1.03 | 1.05 | 1.06 |
| Example 2-6 | 20 | 1.03 | 1.02 | 1.04 | 1.05 |
| Example 2-7 | 30 | 1.02 | 1.02 | 1.04 | 1.04 |
| Example 2-8 | 50 | 1.00 | 1.00 | 1.00 | 1.00 |
| Note) The initial characteristics, low illuminance characteristic and durability are relative values with reference to element No. example 2-8. | | | | | |

**Table 11**

| Element No. | Distance between mixing point of gases and deposition chamber (m) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Example 7-1 | 1 | 1.03 | 1.04 | 1.05 | 1.07 |
| Example 7-2 | 2 | 1.02 | 1.03 | 1.05 | 1.06 |
| Example 7-3 | 3 | 1.02 | 1.03 | 1.03 | 1.05 |
| Example 7-4 | 5 | 1.02 | 1.02 | 1.03 | 1.03 |
| Example 7-5 | 8 | 1.00 | 1.00 | 1.00 | 1.00 |
| Note) The initial characteristics, low illuminance characteristic and durability are relative values with reference to element No. example 7-5. | | | | | |

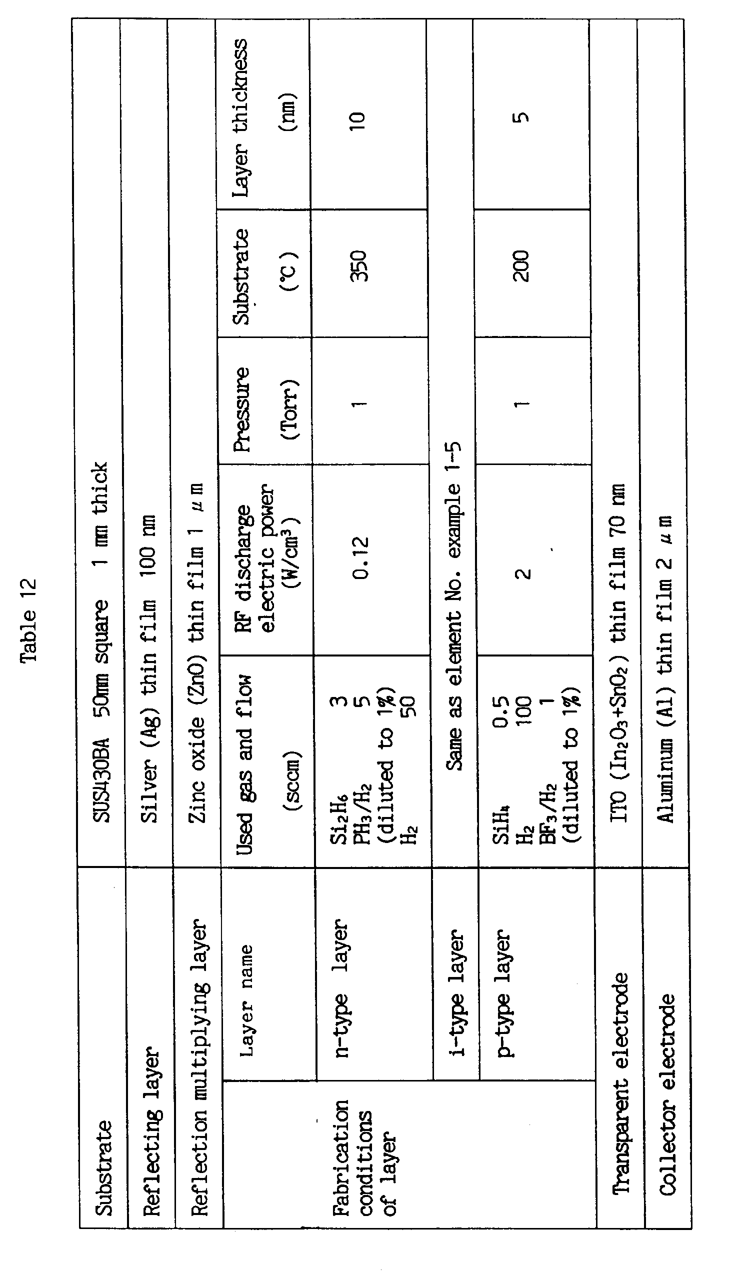

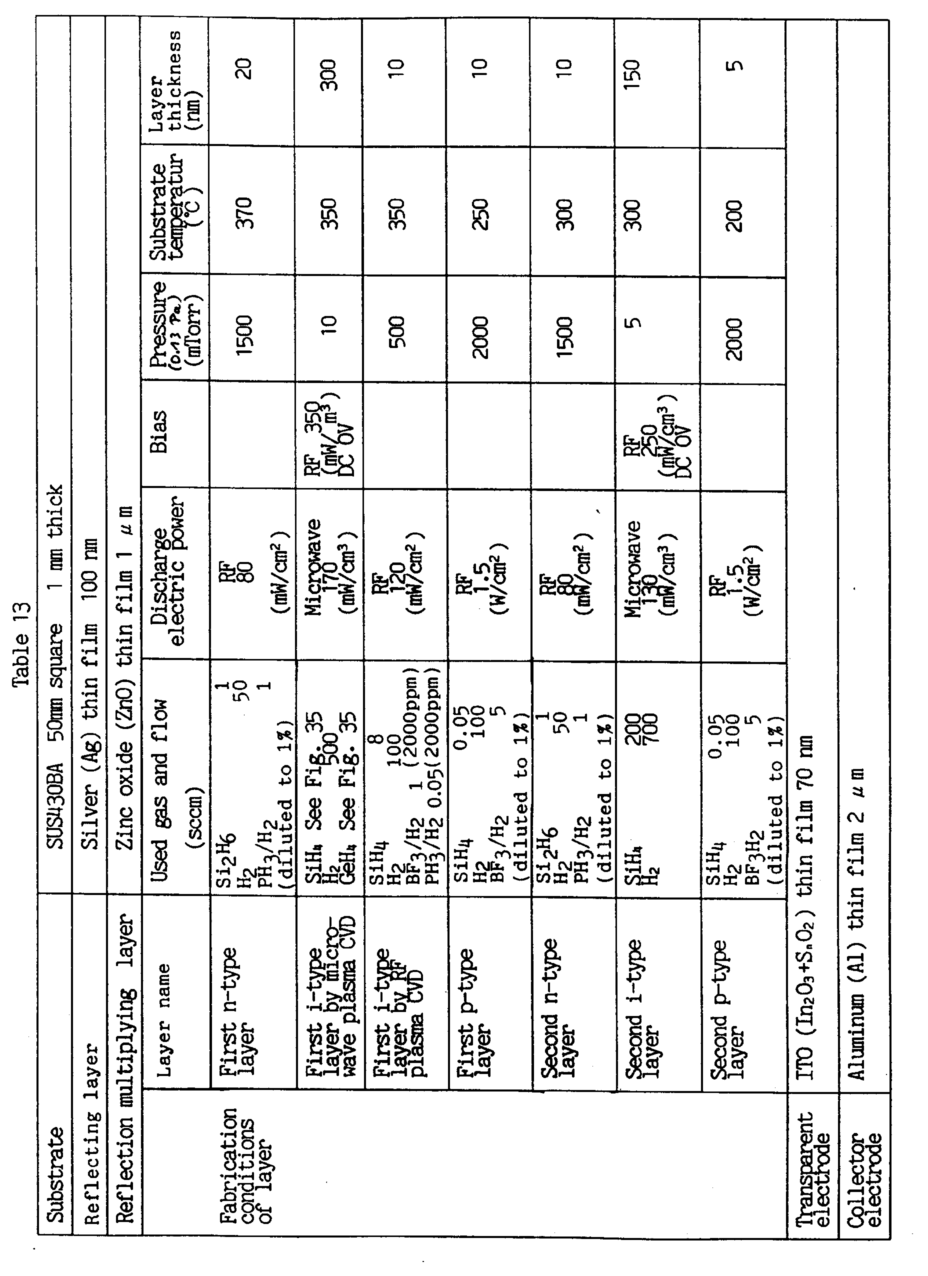

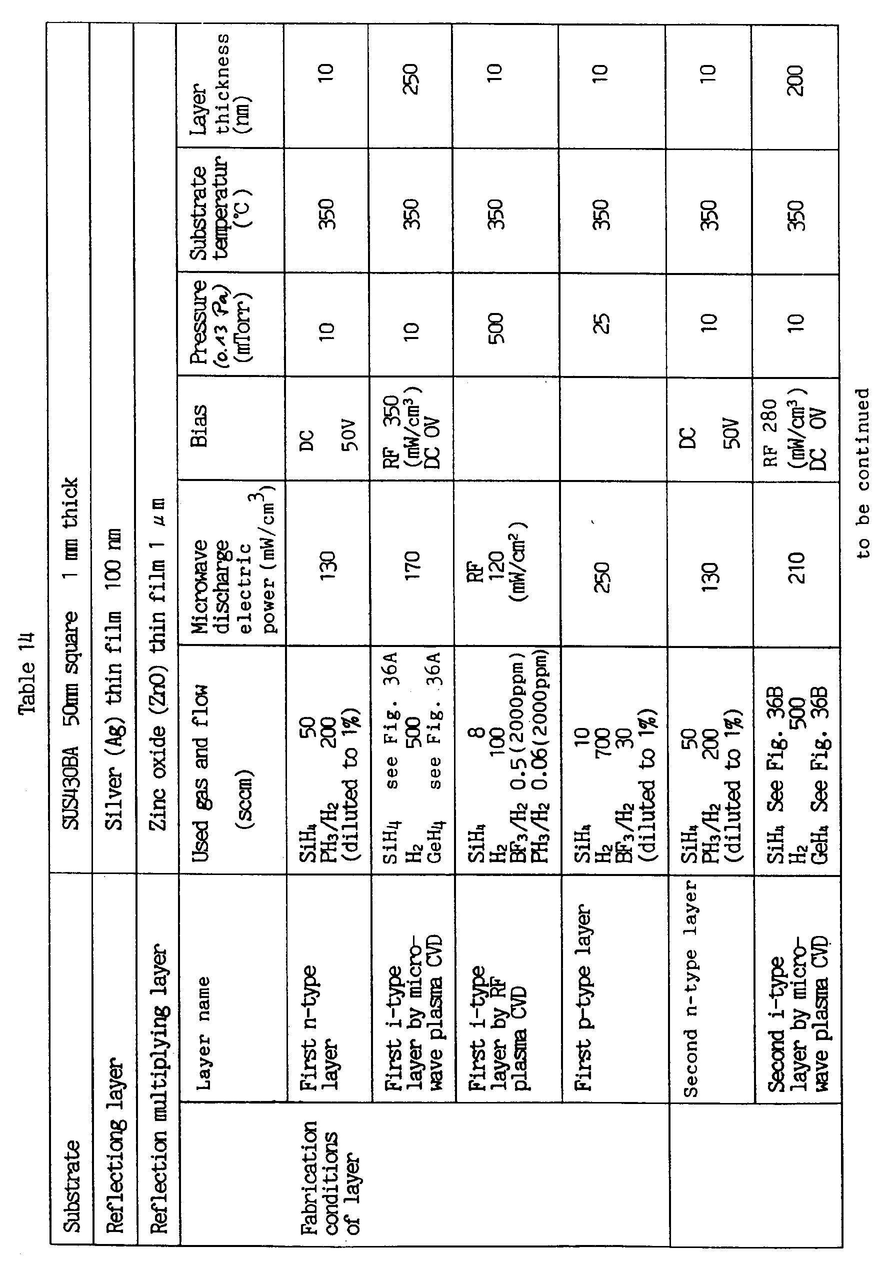

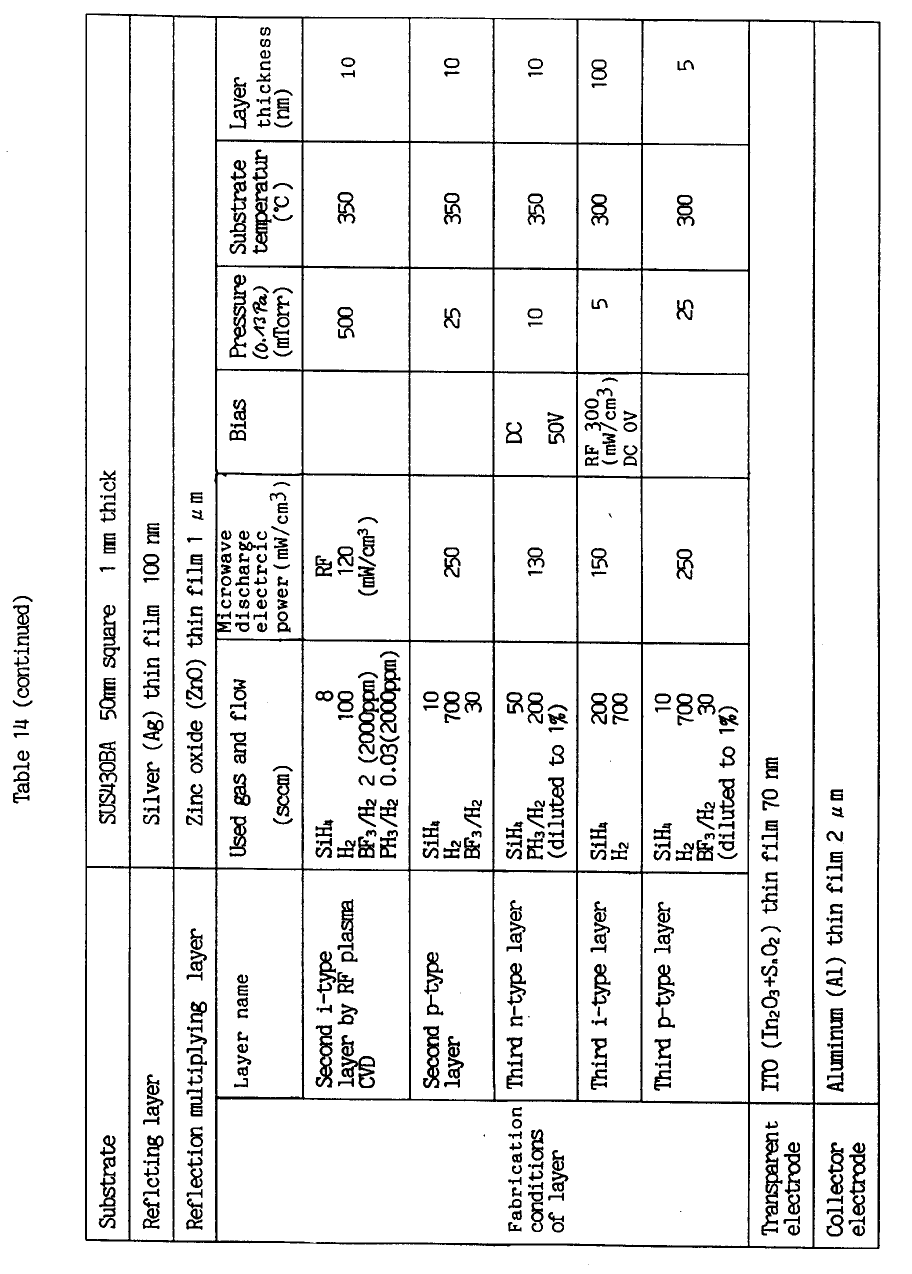

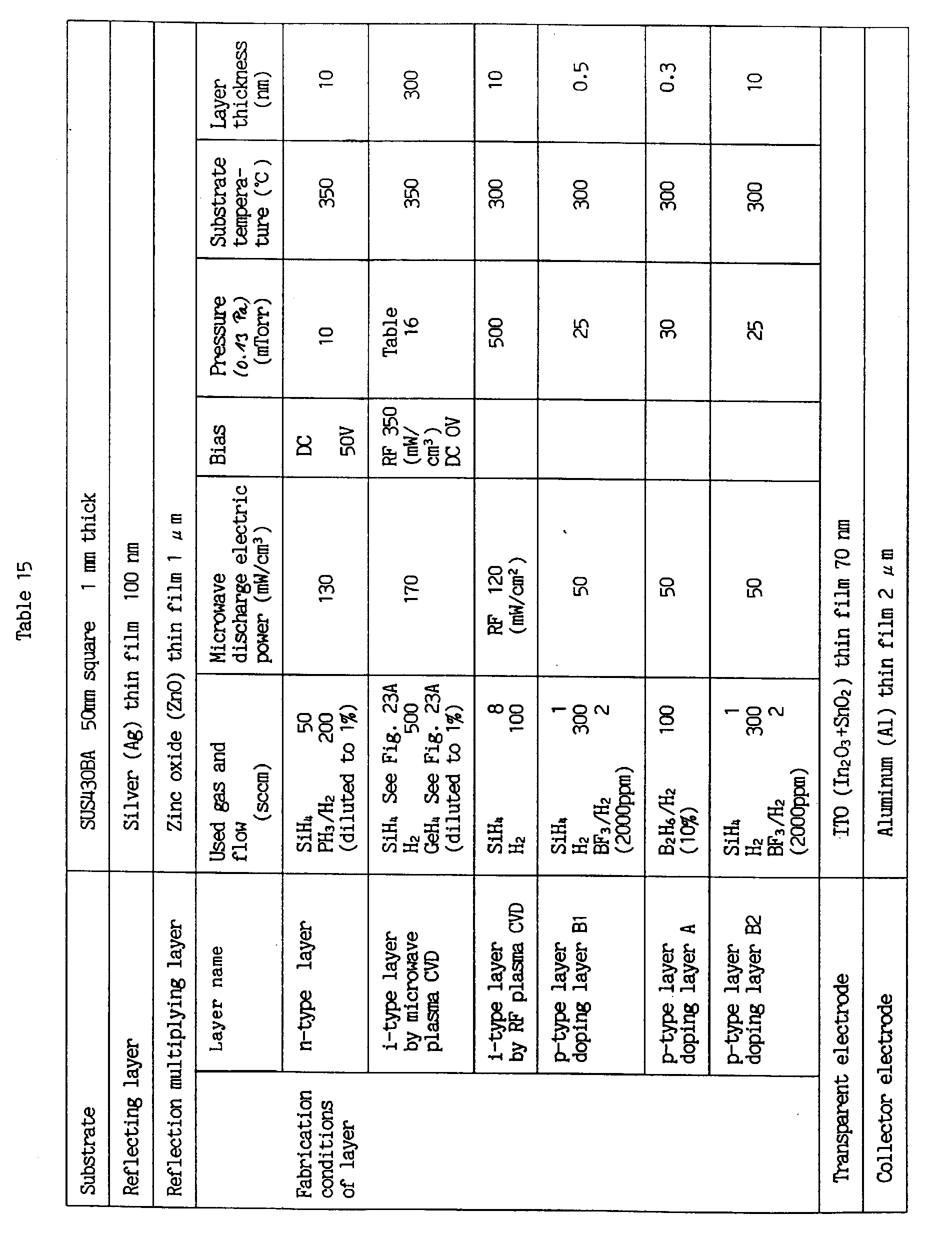

**Table 16**

| Element No. | Pressure within deposition chamber (mTorr) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Example 21-1 | 0.5 | 1.02 | 1.02 | 1.05 | 1.05 |
| Example 21-2 | 1 | 1.02 | 1.02 | 1.06 | 1.05 |
| Example 21-3 | 2 | 1.02 | 1.03 | 1.06 | 1.06 |
| Example 21-4 | 5 | 1.02 | 1.03 | 1.07 | 1.07 |
| Example 21-5 | 10 | 1.03 | 1.03 | 1.06 | 1.07 |
| Example 21-6 | 20 | 1.03 | 1.02 | 1.06 | 1.06 |
| Example 21-7 | 50 | 1.02 | 1.02 | 1.05 | 1.06 |
| Comparative Example 7-1 | 100 | 1.00 | 1.00 | 1.00 | 1.00 |
| Note) The initial characteristics, low illuminance characteristic and durability are relative values with reference to element No. example 7-1. | | | | | |

**Table 17**

| Element No. | Microwave power (W/cm³) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Example 21-8 | 0.1 | 1.02 | 1.02 | 1.08 | 1.07 |
| Example 21-9 | 0.2 | 1.02 | 1.02 | 1.07 | 1.08 |
| Example 21-10 | 0.3 | 1.01 | 1.02 | 1.07 | 1.06 |
| Comparative Example 7-2 | 0.4 | 1.00 | 1.01 | 1.02 | 1.01 |
| Comparative Example 7-3 | 0.5 | 1.00 | 1.00 | 1.00 | 1.00 |
| Note) The initial characteristics, low illuminance characteristic and durability are relative values with reference to element No. comparative example 7-3. | | | | | |

**Table 18**

| Element No. | RF bias (mW/cm³) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Comparative Example 7-4 | 150 | 1.00 | 1.00 | 1.00 | 1.00 |
| Example 21-11 | 200 | 1.02 | 1.02 | 1.05 | 1.06 |
| Example 21-12 | 250 | 1.02 | 1.03 | 1.07 | 1.07 |
| Example 21-13 | 300 | 1.03 | 1.02 | 1.06 | 1.07 |
| Example 21-14 | 350 | 1.02 | 1.02 | 1.06 | 1.06 |
| Note) The initial characteristics, low illuminance characteristic and durability are relative values with reference to element No. comparative example 7-4. | | | | | |

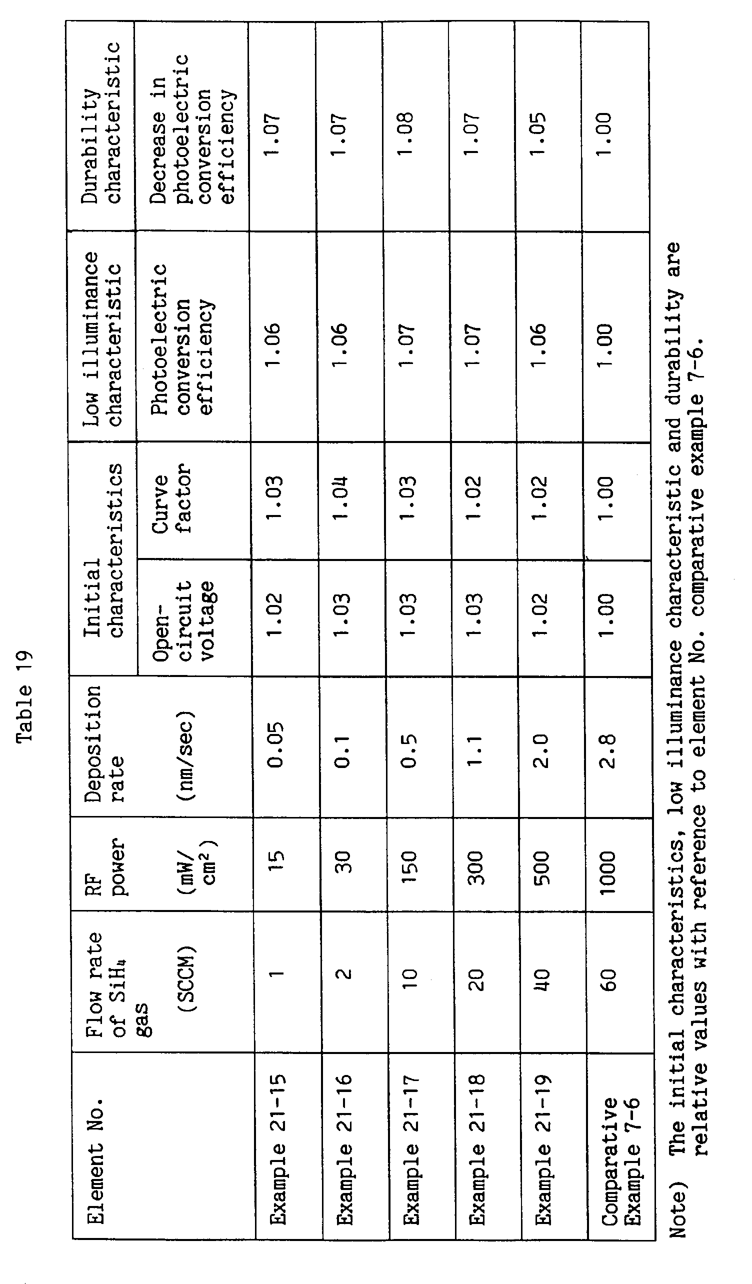

**Table 20**

| Element No. | Layer thickness of i-type layer by RF plasma CVD (nm) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Comparative Example 7-7 | 0 | 1.00 | 1.00 | 1.00 | 1.00 |
| Example 21-20 | 1 | 1.02 | 1.01 | 1.04 | 1.06 |
| Example 21-21 | 3 | 1.02 | 1.03 | 1.05 | 1.07 |
| Example 21-5 | 10 | 1.03 | 1.03 | 1.07 | 1.07 |
| Example 21-22 | 30 | 1.02 | 1.02 | 1.05 | 1.06 |
| Comparative Example 7-8 | 50 | 1.01 | 1.00 | 1.01 | 1.02 |
| Note) The initial characteristics, low illuminance characteristic and durability are relative values with reference to element No. comparative example 7-7. | | | | | |

**Table 21**

| Element No. | RF discharge power (mW/cm²) | Value of half-width at a peak of 2000 cm⁻¹ divided by peak height | Initial characteristics | | Low illuminance characteristic | Durability characteristic |
|---|---|---|---|---|---|---|
| | | | Open-circuit voltage | Curve factor | Photoelectric conversion efficiency | Decrease in photoelectric conversion efficiency |
| Example 21-23 | 90 | 1.31 | 1.02 | 1.02 | 1.05 | 1.05 |
| Example 21-5 | 120 | 1.16 | 1.02 | 1.03 | 1.05 | 1.05 |
| Example 21-24 | 150 | 1.07 | 1.02 | 1.02 | 1.04 | 1.04 |
| Example 21-25 | 180 | 0.95 | 1.00 | 1.01 | 1.01 | 1.02 |
| Example 21-26 | 210 | 0.88 | 1.00 | 1.00 | 1.00 | 1.00 |
| Note) The initial characteristics, low illuminance characteristic and durability are relative values with reference to element No. example 21-26. | | | | | | |

**Table 22**

| Element No. | Layer thickness of the region at maximum bandgap (nm) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Example 22-1 | 1 | 1.02 | 1.02 | 1.04 | 1.04 |
| Example 22-2 | 2 | 1.02 | 1.03 | 1.05 | 1.05 |
| Example 22-3 | 3 | 1.02 | 1.03 | 1.05 | 1.06 |
| Example 22-4 | 5 | 1.02 | 1.03 | 1.06 | 1.07 |
| Example 22-5 | 10 | 1.02 | 1.02 | 1.06 | 1.06 |
| Example 22-6 | 20 | 1.03 | 1.02 | 1.05 | 1.06 |
| Example 22-7 | 30 | 1.02 | 1.01 | 1.05 | 1.06 |
| Example 22-8 | 50 | 1.00 | 1.00 | 1.00 | 1.00 |
| Note) The initial characteristics, low illuminance characteristic and durability are relative values with reference to element No. example 22-8. | | | | | |

**Table 23**

| Element No. | Distance between mixing point of gases and deposition chamber (m) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Example 27-1 | 1 | 1.02 | 1.03 | 1.05 | 1.07 |
| Example 27-2 | 2 | 1.03 | 1.04 | 1.06 | 1.06 |
| Example 27-3 | 3 | 1.02 | 1.03 | 1.06 | 1.05 |
| Example 27-4 | 5 | 1.02 | 1.02 | 1.04 | 1.05 |
| Example 27-5 | 8 | 1.00 | 1.00 | 1.00 | 1.00 |
| Note) The initial characteristics, low illuminance characteristic and durability are relative values with reference to element No. example 27-5. | | | | | |

**Table 24**

| Element No. | Layer thickness of doping layer A (nm) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Example 33-1 | 0.01 | 1.02 | 1.02 | 1.05 | 1.06 |
| Example 33-2 | 0.03 | 1.02 | 1.03 | 1.06 | 1.06 |
| Example 33-3 | 0.1 | 1.03 | 1.02 | 1.07 | 1.07 |
| Example 21-5 | 0.3 | 1.02 | 1.02 | 1.06 | 1.06 |
| Example 33-4 | 1 | 1.02 | 1.02 | 1.05 | 1.04 |
| Example 33-5 | 3 | 1.00 | 1.00 | 1.00 | 1.00 |
| Note) The initial characteristics, low illuminance characteristic and durability are relative values with reference to element No. example 33-5. | | | | | |

**Table 25**

| | | | | | | | |
|---|---|---|---|---|---|---|---|
| Fabrication conditions of n-type layer | Layer name | Used gas and flow (sccm) | | Microwave discharge electric power (mW/cm³) | Pressure (0.13 Pa) (mTorr) | Substrate temperature (°C) | Layer thickness (nm) |
| | n-type layer | SiH₄ | 5 | | | | |
| | doping layer | H2 | 200 | 40 | 30 | 350 | 0.5 |
| | B1 | PH₃/H₂ (1%) | 20 | | | | |
| | n-type layer | | | | | | |
| | doping layer | PH₃/H₂ (1%) | 300 | 50 | 20 | 350 | 0.3 |
| | A | | | | | | |
| | n-type layer | SiH₄ | 50 | | | | |
| | doping layer | | | 150 | 15 | 350 | 10 |
| | B2 | PH₃/H₂ (1%) | 200 | | | | |

**Table 26**

| | | | | | | | |
|---|---|---|---|---|---|---|---|
| Fabrication conditions of n-type layer | Layer name | Used gas and flow (sccm) | | Microwave discharge electric power (mW/cm³) | Pressure (0.13 Pa) (mTorr) | Substrate temperature (°C) | Layer thickness (nm) |
| | | SiH₄ | 1 | | | | |
| | doping layer | H₂ | 300 | 50 | 25 | 300 | 0.3 |
| | B1 | PF₃/H₂ | 2 | | | | |
| | | (2000ppm) | | | | | |
| | doping layer | B₂H₆/H₂ | 100 | 50 | 20 | 300 | 0.1 |
| | A1 | (10%) | | | | | |
| | doping layer | SiH₄ | 1 | | | | |
| | B2 | H₂ | 300 | 50 | 25 | 300 | 0.5 |
| | | BF₃/H₂ | 2 | | | | |
| | | (2000ppm) | | | | | |
| | doping layer | B₂H₆/H₂ | 100 | 30 | 30 | 300 | 0.2 |
| | A2 | (10%) | | | | | |
| | doping layer | SiH₄ | 1 | | | | |
| | B3 | H₂ | 300 | 50 | 25 | 300 | 0.5 |
| | | PF₃/H₂ | 2 | | | | |
| | | (2000ppm) | | | | | |
| | doping layer | B₂H₆/H₂ | 200 | 50 | 20 | 300 | 0.5 |
| | A3 | (10%) | | | | | |
| | doping layer | SiH₄ | 1 | | | | |
| | B4 | H₂ | 300 | 50 | 25 | 300 | 0.8 |
| | | BF₃/H₂ | 2 | | | | |
| | | (2000ppm) | | | | | |

**Table 27**

| | | | | | | | |
|---|---|---|---|---|---|---|---|
| Substrate | | SUS430BA 50mm square 1 mm thick | | | | | |
| Reflecting layer | | Silver (Ag) thin film 100 nm | | | | | |
| Reflection multiplying layer | | Zinc oxide (ZnO) thin film 1 µm | | | | | |
| Fabrication conditions of layer | Layer name | Used gas and flow (sccm) | | RF discharge electric power (W/cm³) | Pressure (1.3 hPa) (Torr) | Substrate temperature (°C) | Layer thickness (nm) |
| | n-type layer | Si₂H₆ | 3 | | | | |
| | | PH₃/H₂ | 5 | 0.12 | 1 | 350 | 10 |
| | | (diluted to 1%) | | | | | |
| | | H₂ | 50 | | | | |
| | i-type layer | Same as element No. example 21-5 | | | | | |
| | p-type layer | SiH₄ | 0.03 | | | | |
| | doping layer | H₂ | 100 | 2 | 1 | 200 | 0.3 |
| | B1 | BF₃/H₂ | 1 | | | | |
| | | (2000ppm) | | | | | |
| | p-type layer | B₂H₆/H₂ | 50 | 3 | 1 | 200 | 0.1 |
| | doping layer A | (10%) | | | | | |
| | p-type layer | SiH₄ | 0.5 | | | | |
| | doping layer | H₂ | 100 | 2 | 1 | 200 | 5 |
| | B2 | BF₃/H₂ | 10 | | | | |
| | | (2000ppm) | | | | | |
| Transparent electrode | ITO (In₂O₃+SnO₂) thin film 70 nm | | | | | | |
| Collector electrode | Aluminum (Al) thin film 2 µm | | | | | | |

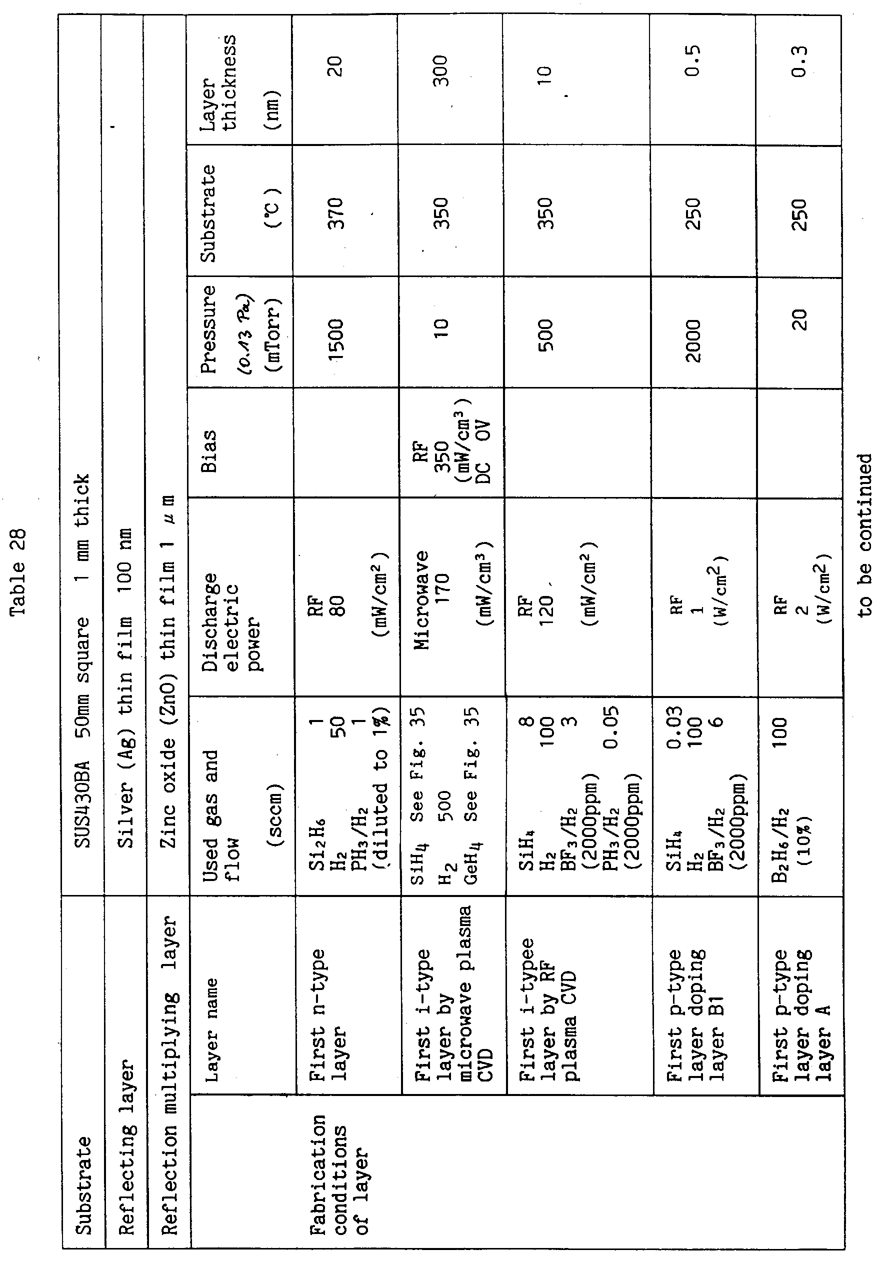

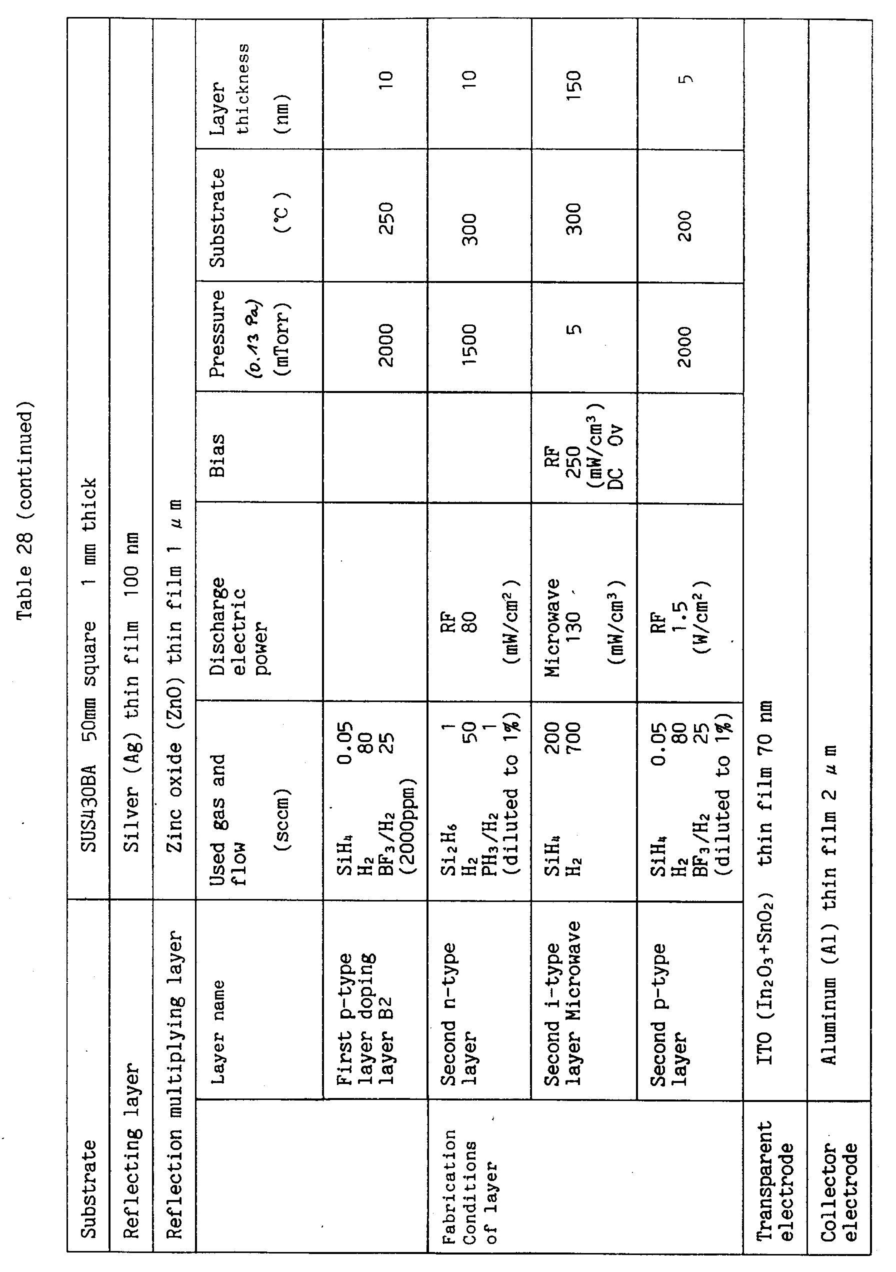

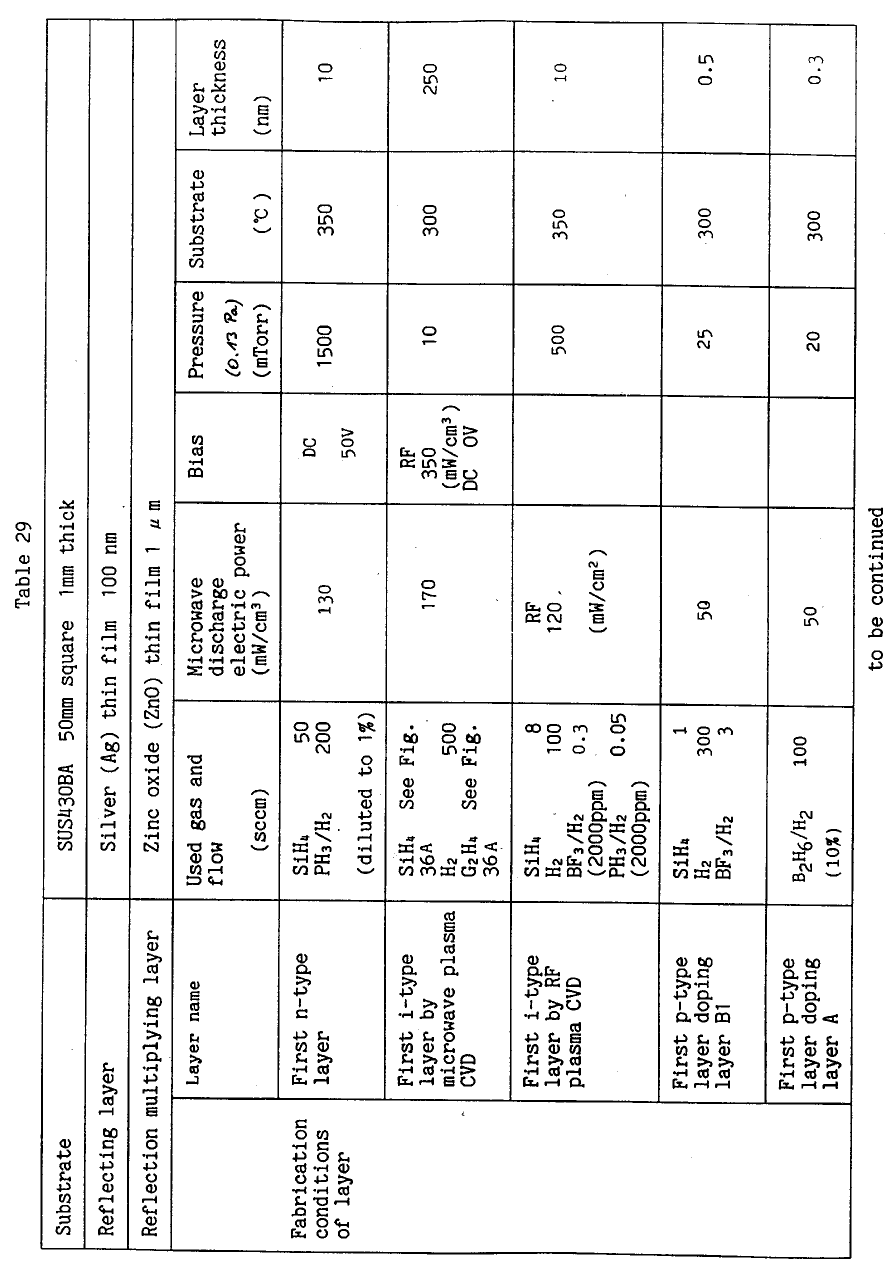

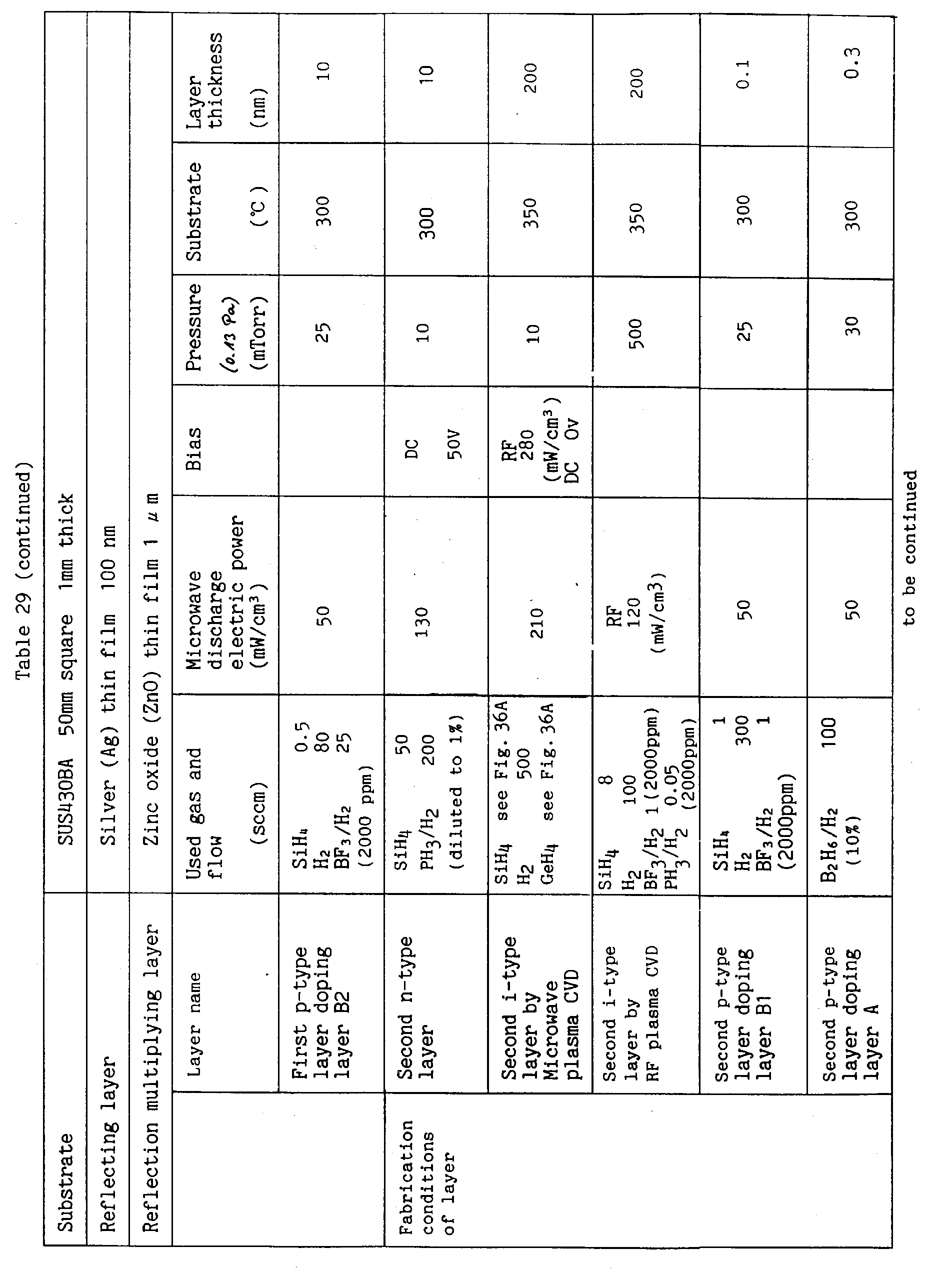

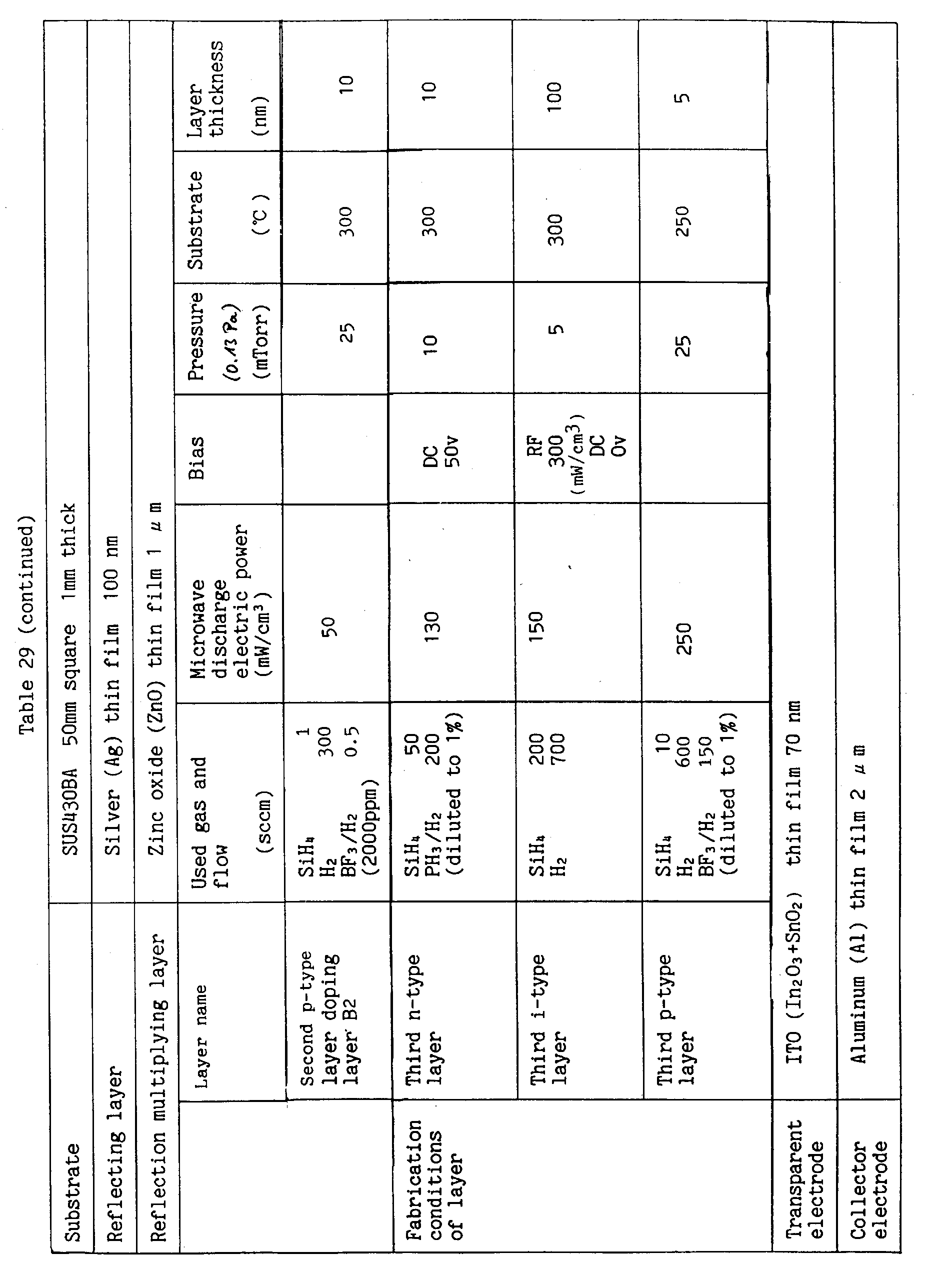

**Table 30**

| Element No. | Pressure within deposition chamber (mtorr) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Example 44-1 | 0.5 | 1.02 | 1.02 | 1.06 | 1.05 |
| Example 44-2 | 1 | 1.02 | 1.03 | 1.07 | 1.06 |
| Example 44-3 | 2 | 1.02 | 1.03 | 1.07 | 1.06 |
| Example 44-4 | 5 | 1.03 | 1.03 | 1.08 | 1.07 |
| Example 44-5 | 10 | 1.03 | 1.03 | 1.07 | 1.07 |
| Example 44-6 | 20 | 1.02 | 1.02 | 1.06 | 1.08 |
| Example 44-7 | 50 | 1.02 | 1.02 | 1.05 | 1.07 |
| Comparative Example 12-1 | 100 | 1.00 | 1.00 | 1.00 | 1.00 |
| Note) The initial characteristics, low illuminance characteristic and durability are relative values with reference to element No. comparative example 12-1. | | | | | |

**Table 31**

| Element No. | Microwave power (W/cm³) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Example 44-8 | 0.1 | 1.02 | 1.02 | 1.08 | 1.07 |
| Example 44-9 | 0.2 | 1.02 | 1.03 | 1.09 | 1.09 |
| Example 44-10 | 0.3 | 1.02 | 1.02 | 1.07 | 1.08 |
| Comparative Example 12-2 | 0.4 | 1.00 | 1.01 | 1.01 | 1.02 |
| Comparative Example 12-3 | 0.5 | 1.00 | 1.00 | 1.00 | 1.00 |
| Note) The initial characteristics, low illuminance characteristic and durability are relative values with reference to element No. comparative example 12-3. | | | | | |

**Table 32**

| Element No. | RF bias (mW/cm³) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Comparative Example 12-4 | 150 | 1.00 | 1.00 | 1.00 | 1.00 |
| Example 44-11 | 200 | 1.02 | 1.02 | 1.05 | 1.04 |
| Example 44-12 | 250 | 1.03 | 1.02 | 1.05 | 1.07 |
| Example 44-13 | 300 | 1.03 | 1.03 | 1.06 | 1.07 |
| Example 44-14 | 350 | 1.03 | 1.02 | 1.06 | 1.05 |
| Note) The initial characteristics, low illuminance characteristic and durability are relative values with reference to element No. comparative example 12-4. | | | | | |

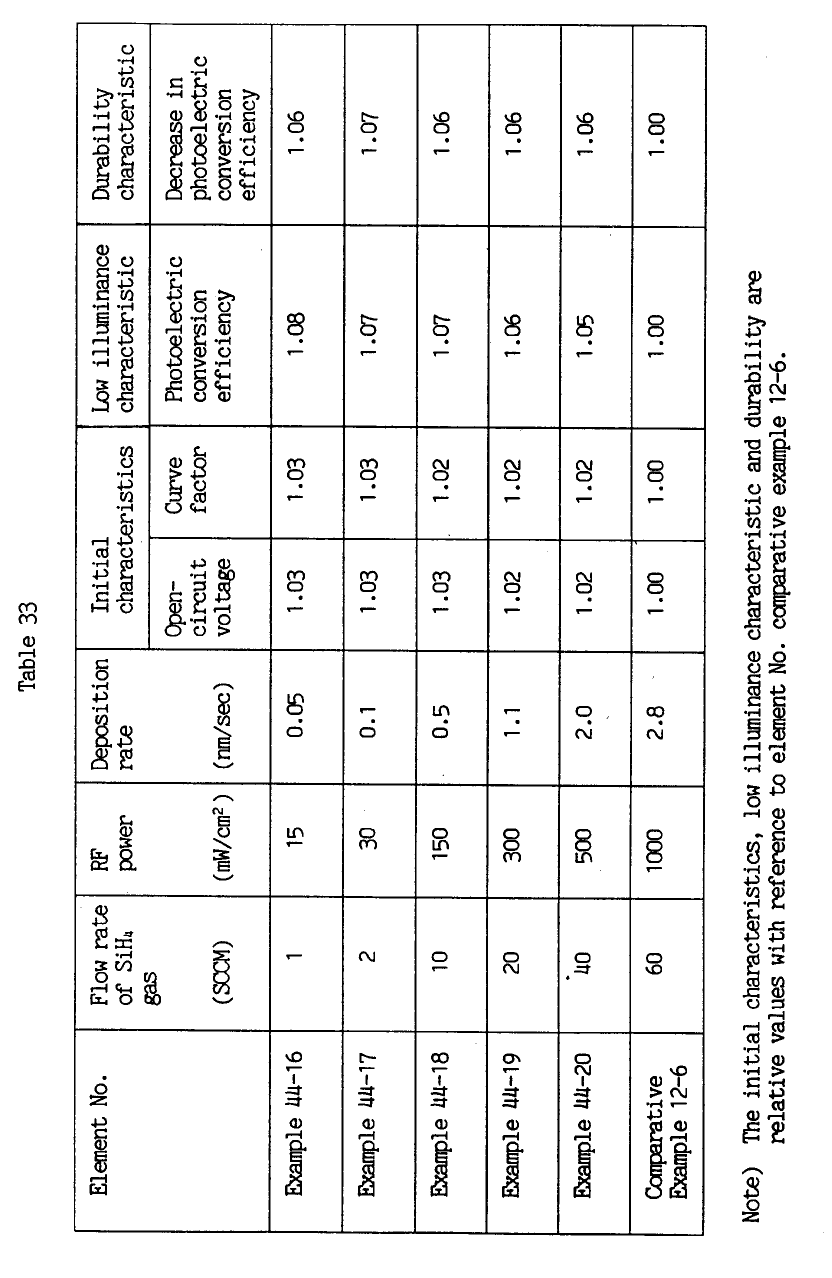

**Table 34**

| Element No. | Layer thickness of i-type layer by RF plasma CVD (nm) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Comparative Example 12-7 | 0 | 1.00 | 1.00 | 1.00 | 1.00 |
| Example 44-21 | 1 | 1.02 | 1.02 | 1.03 | 1.04 |
| Example 44-22 | 3 | 1.02 | 1.02 | 1.05 | 1.06 |
| Example 44-5 | 10 | 1.03 | 1.02 | 1.07 | 1.07 |
| Example 44-23 | 30 | 1.02 | 1.02 | 1.06 | 1.05 |
| Comparative Example 12-8 | 50 | 1.01 | 1.00 | 1.02 | 1.02 |
| Note) The initial characteristics, low illuminance characteristic and durability are relative values with reference to element No. comparative example 12-7. | | | | | |

**Table 35**

| Element No. | RF discharge power (mW/cm²) | Value of half-width at a peak of 2000cm⁻¹ divided by peak height | Initial characteristics | | Low illuminance characteristic | Durability characteristic |
|---|---|---|---|---|---|---|
| | | | Open-circuit voltage | Curve factor | Photoelectric conversion efficiency | Decrease in photoelectric conversion efficiency |
| Example 44-24 | 90 | 1.31 | 1.03 | 1.02 | 1.04 | 1.06 |
| Example 44-5 | 120 | 1.16 | 1.02 | 1.02 | 1.05 | 1.06 |
| Example 44-25 | 150 | 1.07 | 1.01 | 1.01 | 1.05 | 1.05 |
| Example 44-26 | 180 | 0.95 | 1.00 | 1.01 | 1.02 | 1.02 |
| Example 44-27 | 210 | 0.88 | 1.00 | 1.00 | 1.00 | 1.00 |
| Note) The initial characteristics, low illuminance characteristic and durability are relative values with reference to element No. example 44-27. | | | | | | |

**Table 36**

| Element No. | Layer thickness of the region at maximum bandgap (nm) | Initial characteristics | | Low illuminance characteristic | Durability characteristic |
|---|---|---|---|---|---|
| | | Open-circuit boltage | Curve factor | Photoelectric conversion efficiency | Decrease in photoelectric conversion efficiency |
| Example 45-1 | 1 | 1.01 | 1.02 | 1.03 | 1.02 |
| Example 45-2 | 2 | 1.03 | 1.03 | 1.05 | 1.04 |
| Example 45-3 | 3 | 1.03 | 1.03 | 1.05 | 1.06 |
| Example 45-4 | 5 | 1.03 | 1.02 | 1.05 | 1.06 |
| Example 45-5 | 10 | 1.04 | 1.02 | 1.05 | 1.06 |
| Example 45-6 | 20 | 1.04 | 1.02 | 1.04 | 1.06 |
| Example 45-7 | 30 | 1.02 | 1.01 | 1.04 | 1.05 |
| Example 45-8 | 50 | 1.00 | 1.00 | 1.00 | 1.00 |
| Note) The initial characteristics, low illuminance characteristic and durability are relative values with reference to element No. example 45-8. | | | | | |

**Table 37**

| Element No. | Distance between mixing point of gases and deposition chamber (m) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Example 50-1 | 1 | 1.03 | 1.04 | 1.05 | 1.07 |
| Example 50-2 | 2 | 1.03 | 1.04 | 1.05 | 1.07 |
| Example 50-3 | 3 | 1.02 | 1.03 | 1.03 | 1.06 |
| Example 50-4 | 5 | 1.02 | 1.03 | 1.03 | 1.04 |
| Example 50-5 | 8 | 1.00 | 1.00 | 1.00 | 1.00 |
| Note) The initial characteristics, low illuminance characteristic and durability are relative values with reference to element No. example 50-5. | | | | | |

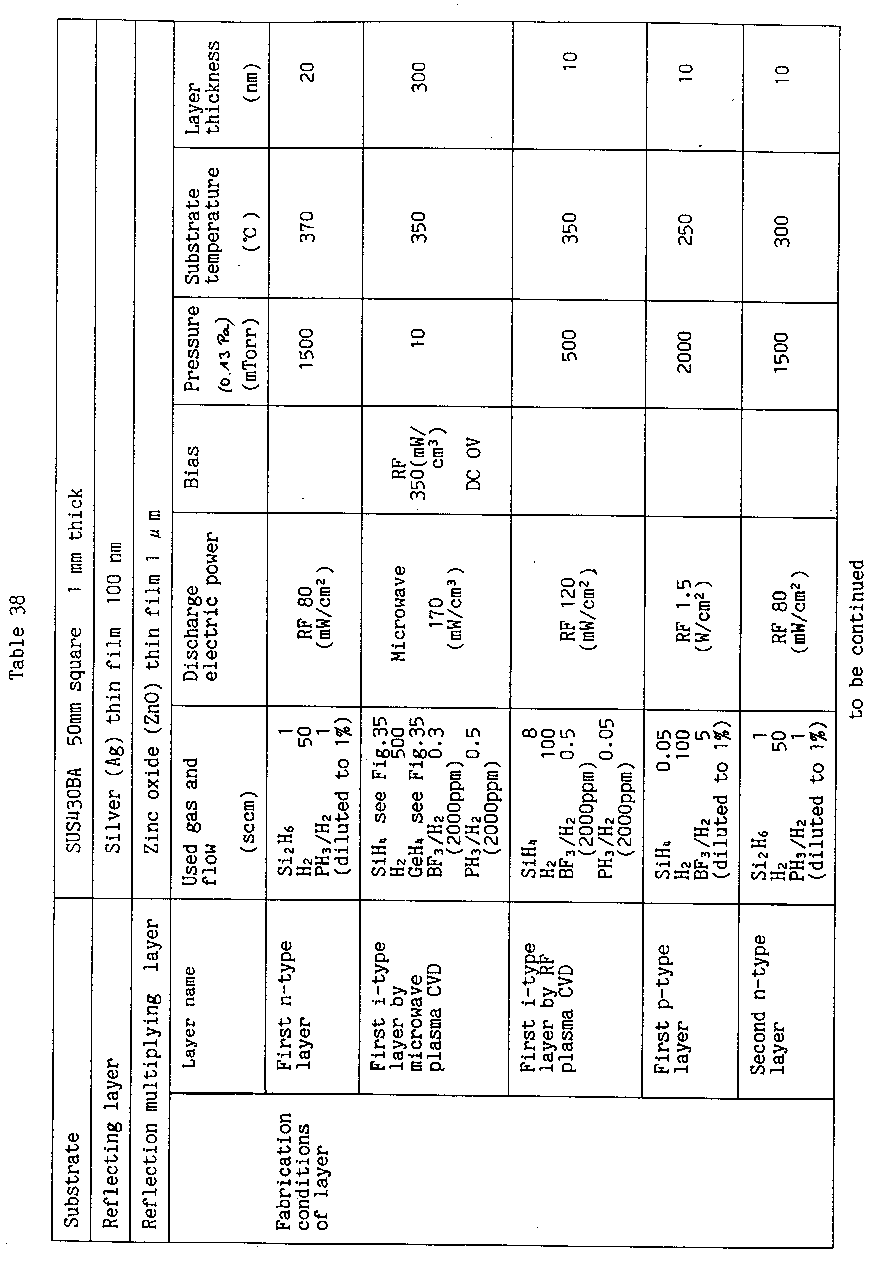

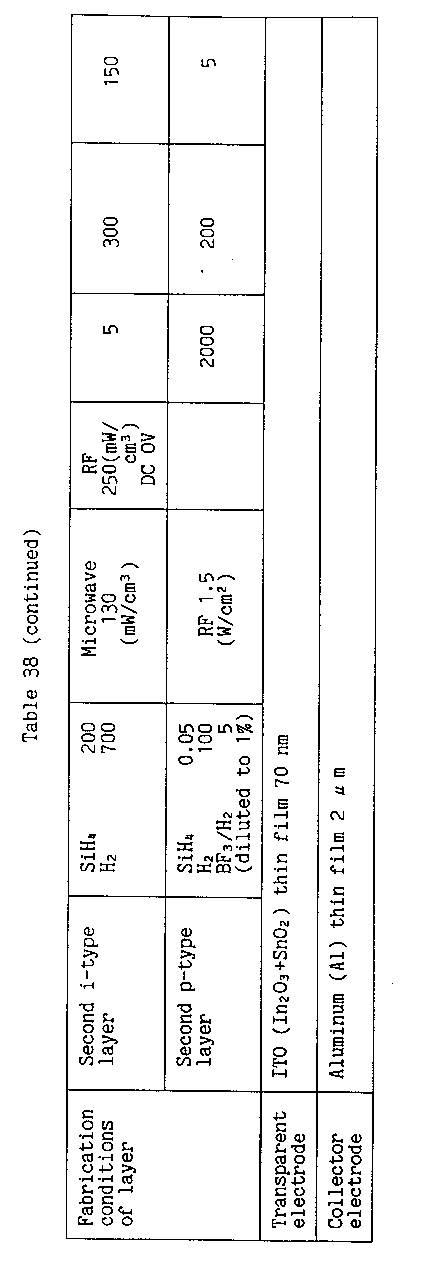

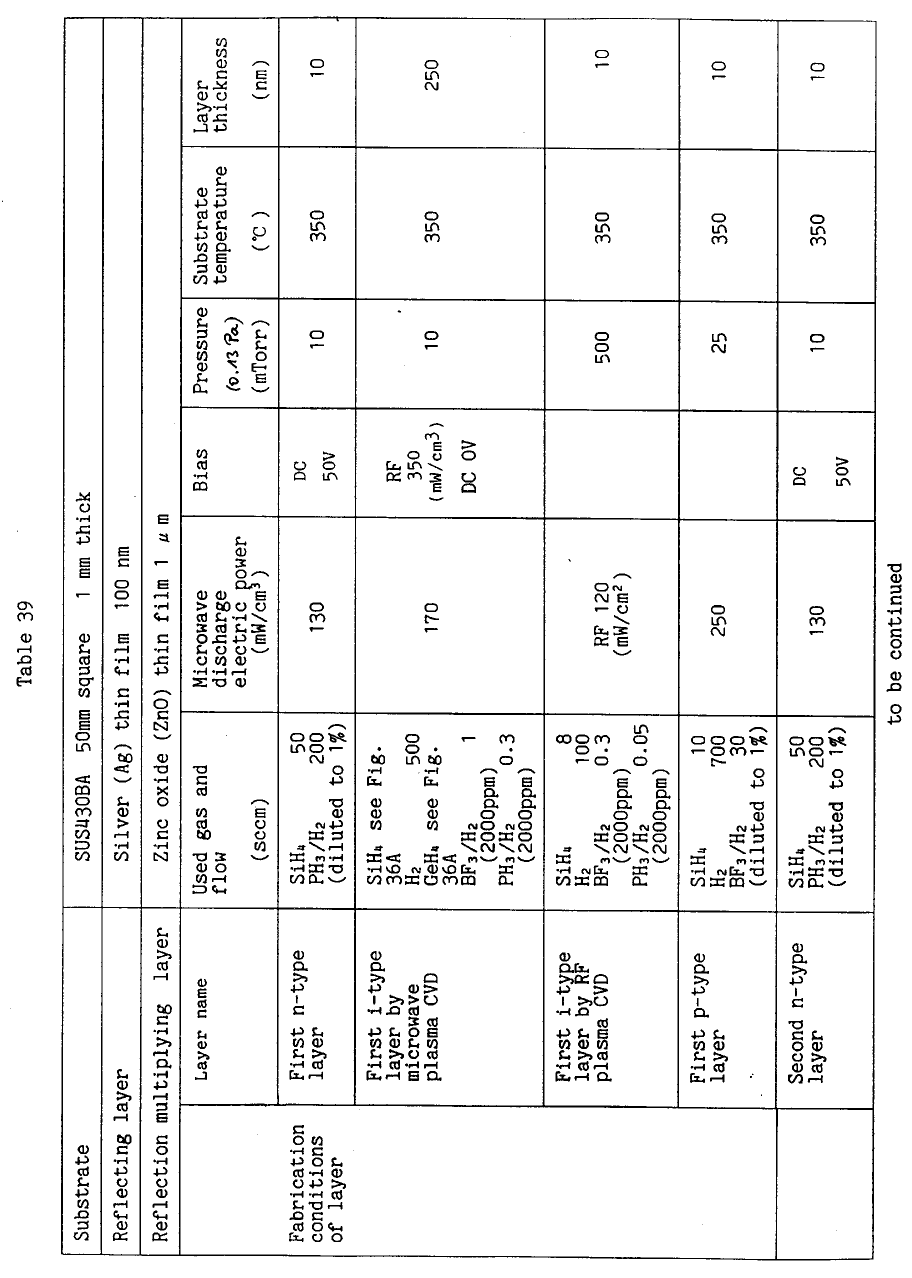

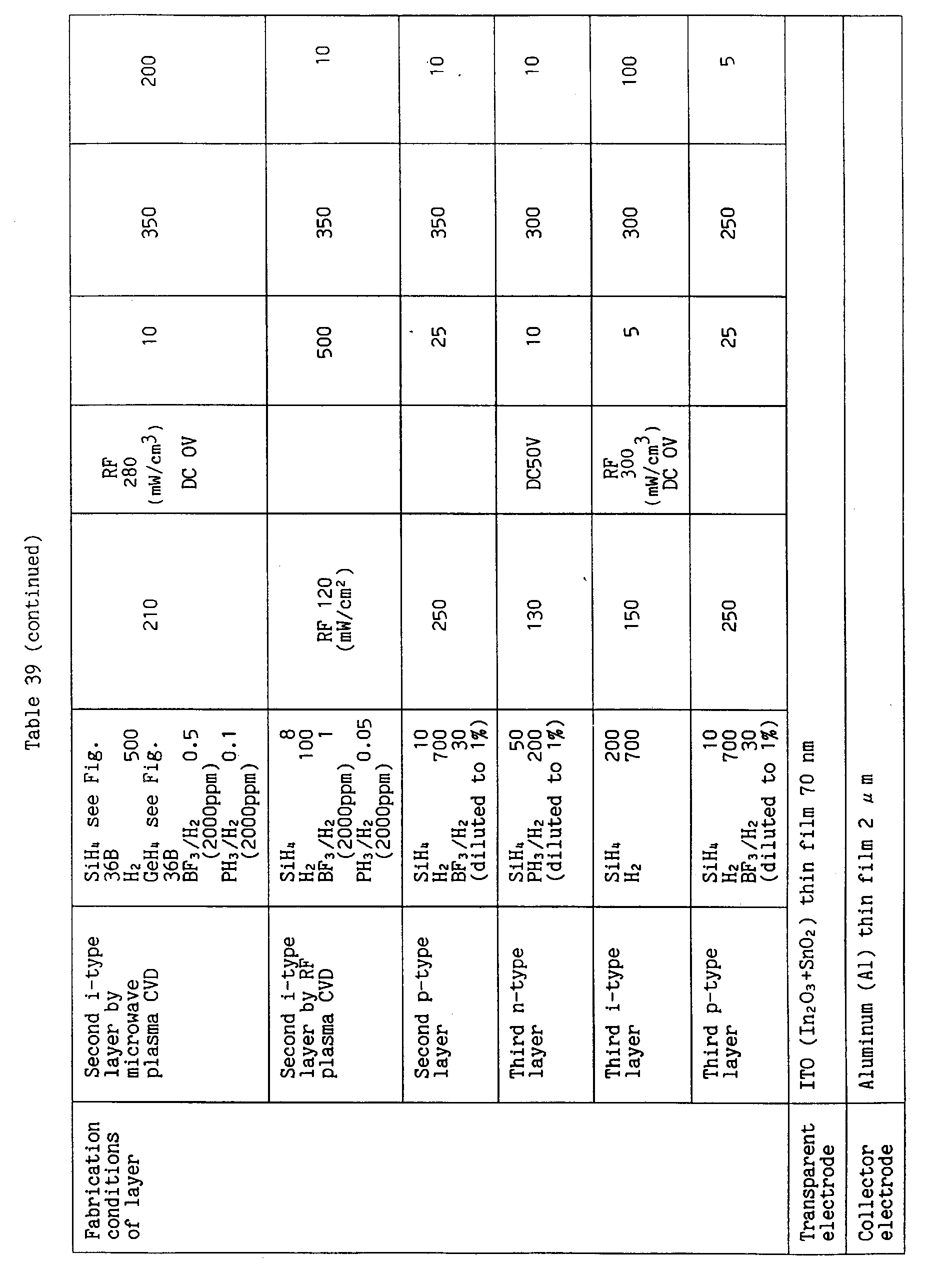

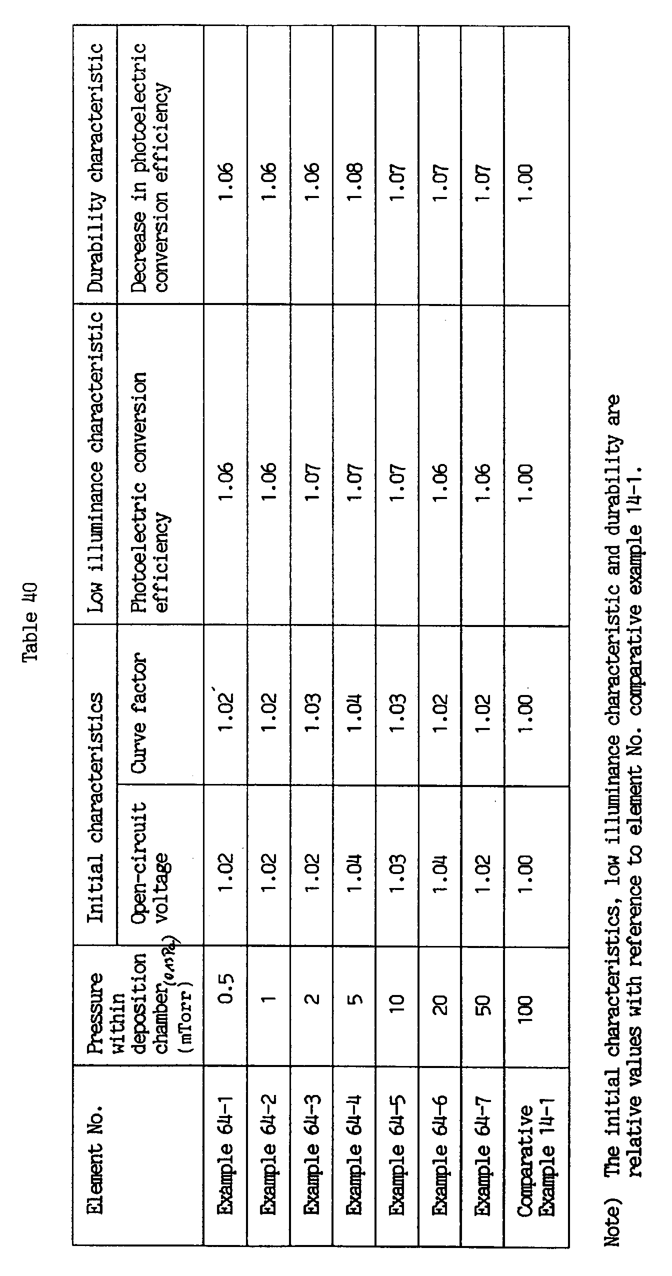

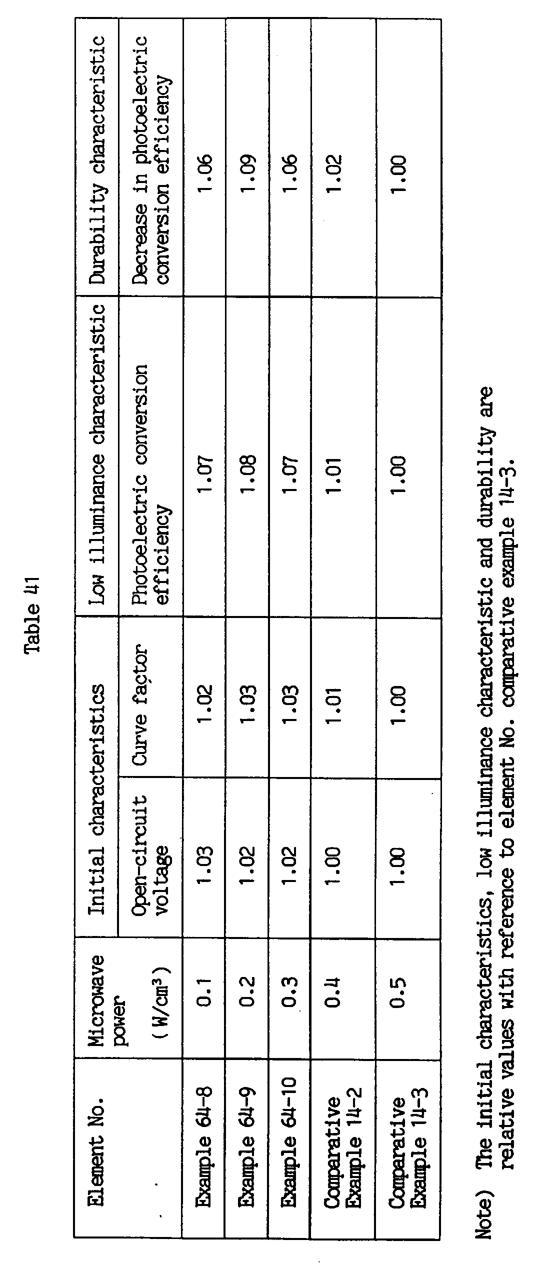

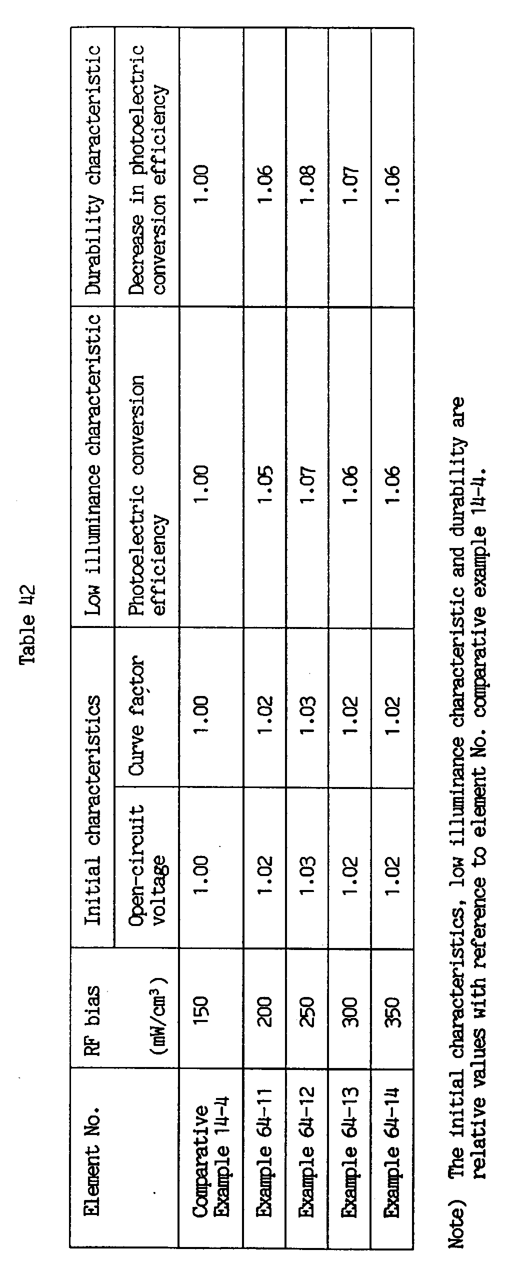

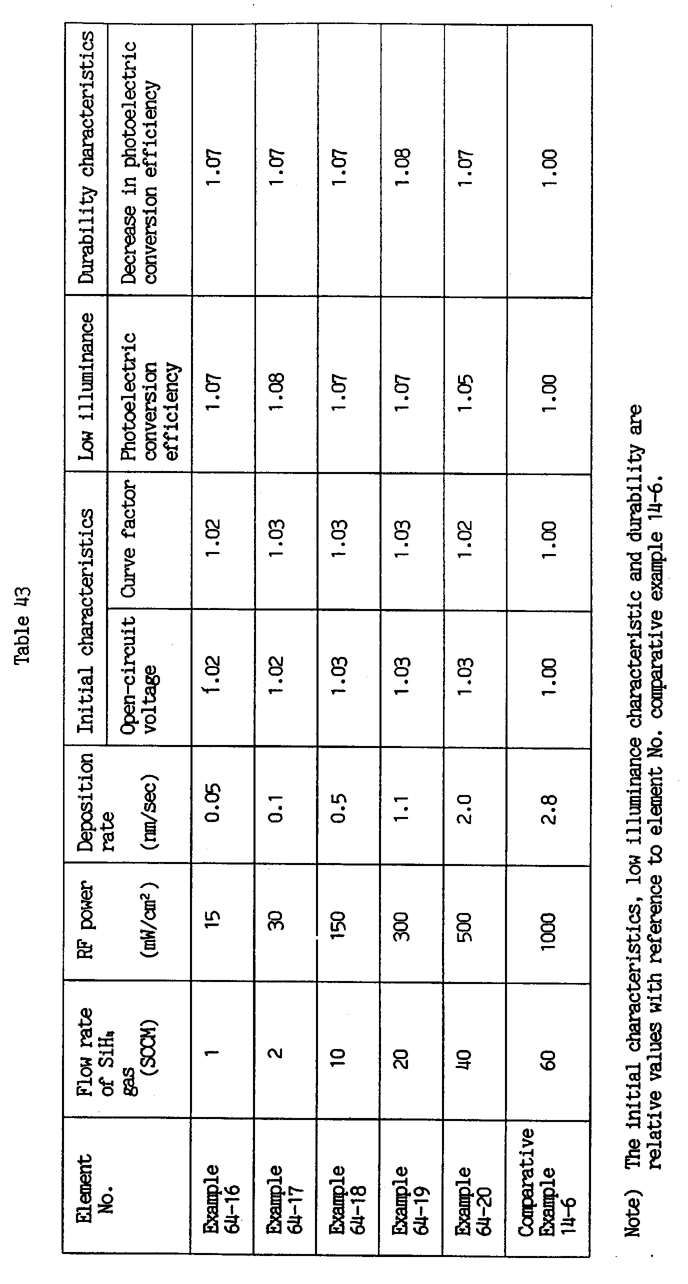

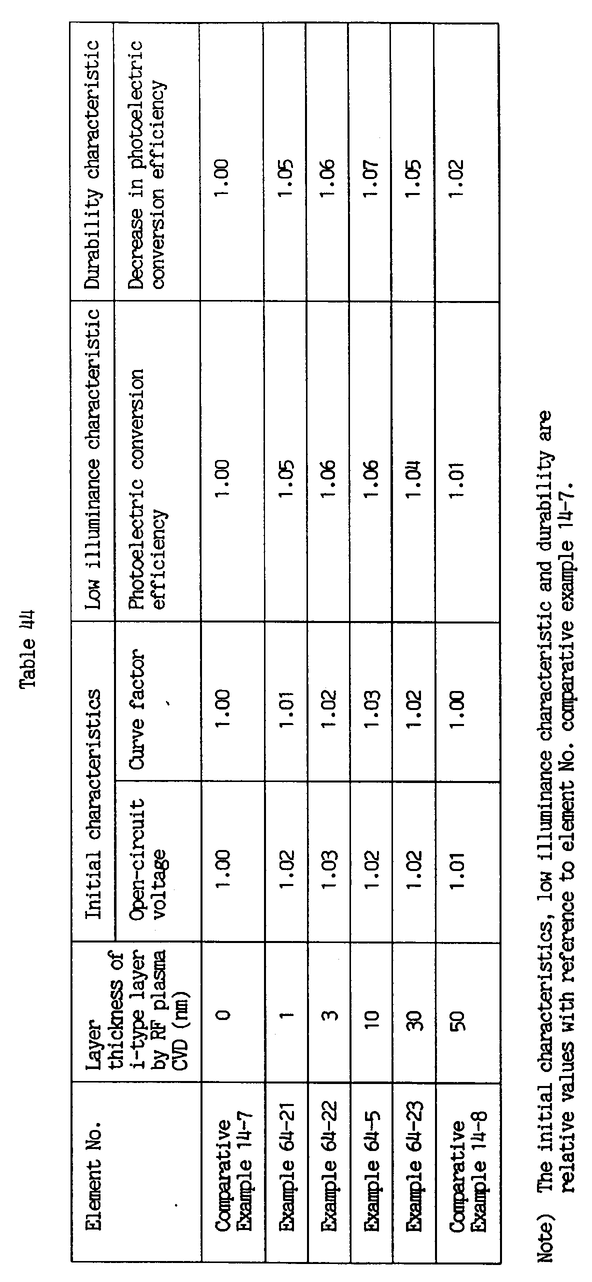

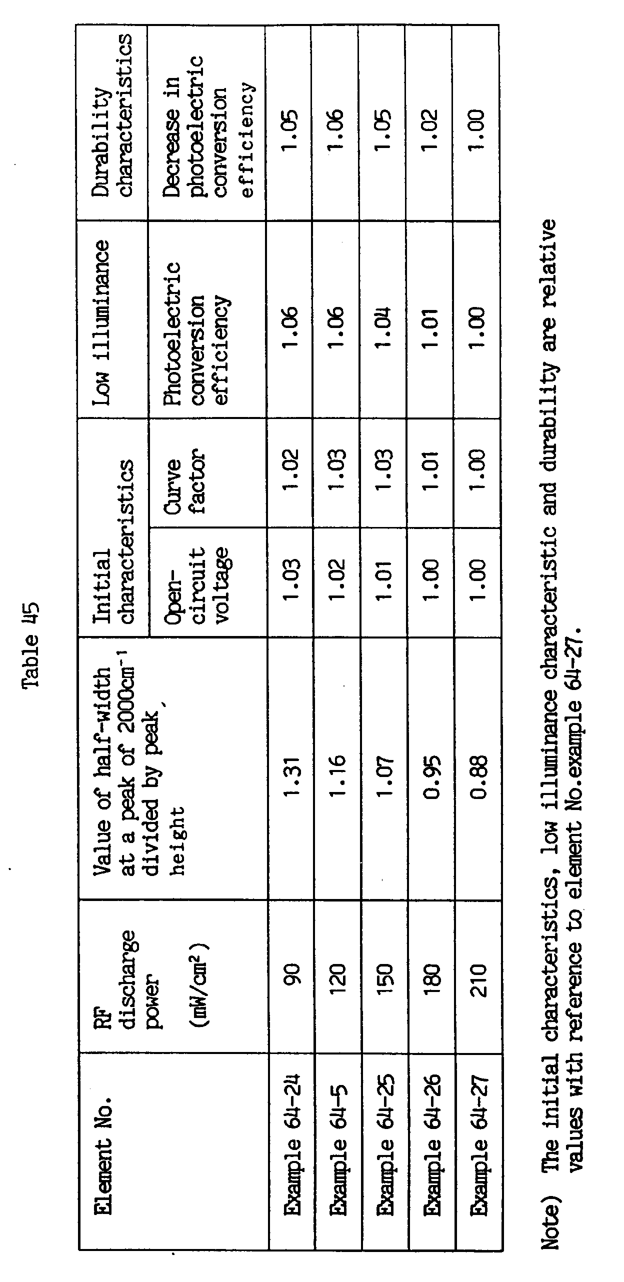

**Table 46**

| Element No. | Layer thickness of the region at maximum bandgap (nm) | Initial characteristics | | Low illuminance | Durability characteristics |
|---|---|---|---|---|---|
| | | Open-circuit voltage | Curve factor | Photoelectric conversion efficiency | Decrease in photoelectric conversion efficiency |
| Example 65-1 | 1 | 1.02 | 1.02 | 1.04 | 1.04 |
| Example 65-2 | 2 | 1.02 | 1.03 | 1.05 | 1.04 |
| Example 65-3 | 3 | 1.02 | 1.03 | 1.06 | 1.05 |
| Example 65-4 | 5 | 1.02 | 1.03 | 1.07 | 1.07 |
| Example 65-5 | 10 | 1.03 | 1.02 | 1.07 | 1.07 |
| Example 65-6 | 20 | 1.03 | 1.02 | 1.05 | 1.06 |
| Example 65-7 | 30 | 1.02 | 1.01 | 1.05 | 1.06 |
| Example 65-8 | 50 | 1.00 | 1.00 | 1.00 | 1.00 |
| Note) The initial characteristics, low illuminance characteristic and durability are relative values with reference to element No. example 65-8. | | | | | |

**Table 47**

| Element No. | Distance betweem mixing point of gases and deposition chamber (m) | Initial characteristics | | Low illuminance characteristic | Durability characteristics |
|---|---|---|---|---|---|
| | | Open-circuit voltage | Curve factor | Photoelectric conversion efficiency | Decrease in photoelectric conversion efficiency |
| Example 70-1 | 1 | 1.03 | 1.03 | 1.05 | 1.07 |
| Example 70-2 | 2 | 1.02 | 1.04 | 1.07 | 1.06 |
| Example 70-3 | 3 | 1.02 | 1.03 | 1.06 | 1.06 |
| Example 70-4 | 5 | 1.02 | 1.03 | 1.04 | 1.06 |
| Example 70-5 | 8 | 1.00 | 1.00 | 1.00 | 1.00 |
| Note) The initial characteristics, low illuminance characteristic and durability are relative values with reference to element No. example 70-5. | | | | | |

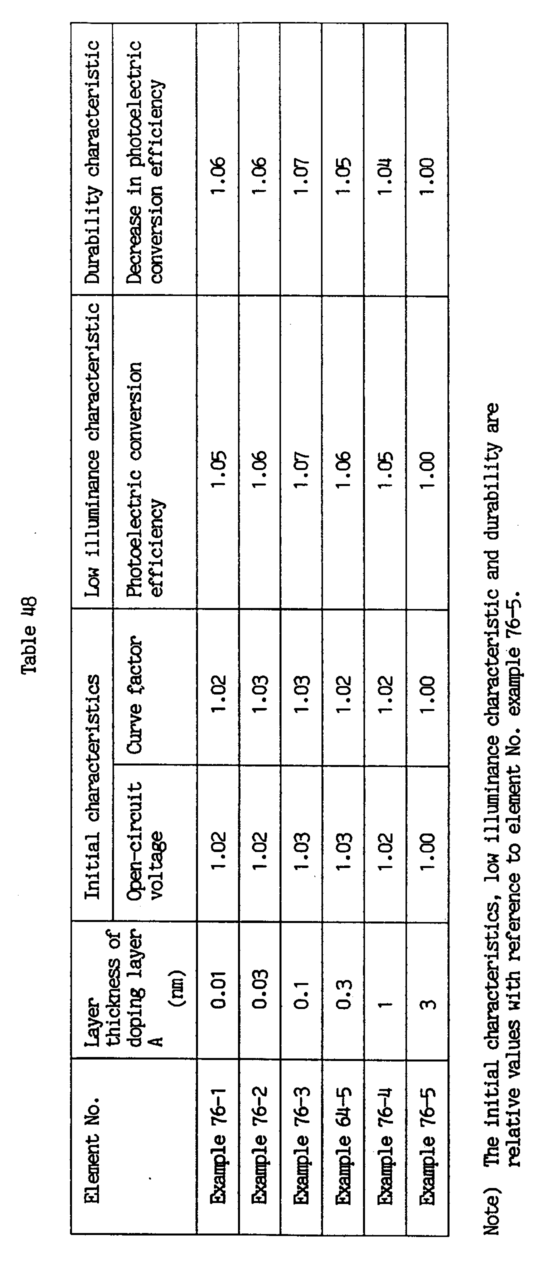

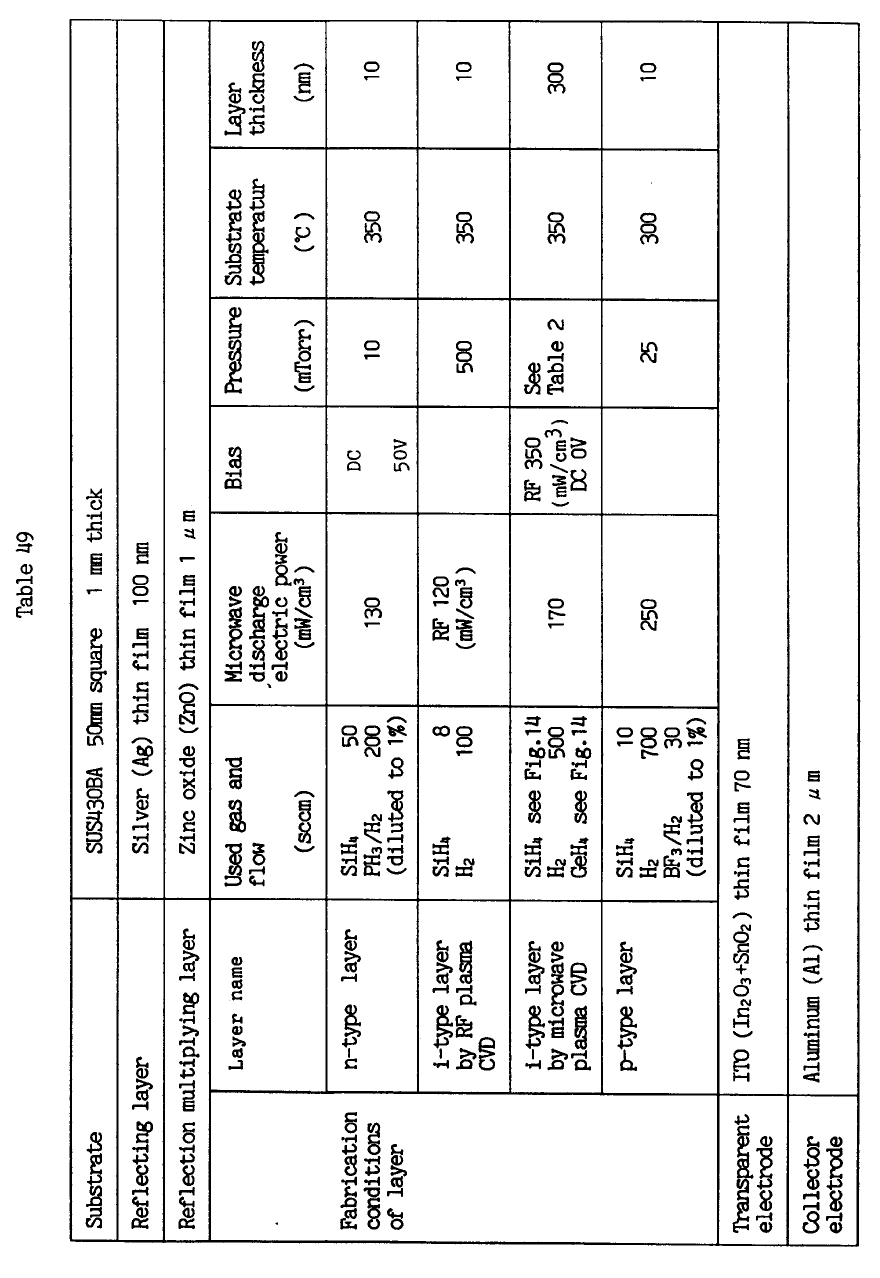

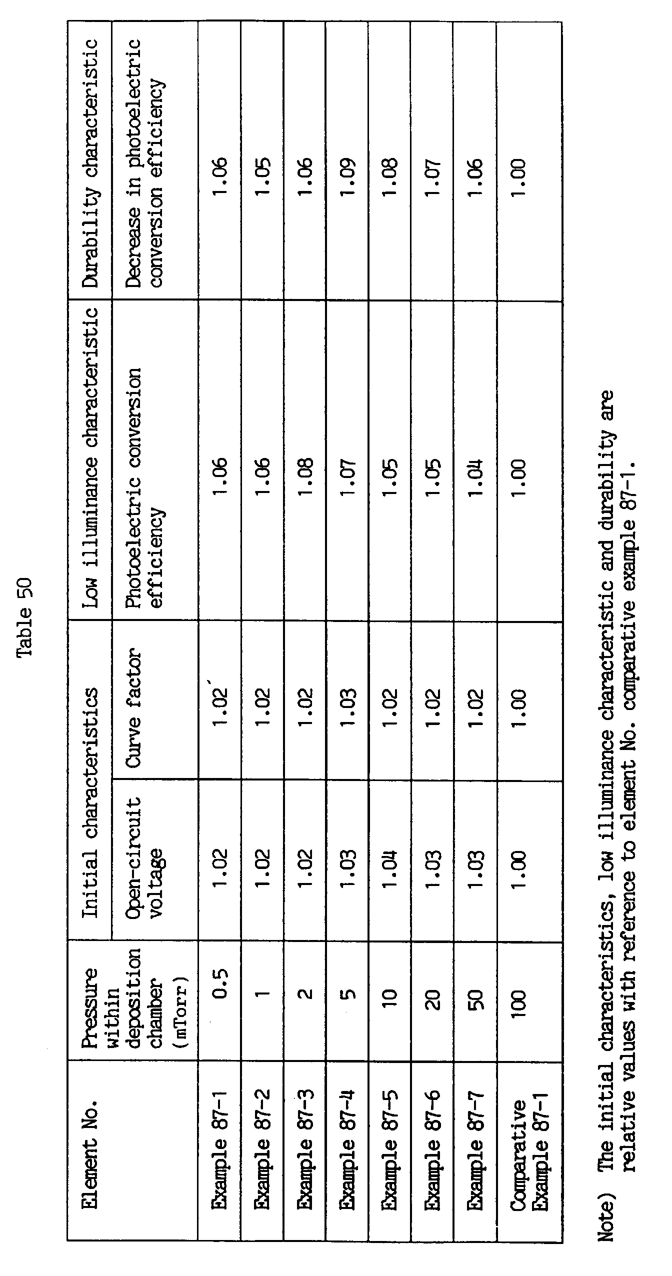

**Table 51**

| Sample No. | Gas flow rate (sccm) | | Decomposition efficiency of source gas at each microwave electric power (W/cm³) (%) | | | | |
|---|---|---|---|---|---|---|---|
| | SiH₄ | GeH₄ | 0.1 | 0.2 | 0.3 | 0.4 | 0.5 |
| Example 87-1 | 200 | 1 | 24 | 45 | 68 | 93 | 100 |
| Example 87-2 | 170 | 20 | 25 | 48 | 73 | 97 | 100 |
| Example 87-3 | 140 | 40 | 27 | 51 | 76 | 99 | 100 |
| Example 87-4 | 110 | 60 | 28 | 53 | 81 | 100 | 100 |
| Example 87-5 | 80 | 80 | 31 | 58 | 88 | 100 | 100 |

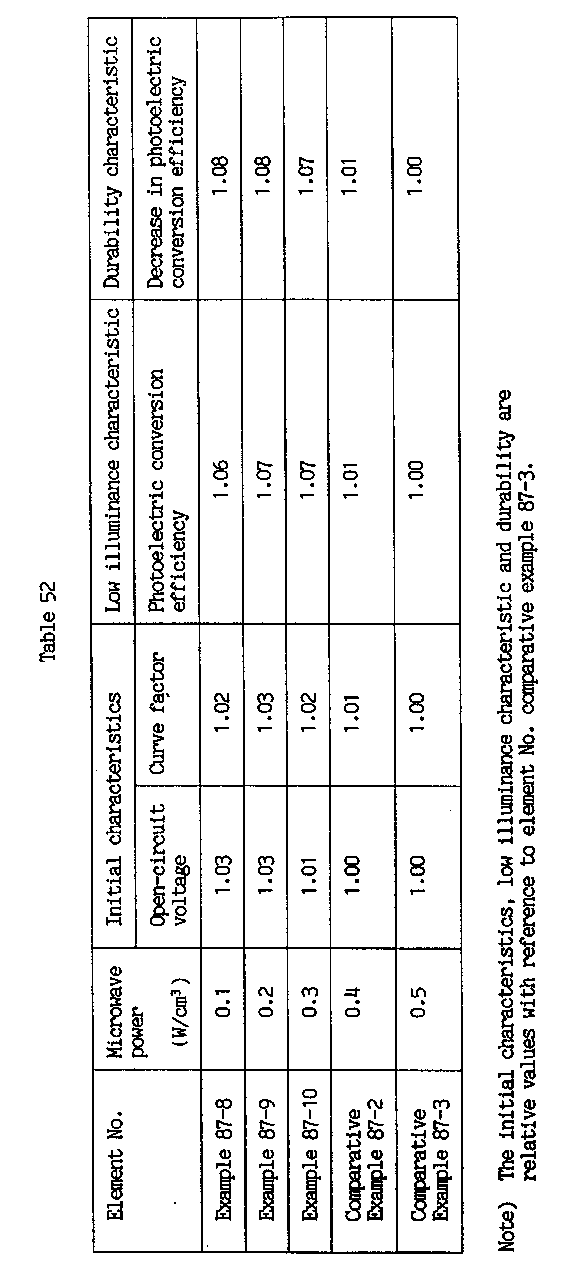

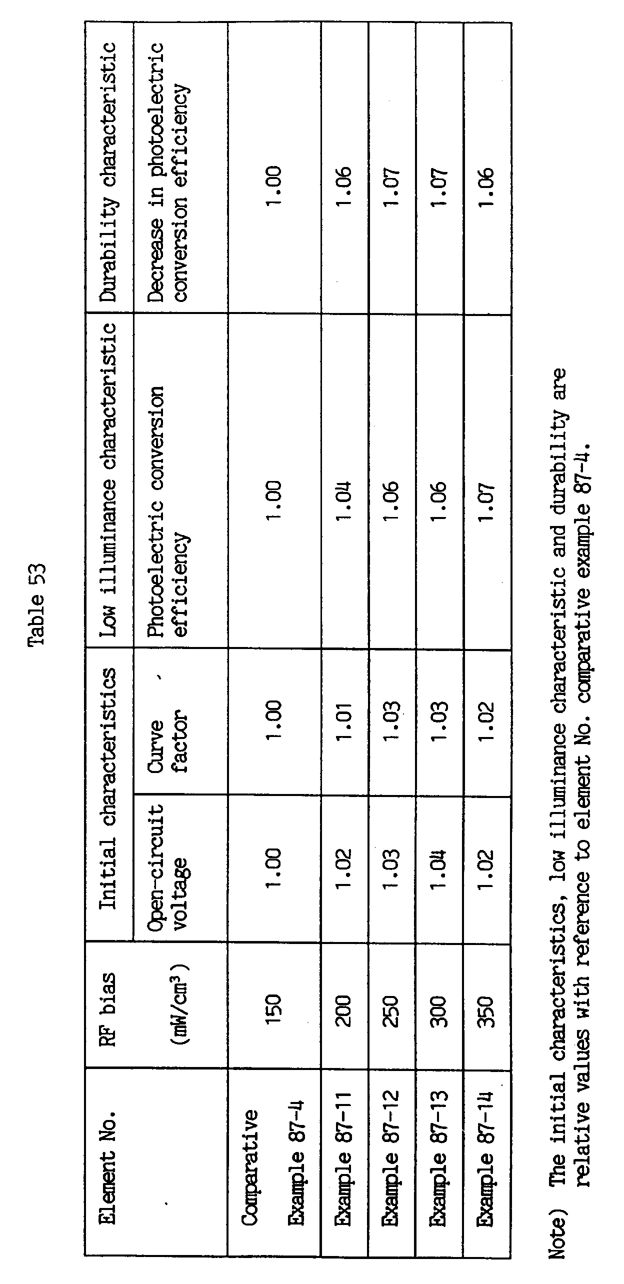

**Table 54**

| Sample No. | Gas flow rate (sccm) | | Bandgap (eV) | Composition ratio | |
|---|---|---|---|---|---|
| | SiH₄ | GeH₄ | | Si | Ge |
| Example 87-6 | 200 | 1 | 1.71 | 100 | 1 |
| Example 87-7 | 170 | 20 | 1.60 | 8.7 | 1 |
| Example 87-8 | 140 | 40 | 1.52 | 3.3 | 1 |
| Example 87-9 | 110 | 60 | 1.45 | 1.9 | 1 |
| Example 87-10 | 80 | 80 | 1.38 | 1.1 | 1 |
| Example 87-11 | - | - | 1.69 | - | - |

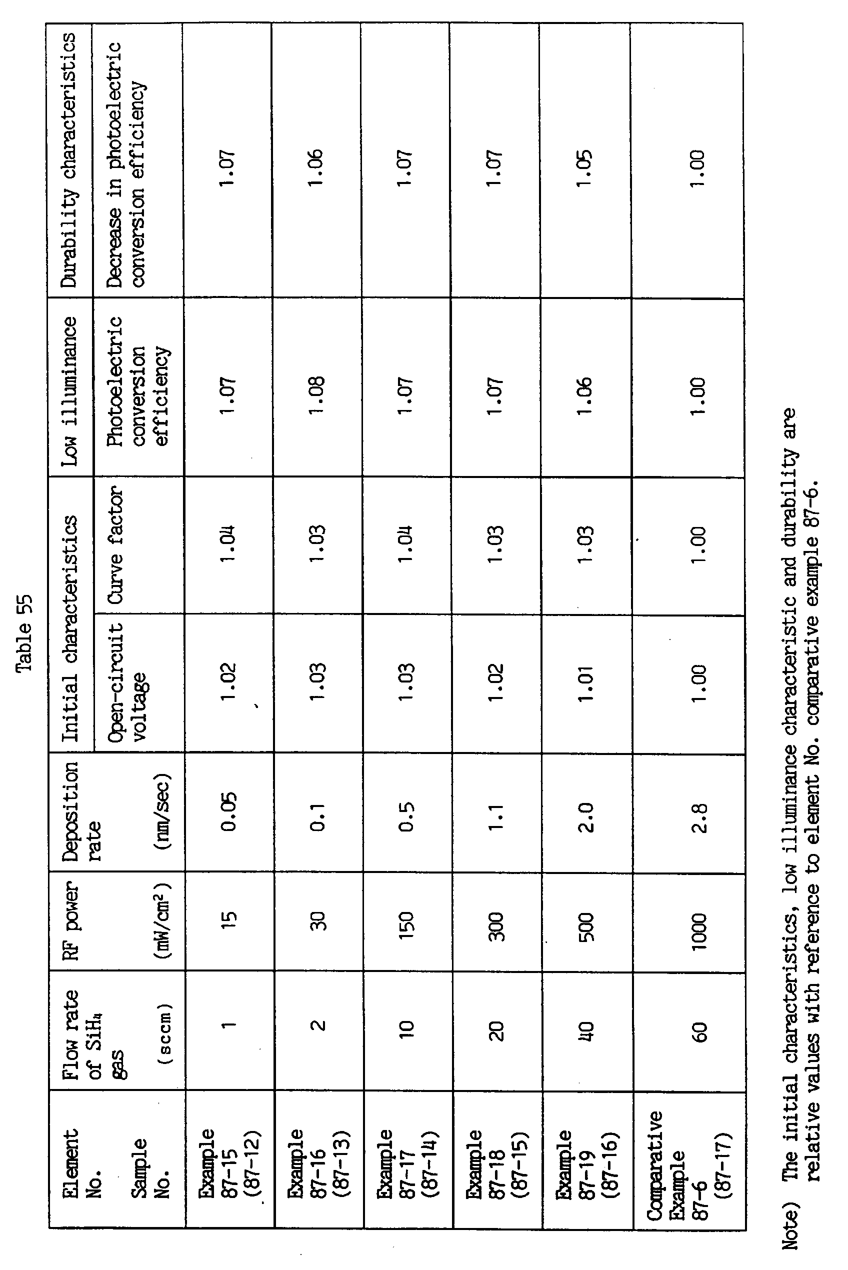

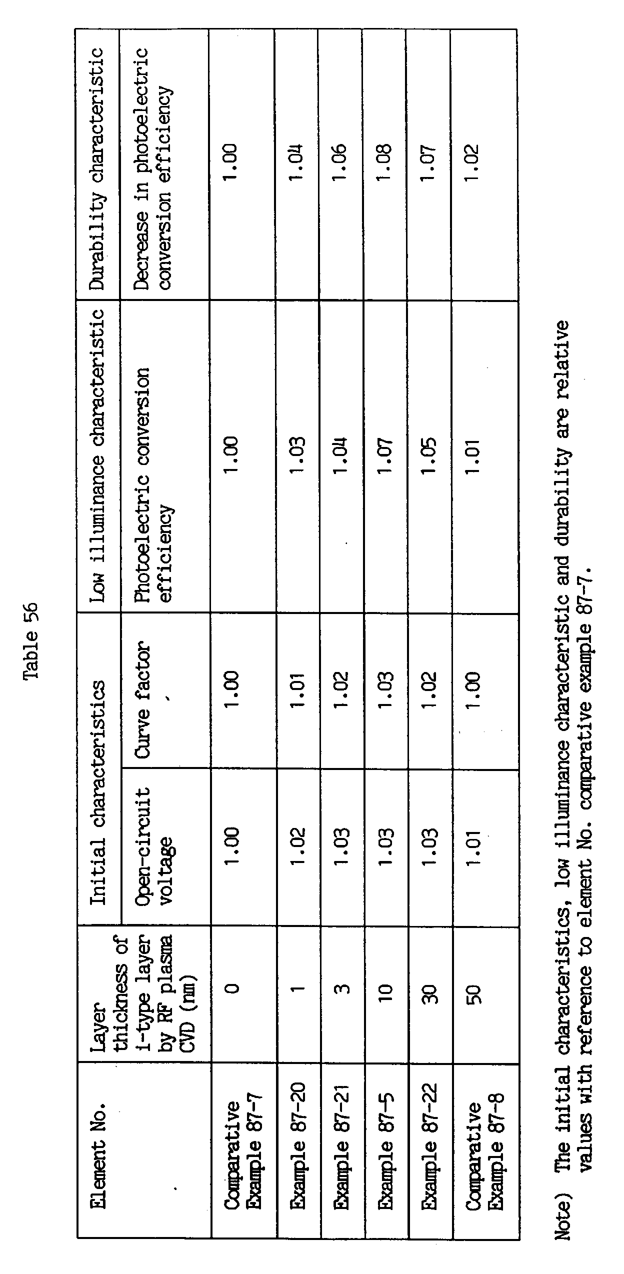

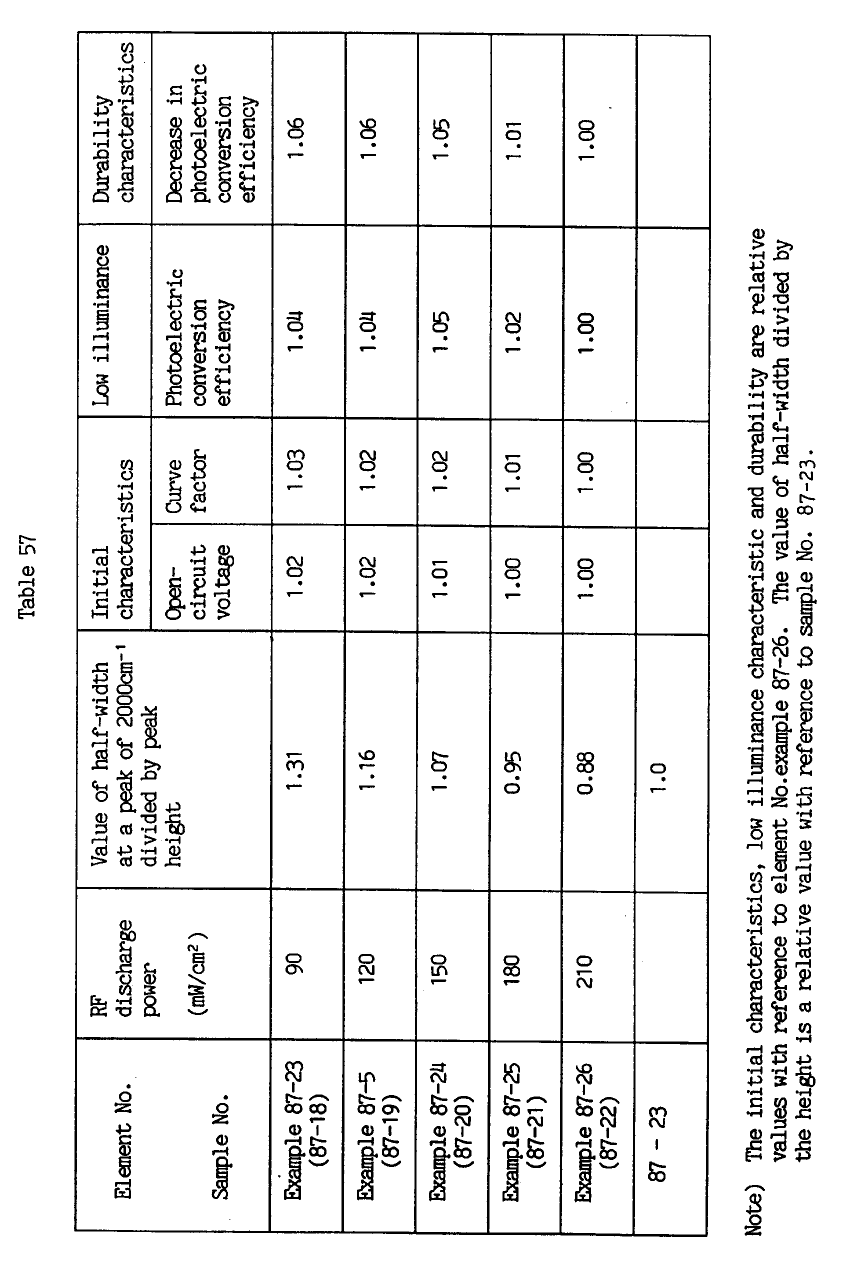

**Table 58**

| Element No. | Layer thickness of the region at maximum bandgap (nm) | Initial characteristics | | Low illuminance | Durability characteristic |
|---|---|---|---|---|---|
| | | Open-circuit voltage | Curve factor | Photoelectric conversion efficiency | Decrease in photoelectric conversion efficiency |
| Example 88-1 | 1 | 1.02 | 1.02 | 1.03 | 1.03 |
| Example 88-2 | 2 | 1.02 | 1.03 | 1.05 | 1.04 |
| Example 88-3 | 3 | 1.03 | 1.04 | 1.06 | 1.07 |
| Example 88-4 | 5 | 1.04 | 1.03 | 1.06 | 1.06 |
| Example 88-5 | 10 | 1.03 | 1.03 | 1.05 | 1.06 |
| Example 88-6 | 20 | 1.03 | 1.02 | 1.04 | 1.05 |
| Example 88-7 | 30 | 1.01 | 1.02 | 1.04 | 1.04 |
| Example 88-8 | 50 | 1.00 | 1.00 | 1.00 | 1.00 |
| Note) The initial characteristics, low illuminance characteristic and durability are relative values with reference to element No. example 88-8. | | | | | |

**Table 59**

| Element No. | Distance between mixing point of gases and deposition chamber (m) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Example 93-1 | 1 | 1.03 | 1.04 | 1.05 | 1.07 |
| Example 93-2 | 2 | 1.03 | 1.03 | 1.05 | 1.06 |
| Example 93-3 | 3 | 1.02 | 1.03 | 1.04 | 1.04 |
| Example 93-4 | 5 | 1.01 | 1.02 | 1.04 | 1.03 |
| Example 93-5 | 8 | 1.00 | 1.00 | 1.00 | 1.00 |
| Note) The initial characteristics, low illuminance characteristic and durability are relative values with reference to element No. example 93-5. | | | | | |

**Table 60**

| | Used gas and flow (sccm) | | RF discharge electric power (W/cm²) | Pressure (1.3 hPa) (Torr) | Substrate temperature (°C) | Layer thickness (nm) |
|---|---|---|---|---|---|---|
| Farbrication conditions of i-type layer by RF plasma CVD | SiH₄ | 8 | | | | |
| | H₂ | 100 | | | | |
| | BF₃/H₂ | 1 | | | | |
| | (diluted to 2000ppm) | | | | | |
| | PH₃/H₂ | 0.06 | 0.12 | 500 | 300 | 10 |
| | (diluted to 2000ppm) | | | | | |

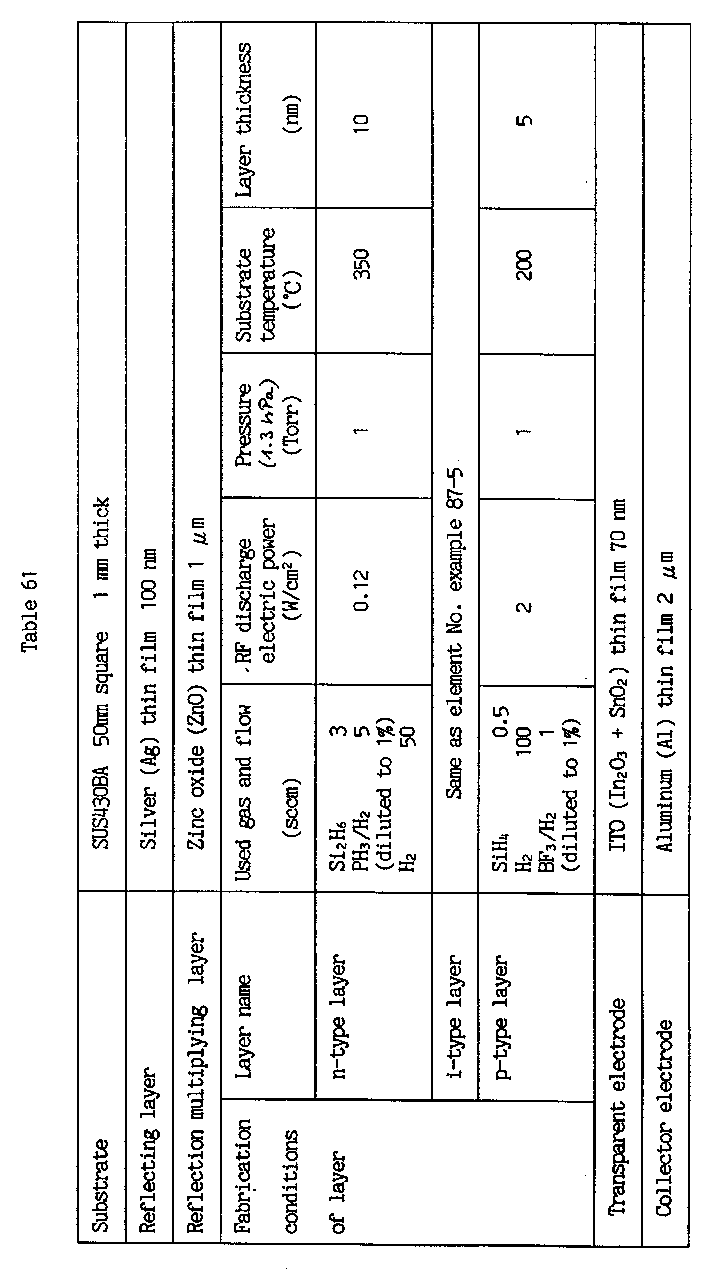

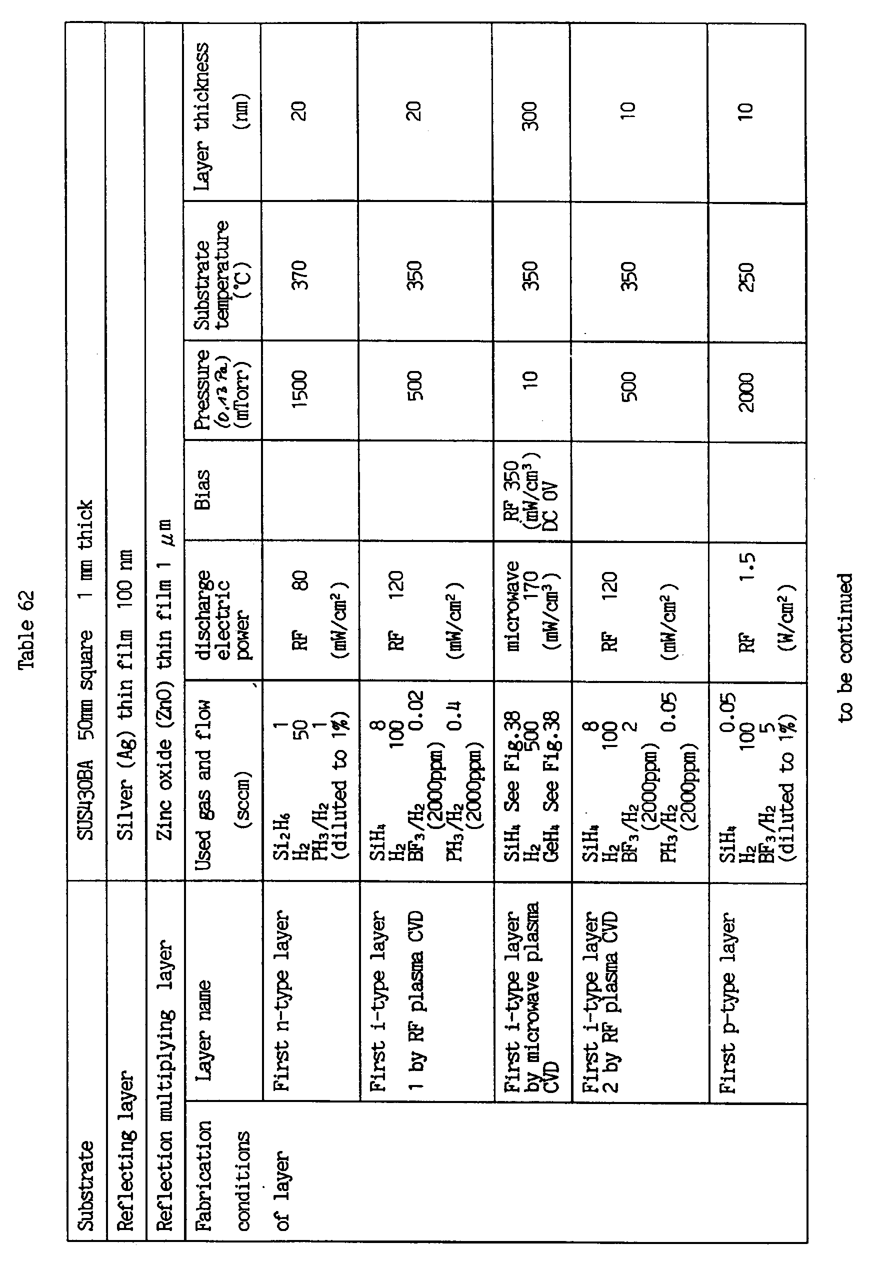

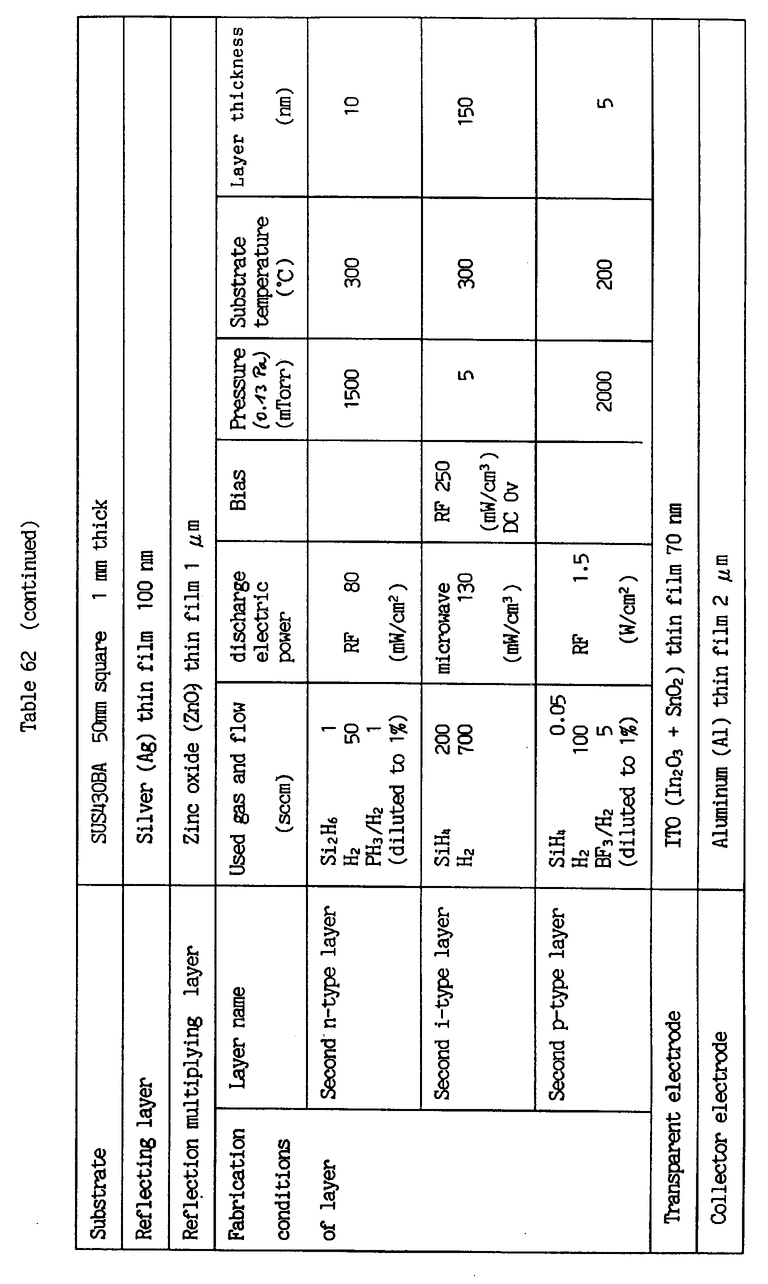

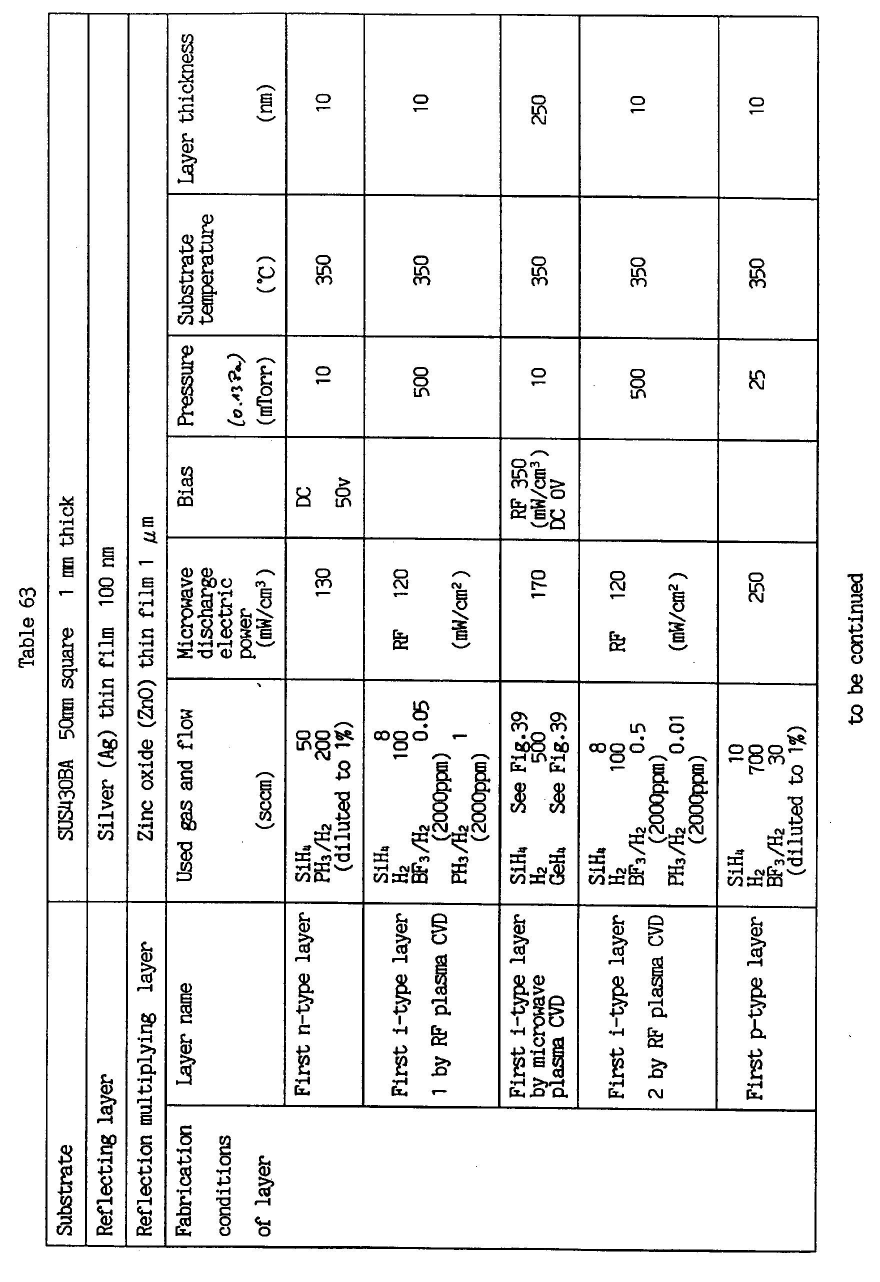

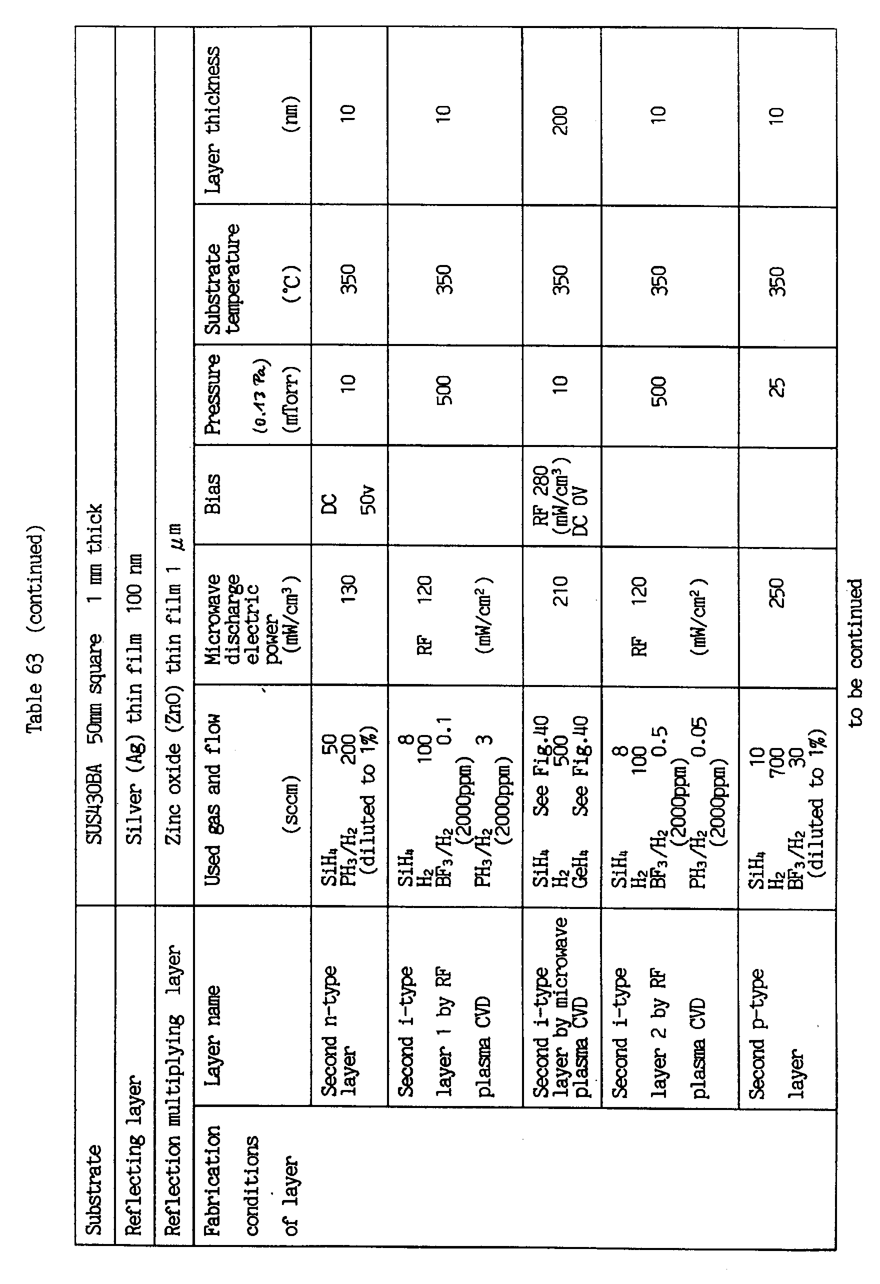

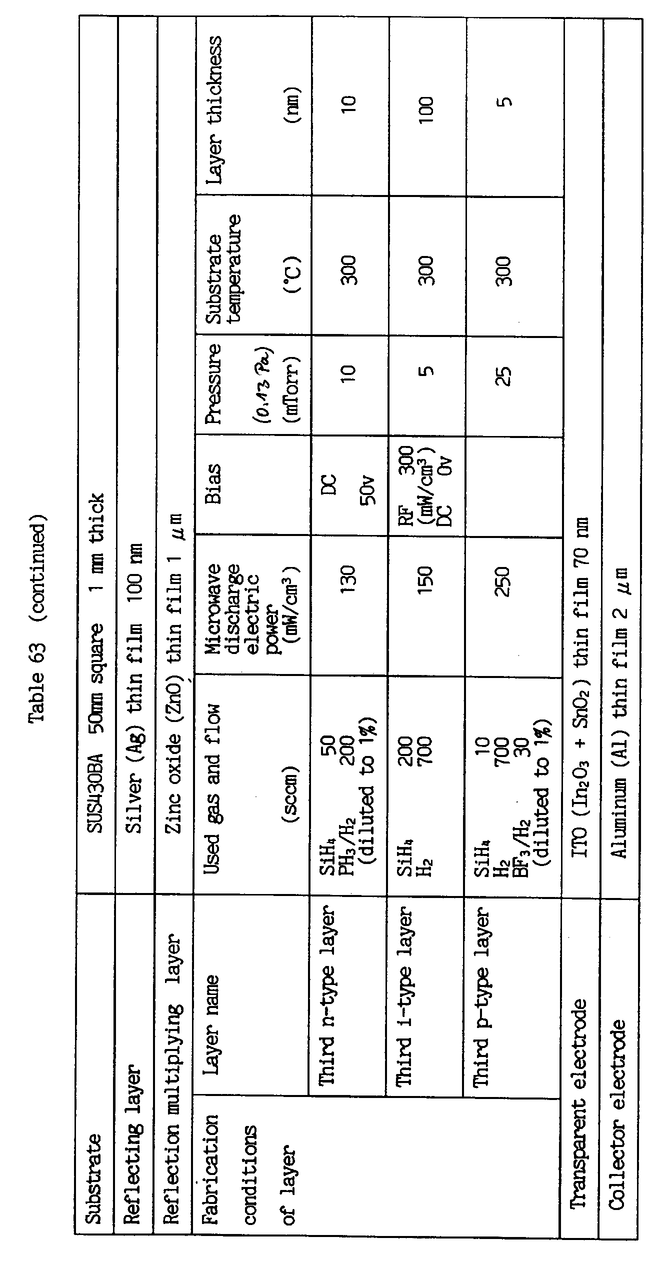

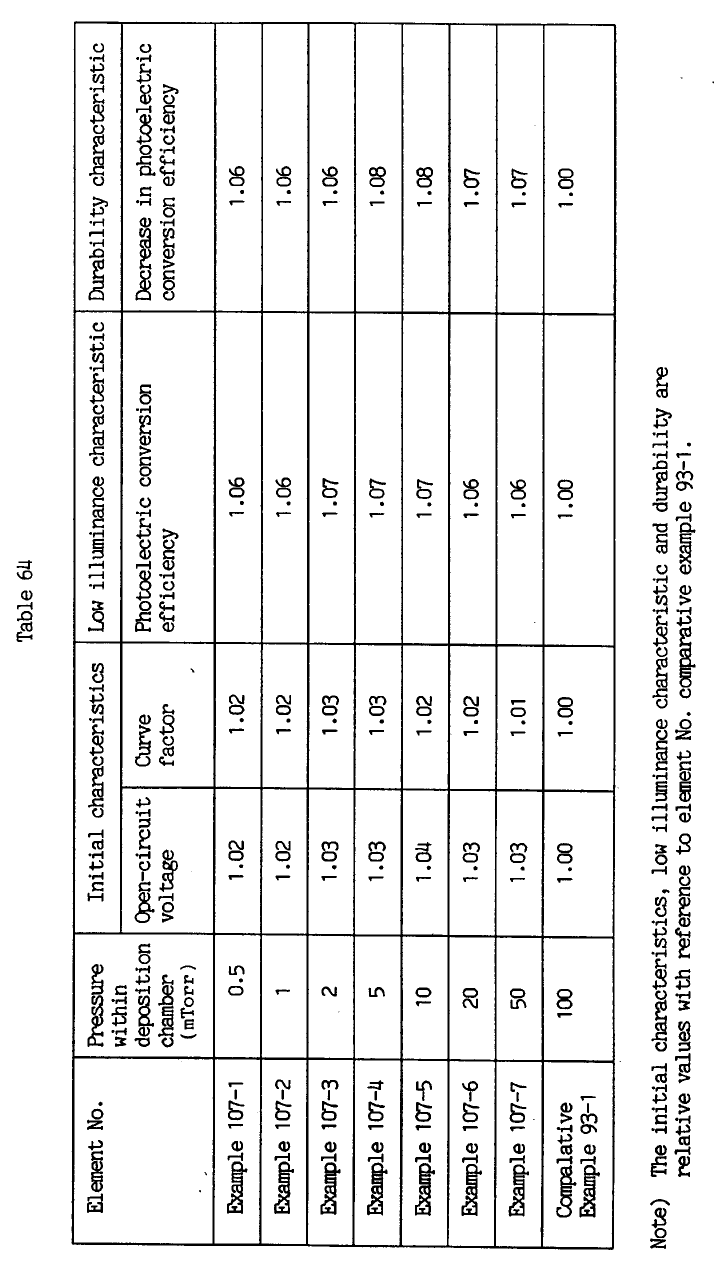

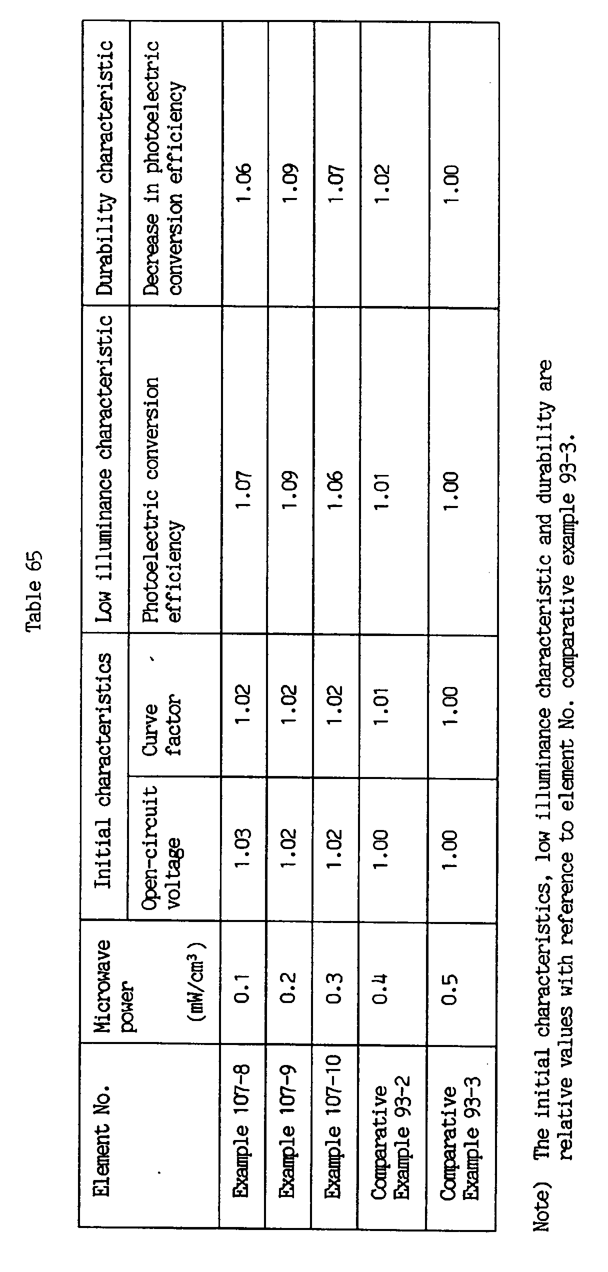

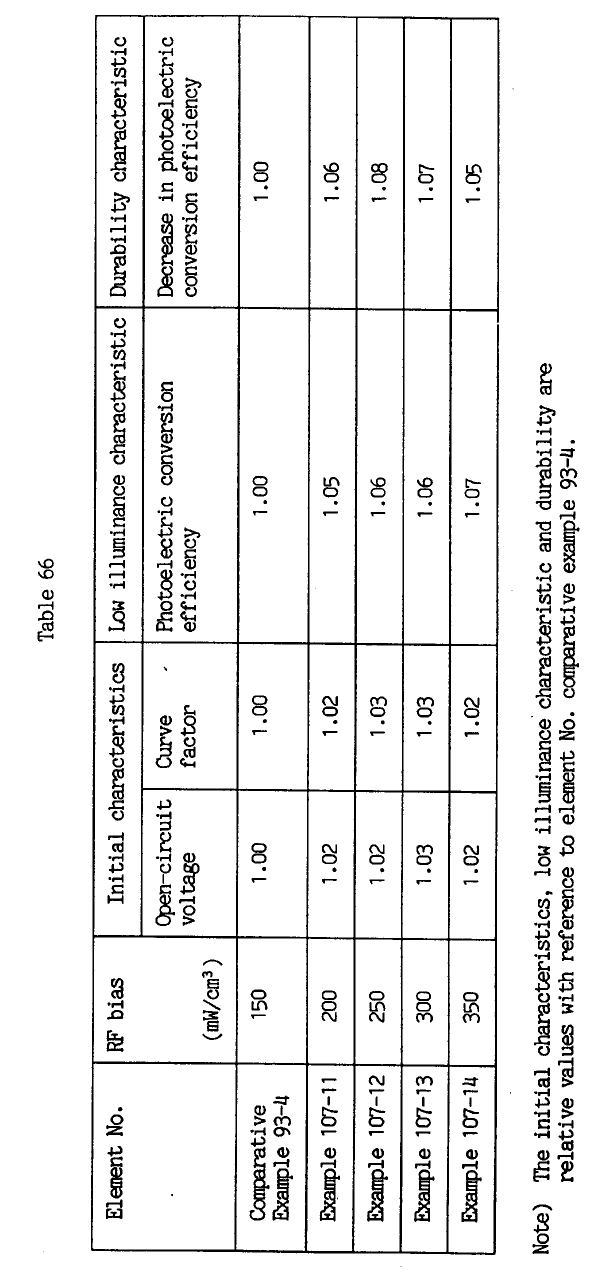

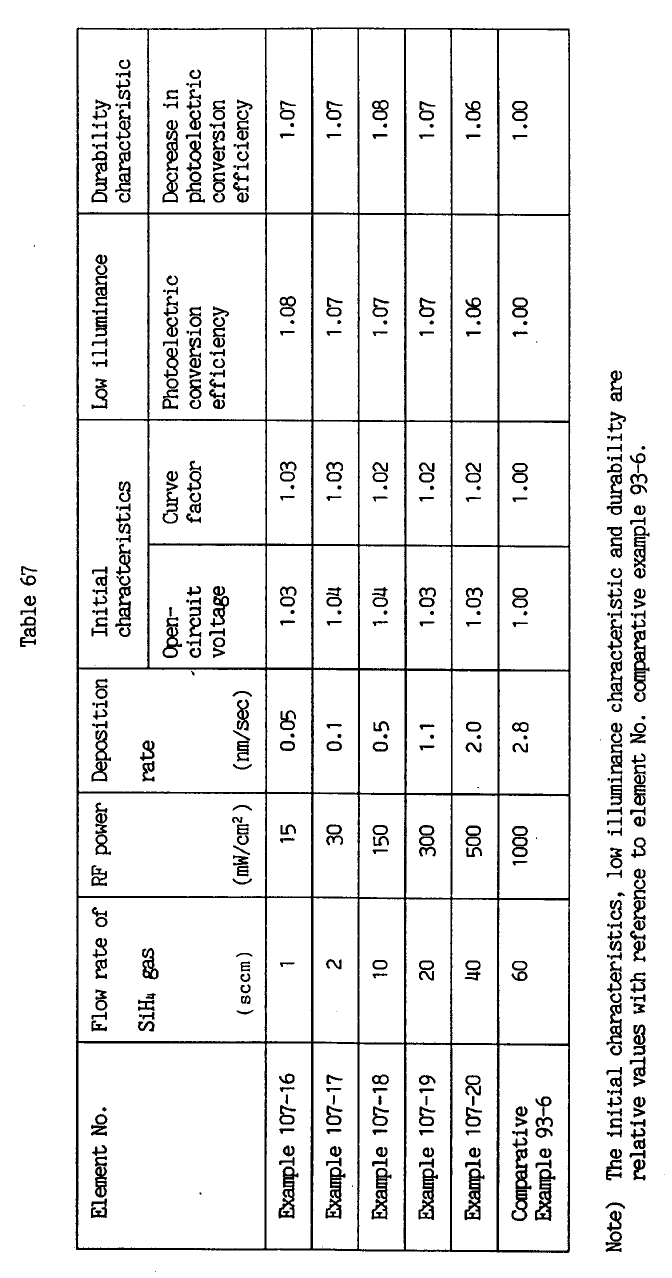

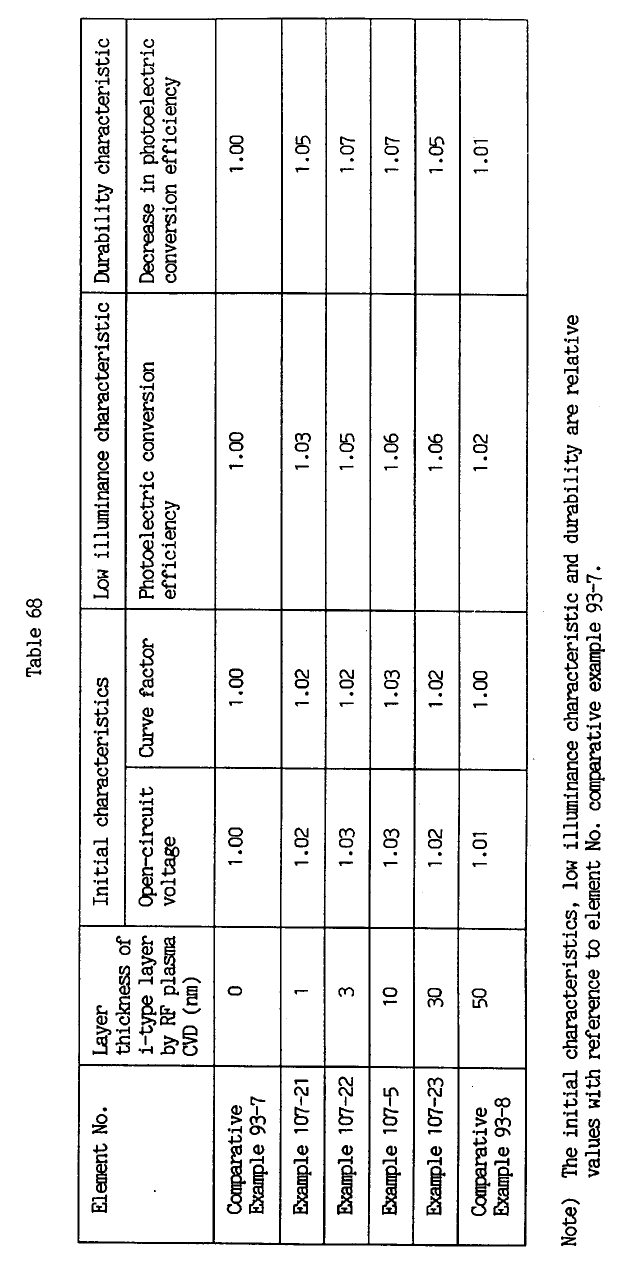

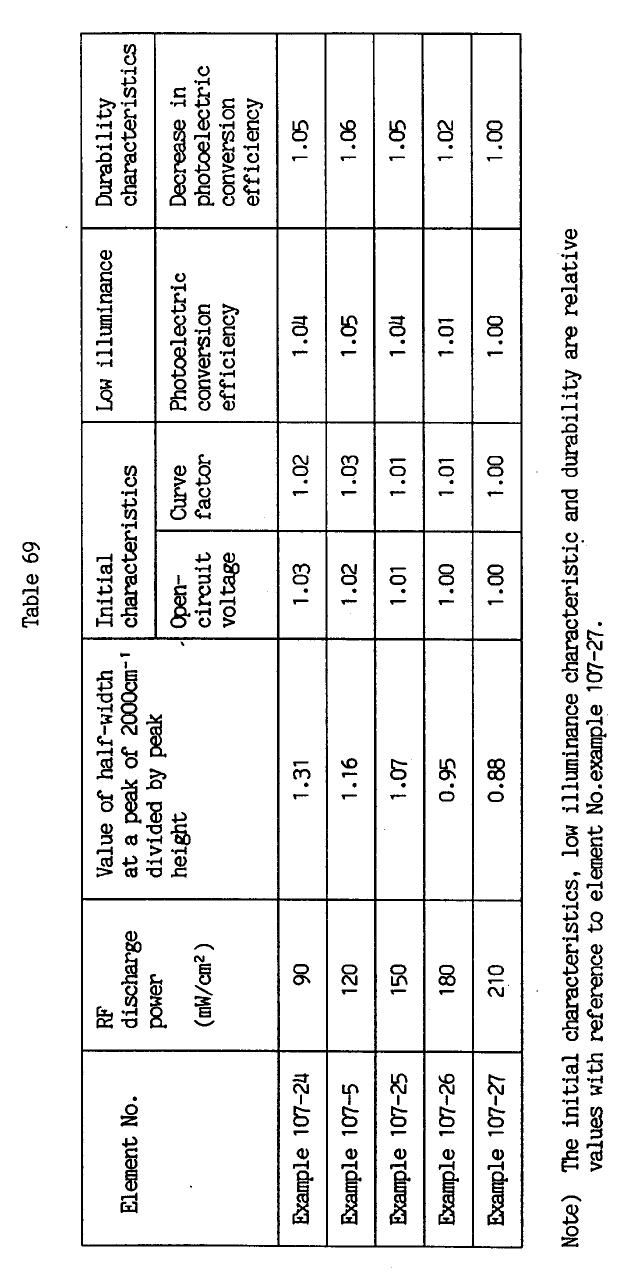

**Table 70**

| Element No. | Layer thickness of the region at maximum bandgap (nm) | Initial characteristics | | Low illuminance | Durability characteristic |
|---|---|---|---|---|---|
| | | Open-circuit voltage | Curve factor | Photoelectric conversion efficiency | Decrease in photoelectric conversion efficiency |
| Example 108-1 | 1 | 1.01 | 1.02 | 1.04 | 1.03 |
| Example 108-2 | 2 | 1.02 | 1.03 | 1.05 | 1.04 |
| Example 108-3 | 3 | 1.02 | 1.03 | 1.05 | 1.06 |
| Example 108-4 | 5 | 1.03 | 1.02 | 1.05 | 1.07 |
| Example 108-5 | 10 | 1.04 | 1.02 | 1.06 | 1.06 |
| Example 108-6 | 20 | 1.04 | 1.02 | 1.05 | 1.06 |
| Example 108-7 | 30 | 1.02 | 1.02 | 1.04 | 1.05 |
| Example 108-8 | 50 | 1.00 | 1.00 | 1.00 | 1.00 |
| Note) The initial characteristics, low illuminance characteristic and durability are relative values with reference to element No. example 108-8. | | | | | |

**Table 71**

| Element No. | Distance between mixing point of gases and deposition chamber (m) | Initial characteristics | | Low illuminance characteristic | Durability characteristic |
|---|---|---|---|---|---|
| | | Open-circuit voltage | Curve factor | Photoelectric conversion efficiency | Decrease in photoelectric conversion efficiency |
| Example 113-1 | 1 | 1.03 | 1.03 | 1.06 | 1.07 |
| Example 113-2 | 2 | 1.03 | 1.04 | 1.05 | 1.06 |
| Example 113-3 | 3 | 1.02 | 1.03 | 1.04 | 1.06 |
| Example 113-4 | 5 | 1.02 | 1.03 | 1.02 | 1.05 |
| Example 113-5 | 8 | 1.00 | 1.00 | 1.00 | 1.00 |
| Note) The initial characteristics, low illuminance characteristic and durability are relative values with reference to element No. example 113-5. | | | | | |

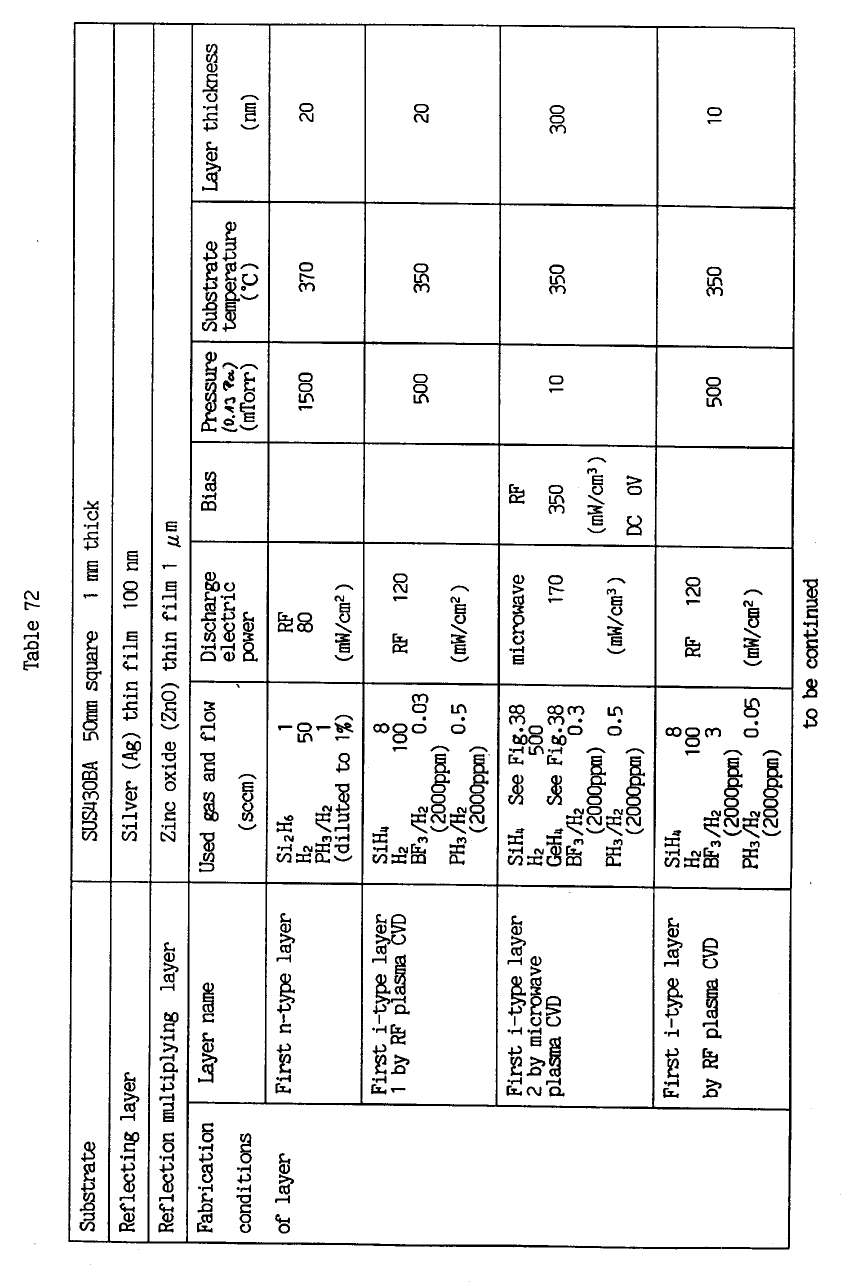

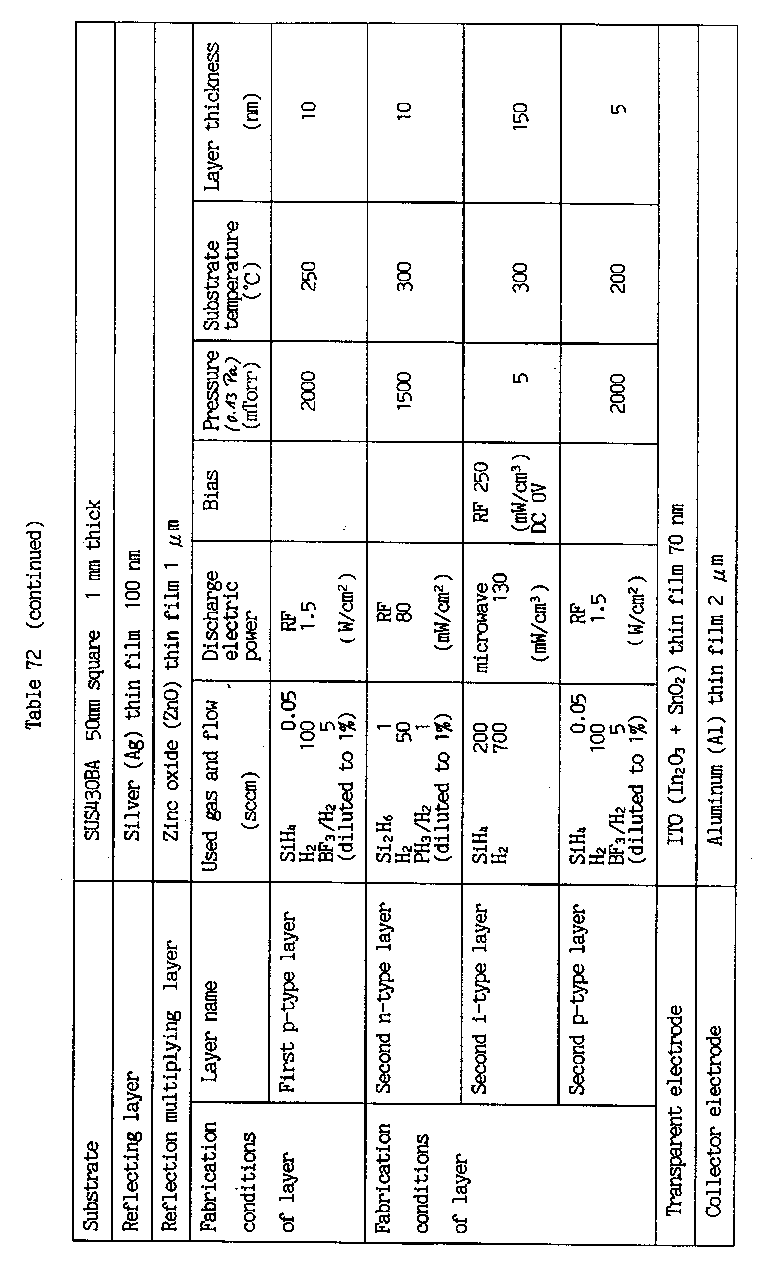

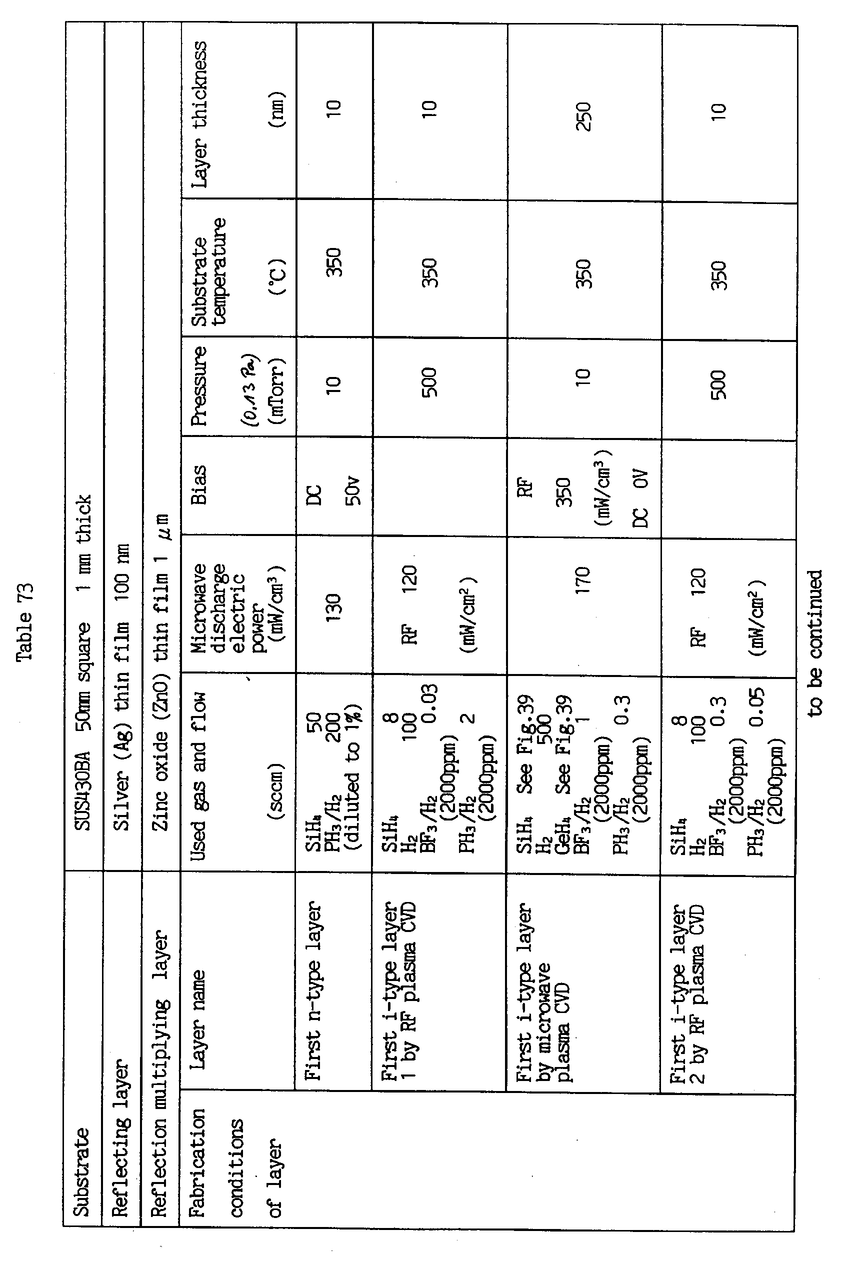

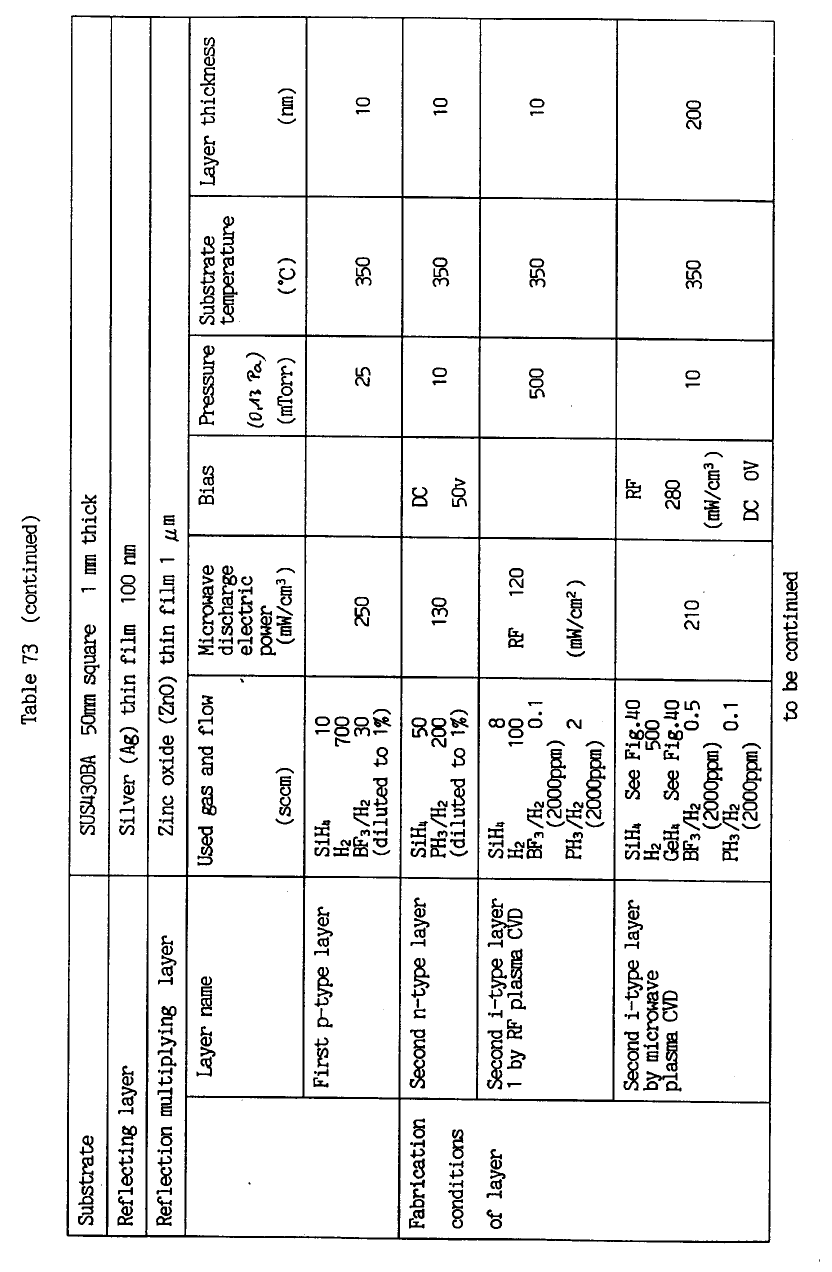

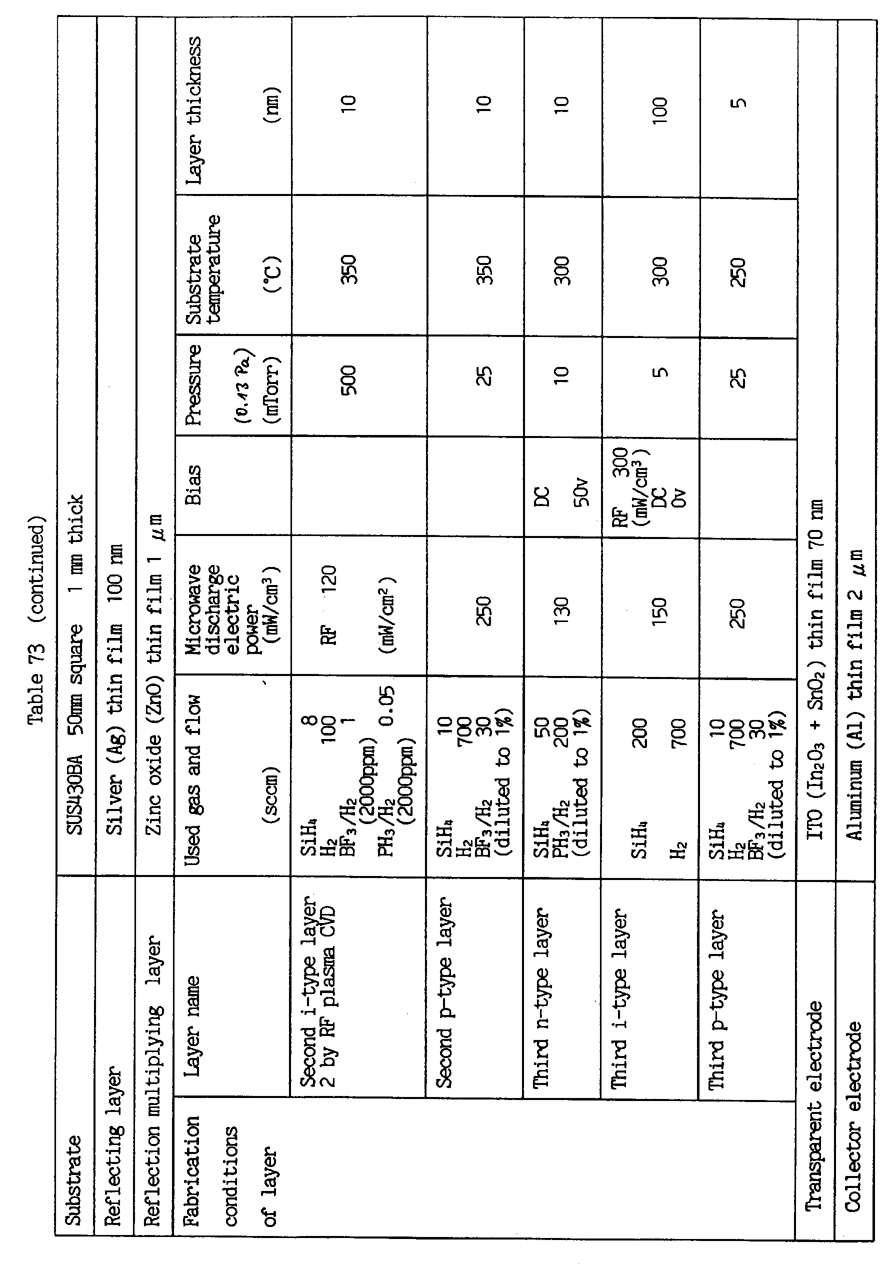

As described above, the present invention can provide a photoelectric conversion element with improved photoelectric conversion efficiency in which the open-circuit voltage and the carrier range of holes are enhanced by preventing the recombination of photoexcited carriers. Also, the photoelectric conversion element of the present invention has a superior conversion efficiency when illuminating light is weak. And the photoelectric conversion element of the present invention is not easily degraded in photoelectric conversion efficiency when annealed under vibrations for the long time.

Furthermore, a power supply system utilizing the photoelectric conversion element of the present invention can exhibit an excellent electric power supply capability when the illuminating light is weak.

## Claims

1. A method of producing a photoelectric conversion element having p (104; 3104), i (103,108;3108,3103,3109) and n (102;3102) laminated layers of silicon type non-monocrystalline semiconductor material, wherein the local minimum energy band gap occurs in a section of said i-layer (103,108;3108,3103,3109) between the centre of said i-layer (103,108;3108,3103,3109) and said p layer (104,3104), the method being characterised by comprising the steps of:
forming a first region (103;3103) of said i-layer (103,108;3103) by microwave plasma CVD in which a source gas including at least a silicon containing gas and a germanium containing gas is simultaneously subjected to microwave energy and RF energy, the RF energy being of a power density greater than the power density of said microwave energy, the power density of the microwave energy being less than that required to completely decompose said source gas; and
forming a second region (108;3108,3109) of said i-layer (103,108;3108,3103,3109) by RF plasma CVD.

2. A method according to claim 1 in which said source gas during said microwave plasma CVD is at a pressure of 6.67 Pa or less.

3. A method according to either of the preceding claims in which said second region (108;3108,3109) of said i-layer (103,108;3108,3103,3109) is formed into a thickness of no greater than 30nm.

4. A method according to any one of the preceding claims in which said second region (108;3108,3109) of said i-layer is deposited at a deposition rate of no greater than 2nm/sec.

5. A method according to any one of the preceding claims, wherein said region (103) of said i-layer (103,108) formed by the microwave plasma CVD process is formed at a position at the side of said n type layer (102).

6. A method according to any one of claims 1 to 4, wherein said region (103) of said i-layer (103,108) formed by the microwave plasma CVD process is formed at a position at the side of the p type layer (104).

7. A method according to any one of the preceding claims, wherein said i-layer (103,108;3108,3103,3109) is formed by simultaneously doping a valence electron controlling material operating as a donor and a valence electron controlling material operating as an acceptor.

8. A method according to any one of the preceding claims, wherein the atmosphere for forming said i-layer (103,108;3108,3103,3109) includes oxygen and/or nitrogen atoms.

9. A method according to any one of the preceding claims including the step of:
forming said p type layer (104;3104) by forming a layer mainly composed of group III atoms, and by forming a layer including a valence electron controlling material and mainly composed of silicon atoms.

10. A method according to any one of the preceding claims including the step of:
forming said n type layer (102;3102) by forming a layer mainly composed of group V atoms, and by forming a layer including a valence electron controlling material and mainly composed of silicon atoms.

11. A method according to any one of the preceding claims, wherein said silicon containing gas and said germanium containing gas are mixed at a position within 5m from the deposition chamber.

12. A method according to any one of the preceding claims, wherein the second i-layer region (108;3108,3109) is provided between said first region (103;3103) of said i-layer (103,108;3108,3103,3109) and said n (102;3102)or p (104;3104) layer.

13. A method according to any one of the preceding claims, wherein the formation of said i-layer (103,108;3108,3103,3109) is controlled so that inactive donors or acceptors occur in the valence electron controlling material of said i-layer (103,108;3108,3103,3109) at a concentration of 0.1-100 ppm.

14. A method according to any one of the preceding claim, wherein the formation of said i-layer (103,108;3108,3103,3109) is controlled so that said i-layer (103,108;3108,3103,3109) includes valence electron controlling material, and the concentration of the valence electron controlling material is a maximum at a section having a local minimum energy band gap.

15. A method according to any one of the preceding claims, wherein the formation of said second region (108;3108,3109) is controlled to have a high concentration of valence electrons at an interface with said p (104;3104) or n (102;3102) layer.

16. A power generation system comprising a photoelectric conversion element produced by a method according to any one of the preceding claims, and a control system for controlling the electric power to be supplied to a load (9105), while sensing the voltage and/or the current of said photoelectric conversion element.

17. A power generation system according to claim 16, in which said load (9105) is an accumulator for accumulating electric power from said photoelectric conversion element and/or supplying electric power to an external load.

## Patentansprüche

1. Verfahren zur Herstellung eines photoelektrischen Wandlerelements mit p (104; 3104), i (103, 108; 3108, 3103, 3109) und n (103; 3102) laminierten Schichten nichtmonokristallinen Halbleitermaterials aus Silizium, wobei der lokale minimale Energiebandabstand in einem Abschnitt der i-Schicht (103, 108; 3108, 3103, 3109) zwischen der Mitte und der i-Schicht (103, 108; 3108, 3103, 3109) und der p-Schicht (104, 3104) auftritt, gekennzeichnet durch die Verfahrensschritte:
Bilden einer ersten Zone (103; 3103) der i-Schicht (103, 108, 3103) durch Mikrowellenplasma-CVD, bei der ein Quellgas mit wenigstens einem siliziumhaltigen und einem germaniumhaltigen Gas gleichzeitig der Mikrowellenenergie und der HF-Energie ausgesetzt wird, wobei die HF-Energie eine Leistungsdichte hat, die größer als die Leistungsdichte der Mikrowellenenergie ist, wobei die Leistungsdichte der Mikrowellenenergie geringer als diejenige ist, die zur vollständigen Aufspaltung des Quellgases erforderlich ist, und
Bilden einer zweiten Zone (108; 3108, 3109) der i-Schicht (103, 108; 3108, 3103, 3109) durch HF-Plasma-CVD.

2. Verfahren nach Anspruch 1, bei dem das Quellgas während des Mikrowellenplasma-CVD einen Druck von 6,67 Pa oder weniger hat.

3. Verfahren nach einem der vorstehenden Ansprüche, bei dem die zweite Zone (108; 3108, 3109) der i-Schicht (103, 108; 3108, 3103, 3109) in einer Stärke von nicht mehr als 30 nm gebildet ist.

4. Verfahren nach einem der vorstehenden Ansprüche, bei dem die Auftragungsrate der zweiten Zone (108; 3108, 3109) der i-Schicht mit nicht mehr als 2 nm/sec beträgt.

5. Verfahren nach einem der vorstehenden Ansprüche, bei dem die Zone (103) der durch den Mikrowellenplasma-CVD-Prozeß gebildeten i-Schicht (103, 108) an einer Stelle auf der Seite der n-dotierten Schicht (102) gebildet ist.

6. Verfahren nach einem der Ansprüche 1 bis 4, bei dem die Zone (103) der durch den Mikrowellenplasma-CVD-Prozeß gebildeten i-Schicht (103, 108) an einer Stelle auf der Seite der p-dotierten Schicht (104) gebildet ist.

7. Verfahren nach einem der vorstehenden Ansprüche, bei dem die i-Schicht (103, 108; 3108, 3103, 3109) durch gleichzeitiges Dotieren eines Valenzband-Steuermaterials gebildet ist, das als Donator dient, und ein Valenzelektronen-Steuermaterial, das als Akzeptor dient.

8. Verfahren nach einem der vorstehenden Ansprüche, bei dem die Atmosphäre zum Bilden der i-Schicht (103, 108; 3108, 3103, 3109) Sauerstoff- und/oder Stickstoffatome enthält.

9. Verfahren nach einem der vorstehenden Ansprüche, mit dem Verfahrensschritt:
Bilden der p-dotierten Schicht (104; 3104) durch Bilden einer Schicht, die hauptsächlich aus Atomen der Gruppe III besteht, und durch Bilden einer Schicht mit einem Valenzelektronen-Steuermaterial, das hauptsächlich aus Siliziumatomen besteht.

10. Verfahren nach einem der vorstehenden Ansprüche, mit dem Verfahrensschritt:
Bilden einer n-dotierten Schicht (103; 3102) durch Bilden einer Schicht, die hauptsächlich aus Atomen der Gruppe V besteht, und durch Bilden einer Schicht, die ein Valenzelektronen-Steuermaterial enthält und hauptsächlich aus Siliziumatomen besteht.

11. Verfahren nach einem der vorstehenden Ansprüche, bei dem das Mischen des siliziumhaltigen Gases und das germaniumhaltigen Gases an einer Position innerhalb 5 m von der Abscheidungskammer erfolgt.

12. Verfahren nach einem der vorstehenden Ansprüche, bei dem die zweite i-Schichtzone (108; 3108, 3109) zwischen der ersten Zone (103; 3103) der i-Schicht (103, 108; 3108, 3103, 3109) und der n- (103; 3102) oder p- (104; 3104) Schicht vorgesehen ist.

13. Verfahren nach einem der vorstehenden Ansprüche, bei dem das Bilden der i-Schicht (103, 108; 3108, 3103, 3109) so gesteuert wird, daß inaktive Donatoren oder Akzeptoren im Valenzelektronen-Steuermaterial der i-Schicht (103, 108; 3108, 3103, 3109) mit einer Konzentration von 0,1 - 100 ppm auftreten.

14. Verfahren nach einem der vorstehenden Ansprüche, bei dem das Bilden der i-Schicht (103, 108; 3108, 3103, 3109) so gesteuert wird, daß die i-Schicht (103, 108; 3108, 3103, 3109) Valenzelektronen-Steuermaterial enthält und die Konzentration des Valenzelektronen-Steuermaterials in einem Abschnitt lokalen minimalen Energiebandabstands maximal ist.

15. Verfahren nach einem der vorstehenden Ansprüche, bei dem das Bilden der zweiten Zone (108; 3108, 3109) gesteuert wird, damit eine hohe Konzentration von Valenzelektronen an einer Übergangsstelle mit der p- (104; 3104) oder n- (102; 3102) Schicht auftritt.

16. Stromerzeugungssystem mit einem photoelektrischen Wandlerelement nach einem der vorstehenden Ansprüche und mit einem Steuersystem zum Steuern des an eine Last (9105) zu liefernden elektrischen Stromes, während eine Messung der Spannung und/oder der Stromes des photoelektrischen Wandlerelements erfolgt.

17. Stromerzeugungssystem nach Anspruch 16, bei dem die Last (9105) ein Akkumulator ist, der elektrische Leistung aus dem photoelektrischen Wandlerelement sammelt, und/oder elektrischen Strom an eine externe Last liefert.

## Revendications

1. Procédé de production d'un élément de conversion photo-électrique ayant des couches stratifiées p (104 ; 3104), i (103, 108 ; 3108, 3103, 3109) et n (102 ; 3102) en matières semiconductrices monocristallines du type silicium, dans lequel la bande d'énergie interdite minimale locale apparaît dans une section de ladite couche i (103, 108 ; 3108, 3103, 3109) entre le centre de ladite couche i (103, 108 ; 3108, 3103, 3109) et ladite couche p (104, 3104), le procédé étant caractérisé en ce qu'il comprend les étapes dans lesquelles :
on forme une première région (103 ; 3103) de ladite couche i (103, 108 ; 3103) par dépôt chimique en phase vapeur (CVD) activé au plasma hyperfréquence dans lequel un gaz de source comprenant au moins un gaz contenant du silicium et un gaz contenant du germanium est soumis simultanément à une énergie hyperfréquence et une énergie RF, l'énergie RF étant d'une densité de puissance supérieure à la densité de puissance de ladite énergie hyperfréquence, la densité de puissance de l'énergie hyperfréquence étant inférieure à celle nécessaire pour décomposer complètement ledit gaz de source ; et
on forme une seconde région (108 ; 3108, 3109) de ladite couche i (103, 108 ; 3108, 3103, 319) par dépôt CVD activé au plasma RF.

2. Procédé selon la revendication 1, dans lequel ledit gaz de source pendant ledit procédé CVD activé au plasma hyperfréquence est à une pression de 6,67 Pa ou moins.

3. Procédé selon l'une des revendications précédentes, dans lequel ladite seconde région (108 ; 3108, 3109) de ladite couche i (103, 108 ; 3108, 3103, 3109) est formée à une épaisseur non supérieure à 30 nanomètres.

4. Procédé selon l'une quelconque des revendications précédentes, dans lequel ladite seconde région (108 ; 3108, 3109) de ladite couche i est déposée à une vitesse de dépôt non supérieure à 2 nanomètres/seconde.

5. Procédé selon l'une quelconque des revendications précédentes, dans lequel ladite région (103) de ladite couche i (103, 108) formée par le procédé CVD activé au plasma hyperfréquence est formée dans une position à côté de ladite couche de type n (102).

6. Procédé selon l'une quelconque des revendications 1 à 4, dans lequel ladite région (103) de ladite couche i (103, 108) formée par le procédé CVD activé au plasma hyperfréquence est formée dans une position à côté de la couche de type p (104).

7. Procédé selon l'une quelconque des revendications précédentes, dans lequel ladite couche i (103, 108 ; 3108, 3103, 3109) est formée par dopage simultané avec une matière de commande d'électrons de valence agissant en tant que donneur et une matière de commande d'électrons de valence agissant en tant qu'accepteur.

8. Procédé selon l'une quelconque des revendications précédentes, dans lequel l'atmosphère pour la formation de ladite couche i (103, 108 ; 3108, 3103, 3109) comprend des atomes d'oxygène et/ou d'azote.

9. Procédé selon l'une quelconque des revendications précédentes, comprenant l'étape dans laquelle :
on forme ladite couche de type p (104 ; 3104) en formant une couche composée principalement d'atomes du groupe III, et en formant une couche comprenant une matière de commande d'électrons de valence et composée principalement d'atomes de silicium.

10. Procédé selon l'une quelconque des revendications précédentes, comprenant l'étape dans laquelle :
on forme ladite couche de type n (102 ; 3102) en formant une couche composée principalement d'atomes du groupe V, et en formant une couche comprenant une matière de commande d'électrons de valence et composée principalement d'atomes de silicium.

11. Procédé selon l'une quelconque des revendications précédentes, dans lequel ledit gaz contenant du silicium et ledit gaz contenant du germanium sont mélangés dans une position en deçà de 5 mètres de la chambre de dépôt.

12. Procédé selon l'une quelconque des revendications précédentes, dans lequel la seconde région (108 ; 3108, 3109) de la couche i est prévue entre ladite première région (103 ; 3103) de ladite couche i (103, 108 ; 3108, 3103, 3109) et ladite couche n (102 ; 3102) ou p (104 ; 3104).

13. Procédé selon l'une quelconque des revendications précédentes, dans lequel la formation de ladite couche i (103, 108 ; 3108,3103, 3109) est commandée de manière que des donneurs ou des accepteurs inactifs apparaissent dans la matière de commande d'électrons de valence de ladite couche i (103, 108 ; 3108,3103, 3109) à une concentration de 0,1 à 100 ppm.

14. Procédé selon l'une quelconque des revendications précédentes, dans lequel la formation de ladite couche i (103, 108 ; 3108, 3103, 3109) est commandée de façon que ladite couche i (103, 108 ; 3108, 3103, 3109) comprenne une matière de commande d'électrons de valence, et que la concentration de la matière de commande d'électrons de valence soit maximale à une section ayant une bande d'énergie interdite minimale locale.

15. Procédé selon l'une quelconque des revendications précédentes, dans lequel la formation de ladite seconde région (108 ; 3108, 3109) est commandée de façon qu'il y ait une concentration élevée d'électrons de valence à une interface avec ladite couche p (104 ; 3104) ou n (102 ; 3102).

16. Système de génération de puissance comportant un élément de conversion photo-électrique produit par un procédé selon l'une quelconque des revendications précédentes, et un système de commande destiné à commander la puissance électrique devant être fournie à une charge (105), tout en captant la tension et/ou le courant dudit élément de conversion photo-électrique.

17. Système de génération de puissance selon la revendication 16, dans lequel ladite charge (9105) est un accumulateur destiné à accumuler de la puissance électrique provenant dudit élément de conversion photo-électrique et/ou à fournir de la puissance électrique à une charge extérieure.
